# EUROPÄISCHE PATENTSCHRIFT

(11) **EP 4 069 709 B1**
(45) Veröffentlichungstag und Bekanntmachung des Hinweises auf die Patenterteilung: **23.04.2025**
(21) Anmeldenummer: 20815826.1
(22) Anmeldetag: 02.12.2020
(51) Int. Cl.: C07F 15/00, H10K 50/11, H10K 85/30

(54) **METALLKOMPLEXE**
METAL COMPLEXES
COMPLEXES MÉTALLIQUES

(30) Priorität: 04.12.2019 EP 19213385
(43) Veröffentlichungstag der Anmeldung: 12.10.2022
(73) Patentinhaber: UDC Ireland Limited, Ballycoolin, Dublin 15 (IE)
(72) Erfinder: STOESSEL, Philipp, 64293 DARMSTADT (DE); AUCH, Armin, 64293 DARMSTADT (DE)
(74) Vertreter: Maiwald GmbH
(86) Internationale Anmeldenummer: PCT/EP2020/084216
(87) Internationale Veröffentlichungsnummer: WO 2021/110720

(56) Entgegenhaltungen:
- WO-A1-2013/061850
- WO-A1-2016/124304
- WO-A1-2018/011186
- WO-A1-2018/041769
- WO-A1-2018/054798
- WO-A1-2018/077769
- JP-A- 2013 168 552
- JP-A- 2013 243 234

## Beschreibung

Die vorliegende Erfindung betrifft Iridiumkomplexe, welche sich für den Einsatz in organischen Elektrolumineszenzvorrichtungen, insbesondere als Emitter, eignen.

Gemäß dem Stand der Technik werden in phosphoreszierenden organischen Elektrolumineszenzvorrichtungen (OLEDs) als Triplettemitter vor allem bis- und tris-ortho-metallierte Irdiumkomplexe mit aromatischen Liganden eingesetzt. Beispiele für solche Komplexe sind Tris(phenyl-pyridyl)iridium(III), sowie eine Vielzahl verwandter Komplexe, beispielsweise mit 1- oder 3-Phenylisochinolinliganden, mit 2-Phenylchinolinliganden oder mit Phenyl-carbenliganden. Derartige Komplexe sind auch mit polypodalen Liganden bekannt, wie beispielsweise in US 7,332,232 und WO 2016/124304 beschrieben. WO2013/061850 und JP2013 168552 beschreiben weitere Iridium-Emitter für den Einsatz in organische Elektrolumineszenzvorrichtungen.

Aufgabe der vorliegenden Erfindung ist die Bereitstellung neuer und insbesondere verbesserter Metallkomplexe, welche sich als Emitter für die Verwendung in OLEDs eignen und welche eine gute Lebensdauer und Effizienz aufweisen.

Überraschend wurde gefunden, dass die nachfolgend beschriebenen Metallkomplexe, welche einen tetradentaten tripodalen Liganden und einen bidentaten oder zwei monodentate Liganden enthalten, diese Aufgabe lösen und sich sehr gut für die Verwendung in einer organischen Elektrolumineszenzvorrichtung eignen. Diese Metallkomplexe und organische Elektrolumineszenzvorrichtungen, welche diese Komplexe enthalten, sind daher der Gegenstand der vorliegenden Erfindung.

Gegenstand der Erfindung ist eine Verbindung der Formel (1), 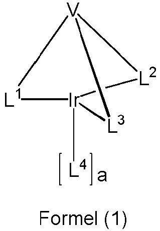 wobei für die verwendeten Symbole und Indizes gilt:
- L¹: ist ein bidentater Teilligand, der über ein Kohlenstoffatom und ein Stickstoffatom oder über zwei Kohlenstoffatome an das Iridium koordiniert;
- L², L³: sind gleich oder verschieden bei jedem Auftreten gewählt aus einer Aryl- oder Heteroarylgruppe mit 5 bis 14 aromatischen Ringatomen oder einer heteroalicyclischen Gruppe mit 5 bis 7 Ringatomen, die jeweils über ein Kohlenstoffatom oder ein Stickstoffatom, das jeweils Teil der Aryl- bzw. Heteroarylgruppe bzw. der heteroalicyclischen Gruppe ist, an das Iridium koordiniert und die durch einen oder mehrere Reste R substituiert sein kann;
- L⁴: ist ein bidentater Ligand oder ist bei jedem Auftreten gleich oder verschieden ein monodentater Ligand;
- a: ist 1, wenn L⁴ ein bidentater Ligand ist, und ist 2, wenn L⁴ ein monodentater Ligand ist;
- V: ist eine Gruppe der Formel (2) oder (3), 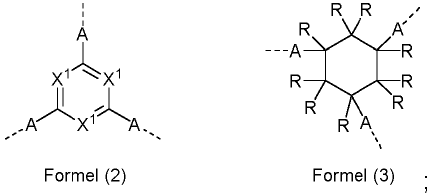 wobei die gestrichelten Bindungen jeweils die Position der Verknüpfung der Teilliganden L¹, L² und L³ darstellen und weiterhin gilt:
- A: ist bei jedem Auftreten gleich oder verschieden CR₂-CR₂ oder eine Gruppe der folgenden Formel (4): 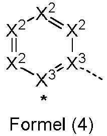 wobei die gestrichelte Bindung jeweils die Position der Bindung der Teilliganden L¹, L² bzw. L³ darstellt und * die Position der Verknüpfung der Einheit der Formel (4) mit der zentralen trivalenten Aryl- bzw. Heteroarylgruppe in Formel (2) bzw. mit der zentralen Cyclohexangruppe in Formel (3) darstellt;
- X¹: ist bei jedem Auftreten gleich oder verschieden CR oder N;
- X²: ist bei jedem Auftreten gleich oder verschieden CR oder N; oder zwei benachbarte Gruppen X² stehen zusammen für NR, O oder S, so dass ein Fünfring entsteht, und die verbleibenden Gruppen X² stehen gleich oder verschieden bei jedem Auftreten für CR oder N; oder zwei benachbarte Gruppen X² stehen zusammen für CR oder N, wenn in dem Cyclus eine der Gruppen X³ für N steht, so dass ein Fünfring entsteht, und die verbleibenden Gruppen X² stehen gleich oder verschieden bei jedem Auftreten für CR oder N; mit der Maßgabe, dass maximal zwei benachbarte Gruppen X² in jedem Ring für N stehen;
- X³: ist bei jedem Auftreten in demselben Cyclus C, oder eine Gruppe X³ steht für N und die andere Gruppe X³ in demselben Cyclus steht für C; mit der Maßgabe, dass zwei benachbarte Gruppen X² zusammen für CR oder N stehen, wenn in dem Cyclus eine der Gruppen X³ für N steht;
- R: ist bei jedem Auftreten gleich oder verschieden H, D, F, Cl, Br, I, N(R¹)₂, OR¹, SR¹, CN, NO₂, COOH, C(=O)N(R¹)₂, Si(R¹)₃, Ge(R¹)₃, B(OR¹)₂, C(=O)R¹, P(=O)(R¹)₂, S(=O)R¹, S(=O)₂R¹, OSO₂R¹, eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R¹ substituiert sein kann und wobei eine oder mehrere nicht benachbarte CH₂-Gruppen durch Si(R¹)₂, C=O, NR¹, O, S oder CONR¹ ersetzt sein können, oder ein aromatisches oder heteroaromatisches Ringsystem mit 5 bis 40 aromatischen Ringatomen, das jeweils durch einen oder mehrere Reste R¹ substituiert sein kann; dabei können zwei Reste R auch miteinander ein Ringsystem bilden;
- R¹: ist bei jedem Auftreten gleich oder verschieden H, D, F, Cl, Br, I, N(R²)₂, OR², SR², CN, NO₂, Si(R²)₃, Ge(R²)₃, B(OR²)₂, C(=O)R², P(=O)(R²)₂, S(=O)R², S(=O)₂R², OSO₂R², eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R² substituiert sein kann und wobei eine oder mehrere nicht benachbarte CH₂-Gruppen durch Si(R²)₂, C=O, NR², O, S oder CONR² ersetzt sein können, oder ein aromatisches oder heteroaromatisches Ringsystem mit 5 bis 40 aromatischen Ringatomen, das jeweils durch einen oder mehrere Reste R² substituiert sein kann; dabei können zwei oder mehrere Reste R¹ miteinander ein Ringsystem bilden;
- R²: ist bei jedem Auftreten gleich oder verschieden H, D, F oder ein aliphatischer, aromatischer und/oder heteroaromatischer organischer Rest, insbesondere ein Kohlenwasserstoffrest, mit 1 bis 20 C-Atomen, in dem auch ein oder mehrere H-Atome durch F ersetzt sein können.

Es handelt sich somit um einen Komplex mit einem tetradentaten, tripodalen Liganden, welcher einen bidentaten und zwei monodentate Teilliganden aufweist, und einem bidentaten oder zwei monodentaten Liganden. Dabei bedeutet "bidentater Teilligand", dass der Teilligand im Komplex über zwei Koordinationsstellen an das Iridium koordiniert bzw. bindet, und "monodentater Teilligand", dass der Teilligand im Komplex über eine Koordinationsstelle an das Iridium koordiniert bzw. bindet. Tripodal bedeutet, dass der Ligand drei Teilliganden aufweist, die an die Brücke V bzw. die Brücke der Formel (2) bzw. (3) gebunden sind. Da der Ligand enthaltend die Brücke V einen bidentaten und zwei monodentate Teilliganden aufweist, ergibt sich insgesamt ein tetradentater Ligand, also ein Ligand, der über vier Koordinationsstellen an das Iridium koordiniert bzw. bindet. Der Begriff "bidentater Teilligand" bzw. "nmonodentater Teilligand" bedeutet im Sinne dieser Anmeldung, dass es sich bei L¹ um einen bidentaten Liganden bzw. bei L² und L³ um monodentate Liganden handeln würde, wenn die Brücke V bzw. die Brücke der Formel (2) bzw. (3) nicht vorhanden wäre. Durch die formale Abstraktion eines Wasserstoffatoms von diesen bidentaten bzw. monodentaten Liganden und die Anknüpfung an die Brücke V bzw. die Brücke der Formel (2) bzw. (3) sind diese jedoch keine separaten Liganden mehr, sondern ein Teil des so entstehenden tetradentaten Liganden, so dass hierfür der Begriff "Teilligand" verwendet wird.

Die Bindungen der Liganden bzw. Teilliganden an das Iridium können Koordinationsbindungen oder kovalente Bindungen sein, bzw. der kovalente Anteil an der Bindung kann je nach Ligand variieren. Wenn in der vorliegenden Anmeldung die Rede davon ist, dass der Ligand bzw. der Teilligand an das Iridium koordiniert oder bindet, so bezeichnet dies im Sinne der vorliegenden Anmeldung jede Art der Bindung der Liganden bzw. Teilliganden an das Iridium, unabhängig vom kovalenten Anteil der Bindung.

Wenn zwei Reste R bzw. R¹ miteinander ein Ringsystem bilden, so kann dieses mono- oder polycyclisch, aliphatisch, heteroaliphatisch, aromatisch oder heteroaromatisch sein. Dabei können diese Reste, die miteinander ein Ringsystem bilden, benachbart sein, d. h. dass diese Reste an dasselbe Kohlenstoffatom oder an Kohlenstoffatome, die direkt aneinander gebunden sind, gebunden sind, oder sie können weiter voneinander entfernt sein. Bevorzugt ist eine solche Ringbildung bei Resten, die an dasselbe Kohlenstoffatom oder an direkt aneinander gebundene Kohlenstoffatome gebunden sind.

Unter der Formulierung, dass zwei oder mehr Reste miteinander einen aliphatischen Ring bilden können, soll im Rahmen der vorliegenden Beschreibung unter anderem verstanden werden, dass die beiden Reste miteinander durch eine chemische Bindung unter formaler Abspaltung von zwei Wasserstoffatomen verknüpft sind. Dies wird durch das folgende Schema verdeutlicht:

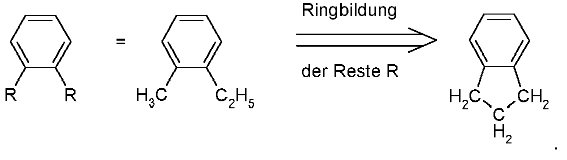

Auch die Bildung einer ankondensierten aromatischen bzw. heteroaromatischen Gruppe ist so möglich, wie durch das folgende Schema verdeutlicht:

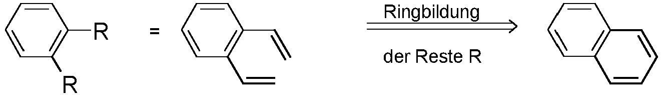

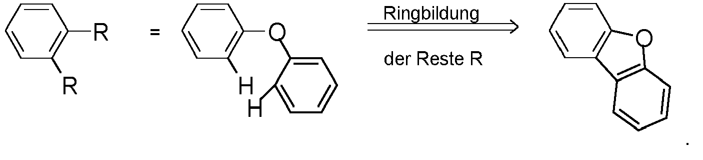

Weiterhin soll unter der oben genannten Formulierung aber auch verstanden werden, dass für den Fall, dass einer der beiden Reste Wasserstoff darstellt, der zweite Rest unter Bildung eines Rings an die Position, an die das Wasserstoffatom gebunden war, bindet. Dies soll durch das folgende Schema verdeutlicht werden:

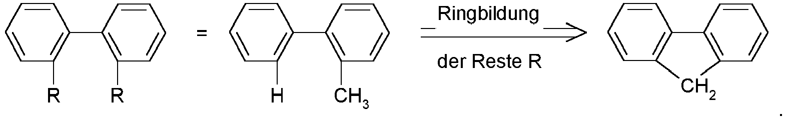

Eine heteroalicyclische Gruppe im Sinne der vorliegenden Erfindung ist eine aliphatische cyclische Gruppe, die mindestens ein Heteroatom als Teil des Cyclus aufweist. Bevorzugt weist sie ein oder zwei Heteroatome als Teil des Cyclus auf, wobei die Heteroatome bevorzugt gewählt sind aus der Gruppe bestehend aus Stickstoff, Sauerstoff und Schwefel.

Eine Arylgruppe im Sinne dieser Erfindung enthält 6 bis 40 C-Atome; eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei enthält die Heteroarylgruppe bevorzugt maximal drei Heteroatome. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden.

Ein aromatisches Ringsystem im Sinne dieser Erfindung enthält 6 bis 40 C-Atome im Ringsystem. Ein heteroaromatisches Ringsystem im Sinne dieser Erfindung enthält 1 bis 40 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom oder eine Carbonylgruppe, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. Weiterhin sollen Systeme, in denen zwei oder mehrere Aryl- oder Heteroarylgruppen direkt aneinander gebunden sind, wie z. B. Biphenyl, Terphenyl, Quaterphenyl oder Bipyridin, ebenfalls als aromatisches bzw. heteroaromatisches Ringsystem verstanden werden. Bevorzugte aromatische bzw. heteroaromatische Ringsysteme sind einfache Aryl- bzw. Heteroarylgruppen sowie Gruppen, in denen zwei oder mehr Aryl- bzw. Heteroarylgruppen direkt miteinander verknüpft sind, beispielsweise Biphenyl oder Bipyridin, sowie Fluoren oder Spirobifluoren.

Im Rahmen der vorliegenden Erfindung wird der Begriff Alkylgruppe als Oberbegriff sowohl für lineare oder verzweigte Alkylgruppen wie auch für cyclische Alkylgruppen verwendet. Analog werden die Begriffe Alkenylgruppe bzw. Alkinylgruppe als Oberbegriffe sowohl für lineare oder verzweigte Alkenyl- bzw. Alkinylgruppen wie auch für cyclische Alkenyl- bzw. Alkinylgruppen verwendet. Unter einer cyclischen Alkyl-, Alkoxy- oder Thioalkoxygruppe im Sinne dieser Erfindung wird eine monocyclische, eine bicyclische oder eine polycyclische Gruppe verstanden.

Im Rahmen der vorliegenden Erfindung werden unter einer C₁- bis C₂₀-Alkylgruppe, in der auch einzelne H-Atome oder CH₂-Gruppen durch die oben genannten Gruppen substituiert sein können, beispielsweise die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]-octyl, 2-(2,6-Dimethyl)octyl, 3-(3,7-Dimethyl)octyl, Adamantyl, Trifluormethyl, Pentafluorethyl, 2,2,2-Trifluorethyl, 1,1-Dimethyl-n-hex-1-yl-, 1,1-Dimethyl-n-hept-1-yl-, 1,1-Dimethyl-n-oct-1-yl-, 1,1-Dimethyl-n-dec-1-yl-, 1,1-Dimethyl-n-dodec-1-yl-, 1,1-Dimethyl-n-tetradec-1-yl-, 1,1-Dimethyl-n-hexadec-1-yl-, 1,1-Dimethyl-n-octadec-1-yl-, 1,1-Diethyl-n-hex-1-yl-, 1,1-Diethyl-n-hept-1-yl-, 1,1-Diethyl-n-oct-1-yl-, 1,1-Diethyl-n-dec-1-yl-, 1,1-Diethyl-n-dodec-1-yl-, 1,1-Diethyl-n-tetradec-1-yl-, 1,1-Diethyln-n-hexadec-1-yl-, 1,1-Diethyl-n-octadec-1-yl-, 1-(n-Propyl)-cyclohex-1-yl-, 1-(n-Butyl)-cyclohex-1-yl-, 1-(n-Hexyl)-cyclohex-1-yl-, 1-(n-Octyl)-cyclohex-1-yl- und 1-(n-Decyl)-cyclohex-1-yl- verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl oder Cyclooctadienyl verstanden. Unter einer Alkinylgruppe werden beispielsweise Ethinyl, Propinyl, Butinyl, Pentinyl, Hexinyl, Heptinyl oder Octinyl verstanden. Unter einer Gruppe OR¹ werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden.

Unter einem aromatischen oder heteroaromatischen Ringsystem mit 5 - 40 aromatischen Ringatomen, welches noch jeweils mit den oben genannten Resten substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

In einer bevorzugten Ausführungsform ist die erfindungsgemäße Verbindung elektrisch neutral. Dabei liegt das Iridium als Ir(III) vor. Ladungsneutralität wird dadurch erreicht, dass die Ladungen der Teilliganden und Liganden L¹ bis L⁴ die Ladung des dreifach positiv geladenen Iridiums ausgleichen. Dabei kann L¹ neutral, monoanionisch oder dianionsch sein. L² und L³ können jeweils neutral oder monoanionsch sein. Beispiele für geeignete Kombinationen der Teilliganden und Liganden L¹ bis L⁴ sind in der folgenden Tabelle aufgeführt:

| L¹ | L² | L³ | L⁴ (bidentat) | L⁴ (monodentat) |
|---|---|---|---|---|
| monoanionisch | monoanionisch | monoanionisch | neutral | --- |
| monoanionisch | monoanionisch | neutral | monoanionisch | --- |
| monoanionisch | neutral | neutral | dianionisch | --- |
| monoanionisch | monoanionisch | monoanionisch | --- | 2x neutral |
| monoanionisch | monoanionisch | neutral | --- | neutral + monoanionisch |
| monoanionisch | neutral | neutral | --- | 2x monoanionisch |
| neutral | monoanionisch | monoanionisch | monoanionisch | --- |
| neutral | monoanionisch | neutral | dianionisch | --- |
| neutral | monoanionisch | monoanionisch | --- | neutral + monoanionisch |
| neutral | monoanionisch | neutral | --- | 2x monoanionisch |
| dianionisch | monoanionisch | neutral | neutral | --- |
| dianionisch | neutral | neutral | monoanionisch | --- |
| dianionisch | monoanionisch | neutral | --- | 2x neutral |
| dianionisch | neutral | neutral | --- | neutral + monoanionisch |

In einer bevorzugten Ausführungsform der Erfindung ist L¹ monoanionisch, so dass die ersten sechs Einträge in der Tabelle bevorzugt sind.

Im Folgenden werden bevorzugte Ausführungsformen des Brückenkopfes V, also der Struktur der Formel (2) bzw. (3), ausgeführt.

In einer bevorzugten Ausführungsform der Erfindung stehen alle Gruppen X¹ in der Gruppe der Formel (2) für CR, so dass der zentrale trivalente Cyclus der Formel (2) ein Benzol darstellt, oder alle Gruppen X¹ stehen für ein Stickstoffatom, so dass der zentrale trivalente Cyclus der Formel (2) ein Triazin darstellt. Besonders bevorzugt stehen alle Gruppen X¹ gleich oder verschieden für CR.

Für bevorzugte Reste R am trivalenten zentralen Benzolring der Formel (2) bzw. am zentralen Cyclohexanring der Formel (3) gilt:
- R: ist bei jedem Auftreten gleich oder verschieden H, D, F, CN, OR¹, eine geradkettige Alkylgruppe mit 1 bis 10 C-Atomen, bevorzugt mit 1 bis 4 C-Atomen, oder eine Alkenylgruppe mit 2 bis 10 C-Atomen oder eine verzweigte oder cyclische Alkylgruppe mit 3 bis 10 C-Atomen, bevorzugt mit 3 bis 6 C-Atomen, die jeweils mit einem oder mehreren Resten R¹ substituiert sein kann, bevorzugt aber unsubstituiert ist, oder ein aromatisches oder heteroaromatisches Ringsystem mit 5 bis 24 aromatischen Ringatomen, bevorzugt mit 6 bis 12 aromatischen Ringatomen, das jeweils durch einen oder mehrere Reste R¹ substituiert sein kann; dabei kann der Rest R auch mit einem Rest R an X² ein Ringsystem bilden;
- R¹: ist bei jedem Auftreten gleich oder verschieden H, D, F, CN, OR², eine geradkettige Alkylgruppe mit 1 bis 10 C-Atomen, bevorzugt mit 1 bis 4 C-Atomen, oder eine Alkenylgruppe mit 2 bis 10 C-Atomen oder eine verzweigte oder cyclische Alkylgruppe mit 3 bis 10 C-Atomen, bevorzugt mit 3 bis 6 C-Atomen, die jeweils mit einem oder mehreren Resten R² substituiert sein kann, bevorzugt aber unsubstituiert ist, oder ein aromatisches oder heteroaromatisches Ringsystem mit 5 bis 24 aromatischen Ringatomen, bevorzugt mit 6 bis 12 aromatischen Ringatomen, das jeweils durch einen oder mehrere Reste R² substituiert sein kann; dabei können zwei oder mehrere benachbarte Reste R¹ miteinander ein Ringsystem bilden;
- R²: ist bei jedem Auftreten gleich oder verschieden H, D, F oder ein aliphatischer, aromatischer und/oder heteroaromatischer organischer Rest mit 1 bis 20 C-Atomen, in dem auch ein oder mehrere H-Atome durch F ersetzt sein können, bevorzugt ein aliphatischer oder aromatischer Kohlenwasserstoffrest mit 1 bis 12 C-Atomen.

Besonders bevorzugt stehen alle Gruppen X¹ in Formel (2) für CH oder CD, insbesondere für CH. Weiterhin bevorzugt stehen alle Gruppen R in der Gruppe der Formel (3) für H oder D, insbesondere für H, so dass der zentrale Cyclus in Formel (3) eine unsubstituierte Cyclohexangruppe darstellt.

Bevorzugte Ausführungsformen der Gruppe der Formel (2) bzw. (3) sind die Strukturen der folgenden Formeln (2a) bzw. (3a), 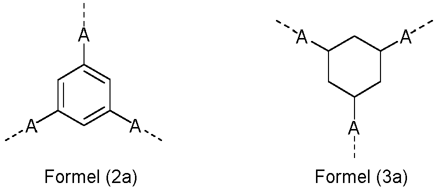 wobei die verwendeten Symbole die oben genannten Bedeutungen aufweisen.

Im Folgenden werden bevorzugte bivalente Arylen- bzw. Heteroaryleneinheiten A bzw. die Gruppen der Formel (4) beschrieben, wie sie in der Gruppe der Formeln (2) und (3) vorkommen.

In einer bevorzugten Ausführungsform der Erfindung steht das Symbol X³ in der Gruppe der Formel (4) für C, so dass die Gruppe der Formel (4) durch die folgende Formel (4') dargestellt wird: 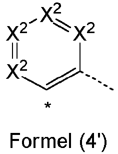 wobei die Symbole die oben aufgeführten Bedeutungen aufweisen.

Die Gruppe der Formel (4) bzw. (4') kann einen heteroaromatischen Fünfring oder einen aromatischen oder heteroaromatischen Sechsring darstellen. In einer bevorzugten Ausführungsform der Erfindung enthält die Gruppe der Formel (4) bzw. (4') maximal zwei Heteroatome in der Aryl- bzw. Heteroarylgruppe, besonders bevorzugt maximal ein Heteroatom. Dies schließt nicht aus, dass Substituenten, die gegebenenfalls an dieser Gruppe gebunden sind, auch Heteroatome enthalten können. Weiterhin schließt diese Definition nicht aus, dass durch die Ringbildung von Substituenten kondensierte aromatische oder heteroaromatische Strukturen entstehen, wie beispielsweise Naphthalin, Benzimidazol, etc.. Beispiele für geeignete Gruppen der Formel (4) bzw. (4') sind Benzol, Pyridin, Pyrimidin, Pyrazin, Pyridazin, Pyrrol, Furan, Thiophen, Pyrazol, Imidazol, Oxazol und Thiazol.

Bevorzugte Ausführungsformen der Gruppe der Formel (4') sind die Strukturen der folgenden Formeln (4a) bis (4q), 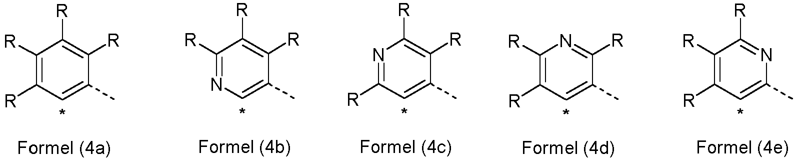 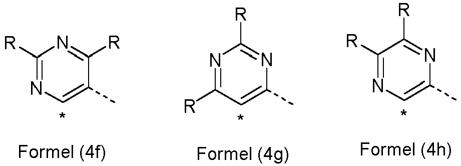 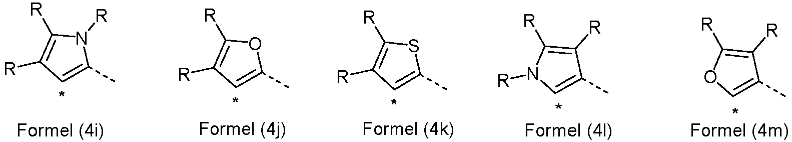 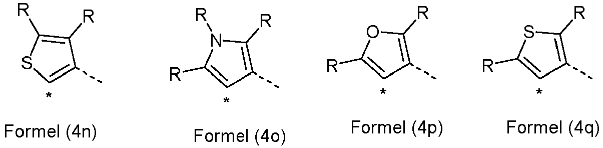 wobei die verwendeten Symbole die oben genannten Bedeutungen aufweisen.

Wenn eine Gruppe X³ in Formel (4) für ein Kohlenstoffatom und die andere Gruppe X³ für ein Stickstoffatom steht, sind bevorzugte Ausführungsformen der Gruppe der Formel (4) die Strukturen der folgenden Formeln (4r) bis (4y), 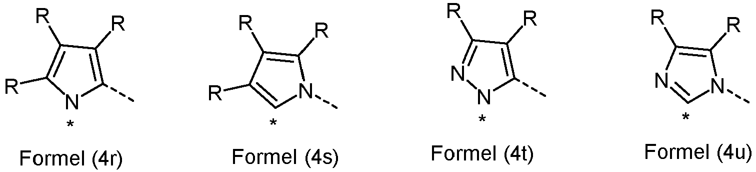 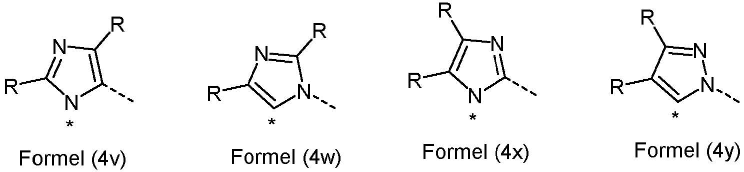 wobei die verwendeten Symbole die oben genannten Bedeutungen aufweisen.

Besonders bevorzugt ortho-Phenylen, also eine Gruppe der oben genannten Formel (4a).

Wenn zwei oder drei Gruppen der Formel (4) vorhanden sind, können diese gleich oder verschieden sein. In einer bevorzugten Ausführungsform der Erfindung sind, wenn zwei oder drei Gruppen der Formel (4) vorhanden sind, diese Gruppen gleich und sind auch gleich substituiert.

Für die Gruppen A sind die folgenden Kombinationen bevorzugt:
- alle drei Gruppen A stehen für die gleiche Gruppe der Formel (4), insbesondere für die gleiche Gruppe der Formel (4a);
- zwei Gruppen A stehen für die gleiche Gruppe der Formel (4), insbesondere für die gleiche Gruppe der Formel (4a), und die dritte Gruppe A steht für CR₂-CR₂;
- eine Gruppe A steht für eine Gruppe der Formel (4), insbesondere für die gleiche Gruppe der Formel (4a), und die beiden anderen Gruppen A stehen für die gleiche Gruppe CR₂-CR₂; oder
- alle drei Gruppen A stehen für die gleiche Gruppe CR₂-CR₂.

Dabei bedeutet "die gleiche Gruppe der Formel (4)" bzw. "die gleiche Gruppe der Formel (4a)", dass diese Gruppen dasselbe Grundgerüst aufweisen und gleich substituiert sind. Weiterhin bedeutet "die gleiche Gruppe CR₂-CR₂", dass diese Gruppen gleich substituiert sind.

Bevorzugte Reste R an der Gruppe -CR₂-CR₂- sind gewählt aus der Gruppe bestehend aus H, D, F und einer Alkylgruppe mit 1 bis 5 C-Atomen, wobei auch H-Atome durch D oder F ersetzt sein können und wobei benachbarte R miteinander ein Ringsystem bilden können. Besonders bevorzugte Reste R an diesen Gruppen sind gewählt aus H, D, CH₃ oder CD₃, oder zwei Reste R, die an dasselbe Kohlenstoffatom binden, bilden zusammen mit dem Kohlenstoffatom, an das sie binden, einen Cyclopentan- oder Cyclohexanring. Ganz besonders bevorzugte Reste R an dieser Gruppe sind gewählt aus H oder D, insbesondere H.

Für die Gruppen A sind daher die folgenden Kombinationen besonders bevorzugt:
- alle drei Gruppen A stehen für die Gruppe der Formel (4a) mit R = H;
- zwei Gruppen A stehen für die Gruppe der Formel (4a) mit R = H, und die dritte Gruppe A steht für CH₂-CH₂;
- eine Gruppe A steht für eine Gruppe der Formel (4a) mit R = H und die beiden anderen Gruppen A stehen für die Gruppe CH₂-CH₂; oder
- alle drei Gruppen A stehen für die Gruppe CH₂-CH₂.

Besonders bevorzugt sind die Strukturen der Formeln (2) und (3) ausgewählt aus den Strukturen der folgenden Formeln (2a) bis (2d) und (3a) bis (3d), 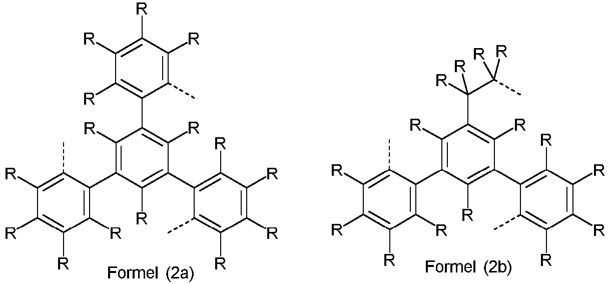 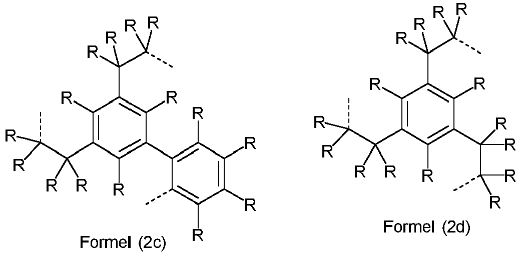 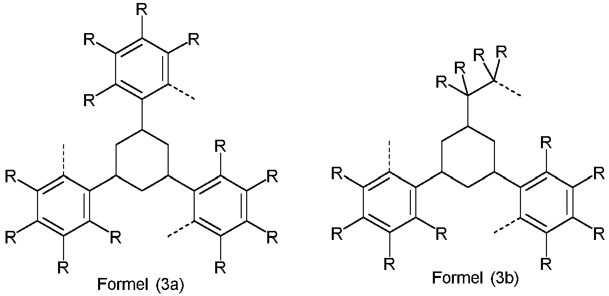 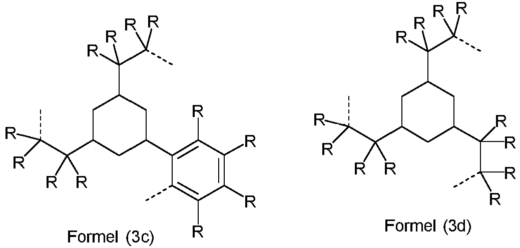 wobei die verwendeten Symbole die oben genannten Bedeutungen aufweisen. Dabei steht R im zentralen Benzolring der Formeln (2a) bis (2d) bevorzugt für H oder D, insbesondere für H. Die Formeln (2a) und (2c) sind besonders bevorzugt.

Besonders bevorzugt sind die Substituenten R in den Formeln (2a) bis (2d) und (3a) bis (3d) bei jedem Auftreten gleich oder verschieden H, D oder eine Alkylgruppe mit 1 bis 4 C-Atomen. Ganz besonders bevorzugt ist R = H oder D, insbesondere H. Besonders bevorzugte Ausführungsformen der Formeln (2a) bis (2d) und (3a) bis (3d) sind daher die Strukturen der folgenden Formeln (2a-1) bis (2d-1) und (3a-1) bis (3d-1), 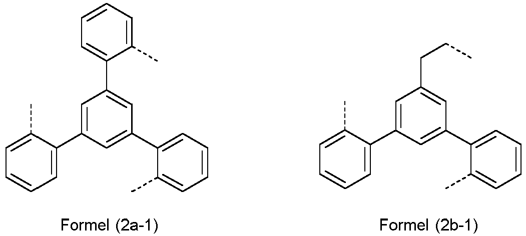 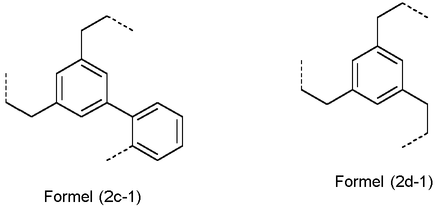 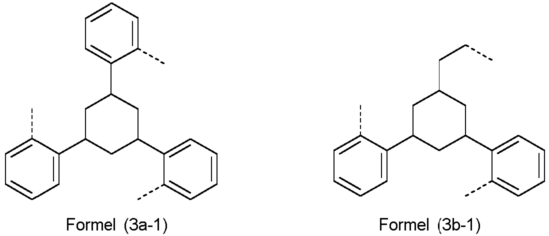 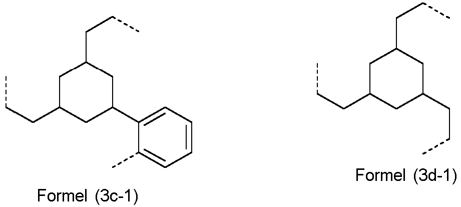 wobei die verwendeten Symbole die oben genannten Bedeutungen aufweisen.

Im Folgenden wird der bidentate Teilligand L¹ beschrieben. Wie oben beschrieben, koordiniert L¹ an das Iridium über ein Kohlenstoffatom und ein Stickstoffatom oder über zwei Kohlenstoffatome. In einer bevorzugten Ausführungsform koordiniert der Teilligand L¹ an das Iridium über ein Kohlenstoffatom und ein Stickstoffatom.

Es ist weiterhin bevorzugt, wenn es sich bei dem Metallacyclus, der aus dem Iridium und dem Teilliganden L¹ aufgespannt wird, um einen Fünfring handelt. Die Bildung eines Fünfrings wird im Folgenden schematisch dargestellt: 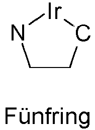 wobei N ein koordinierendes Stickstoffatom und C ein koordinierendes Kohlenstoffatom darstellen und die eingezeichneten Kohlenstoffatome Atome des Teilliganden L¹ darstellen.

In einer bevorzugten Ausführungsform der Erfindung steht der Teilligand L¹ für eine Struktur gemäß einer der folgenden Formeln (L¹-1) oder (L¹-2), 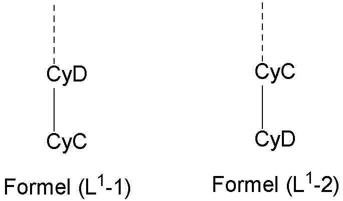 wobei die gestrichelte Bindung die Bindung des Teilliganden L¹ an V bzw. an die Brücke der Formel (2) bzw. (3) darstellt und für die weiteren verwendeten Symbole gilt:
- CyC: ist gleich oder verschieden bei jedem Auftreten eine substituierte oder unsubstituierte Aryl- oder Heteroarylgruppe mit 5 bis 14 aromatischen Ringatomen, welche jeweils über ein Kohlenstoffatom an das Iridium koordiniert und welche über eine kovalente Bindung mit CyD verbunden ist;
- CyD: ist gleich oder verschieden bei jedem Auftreten eine substituierte oder unsubstituierte Heteroarylgruppe mit 5 bis 14 aromatischen Ringatomen oder eine substituierte oder unsubstituierte heteroalicyclische Gruppe mit 5 bis 7 Ringatomen, welche jeweils über ein Stickstoffatom oder über ein Carben-Kohlenstoffatom an das Iridium koordiniert und welche über eine kovalente Bindung mit CyC verbunden ist;
dabei können mehrere der optionalen Substituenten miteinander ein Ringsystem bilden; die optionalen Reste sind bevorzugt ausgewählt aus den oben genannten Resten R.

Dabei koordiniert CyD über ein neutrales oder anionisches Stickstoffatom oder über ein Carben-Kohlenstoffatom, bevorzugt über ein neutrales Stickstoffatom oder über ein Carben-Kohlenstoffatom. Weiterhin koordiniert CyC über ein anionisches Kohlenstoffatom.

Wenn mehrere der Substituenten, insbesondere mehrere Reste R, miteinander ein Ringsystem bilden, so ist die Bildung eines Ringsystems aus Substituenten, die an direkt benachbarten Kohlenstoffatomen gebunden sind, möglich. Weiterhin ist es auch möglich, dass die Substituenten an CyC und CyD miteinander einen Ring bilden, wodurch CyC und CyD auch zusammen eine einzige kondensierte Aryl- bzw. Heteroarylgruppe als bidentaten Teilliganden bilden können.

In einer bevorzugten Ausführungsform der vorliegenden Erfindung ist CyC eine Aryl- oder Heteroarylgruppe mit 6 bis 13 aromatischen Ringatomen, besonders bevorzugt mit 6 bis 10 aromatischen Ringatomen, ganz besonders bevorzugt mit 6 aromatischen Ringatomen, welche über ein Kohlenstoffatom an das Iridium koordiniert, welche mit einem oder mehreren Resten R substituiert sein kann und welche über eine kovalente Bindung mit CyD verbunden ist.

Bevorzugte Ausführungsformen der Gruppe CyC sind die Strukturen der folgenden Formeln (CyC-1) bis (CyC-20), wobei die Gruppe CyC jeweils an der durch # gekennzeichneten Position an CyD bindet und an der durch * gekennzeichneten Position an das Iridium koordiniert, 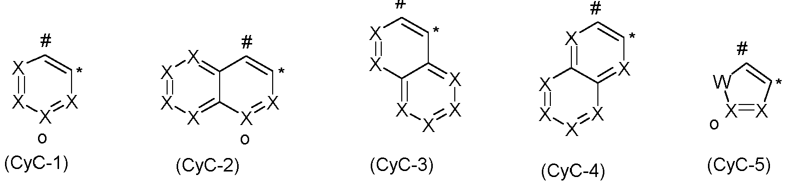 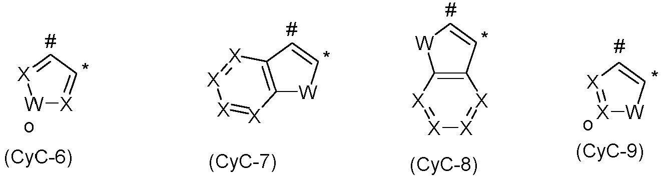 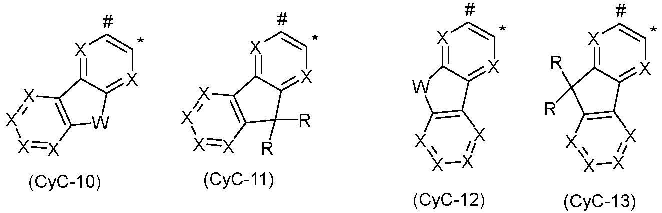 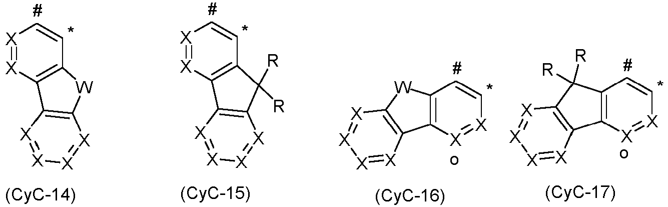 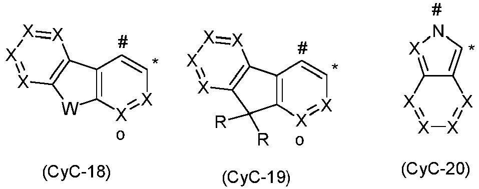 wobei R die oben genannten Bedeutungen aufweist und für die weiteren verwendeten Symbole gilt:
- X: ist bei jedem Auftreten gleich oder verschieden CR oder N mit der Maßgabe, dass maximal zwei Symbole X pro Cyclus für N stehen;
- W: ist bei jedem Auftreten gleich oder verschieden NR, O oder S;
mit der Maßgabe, dass, wenn die Brücke V bzw. die Brücke der Formel (2) bzw. (3) an CyC gebunden ist, ein Symbol X für C steht und die Brücke der Formel (2) bzw. (3) an dieses Kohlenstoffatom gebunden ist. Wenn die Gruppe CyC an die Brücke V bzw. die Brücke der Formel (2) bzw. (3) gebunden ist, so erfolgt die Bindung bevorzugt über die mit "o" markierte Position der oben abgebildeten Formeln, so dass dann bevorzugt das mit "o" markierte Symbol X für C steht. Die oben abgebildeten Strukturen, die kein mit "o" markiertes Symbol X enthalten, sind bevorzugt nicht direkt an die Brücke V bzw. die Brücke der Formel (2) bzw. (3) gebunden, da eine solche Bindung an die Brücke aus sterischen Gründen nicht vorteilhaft ist.

Bevorzugt steht maximal ein Symbol X in CyC für N und besonders bevorzugt stehen alle Symbole X für CR, mit der Maßgabe, dass, wenn die Brücke V bzw. die Brücke der Formel (2) bzw. (3) an CyC gebunden ist, ein Symbol X für C steht und die Brücke V bzw. die Brücke der Formel (2) bzw. (3) an dieses Kohlenstoffatom gebunden ist.

Besonders bevorzugte Gruppen CyC sind die Gruppen der folgenden Formeln (CyC-1a) bis (CyC-20a), 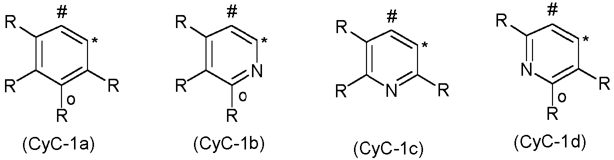 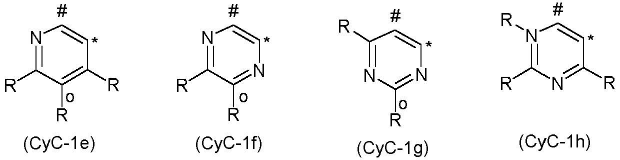 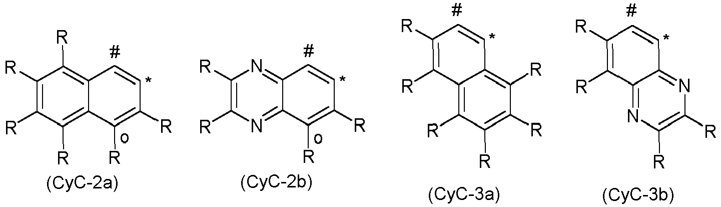 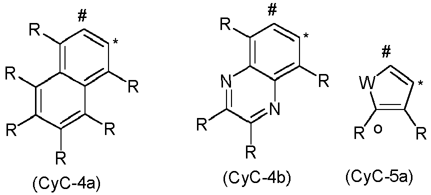 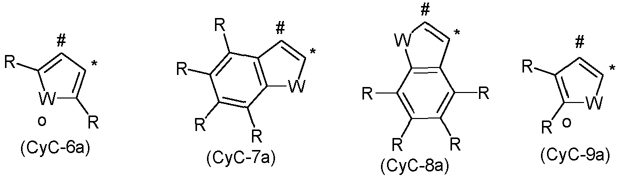 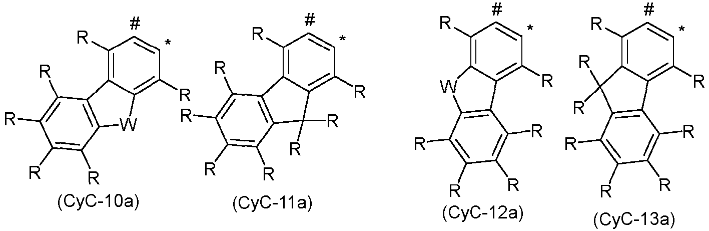 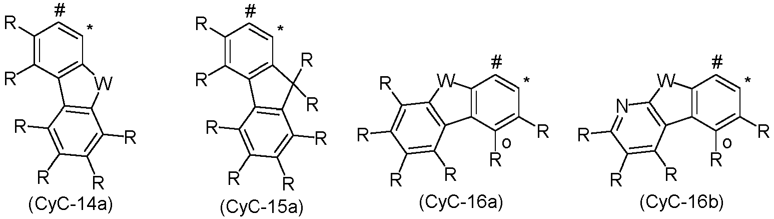 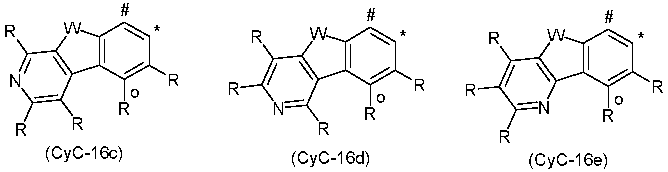 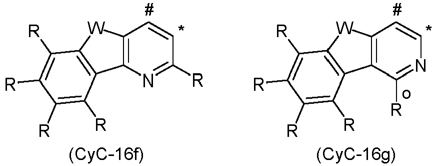 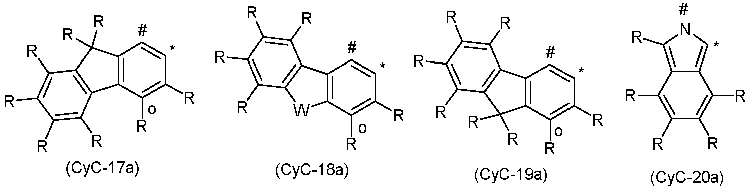 wobei die verwendeten Symbole die oben genannten Bedeutungen aufweisen und, wenn die Brücke V bzw. die Brücke der Formel (2) bzw. (3) an CyC gebunden ist, ein Rest R nicht vorhanden ist und die Brücke V bzw. die Brücke der Formel (2) bzw. (3) an das entsprechende Kohlenstoffatom gebunden ist. Wenn die Gruppe CyC an die Brücke V bzw. die Brücke der Formel (2) bzw. (3) gebunden ist, so erfolgt die Bindung bevorzugt über die mit "o" markierte Position der oben abgebildeten Formeln, so dass dann in dieser Position der Rest R nicht vorhanden ist. Die oben abgebildeten Strukturen, die kein mit "o" markiertes Kohlenstoffatom enthalten, sind bevorzugt nicht direkt an die Brücke V bzw. die Brücke der Formel (2) bzw. (3) gebunden. Dabei sind bevorzugt maximal drei Substituenten R ungleich H oder D, besonders bevorzugt maximal zwei Substituenten R und ganz besonders bevorzugt maximal ein Substituent.

Bevorzugte Gruppen unter den Gruppen (CyC-1) bis (CyC-20) sind die Gruppen (CyC-1), (CyC-3), (CyC-8), (CyC-10), (CyC-12), (CyC-13) und (CyC-16), und besonders bevorzugt sind die Gruppen (CyC-1a), (CyC-3a), (CyC-8a), (CyC-10a), (CyC-12a), (CyC-13a) und (CyC-16a).

In einer weiteren bevorzugten Ausführungsform der Erfindung ist CyD eine Heteroarylgruppe 5 bis 13 aromatischen Ringatomen, besonders bevorzugt mit 6 bis 10 aromatischen Ringatomen, oder eine heteroalicyclische Gruppe mit 5 oder 6 Ringatomen, bevorzugt mit 5 Ringatomen, welche jeweils über ein neutrales oder anionisches Stickstoffatom oder über ein Carben-Kohlenstoffatom an das Iridium koordiniert und welche mit einem oder mehreren Resten R substituiert sein kann und welche über eine kovalente Bindung mit CyC verbunden ist.

Bevorzugte Ausführungsformen der Gruppe CyD sind die Strukturen der folgenden Formeln (CyD-1) bis (CyD-23), wobei die Gruppe CyD jeweils an der durch # gekennzeichneten Position an CyC bindet und an der durch * gekennzeichneten Position an das Iridium koordiniert, 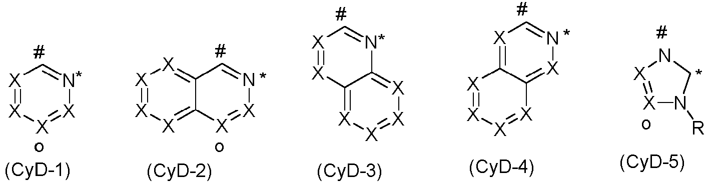 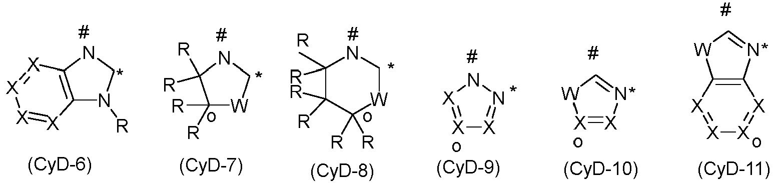 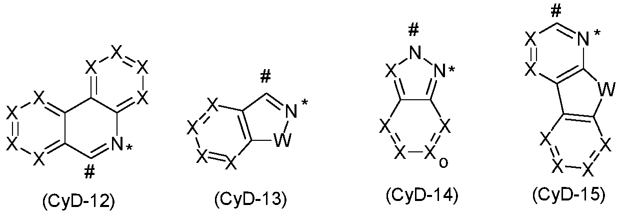 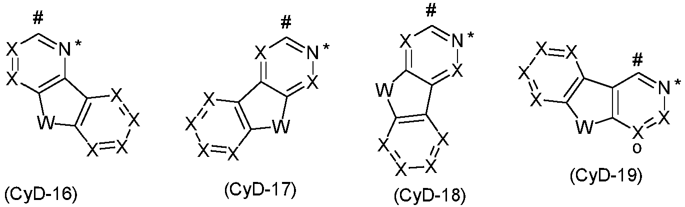 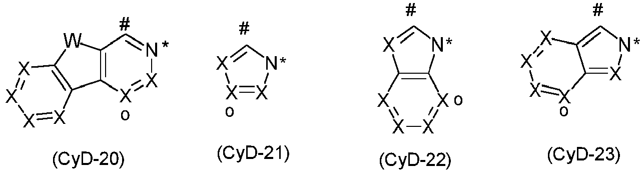 wobei X und R die oben genannten Bedeutungen aufweisen und W für CR₂, NR, O oder S steht, mit der Maßgabe, dass, wenn die Brücke V bzw. die Brücke der Formel (2) bzw. (3) an CyD gebunden ist, ein Symbol X für C steht und die Brücke V bzw. die Brücke der Formel (2) bzw. (3) an dieses Kohlenstoffatom gebunden ist bzw. wenn die Brücke V bzw. die Brücke der Formel (2) bzw. (3) an CyD gebunden ist, in Formel (CyD-7) und (CyD-8) eine Gruppe R nicht vorhanden ist und die Brücke V in dieser Position gebunden ist. Wenn die Gruppe CyD an die Brücke V bzw. die Brücke der Formel (2) bzw. (3) gebunden ist, so erfolgt die Bindung bevorzugt über die mit "o" markierte Position der oben abgebildeten Formeln, so dass dann bevorzugt das mit "o" markierte Symbol X für C steht. Die oben abgebildeten Strukturen, die kein mit "o" markiertes Symbol X enthalten, sind bevorzugt nicht direkt an die Brücke V bzw. die Brücke der Formel (2) bzw. (3) gebunden, da eine solche Bindung an die Brücke aus sterischen Gründen nicht vorteilhaft ist.

Dabei koordinieren die Gruppen (CyD-1) bis (CyD-4) und (CyD-9) bis (CyD-20) über ein neutrales Stickstoffatom, (CyD-5) bis (CyD-8) über ein Carben-Kohlenstoffatom und (CyD-21) bis (CyD-23) über ein anionisches Stickstoffatom an das Iridium.

Bevorzugt steht maximal ein Symbol X in CyD für N, und besonders bevorzugt stehen alle Symbole X für CR, mit der Maßgabe, dass, wenn die Brücke V bzw. die Brücke der Formel (2) bzw. (3) an CyD gebunden ist, ein Symbol X für C steht und die Brücke V bzw. die Brücke der Formel (2) bzw. (3) an dieses Kohlenstoffatom gebunden ist.

Besonders bevorzugte Gruppen CyD sind die Gruppen der folgenden Formeln (CyD-1a) bis (CyD-23a), 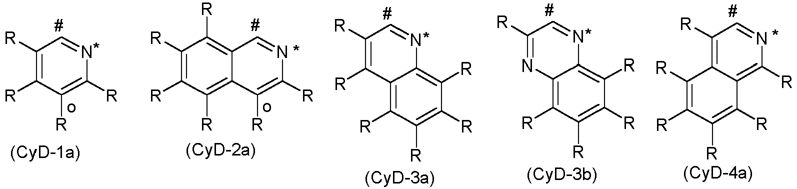 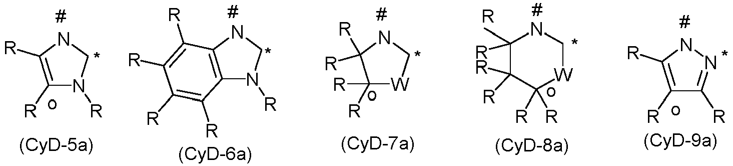 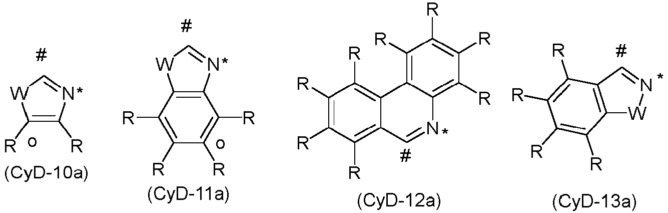 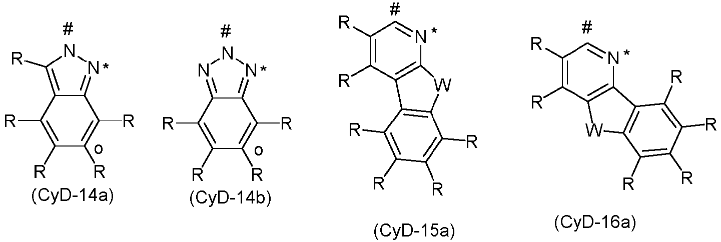 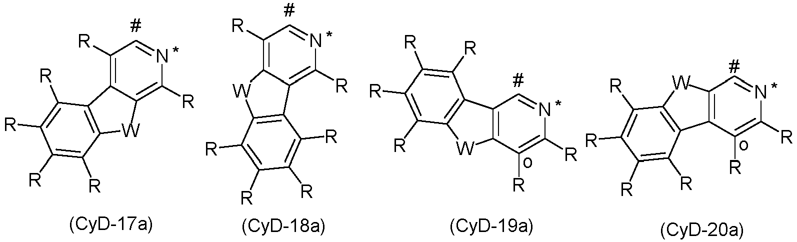 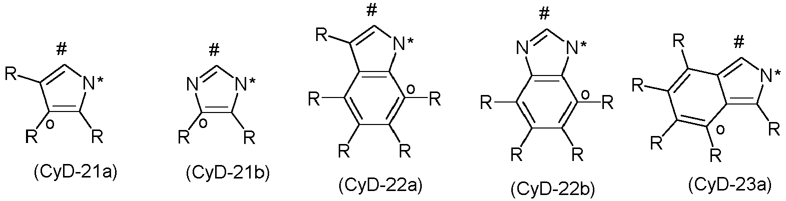 wobei die verwendeten Symbole die oben genannten Bedeutungen aufweisen und, wenn die Brücke V bzw. die Brücke der Formel (2) bzw. (3) an CyD gebunden ist, ein Rest R nicht vorhanden ist und die Brücke V bzw. die Brücke der Formel (2) bzw. (3) an das entsprechende Kohlenstoffatom gebunden ist. Wenn die Gruppe CyD an die Brücke V bzw. die Brücke der Formel (2) bzw. (3) gebunden ist, so erfolgt die Bindung bevorzugt über die mit "o" markierte Position der oben abgebildeten Formeln, so dass dann in dieser Position der Rest R nicht vorhanden ist. Die oben abgebildeten Strukturen, die kein mit "o" markiertes Kohlenstoffatom enthalten, sind bevorzugt nicht direkt an die Brücke V bzw. die Brücke der Formel (2) bzw. (3) gebunden. Dabei sind bevorzugt maximal drei Substituenten R ungleich H oder D, besonders bevorzugt maximal zwei Substituenten R und ganz besonders bevorzugt maximal ein Substituent.

Bevorzugte Gruppen unter den Gruppen (CyD-1) bis (CyD-12) sind die Gruppen (CyD-1), (CyD-2), (CyD-3), (CyD-4), (CyD-5) und (CyD-6), insbesondere (CyD-1), (CyD-2) und (CyD-3), und besonders bevorzugt sind die Gruppen (CyD-1a), (CyD-2a), (CyD-3a), (CyD-4a), (CyD-5a) und (CyD-6a), insbesondere (CyD-1a), (CyD-2a) und (CyD-3a).

In einer bevorzugten Ausführungsform der Erfindung ist CyC eine Aryl- oder Heteroarylgruppe mit 6 bis 13 aromatischen Ringatomen, und gleichzeitig ist CyD eine Heteroarylgruppe mit 5 bis 13 aromatischen Ringatomen. Besonders bevorzugt ist CyC eine Aryl- oder Heteroarylgruppe mit 6 bis 10 aromatischen Ringatomen, und gleichzeitig ist CyD eine Heteroarylgruppe mit 5 bis 10 aromatischen Ringatomen. Ganz besonders bevorzugt ist CyC eine Aryl- oder Heteroarylgruppe mit 6 aromatischen Ringatomen und CyD eine Heteroarylgruppe mit 6 bis 10 aromatischen Ringatomen. Dabei können CyC und CyD mit einem oder mehreren Resten R substituiert sein.

Die oben genannten bevorzugten Gruppen (CyC-1) bis (CyC-20) und (CyD-1) bis (CyD-21) können beliebig miteinander kombiniert werden, sofern mindestens eine der Gruppen CyC bzw. CyD eine geeignete Anknüpfungsstelle an die Brücke V bzw. eine Brücke der Formel (2) bzw. (3) aufweist, wobei geeignete Anknüpfungsstellen in den oben genannten Formeln mit "o" gekennzeichnet sind.

Insbesondere bevorzugt ist es, wenn die oben als besonders bevorzugt genannten Gruppen CyC und CyD, also die Gruppen der Formeln (CyC-1a) bis (CyC-20a) und die Gruppen der Formeln (CyD1-a) bis (CyD-21a) miteinander kombiniert werden, sofern mindestens eine der bevorzugten Gruppen CyC bzw. CyD eine geeignete Anknüpfungsstelle an die Brücke V bzw. die Brücke der Formel (2) bzw. (3) aufweist, wobei geeignete Anknüpfungsstellen in den oben genannten Formeln mit "o" gekennzeichnet sind. Kombinationen, in denen weder CyC noch CyD eine solche geeignete Anknüpfungsstelle für die Brücke V bzw. die Brücke der Formel (2) bzw. (3) aufweist, sind daher nicht bevorzugt.

Ganz besonders bevorzugt ist es, wenn eine der Gruppen (CyC-1), (CyC-3), (CyC-8), (CyC-10), (CyC-12), (CyC-13) und (CyC-16), und insbesondere die Gruppen (CyC-1a), (CyC-3a), (CyC-8a), (CyC-10a), (CyC-12a), (CyC-13a) und (CyC-16a), mit einer der Gruppen (CyD-1), (CyD-2) und (CyD-3), und insbesondere mit einer der Gruppen (CyD-1a), (CyD-2a) und (CyD-3a), kombiniert wird.

Bevorzugte Teilliganden (L¹-1) sind die Strukturen der Formeln (L¹-1-1) bis (L¹-1-3), und bevorzugte Teilliganden (L¹-2) sind die Strukturen der Formeln (L¹-2-1) bis (L¹-2-5), die über die beiden mit * gekennzeichneten Positionen an das Iridium koordinieren, 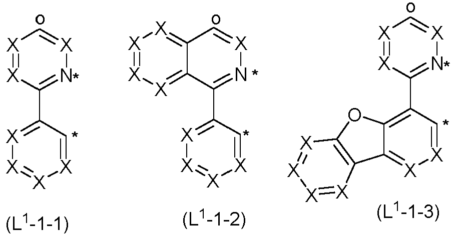 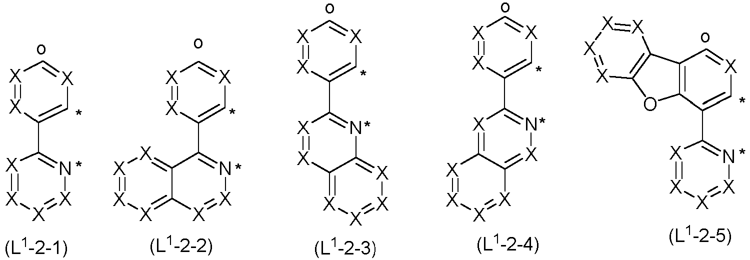 wobei die verwendeten Symbole die oben genannten Bedeutungen aufweisen und "o" die Position der Bindung an die Brücke V bzw. die Brücke der Formel (2) bzw. (3) darstellt.

Besonders bevorzugte Teilliganden (L¹-1) sind die Strukturen der Formeln (L¹-1-1a) bis (L¹-1-3b), und besonders bevorzugte Teilliganden (L¹-2) sind die Strukturen der Formeln (L¹-2-1a) bis (L¹-2-5a), die über die beiden mit * gekennzeichneten Positionen an das Iridium koordinieren, 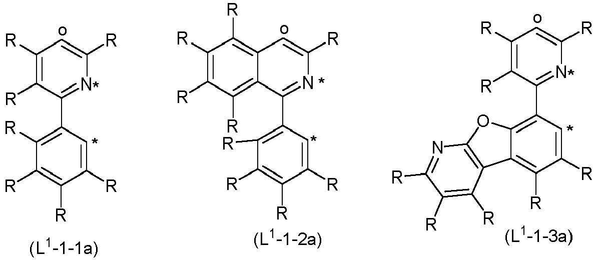 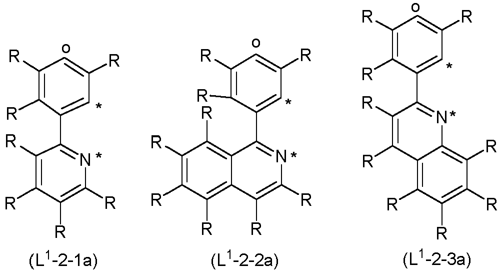 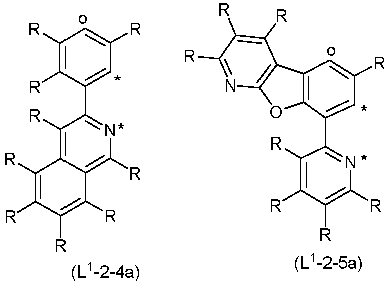 wobei die verwendeten Symbole die oben genannten Bedeutungen aufweisen und "o" die Position der Bindung an die Brücke V bzw. die Brücke der Formel (2) bzw. (3) darstellt. Dabei sind bevorzugt maximal drei Substituenten R ungleich H oder D, besonders bevorzugt maximal zwei Substituenten R und ganz besonders bevorzugt maximal ein Substituent.

Wenn zwei Reste R, von denen einer an CyC und der andere an CyD gebunden sind, miteinander ein aromatisches Ringsystem bilden, können sich überbrückte Teilliganden und auch Teilliganden ergeben, die insgesamt eine einzige größere Heteroarylgruppe darstellen. Die Ringbildung zwischen den Substituenten an CyC und CyD erfolgt dabei bevorzugt durch eine Gruppe gemäß einer der folgenden Formeln (5) bis (14), 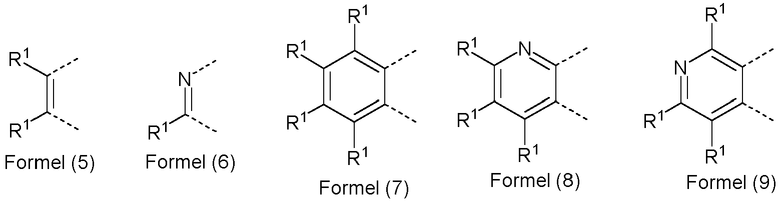 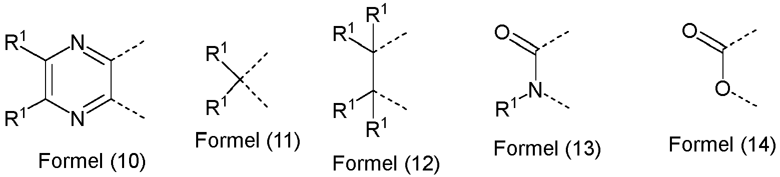 wobei R¹ die oben genannten Bedeutungen aufweist und die gestrichelten Bindungen die Bindungen an CyC und CyD andeuten. Dabei können die unsymmetrischen der oben genannten Gruppen in jeder der beiden Möglichkeiten eingebaut werden. Beispielsweise kann bei der Gruppe der Formel (14) das Sauerstoffatom an die Gruppe CyC und die Carbonylgruppe an die Gruppe CyD binden, oder das Sauerstoffatom kann an die Gruppe CyD und die Carbonylgruppe an die Gruppe CyC binden.

Dabei ist die Gruppe der Formel (11) besonders dann bevorzugt, wenn sich dadurch die Ringbildung zu einem Sechsring ergibt, wie beispielsweise unten durch die Formeln (L¹-21) und (L¹-22) dargestellt.

Bevorzugte Liganden, die durch Ringbildung zweier Reste R an CyC und CyD entstehen, sind die im Folgenden aufgeführten Strukturen der Formeln (L¹-3) bis (L¹-30), 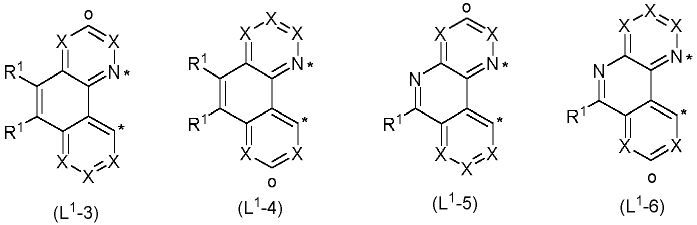 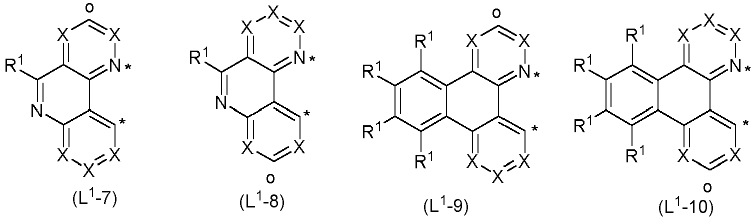 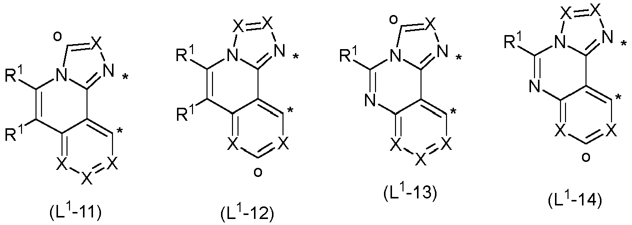 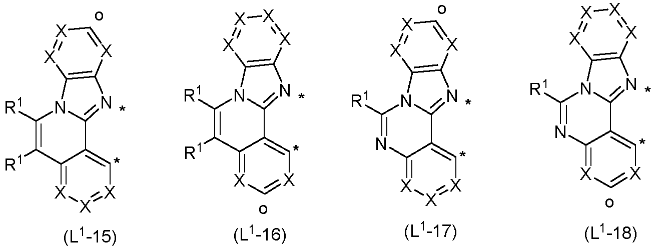 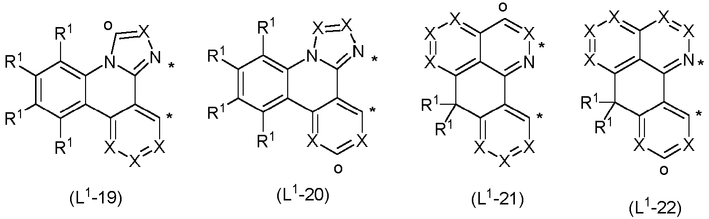 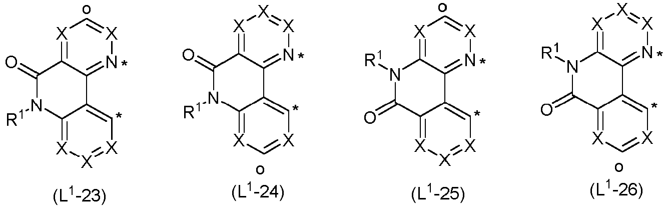 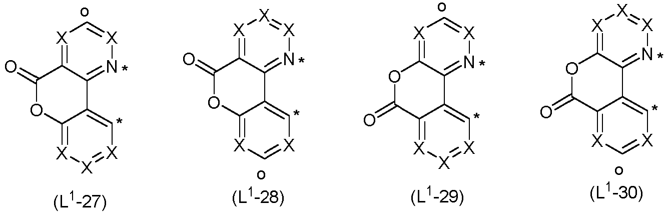 wobei die verwendeten Symbole die oben genannten Bedeutungen aufweisen und "o" die Position angibt, an denen dieser Teilligand mit der Brücke V bzw. der Brücke der Formel (2) bzw. (3) verknüpft ist.

In einer bevorzugten Ausführungsform der Teilliganden der Formeln (L¹-3) bis (L¹-30) stehen alle Symbole X für CR, oder ein Symbol steht X für N und die anderen Symbole X stehen für CR.

In einer weiteren Ausführungsform der Erfindung ist es bevorzugt, falls in den Gruppen (CyC-1) bis (CyC-20) oder (CyD-1) bis (CyD-21) oder in den Teilliganden (L¹-3) bis (L¹-30) eines der Atome X für N steht, wenn benachbart zu diesem Stickstoffatom eine Gruppe R als Substituent gebunden ist, welche ungleich Wasserstoff oder Deuterium ist. Dies gilt analog für die bevorzugten Strukturen (CyC-1a) bis (CyC-20a) oder (CyD-1a) bis (CyD-14b), in denen bevorzugt benachbart zu einem nicht koordinierenden Stickstoffatom eine Gruppe R als Substituent gebunden ist, welche ungleich Wasserstoff oder Deuterium ist. Dabei ist dieser Substituent R bevorzugt eine Gruppe, ausgewählt aus CF₃, OCF₃, Alkylgruppen mit 1 bis 10 C-Atomen, insbesondere verzweigten oder cyclischen Alkylgruppen mit 3 bis 10 C-Atomen, OR¹, wobei R¹ für eine Alkylgruppe mit 1 bis 10 C-Atomen, insbesondere eine verzweigte oder cyclische Alkylgruppe mit 3 bis 10 C-Atomen steht, einer Dialkylaminogruppe mit 2 bis 10 C-Atomen, aromatischen bzw. heteroaromatischen Ringsystemen oder Aralkyl- bzw. Heteroaralkylgruppen. Es handelt sich bei diesen Gruppen um sterisch anspruchsvolle Gruppen. Weiterhin bevorzugt kann dieser Rest R auch mit einem benachbarten Rest R einen Cyclus bilden.

Ein weiterer geeigneter bidentater Teilligand L¹ ist eine Struktur gemäß einer der folgenden Formeln (L¹-31) und (L¹-32), 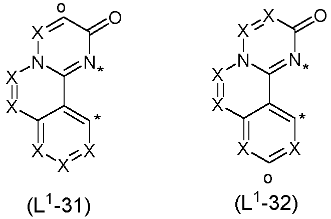 wobei R die oben genannten Bedeutungen aufweist, * die Position der Koordination an das Metall darstellt, "o" die Position der Verknüpfung des Teilliganden mit der Brücke V bzw. der Brücke der Formel (2) bzw. (3) darstellt und weiterhin gilt:
- X: ist bei jedem Auftreten gleich oder verschieden CR oder N mit der Maßgabe, dass maximal ein Symbol X pro Cyclus für N steht.

Wenn zwei Reste R, die in den Teilliganden (L¹-31) bzw. (L¹-32) an benachbarten Kohlenstoffatomen gebunden sind, miteinander einen aromatischen Cyclus bilden, so ist dieser zusammen mit den beiden benachbarten Kohlenstoffatomen bevorzugt eine Struktur der Formel (15), 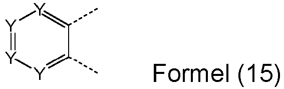 wobei die gestrichelten Bindungen die Verknüpfung dieser Gruppe im Teilliganden symbolisieren und Y gleich oder verschieden bei jedem Auftreten für CR¹ oder N steht und bevorzugt maximal ein Symbol Y für N steht.

In einer bevorzugten Ausführungsform des Teilliganden (L¹-31) bzw. (L¹-32) ist maximal eine Gruppe der Formel (15) vorhanden. Es handelt sich also bevorzugt um Teilliganden der folgenden Formeln (L¹-33) bis (L¹-38), 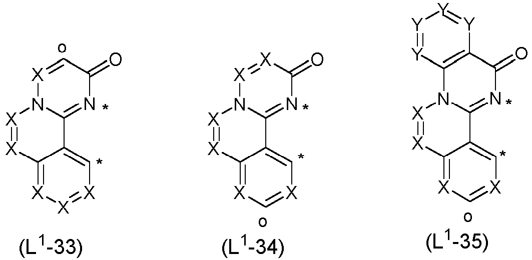 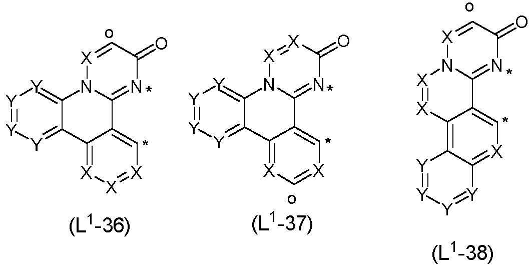 wobei X die oben genannten Bedeutungen aufweist, jedoch die Reste R, wenn X für CR steht, nicht miteinander ein aromatisches oder heteroaromatisches Ringsystem bilden und die weiteren Symbole die oben genannten Bedeutungen aufweisen.

In einer bevorzugten Ausführungsform der Erfindung stehen im Teilliganden der Formel (L¹-31) bis (L¹-38) insgesamt 0, 1 oder 2 der Symbole X und, falls vorhanden, Y für N. Besonders bevorzugt stehen insgesamt 0 oder 1 der Symbole X und, falls vorhanden, Y für N.

Bevorzugte Ausführungsformen der Formeln (L¹-33) bis (L¹-38) sind die Strukturen der folgenden Formeln (L¹-33a) bis (L¹-38f), 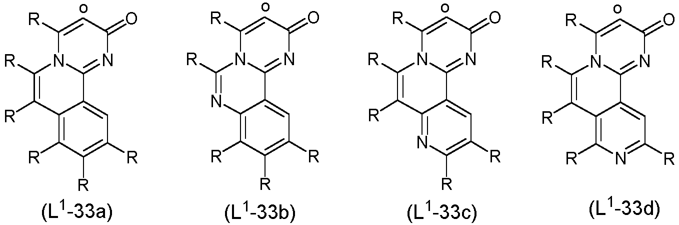 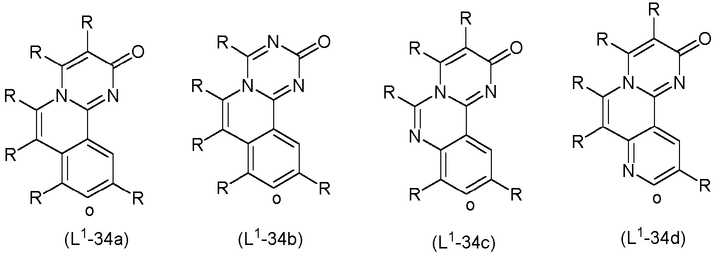 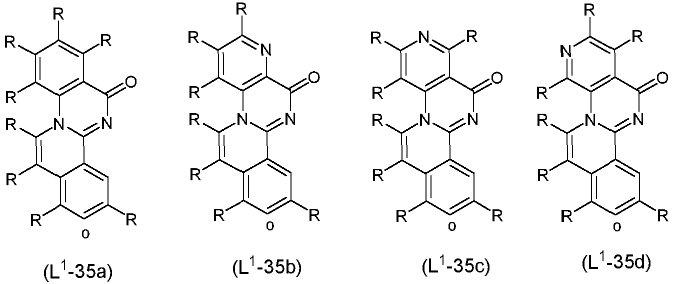 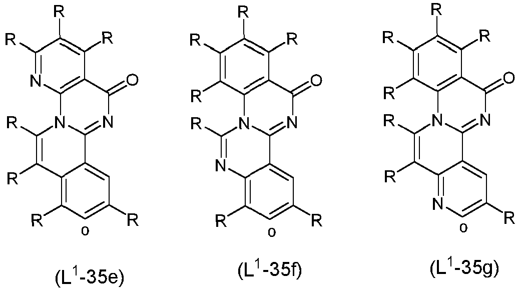 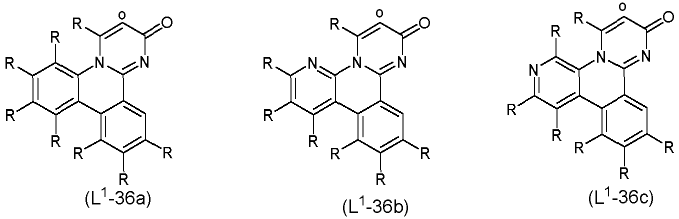 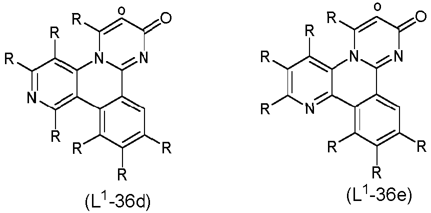 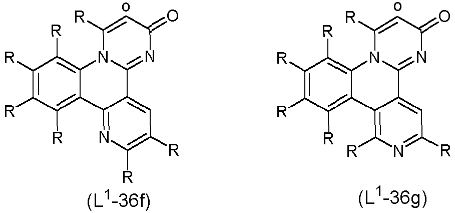 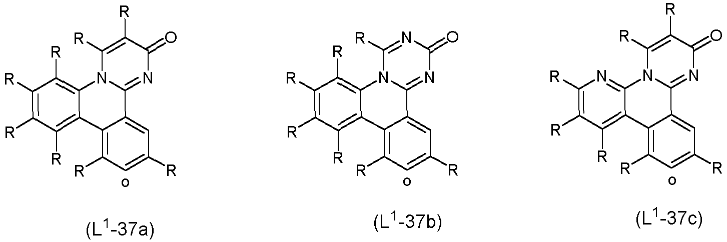 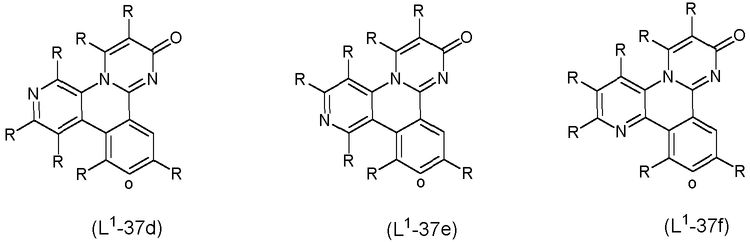 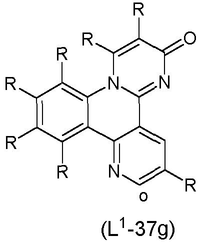 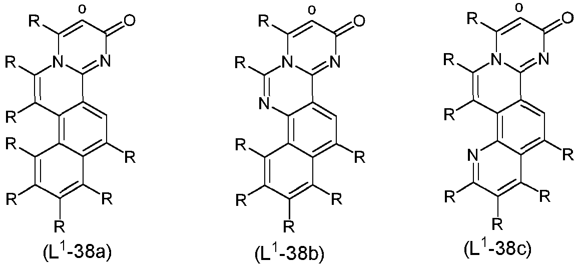 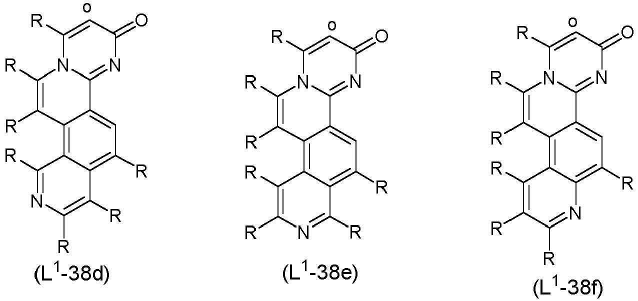 wobei die verwendeten Symbole die oben genannten Bedeutungen aufweisen und "o" die Position der Verknüpfung mit der Brücke V bzw. der Brücke der Formel (2) bzw. (3) anzeigt. Dabei sind bevorzugt maximal drei Substituenten R ungleich H oder D, besonders bevorzugt maximal zwei Substituenten R und ganz besonders bevorzugt maximal ein Substituent.

In einer bevorzugten Ausführungsform der Erfindung steht die Gruppe X, die in ortho-Position zur Koordination an das Metall vorliegt, für CR. Dabei ist in dieser Rest R, der in ortho-Position zur Koordination an das Metall gebunden ist, bevorzugt ausgewählt aus der Gruppe bestehend aus H, D, F und Methyl.

In einer weiteren Ausführungsform der Erfindung ist es bevorzugt, falls eines der Atome X oder, wenn vorhanden, Y für N steht, wenn benachbart zu diesem Stickstoffatom eine Gruppe R als Substituent gebunden ist, welche ungleich Wasserstoff oder Deuterium ist. Dabei ist dieser Substituent R bevorzugt eine Gruppe, ausgewählt aus CF₃, OCF₃, Alkylgruppen mit 1 bis 10 C-Atomen, insbesondere verzweigten oder cyclischen Alkylgruppen mit 3 bis 10 C-Atomen, OR¹, wobei R¹ für eine Alkylgruppe mit 1 bis 10 C-Atomen, insbesondere eine verzweigte oder cyclische Alkylgruppe mit 3 bis 10 C-Atomen steht, einer Dialkylaminogruppe mit 2 bis 10 C-Atomen, aromatischen bzw. heteroaromatischen Ringsystemen oder Aralkyl- bzw. Heteroaralkylgruppen. Es handelt sich bei diesen Gruppen um sterisch anspruchsvolle Gruppen. Weiterhin bevorzugt kann dieser Rest R auch mit einem benachbarten Rest R einen Cyclus bilden.

In einer bevorzugten Ausführungsform der Erfindung ist L¹ ein Teilligand gemäß einer der folgenden Formeln (L¹-39) und (L¹-40), der über die beiden mit * gekennzeichneten Positionen an das Iridium koordiniert, 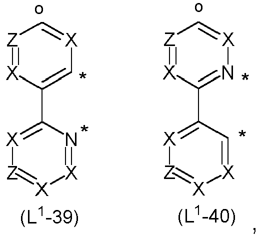 wobei "o" die Position der Verknüpfung mit der Brücke V bezeichnet und weiterhin gilt:
- X: ist bei jedem Auftreten gleich oder verschieden CR oder N;
- Z: ist CR', CR oder N, mit der Maßgabe, dass genau ein Z für CR' steht und das andere Z für CR oder N steht;

dabei steht insgesamt maximal ein Symbol X oder Z pro Cyclus für N;
R' ist eine Gruppe der folgenden Formel (16) oder (17), 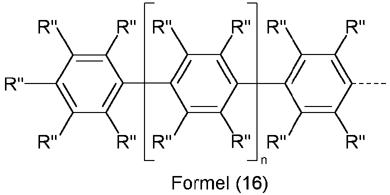 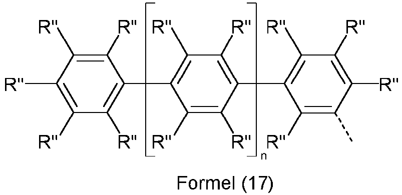
wobei die gestrichelte Bindung die Verknüpfung der Gruppe an den Teilliganden der Formel (L¹-39) bzw. (L¹-40) andeutet;
   - R": ist gleich oder verschieden bei jedem Auftreten H, D, F, CN, eine geradkettige Alkylgruppe mit 1 bis 10 C-Atomen, in der auch ein oder mehrere H-Atome durch D oder F ersetzt sein können, oder eine verzweigte oder cyclische Alkylgruppe mit 3 bis 10 C-Atomen, in der auch ein oder mehrere H-Atome durch D oder F ersetzt sein können, oder eine Alkenylgruppe mit 2 bis 10 C-Atomen, in der auch ein oder mehrere H-Atome durch D oder F ersetzt sein können; dabei können auch zwei benachbarte Reste R" bzw. zwei Reste R" an benachbarten Phenylgruppen miteinander ein Ringsystem bilden; oder zwei R" an benachbarten Phenylgruppen stehen zusammen für eine Gruppe ausgewählt aus C(R¹)₂, NR¹, O oder S, so dass die beiden Phenylringe zusammen mit der verbrückenden Gruppe für ein Carbazol, Fluoren, Dibenzofuran oder Dibenzothiophen stehen, und die weiteren R" sind wie vorstehend definiert;
   - n: ist 0, 1, 2, 3, 4 oder 5.

Dabei ist der Rest R¹ am Stickstoff wie oben definiert und steht bevorzugt für eine Alkylgruppe mit 1 bis 10 C-Atomen oder ein aromatisches oder heteroaromatisches Ringsystem mit 6 bis 24 aromatischen Ringatomen, welches durch einen oder mehrere Reste R² substituiert sein kann, besonders bevorzugt für ein aromatisches oder heteroaromatisches Ringsystem mit 6 bis 18 aromatischen Ringatomen, welches durch einen oder mehrere Reste R² substituiert sein kann, bevorzugt aber unsubstituiert ist.

In einer bevorzugten Ausführungsform der Erfindung ist n = 0, 1 oder 2, bevorzugt 0 oder 1 und ganz besonders bevorzugt 0.

In einer weiteren bevorzugten Ausführungsform der Erfindung sind beide Substituenten R', welche in den ortho-Positionen zu dem Kohlenstoffatom gebunden sind, mit dem die Gruppe der Formel (16) bzw. (17) an den Teilliganden L¹ gebunden ist, gleich oder verschieden H oder D.

In einer bevorzugten Ausführungsform der Erfindung steht X gleich oder verschieden bei jedem Auftreten für CR. Weiterhin bevorzugt steht eine Gruppe Z für CR und die andere Gruppe Z für CR'. Besonders bevorzugt stehen im Teilliganden (L¹-39) bzw. (L¹-40) die Gruppen X gleich oder verschieden bei jedem Auftreten für CR, und gleichzeitig steht eine Gruppe Z für CR und die andere Gruppe Z steht für CR'. Der Teilligand L¹ weist bevorzugt eine Struktur gemäß einer der folgenden Formeln (L¹-39a) bzw. (L¹-40a) auf, wobei die Verknüpfung mit der Brücke V bzw. der Brücke der Formel (2) bzw. (3) über die mit "o" gekennzeichnete Position erfolgt, 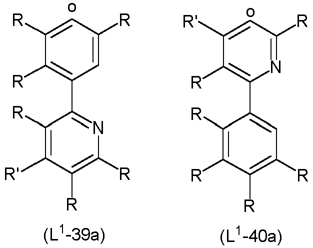 wobei die verwendeten Symbole die oben genannten Bedeutungen aufweisen.

Besonders bevorzugt weist der Teilligand der Formel (L¹-39) bzw. (L¹-40) eine Struktur gemäß einer der folgenden Formeln (L¹-39a') bzw. (L¹-40a') auf, 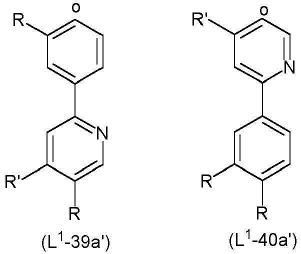 wobei die verwendeten Symbole die oben genannten Bedeutungen aufweisen.

Die Reste R am Teilliganden L¹ der Formel (L¹-39) bzw. (L¹-40) bzw. den bevorzugten Ausführungsformen sind bevorzugt ausgewählt aus der Gruppe bestehend aus H, D, CN, OR¹, einer geradkettigen Alkylgruppe mit 1 bis 6 C-Atomen, bevorzugt mit 1, 2 oder 3 C-Atomen, oder einer verzweigten oder cyclischen Alkylgruppe mit 3, 4, 5 oder 6 C-Atomen oder einer Alkenylgruppe mit 2 bis 6 C-Atomen, bevorzugt mit 2, 3 oder 4 C-Atomen, die jeweils durch einen oder mehrere Reste R¹ substituiert sein kann, oder einer Phenylgruppe, die durch einen oder mehrere nicht-aromatische Reste R¹ substituiert sein kann. Dabei können zwei oder mehrere benachbarte Reste R auch miteinander ein Ringsystem bilden.

Dabei ist der Substituent R, der in ortho-Position zu dem koordinierenden Atom gebunden ist, bevorzugt ausgewählt aus der Gruppe bestehend aus H, D, F oder Methyl, besonders bevorzugt H, D oder Methyl und insbesondere H oder D.

Weiterhin ist es bevorzugt, wenn alle Substituenten R, die in ortho-Position zu R' stehen, für H oder D stehen.

Wenn Reste R am Teilliganden L¹ der Formel (L¹-39) bzw. (L¹-40) miteinander ein Ringsystem bilden, so handelt es sich bevorzugt um ein aliphatisches, heteroaliphatisches oder heteroaromatisches Ringsystem. Weiterhin ist die Ringbildung zwischen zwei Resten R an den beiden Ringen des Teilliganden L¹ bevorzugt, wobei dabei bevorzugt ein Phenanthridin bzw. ein Phenanthridin, welches noch weitere Stickstoffatome enthalten kann, gebildet wird. Wenn Reste R miteinander ein heteroaromatisches Ringsystem bilden, so wird dadurch bevorzugt eine Struktur gebildet, welche ausgewählt ist aus der Gruppe bestehend aus Chinolin, Isochinolin, Dibenzofuran, Dibenzothiophen und Carbazol, welche jeweils durch einen oder mehrere Reste R¹ substituiert sein können und wobei im Dibenzofuran, Dibenzothiophen und Carbazol einzelne C-Atome auch durch N ersetzt sein können. Besonders bevorzugt sind Chinolin, Isochinolin, Dibenzofuran und Azadibenzofuran. Dabei können die ankondensierten Strukturen in jeder möglichen Position gebunden sein. Bevorzugte Teilliganden L¹ mit ankondensierten Benzogruppen sind die nachfolgend aufgeführten Strukturen Formel (L¹-39b) bis (L¹-40e), wobei die Verknüpfung mit der Brücke V über die mit "o" gekennzeichnete Position erfolgt: 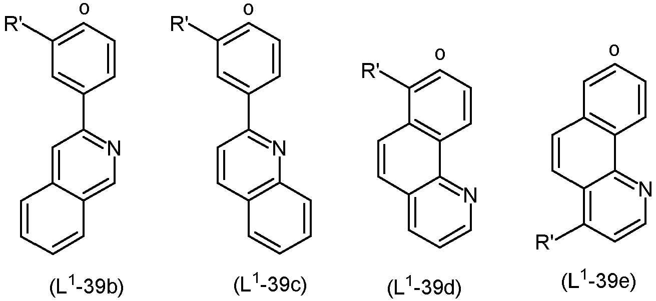 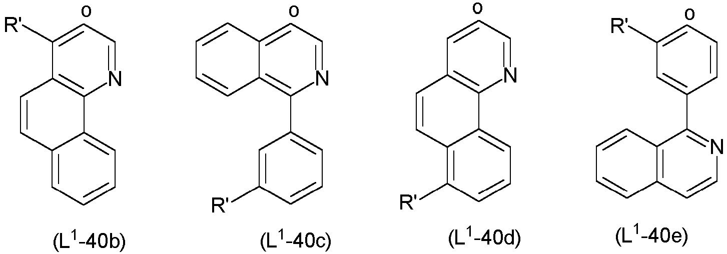 wobei die Teilliganden jeweils auch durch einen oder mehrere weitere Reste R substituiert sein können und die ankondensierte Struktur durch einen oder mehrere Reste R¹ substituiert sein kann. Bevorzugt sind keine weiteren Reste R oder R¹ vorhanden.

Bevorzugte Teilliganden L¹ der Formel (L¹-39) bzw. (L¹-40) mit ankondensierter Benzofuran- bzw. Azabenzofurangruppe sind die nachfolgend aufgeführten Strukturen Formel (L¹-39f) bis (L¹-40m), wobei die Verknüpfung mit der Brücke V über die durch "o" gekennzeichnete Position erfolgt: 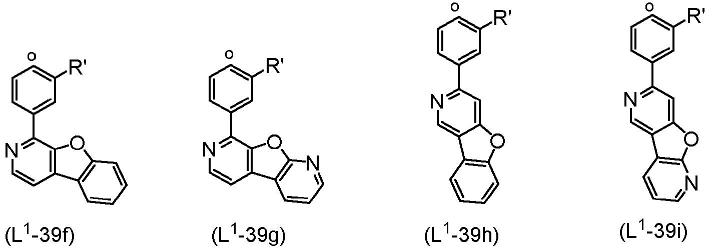 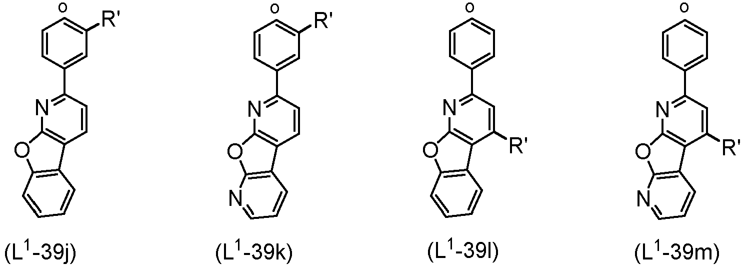 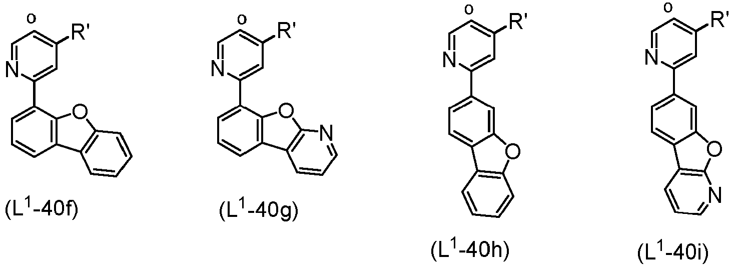 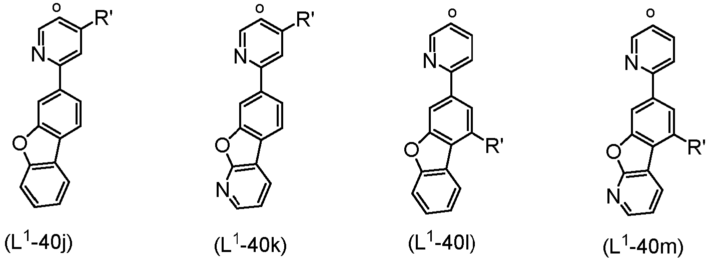 wobei die Liganden jeweils auch durch einen oder mehrere weitere Reste R substituiert sein können und die ankondensierte Struktur durch einen oder mehrere Reste R¹ substituiert sein kann. Bevorzugt sind keine weiteren Reste R oder R¹ vorhanden. Ebenso kann in diesen Strukturen O durch S oder NR¹ ersetzt sein.

Wie oben beschrieben, ist R' eine Gruppe der Formel (16) oder (17). Dabei unterscheiden sich die beiden Gruppen lediglich darin, dass die Gruppe der Formel (16) in der para-Position und die Gruppe der Formel (17) in der meta-Position mit dem Teilliganden L¹ verknüpft ist.

In einer bevorzugten Ausführungsform der Erfindung ist n = 0, 1 oder 2, bevorzugt 0 oder 1 und ganz besonders bevorzugt 0.

In einer weiteren bevorzugten Ausführungsform der Erfindung sind beide Substituenten R", welche in den ortho-Positionen zu dem Kohlenstoffatom gebunden sind, mit dem die Gruppe der Formel (16) bzw. (17) an den Phenylpyridinliganden gebunden ist, gleich oder verschieden H oder D.

Bevorzugte Ausführungsformen der Struktur der Formel (16) sind die Strukturen der Formeln (16a) bis (16h), und bevorzugte Ausführungsformen der Struktur der Formel (17) sind die Strukturen der Formeln (17a) bis (17h), 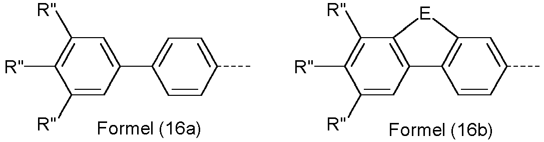 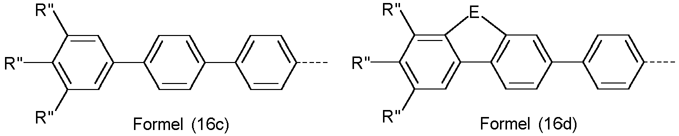 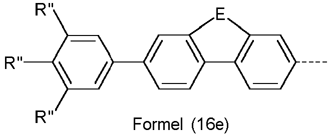 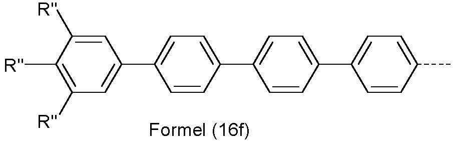 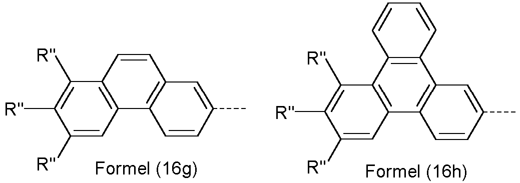 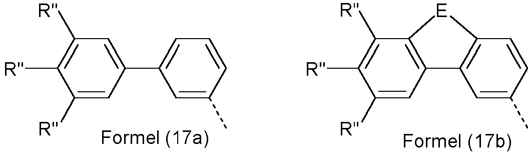 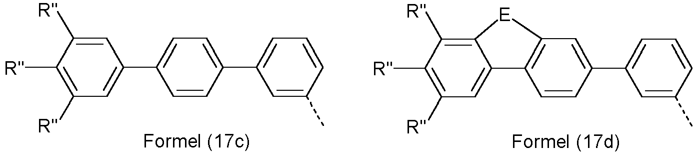 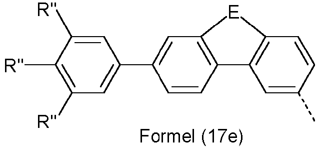 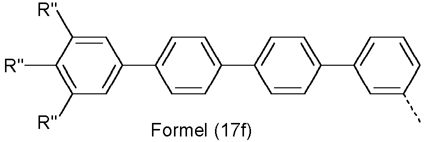 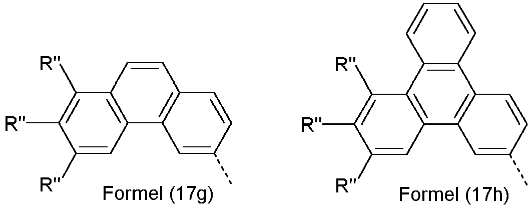 wobei E für O, S, C(R¹)₂ oder NR¹ steht und die weiteren verwendeten Symbole die oben genannten Bedeutungen aufweisen. Dabei steht R¹ für E = NR¹ bevorzugt für ein aromatisches oder heteroaromatisches Ringsystem mit 6 bis 18 aromatischen Ringatomen, welches durch einen oder mehrere Reste R² substituiert sein kann, bevorzugt aber unsubstituiert ist. Weiterhin steht R¹ für E = C(R¹)₂ bevorzugt gleich oder verschieden bei jedem Auftreten für eine Alkylgruppe mit 1 bis 6 C-Atomen, bevorzugt mit 1 bis 4 C-Atomen, besonders bevorzugt Methylgruppen.

Bevorzugte Substituenten R' an den Gruppen der Formel (16) bzw. (17) bzw. den bevorzugten Ausführungsformen sind gewählt aus der Gruppe bestehend aus der Gruppe bestehend aus H, D, CN und einer Alkylgruppe mit 1 bis 4 C-Atomen, besonders bevorzugt H, D, Methyl, Cyclopentyl, 1-Methylcyclopentyl, Cyclohexyl oder 1-Methylcyclohexyl, insbesondere H, D oder Methyl.

Im Folgenden werden die monodentaten Teilliganden L² und L³ beschrieben. Dabei können L² und L³ gleich oder verschieden bei jedem Auftreten einen neutralen oder einen monoanionischen Teilliganden darstellen.

In einer bevorzugten Ausführungsform der vorliegenden Erfindung stehen L² und L³ gleich oder verschieden bei jedem Auftreten für eine Aryl- oder Heteroarylgruppe mit 5 bis 13 aromatischen Ringatomen, besonders bevorzugt mit 6 bis 13 aromatischen Ringatomen, ganz besonders bevorzugt mit 6 bis 10 aromatischen Ringatomen, welche über ein Kohlenstoffatom oder ein Stickstoffatom, das jeweils Teil der Aryl- bzw. Heteroarylgruppe ist, an das Iridium koordiniert und welche mit einem oder mehreren Resten R substituiert sein kann. Wenn die Gruppe über ein Kohlenstoffatom an das Iridium koordiniert, so kann dieses anionisch oder ein neutrales Carben-Kohlenstoffatom sein. Wenn die Gruppe über ein Stickstoffatom an das Iridium koordiniert, so kann dieses neutral oder anionisch sein.

Bevorzugte Ausführungsformen von L² und L³ sind gleich oder verschieden bei jedem Auftreten die Strukturen der folgenden Formeln (L²-1) bzw.

(L³-1) bis (L²-55) bzw. (L³-55), wobei die Gruppe jeweils an der durch * gekennzeichneten Position an das Iridium koordiniert und an der durch "o" gekennzeichneten Position an den Brückenkopf V bzw. an die Gruppe der Formel (2) bzw. (3) gebunden ist, 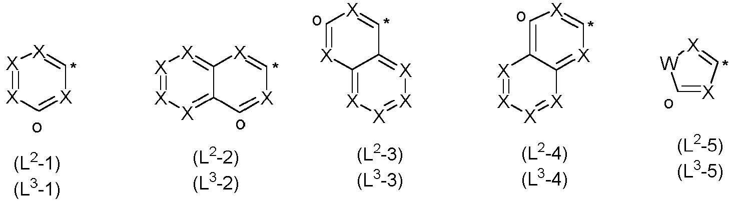 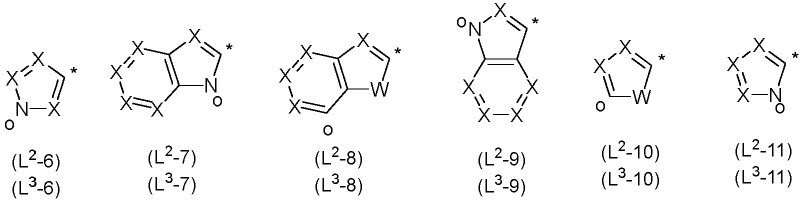 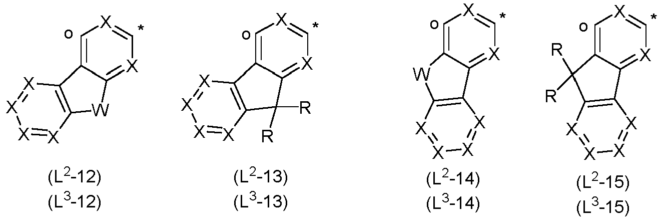 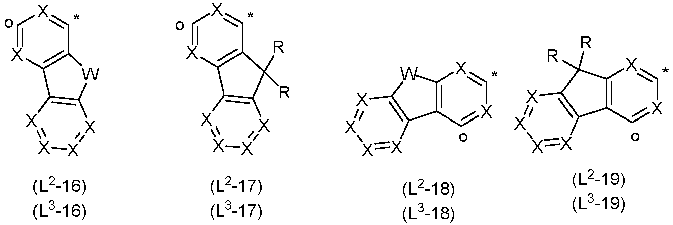 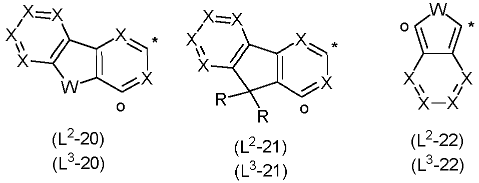 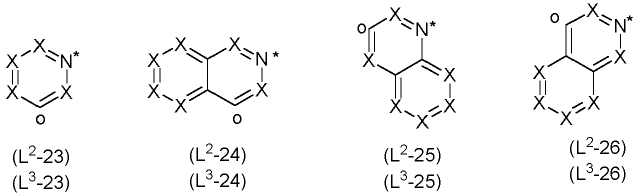 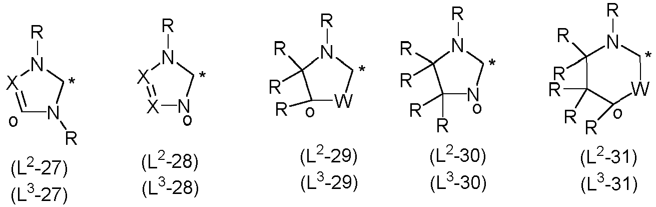 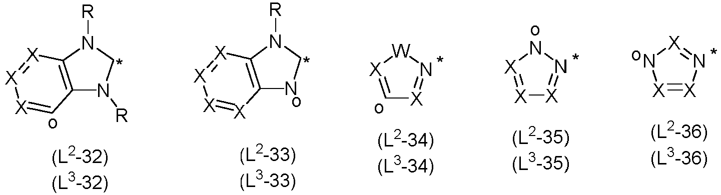 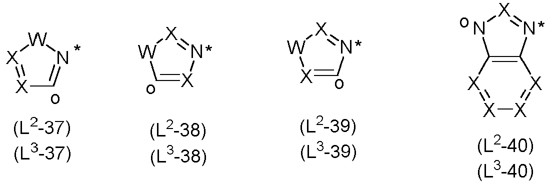 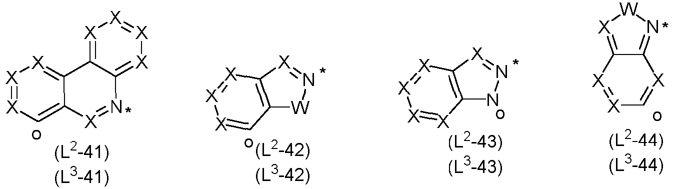 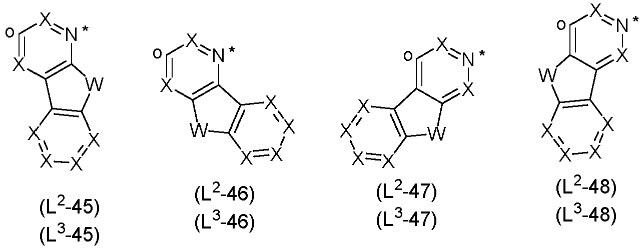 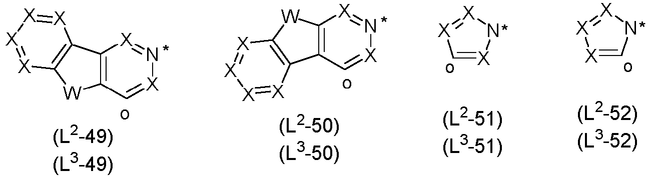 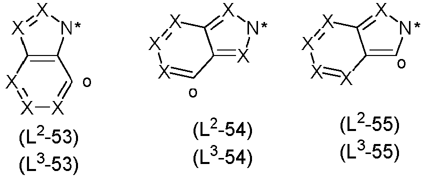 wobei R die oben genannten Bedeutungen aufweist und für die weiteren verwendeten Symbole gilt:
- X: ist bei jedem Auftreten gleich oder verschieden CR oder N mit der Maßgabe, dass maximal zwei Symbole X pro Cyclus für N stehen;
- W: ist bei jedem Auftreten gleich oder verschieden NR, O oder S.

Dabei koordinieren die Gruppen (L²-1) bzw. (L³-1) bis (L²-22) bzw. (L³-22) über ein anionisches Kohlenstoffatom, die Gruppen (L²-23) bzw. (L³-23) bis (L²-26) bzw. (L³-26) und (L²-34) bzw. (L³-34) bis (L²-50) bzw. (L³-50) über ein neutrales Stickstoffatom, die Gruppen (L²-27) bzw. (L³-27) bis (L²-33) bzw. (L³-33) über ein neutrales Carben-Kohlenstoffatom und die Gruppen (L²-51) bzw. (L³-51) bis (L²-55) bzw. (L³-55) über ein anionisches Stickstoffatom an das Iridium.

Bevorzugt steht maximal ein Symbol X für N, und ganz besonders bevorzugt stehen alle Symbole X für CR.

Besonders bevorzugte Gruppen L² bzw. L³ sind die Gruppen der folgenden Formeln (L²-1a) bzw. (L³-1a) bis (L²-55a) bzw. (L³-55a), 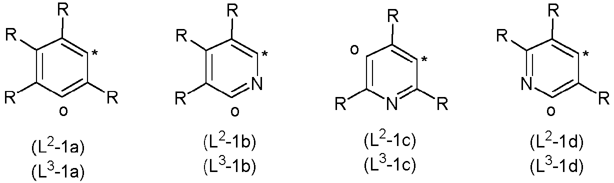 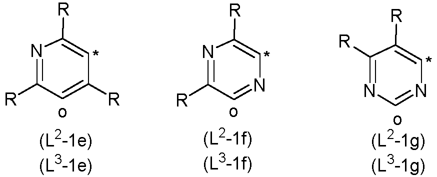 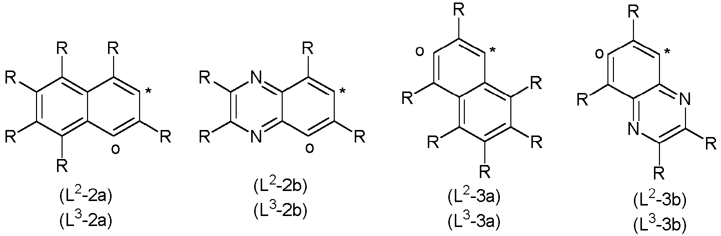 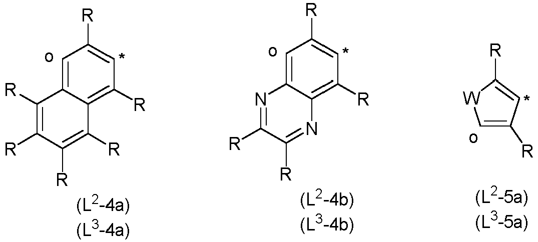 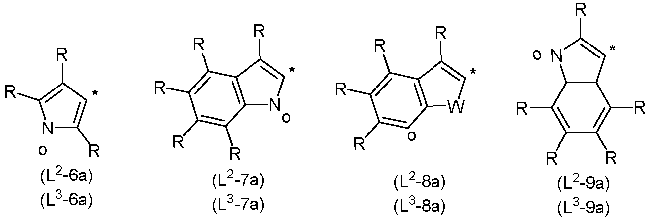 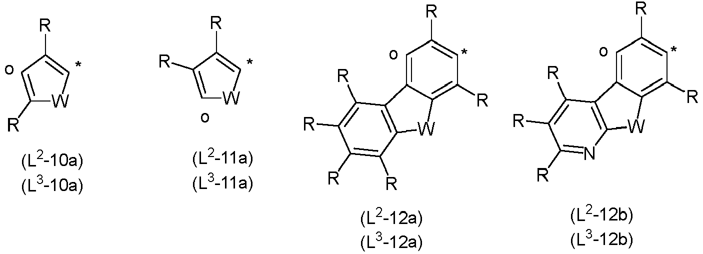 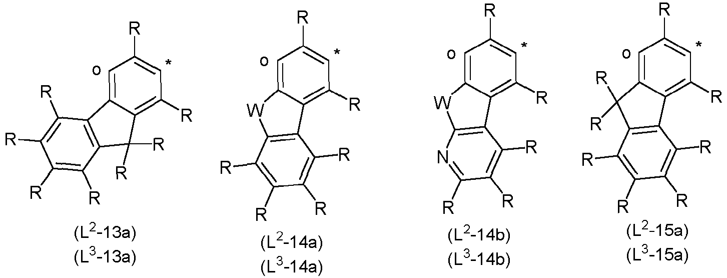 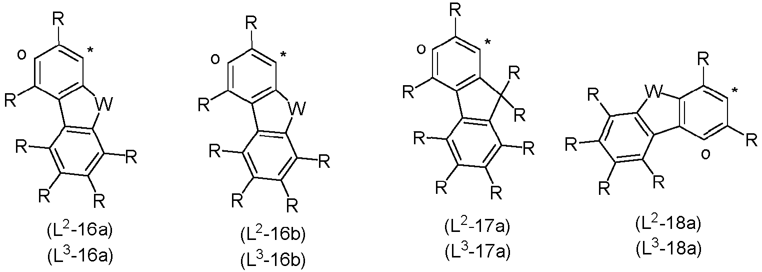 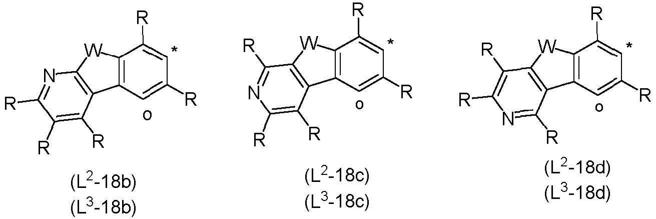 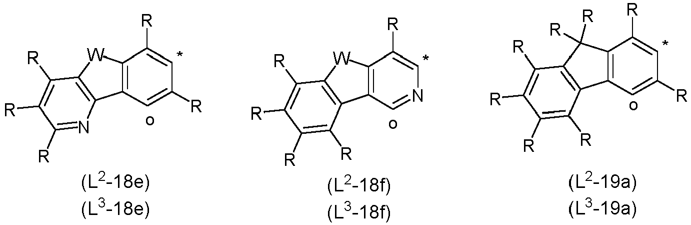 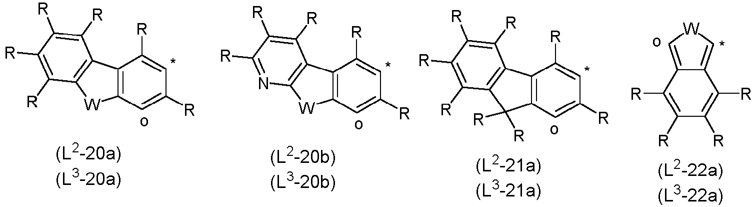 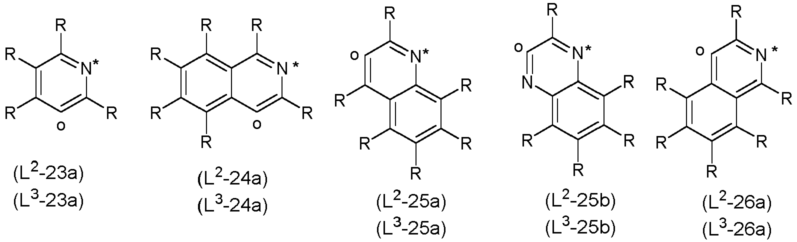 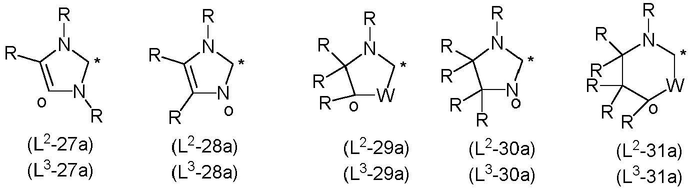 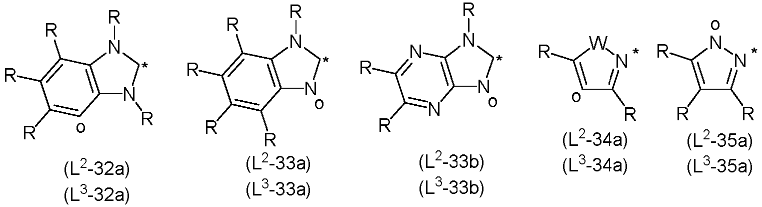 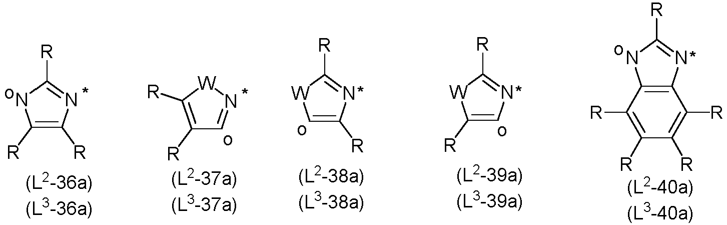 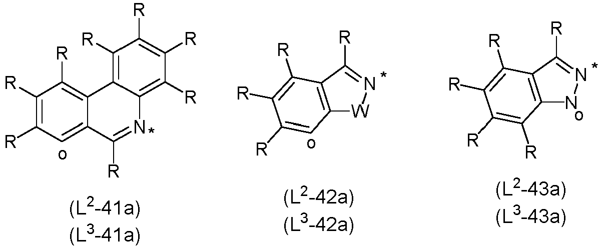 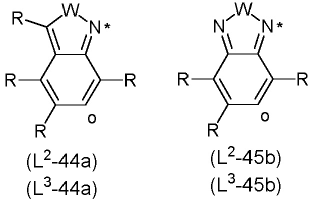 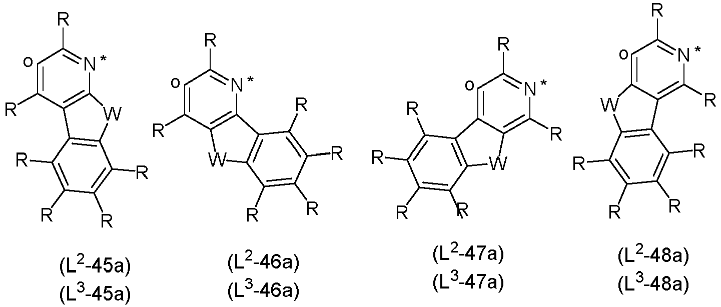 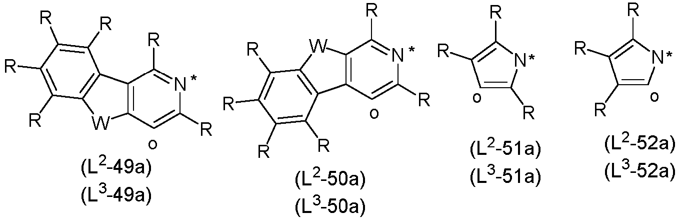 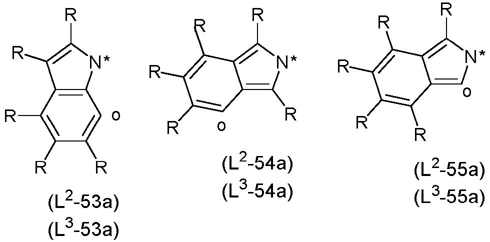 wobei die verwendeten Symbole die oben genannten Bedeutungen aufweisen. Dabei sind bevorzugt maximal drei Substituenten R ungleich H oder D, besonders bevorzugt maximal zwei Substituenten R und ganz besonders bevorzugt maximal ein Substituent R.

Bevorzugte monodentate Teilliganden L² und L³ sind die Strukturen (L²-1), (L³-1), (L²-23), (L³-23), (L²-27), (L³-27), (L²-28), (L³-28), (L²-32), (L³-32), (L²-33) und (L³-33). Besonders bevorzugte monodentate Teilliganden L² und L³ sind die Strukturen (L²-1a), (L³-1a), (L²-23a), (L³-23a), (L²-27a), (L³-27a), (L²-28a), (L³-28a), (L²-32a), (L³-32a), (L²-33a), (L³-33a), (L²-33b) und (L³-33b).

Im Folgenden werden bevorzugte Ausführungsformen für den Liganden L⁴ beschrieben. Wie oben beschrieben, kann L⁴ monodentat oder bidentat sein. Wenn der Ligand L⁴ monodentat ist, kann er neutral oder monoanionisch sein. Wenn der Ligand L⁴ bidentat ist, kann er neutral, monoanionisch oder dianionisch sein. Wenn die Liganden L⁴ monodentat sind, koordinieren sie bevorzugt über Atome, welche gleich oder verschieden gewählt sind aus der Gruppe bestehend aus Kohlenstoff, Stickstoff, Sauerstoff, Schwefel und Phosphor. Wenn der Ligand L⁴ bidentat ist, koordiniert er bevorzugt über zwei Atome, welche gleich oder verschieden gewählt sind aus der Gruppe bestehend aus Kohlenstoff, Stickstoff, Sauerstoff, Schwefel und Phoshor.

Geeignete neutrale, monodentate Liganden L⁴ sind gleich oder verschieden bei jedem Auftreten ausgewählt aus der Gruppe bestehend aus Kohlenmonoxid (CO), Stickstoffmonoxid (NO), Alkylcyaniden, wie z. B. Acetonitril, Arylcyaniden, wie z. B. Benzonitril, Alkylisocyaniden, wie z. B. Methylisonitril, tert-Butylisonitril, Adamantylisonitril, Arylisocyaniden, wie z. B. Phenylisonitril, Aminen, wie z. B. Trimethylamin, Triethylamin, Morpholin, Phosphinen, insbesondere Halogenphosphine, Trialkylphosphine, Triarylphosphine oder Alkylarylphosphine, wie z. B. Trifluorphosphin, Trimethylphosphin, Tricyclohexylphosphin, Tri-*tert*-butylphosphin, Triphenylphosphin, Tris(pentafluorphenyl)phosphin, Dimethylphenylphosphin, Methyldiphenylphosphin, Bis(tert-butyl)phenylphosphin, Phosphiten, wie z. B. Trimethylphosphit, Triethylphosphit, Arsinen, wie z. B. Trifluorarsin, Trimethylarsin, Tricyclohexylarsin, Tri-*tert*-butylarsin, Triphenylarsin, Tris(pentafluorphenyl)arsin, Stibinen, wie z. B. Trifluorstibin, Trimethylstibin, Tricyclohexylstibin, Tri-*tert*-butylstibin, Triphenylstibin, Tris(pentafluorphenyl)stibin, stickstoffhaltigen Heterocyclen, wie z. B. Pyridin, Pyridazin, Pyrazin, Pyrimidin, Triazin, und Carbenen, insbesondere Arduengo-Carbenen. Bevorzugte monodentate neutrale Liganden L⁴ sind gewählt aus der Gruppe bestehend aus CO, PF₃ und Trialkylphosphinen, wobei die Alkylgruppen gleich oder verschieden bei jedem Auftreten 1 bis 10 C-Atome aufweisen.

Geeignete monoanionische, monodentate Liganden L⁴ sind gleich oder verschieden bei jedem Auftreten ausgewählt aus Hydrid, Deuterid, den Halogeniden F⁻, Cl⁻, Br⁻ und I⁻, Alkylacetyliden, wie z. B. Methyl-C≡C⁻, tert-Butyl-C≡C⁻, Arylacetyliden, wie z. B. Phenyl-C≡C⁻, Cyanid, Cyanat, Isocyanat, Thiocyanat, Isothiocyanat, aliphatischen oder aromatischen Alkoholaten, wie z. B. Methanolat, Ethanolat, Propanolat, *iso*-Propanolat, *tert*-Butylat, Phenolat, aliphatischen oder aromatischen Thioalkoholaten, wie z. B. Methanthiolat, Ethanthiolat, Propanthiolat, *iso*-Propanthiolat, *tert-*Thiobutylat, Thiophenolat, Amiden, wie z. B. Dimethylamid, Diethylamid, Di-*iso*-propylamid, Morpholid, Carboxylaten, wie z. B. Acetat, Trifluoracetat, Propionat, Benzoat, Arylgruppen, wie z. B. Phenyl, Naphthyl, und anionischen, stickstoffhaltigen Heterocyclen, wie Pyrrolid, Imidazolid, Pyrazolid. Dabei sind die Alkylgruppen in diesen Gruppen bevorzugt C₁-C₂₀-Alkylgruppen, besonders bevorzugt C₁-C₁₀-Alkylgruppen, ganz besonders bevorzugt C₁-C₄-Alkylgruppen. Unter einer Arylgruppe werden auch Heteroarylgruppen verstanden. Diese Gruppen sind wie oben definiert. Ein bevorzugter monodentater monoanionischer Ligand L⁴ ist CN.

Bevorzugte neutrale oder mono- oder dianionische, bidentate Liganden L⁴ sind ausgewählt aus Diaminen, wie z. B. Ethylendiamin, N,N,N',N'-Tetramethylethylendiamin, Propylendiamin, N,N,N',N'-Tetramethylpropylendi-amin, cis- oder trans-Diaminocyclohexan, cis- oder trans-N, N, N', N'-Tetra-methyldiaminocyclohexan, Iminen, wie z. B. 2-[1-(Phenylimino)ethyl]-pyridin, 2-[1-(2-Methylphenylimino)ethyl]pyridin, 2-[1-(2,6-Di-*iso*-propyl-phenylimino)ethyl]pyridin, 2-[1-(Methylimino)ethyl]pyridin, 2-[1-(ethylimino)-ethyl]pyridin, 2-[1-(*Iso*-Propylimino)ethyl]pyridin, 2-[1-(*Tert*-Butylimino)-ethyl]pyridin, Diiminen, wie z. B. 1,2-Bis(methylimino)ethan, 1,2-Bis(ethyl-imino)ethan, 1,2-Bis(*iso*-propylimino)ethan, 1,2-Bis(*tert*-butylimino)ethan, 2,3-Bis(methylimino)butan, 2,3-Bis(ethylimino)butan, 2,3-Bis(*iso*-propyl-imino)butan, 2,3-Bis(*tert*-butylimino)butan, 1,2-Bis(phenylimino)ethan, 1,2-Bis(2-methylphenylimino)ethan, 1,2-Bis(2,6-di-*iso*-propylphenylimino)-ethan, 1,2-Bis(2,6-di-*tert*-butylphenylimino)ethan, 2,3-Bis(phenylimino)-butan, 2,3-Bis(2-methylphenylimino)butan, 2,3-Bis(2,6-di-*iso*-propylphenyl-imino)butan, 2,3-Bis(2,6-di-*tert*-butylphenylimino)butan, Heterocyclen enthaltend zwei Stickstoffatome, wie z. B. 2,2'-Bipyridin, o-Phenanthrolin, Diphosphinen, wie z. B. Bis(diphenylphosphino)methan, Bis(diphenylphos-phino)ethan, Bis(diphenylphosphino)propan, Bis(diphenylphosphino)-butan, Bis(dimethylphosphino)methan, Bis(dimethylphosphino)ethan, Bis-(dimethylphosphino)propan, Bis(diethylphosphino)methan, Bis(diethyl-phosphino)ethan, Bis(diethylphosphino)propan, Bis(di-*tert*-butylphos-phino)methan, Bis(di-*tert*-butylphosphino)ethan, Bis(*tert*-butylphosphino)-propan, 1,3-Diketonaten abgeleitet von 1,3-Diketonen, wie z. B. Acetylaceton, Benzoylaceton, 1,5-Diphenylacetylaceton, Dibenzoylmethan, Bis-(1,1,1-trifluoracetyl)methan, 3-Ketonaten abgeleitet von 3-Ketoestern, wie z. B. Acetessigsäureethylester, Carboxylate, abgeleitet von Aminocarbonsäuren, wie z. B. Pyridin-2-carbonsäure, Chinolin-2-carbonsäure, Glycin, N,N-Dimethylglycin, Alanin, N,N-Dimethylaminoalanin, Salicyliminaten abgeleitet von Salicyliminen, wie z. B. Methylsalicylimin, Ethylsalicylimin, Phenylsalicylimin, Dialkoholaten abgeleitet von Dialkoholen, wie z. B. Ethylenglykol, 1,3-Propylenglykol, Dithiolaten abgeleitet von Dithiolen, wie z. B. 1,2-Ethylendithiol, 1,3-Propylendithiol, Bis(pyrazolylboraten), Bis-(imidazolyl)boraten, 3-(2-Pyridyl)-diazolen oder 3-(2-Pyridyl)-triazolen.

Bevorzugt sind weiterhin bidentate monoanionische, neutrale oder dianionische Liganden L⁴, insbesondere monoanionische Liganden, welche mit dem Iridium einen cyclometallierten Fünfring oder Sechsring mit mindestens einer Iridium-Kohlenstoff-Bindung aufweisen, insbesondere einen cyclometallierten Fünfring. Dies sind insbesondere Liganden, wie sie allgemein im Gebiet der phosphoreszierenden Metallkomplexe für organische Elektrolumineszenzvorrichtungen verwendet werden, also Liganden vom Typ Phenylpyridin, Naphthylpyridin, Phenylchinolin, Phenylisochinolin, etc., welche jeweils durch einen oder mehrere Reste R substituiert sein können. Dem Fachmann auf dem Gebiet der phosphoreszierenden Elektrolumineszenzvorrichtungen ist eine Vielzahl derartiger Liganden bekannt, und er kann ohne erfinderisches Zutun weitere derartige Liganden als Ligand L⁴ für Verbindungen gemäß Formel (1) auswählen.

Geeignete bidentate Liganden L⁴ sind ausgewählt aus den Liganden der folgenden Formeln (L⁴-1), (L⁴-2) und (L⁴-3), 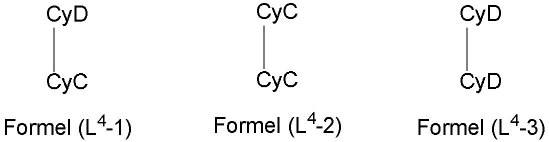 wobei für die verwendeten Symbole gilt:
- CyC: ist gleich oder verschieden bei jedem Auftreten eine substituierte oder unsubstituierte Aryl- oder Heteroarylgruppe mit 5 bis 14 aromatischen Ringatomen, welche jeweils über ein Kohlenstoffatom an das Metall koordiniert und welche über eine kovalente Bindung mit CyD verbunden ist;
- CyD: ist gleich oder verschieden bei jedem Auftreten eine substituierte oder unsubstituierte Heteroarylgruppe mit 5 bis 14 aromatischen Ringatomen, welche über ein Stickstoffatom oder über ein Carben- Kohlenstoffatom an das Metall koordiniert und welche über eine kovalente Bindung mit CyC verbunden ist;
dabei können mehrere der optionalen Substituenten miteinander ein Ringsystem bilden; die optionalen Reste sind bevorzugt ausgewählt aus den oben genannten Resten R.

Dabei koordiniert CyD über ein neutrales oder anionisches Stickstoffatom oder über ein Carben-Kohlenstoffatom. Weiterhin koordiniert CyC über ein anionisches Kohlenstoffatom.

Wenn mehrere der Substituenten, insbesondere mehrere Reste R, miteinander ein Ringsystem bilden, so ist die Bildung eines Ringsystems aus Substituenten, die an direkt benachbarten Kohlenstoffatomen gebunden sind, möglich. Weiterhin ist es auch möglich, dass die Substituenten an CyC und CyD miteinander einen Ring bilden, wodurch CyC und CyD auch zusammen eine einzige kondensierte Aryl- bzw. Heteroarylgruppe als bidentaten Teilliganden bilden können.

In einer bevorzugten Ausführungsform der vorliegenden Erfindung ist CyC eine Aryl- oder Heteroarylgruppe mit 6 bis 13 aromatischen Ringatomen, besonders bevorzugt mit 6 bis 10 aromatischen Ringatomen, ganz besonders bevorzugt mit 6 aromatischen Ringatomen, welche über ein Kohlenstoffatom an das Metall koordiniert, welche mit einem oder mehreren Resten R substituiert sein kann und welche über eine kovalente Bindung mit CyD verbunden ist.

Bevorzugte Ausführungsformen der Gruppe CyC sind die Strukturen der folgenden Formeln (CyC-1) bis (CyC-20), wobei die Gruppe CyC jeweils an der durch # gekennzeichneten Position an CyD bindet und an der durch * gekennzeichneten Position an das Iridium koordiniert, 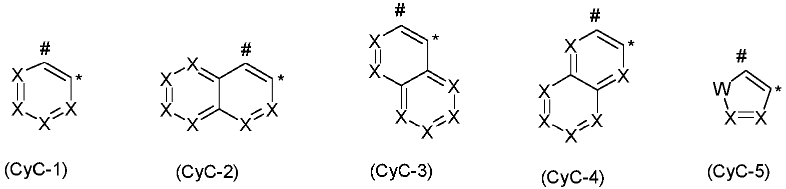 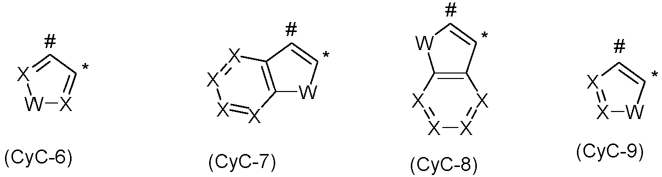 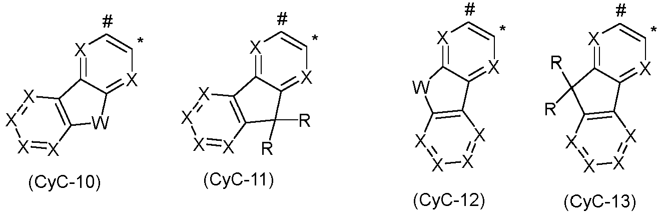 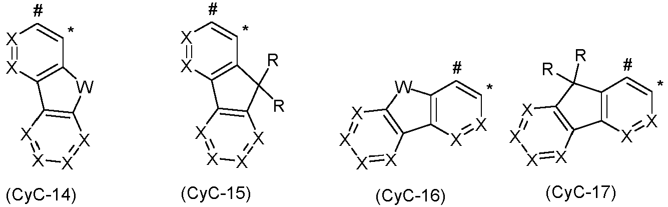 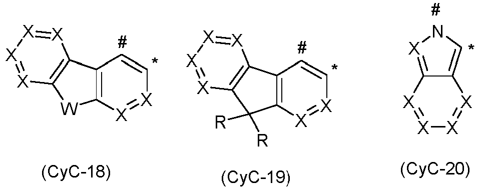 wobei R die oben genannten Bedeutungen aufweist und für die weiteren verwendeten Symbole gilt:
- X: ist bei jedem Auftreten gleich oder verschieden CR oder N mit der Maßgabe, dass maximal zwei Symbole X pro Cyclus für N stehen;
- W: ist bei jedem Auftreten gleich oder verschieden NR, O oder S.

Bevorzugt steht maximal ein Symbol X in CyC für N, und besonders bevorzugt stehen alle Symbole X für CR.

Besonders bevorzugte Gruppen CyC sind die Gruppen der folgenden Formeln (CyC-1a) bis (CyC-20a), 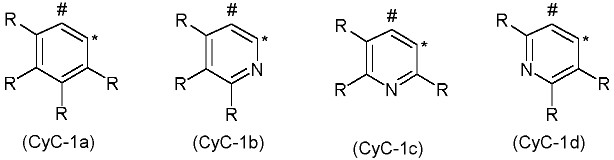 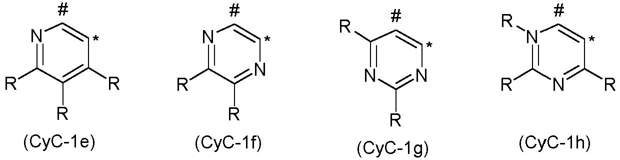 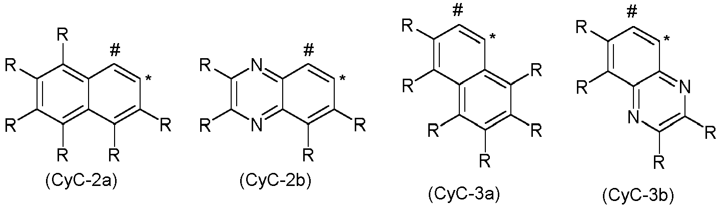 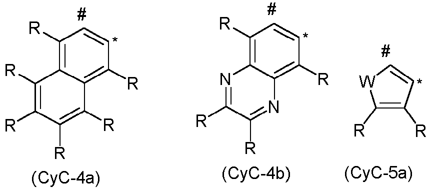 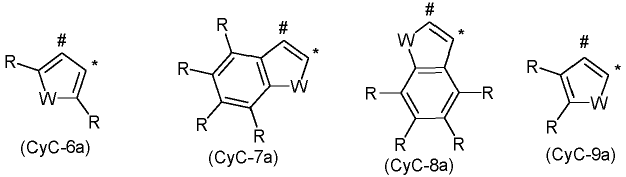 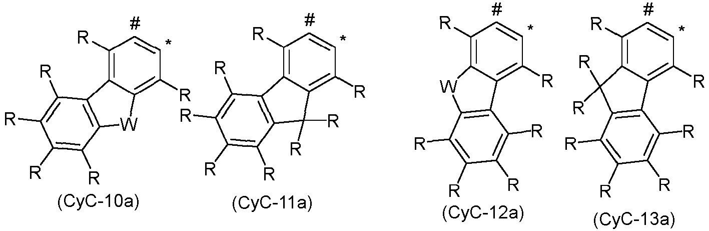 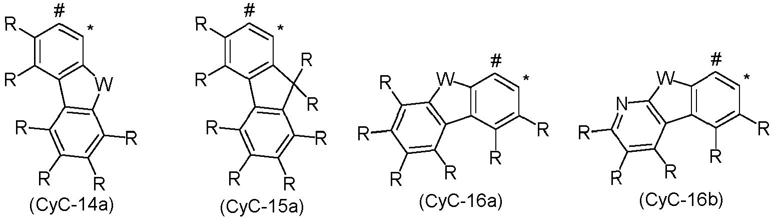 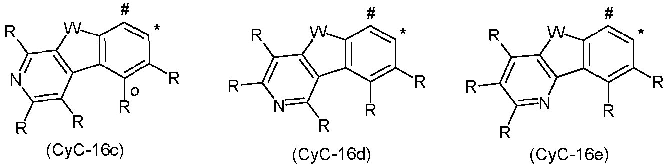 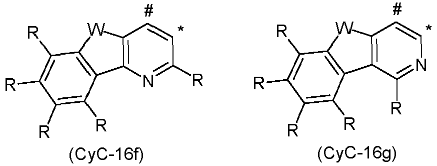 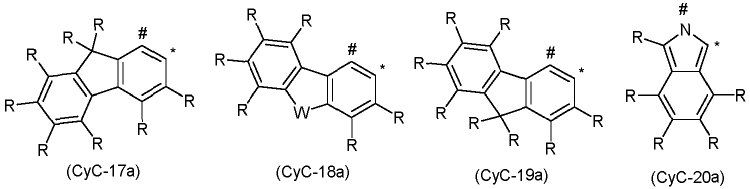 wobei die verwendeten Symbole die oben genannten Bedeutungen aufweisen. Dabei sind bevorzugt maximal drei Substituenten R ungleich H oder **D,** besonders bevorzugt maximal zwei Substituenten R und ganz besonders bevorzugt maximal ein Substituent.

Bevorzugte Gruppen unter den Gruppen (CyC-1) bis (CyC-20) sind die Gruppen (CyC-1), (CyC-3), (CyC-8), (CyC-10), (CyC-12), (CyC-13) und (CyC-16), und besonders bevorzugt sind die Gruppen (CyC-1a), (CyC-3a), (CyC-8a), (CyC-10a), (CyC-12a), (CyC-13a) und (CyC-16a).

**In** einer weiteren bevorzugten Ausführungsform der Erfindung ist CyD eine Heteroarylgruppe 5 bis 13 aromatischen Ringatomen, besonders bevorzugt mit 6 bis 10 aromatischen Ringatomen, welche über ein neutrales Stickstoffatom oder über ein Carben-Kohlenstoffatom an das Metall koordiniert und welche mit einem oder mehreren Resten R substituiert sein kann und welche über eine kovalente Bindung mit CyC verbunden ist.

Bevorzugte Ausführungsformen der Gruppe CyD sind die Strukturen der folgenden Formeln (CyD-1) bis (CyD-21), wobei die Gruppe CyD jeweils an der durch # gekennzeichneten Position an CyC bindet und an der durch * gekennzeichneten Position an das Iridium koordiniert, 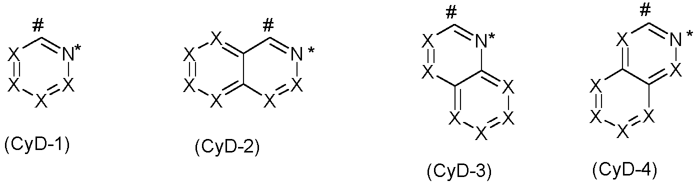 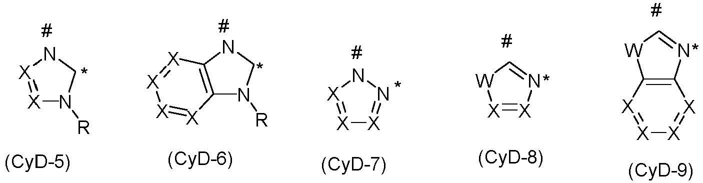 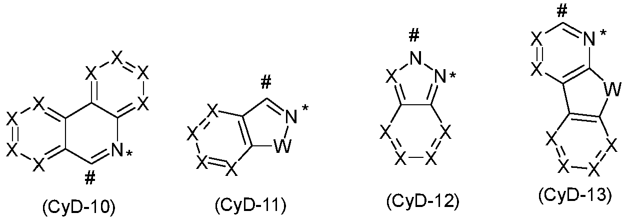 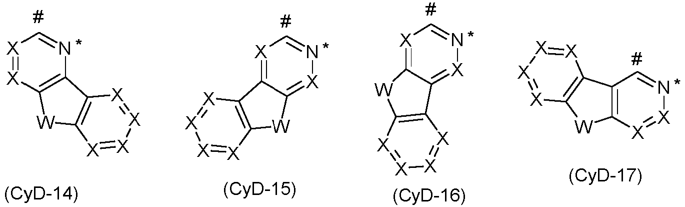 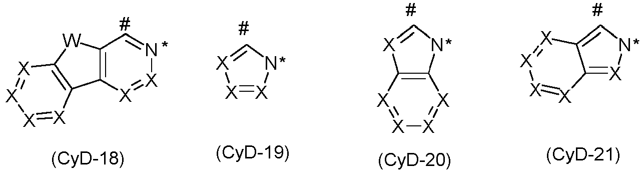 wobei X, Wund R die oben genannten Bedeutungen aufweisen.

Dabei koordinieren die Gruppen (CyD-1) bis (CyD-4) und (CyD-7) bis (CyD-18) über ein neutrales Stickstoffatom, (CyD-5) und (CyD-6) über ein Carben-Kohlenstoffatom und (CyD-19) bis (CyD-21) über ein anionisches Stickstoffatom an das Metall.

Bevorzugt steht maximal ein Symbol X in CyD für N, und besonders bevorzugt stehen alle Symbole X für CR.

Besonders bevorzugte Gruppen CyD sind die Gruppen der folgenden Formeln (CyD-1a) bis (CyD-21a), 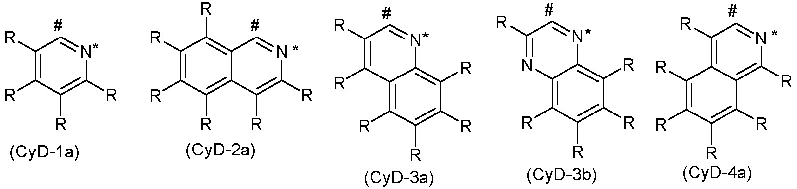 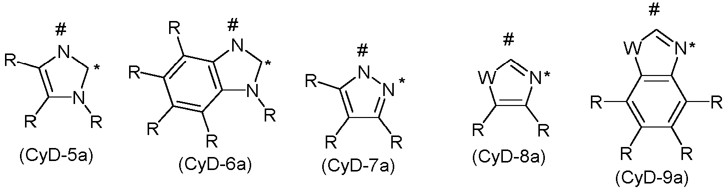 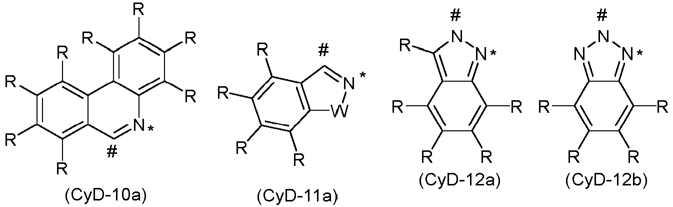 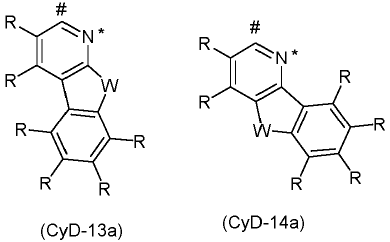 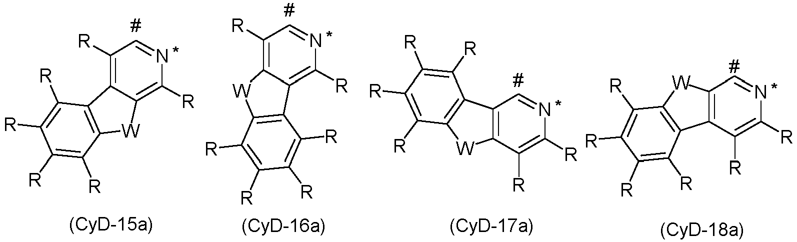 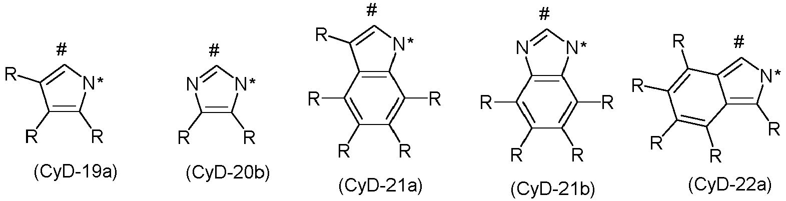 wobei die verwendeten Symbole die oben genannten Bedeutungen aufweisen. Dabei sind bevorzugt maximal drei Substituenten R ungleich H oder **D,** besonders bevorzugt maximal zwei Substituenten R und ganz besonders bevorzugt maximal ein Substituent.

Bevorzugte Gruppen unter den Gruppen (CyD-1) bis (CyD-12) sind die Gruppen (CyD-1), (CyD-2), (CyD-3), (CyD-4), (CyD-5) und (CyD-6), insbesondere (CyD-1), (CyD-2) und (CyD-3), und besonders bevorzugt sind die Gruppen (CyD-1a), (CyD-2a), (CyD-3a), (CyD-4a), (CyD-5a) und (CyD-6a), insbesondere (CyD-1a), (CyD-2a) und (CyD-3a).

**In** einer bevorzugten Ausführungsform der Erfindung ist CyC eine Aryl-oder Heteroarylgruppe mit 6 bis 13 aromatischen Ringatomen, und gleichzeitig ist CyD eine Heteroarylgruppe mit 5 bis 13 aromatischen Ringatomen. Besonders bevorzugt ist CyC eine Aryl- oder Heteroarylgruppe mit 6 bis 10 aromatischen Ringatomen, und gleichzeitig ist CyD eine Heteroarylgruppe mit 5 bis 10 aromatischen Ringatomen. Ganz besonders bevorzugt ist CyC eine Aryl- oder Heteroarylgruppe mit 6 aromatischen Ringatomen und CyD eine Heteroarylgruppe mit 6 bis 10 aromatischen Ringatomen. Dabei können CyC und CyD mit einem oder mehreren Resten R substituiert sein.

Die oben genannten bevorzugten Gruppen (CyC-1) bis (CyC-20) und (CyD-1) bis (CyD-23) können beliebig miteinander kombiniert werden. Insbesondere bevorzugt ist es, wenn die oben als besonders bevorzugt genannten Gruppen CyC und CyD, also die Gruppen der Formeln (CyC-1a) bis (CyC-20a) und die Gruppen der Formeln (CyD1-a) bis (CyD-14b) miteinander kombiniert werden. Ganz besonders bevorzugt ist es, wenn eine der Gruppen (CyC-1), (CyC-3), (CyC-8), (CyC-10), (CyC-12), (CyC-13) und (CyC-16), und insbesondere die Gruppen (CyC-1a), (CyC-3a), (CyC-8a), (CyC-10a), (CyC-12a), (CyC-13a) und (CyC-16a), mit einer der Gruppen (CyD-1), (CyD-2) und (CyD-3), und insbesondere mit einer der Gruppen (CyD-1a), (CyD-2a) und (CyD-3a), kombiniert wird.

Bevorzugte Liganden (L⁴-1) sind die Strukturen der Formeln (L⁴-1-1) bis (L⁴-1-5), 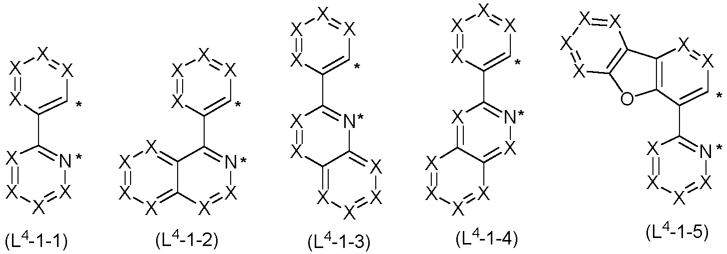 wobei die verwendeten Symbole die oben genannten Bedeutungen aufweisen.

Besonders bevorzugte Teilliganden (L⁴-1) sind die Strukturen der Formeln (L⁴-1-1a) bis (L⁴-1-5a), 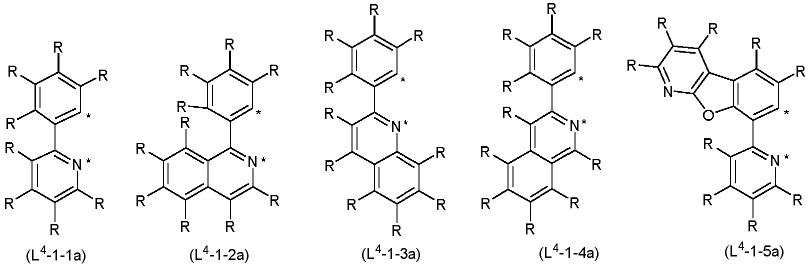 wobei die verwendeten Symbole die oben genannten Bedeutungen aufweisen. Dabei sind bevorzugt maximal drei Substituenten R ungleich H oder **D,** besonders bevorzugt maximal zwei Substituenten R und ganz besonders bevorzugt maximal ein Substituent.

Wenn zwei Reste **R,** von denen einer an CyC und der andere an CyD gebunden sind, miteinander ein aromatisches Ringsystem bilden, können sich überbrückte Liganden und auch Liganden ergeben, die insgesamt eine einzige größere Heteroarylgruppe darstellen. Die Ringbildung zwischen den Substituenten an CyC und CyD erfolgt dabei bevorzugt durch eine Gruppe gemäß einer der Formeln (5) bis (14), wie oben für den Teilliganden L¹ aufgeführt.

Bevorzugte Liganden L⁴, die durch Ringbildung zweier Reste R an den unterschiedlichen Cyclen entstehen, sind die im Folgenden aufgeführten Strukturen der Formeln (L⁴-3) bis (L⁴-16), 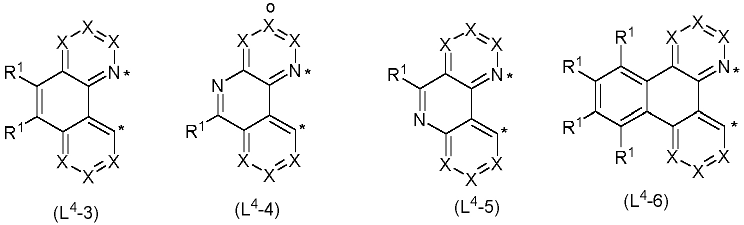 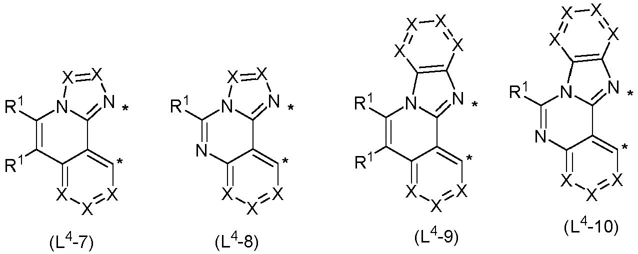 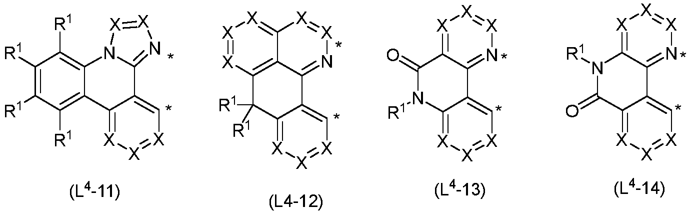 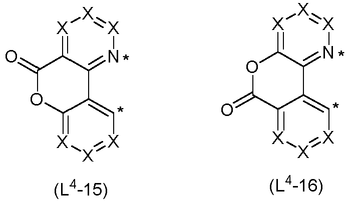 wobei die verwendeten Symbole die oben genannten Bedeutungen aufweisen.

In einer bevorzugten Ausführungsform der Teilliganden der Formeln (L⁴-4) bis (L⁴-16) steht insgesamt ein Symbol X für N und die anderen Symbole X stehen für CR, oder alle Symbole X stehen für CR.

In einer weiteren Ausführungsform der Erfindung ist es bevorzugt, falls in den Gruppen (CyC-1) bis (CyC-20) oder (CyD-1) bis (CyD-14) oder in den Teilliganden (L⁴-4) bis (L⁴-16) eines der Atome X für N steht, wenn benachbart zu diesem Stickstoffatom eine Gruppe R als Substituent gebunden ist, welche ungleich Wasserstoff oder Deuterium ist. Dies gilt analog für die bevorzugten Strukturen (CyC-1a) bis (CyC-20a) oder (CyD-1a) bis (CyD-14b), in denen bevorzugt benachbart zu einem nicht koordinierenden Stickstoffatom eine Gruppe R als Substituent gebunden ist, welche ungleich Wasserstoff oder Deuterium ist. Dabei ist dieser Substituent R bevorzugt eine Gruppe, ausgewählt aus CF₃, OCF₃, Alkylgruppen mit 1 bis 10 C-Atomen, insbesondere verzweigten oder cyclischen Alkylgruppen mit 3 bis 10 C-Atomen, OR¹, wobei R¹ für eine Alkylgruppe mit 1 bis 10 C-Atomen, insbesondere eine verzweigte oder cyclische Alkylgruppe mit 3 bis 10 C-Atomen steht, einer Dialkylaminogruppe mit 2 bis 10 C-Atomen, aromatischen bzw. heteroaromatischen Ringsystemen oder Aralkyl- bzw. Heteroaralkylgruppen. Es handelt sich bei diesen Gruppen um sterisch anspruchsvolle Gruppen. Weiterhin bevorzugt kann dieser Rest R auch mit einem benachbarten Rest R einen Cyclus bilden.

Ein weiterer geeigneter bidentater Ligand L⁴ ist eine Struktur der folgenden Formel (L⁴-17), 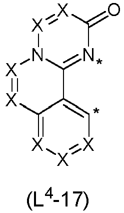 wobei R die oben genannten Bedeutungen aufweist, * die Position der Koordination an das Iridium darstellt und für die weiteren verwendeten Symbole gilt:
X ist bei jedem Auftreten gleich oder verschieden CR oder N mit der Maßgabe, dass maximal ein Symbol X pro Cyclus für N steht.

Bevorzugte Ausführungsformen des Liganden (L⁴-17) können den Anmeldungen WO 2011/044988, WO 2014/094962, WO 2014/094961 und WO 2014/094960 entnommen werden.

In einer weiteren Ausführungsform der Erfindung ist L ein Ligand der folgenden Formel (L⁴-18), der über die beiden mit * gekennzeichneten Positionen an das Iridium koordiniert, 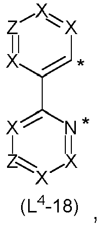 dabei haben die Symbole X, Z, R', R" und n dieselben Bedeutungen, wie oben für den Teilliganden (L¹-39) und (L¹-40) beschrieben.

Bevorzugte Ausführungsformen für den Liganden (L⁴-18) sind dieselben, wie oben für die Teilliganden (L¹-39) und (L¹-40) beschrieben.

Eine bevorzugte Ausführungsform des Liganden (L⁴-18) ist der Ligand der folgenden Formel (L⁴-18a), 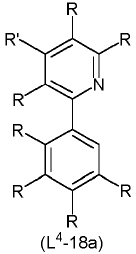 wobei die verwendeten Symbole die oben genannten Bedeutungen aufweisen.

Besonders bevorzugt weist der Ligand der Formel (L⁴-18) eine Struktur gemäß der folgenden Formel (L⁴-18b) auf, 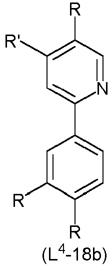 wobei die verwendeten Symbole die oben genannten Bedeutungen aufweisen.

Für bevorzugte Reste R und R' am Liganden der Formel (L⁴-18) bzw. den bevorzugten Ausführungsformen gilt dasselbe, wie oben für die Teilliganden (L¹-39) und (L¹-40) ausgeführt.

Bevorzugte Liganden L⁴ mit ankondensierten Benzogruppen sind die nachfolgend aufgeführten Strukturen Formel (L⁴-18c) bis (L⁴-18h): 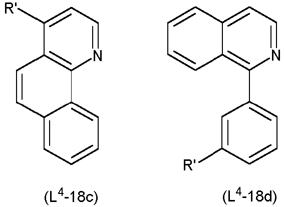 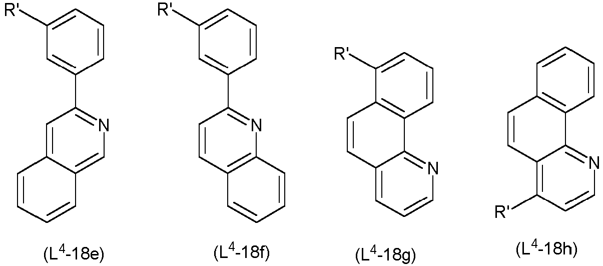 wobei die Liganden jeweils auch durch einen oder mehrere weitere Reste R substituiert sein können und die ankondensierte Struktur durch einen oder mehrere Reste R¹ substituiert sein kann. Bevorzugt sind keine weiteren Reste R oder R¹ vorhanden.

Bevorzugte Liganden L⁴ der Formel (L⁴-18) mit ankondensierten Benzofuran- bzw. Azabenzofurangruppen sind die nachfolgend aufgeführten Strukturen Formel (L⁴-18i) bis (L⁴-18y),: 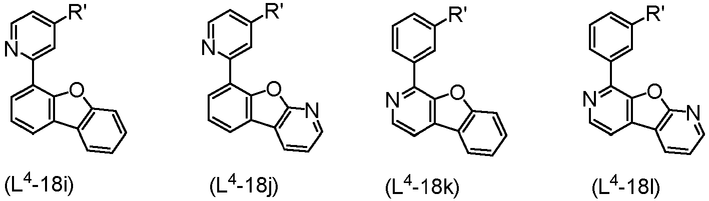 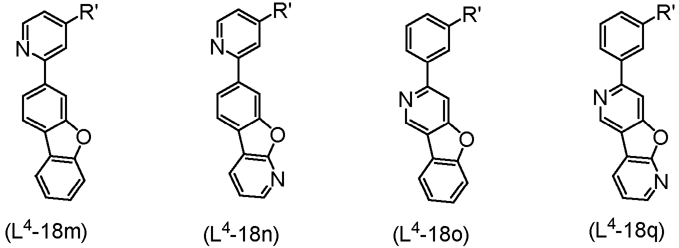 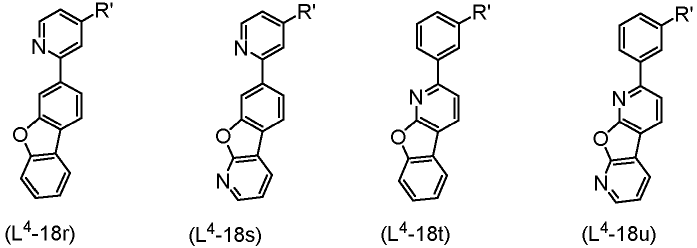 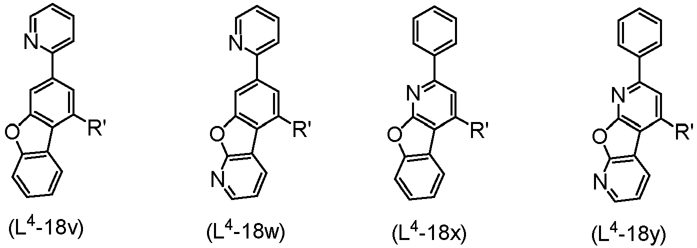 wobei die Liganden jeweils auch durch einen oder mehrere weitere Reste R substituiert sein können und die ankondensierte Struktur durch einen oder mehrere Reste R¹ substituiert sein kann. Bevorzugt sind keine weiteren Reste R oder R¹ vorhanden. Ebenso kann in diesen Strukturen O durch S oder NR¹ ersetzt sein.

Bevorzugte Ausführungsformen des Substituenten R' der Formel (16) oder (17) im Liganden L⁴ entsprechen den oben für (L¹-39) und (L¹-40) beschriebenen bevorzugten Ausführungsformen.

Weitere Ausführungsformen von L⁴ sind die bidentaten dianionischen Liganden (L⁴-19) und (L⁴-20) und die bidentaten monoanionischen Liganden (L⁴-21) bis (L⁴-24), die jeweils über die beiden mit * gekennzeichneten Atome an das Iridium koordinieren, 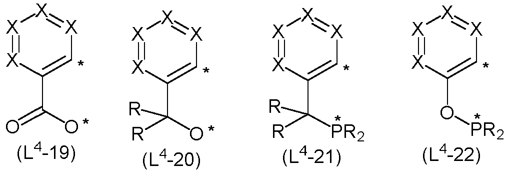 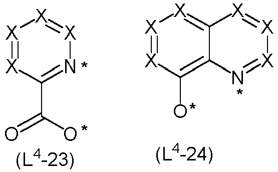 wobei R die oben genannten Bedeutungen aufweist und X gleich oder verschieden bei jedem Auftreten für CR oder N steht mit der Maßgabe, dass nicht mehr als zwei X für N stehen. Bevorzugt steht nicht mehr als ein X für N und besonders bevorzugt stehen alle X gleich oder verschieden bei jedem Auftreten für CR.

Bevorzugt sind die Liganden (L⁴-19a) bis (L⁴-24a), 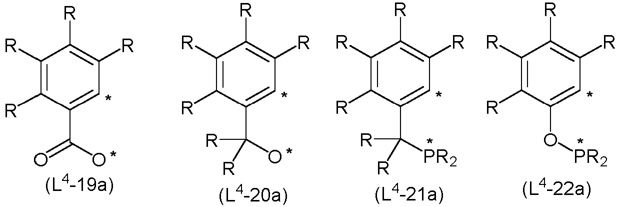 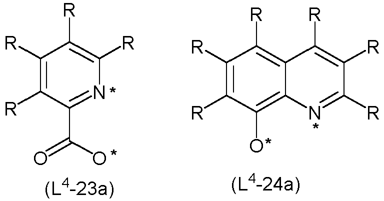 wobei R die oben genannten Bedeutungen aufweist. Dabei sind bevorzugt maximal drei Substituenten R ungleich H oder D, besonders bevorzugt maximal zwei Substituenten R und ganz besonders bevorzugt maximal ein Substituent.

Im Folgenden werden bevorzugte Substituenten beschrieben, wie sie an den oben beschriebenen Teilliganden L¹, L² und/oder L³ bzw. dem oben beschriebenen Liganden L⁴ vorliegen können. Diese Substituenten können auch an der bivalenten Arylen- oder Heteroarylengruppe in den Strukturen der Formel (4) vorliegen.

In einer bevorzugten Ausführungsform der Erfindung enthält der erfindungsgemäße Metallkomplex zwei Substituenten R oder zwei Substituenten R¹, die an benachbarte Kohlenstoffatome gebunden sind und die miteinander einen aliphatischen Ring gemäß einer der nachfolgend beschriebenen Formeln bilden. Dabei können die beiden Substituenten R, die diesen aliphatischen Ring bilden, an der Brücke V bzw. die Brücke der Formel (2) bzw. (3) vorliegen und/oder an dem bidentaten Teilliganden und/oder an einem der monodentaten Teilliganden vorliegen. Der aliphatische Ring, der durch die Ringbildung von zwei Substituenten R miteinander oder von zwei Substituenten R¹ miteinander gebildet wird, wird bevorzugt durch eine der folgenden Formeln (18) bis (24) beschrieben, 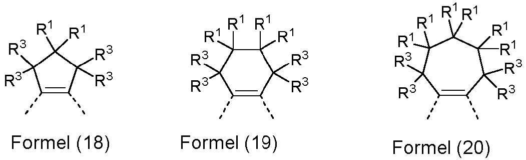 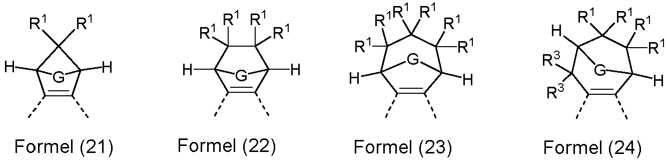 wobei R¹ und R² die oben genannten Bedeutungen aufweisen, die gestrichelten Bindungen die Verknüpfung der beiden Kohlenstoffatome im Liganden andeuten und weiterhin gilt:
- G: ist eine Alkylengruppe mit 1, 2 oder 3 C-Atomen, welche mit einem oder mehreren Resten R² substituiert sein kann, -CR²=CR²- oder eine ortho-verknüpfte Arylen- oder Heteroarylengruppe mit 5 bis 14 aromatischen Ringatomen, welche durch einen oder mehrere Reste R² substituiert sein kann;
- R³: ist gleich oder verschieden bei jedem Auftreten H, F, eine geradkettige Alkyl- oder Alkoxygruppe mit 1 bis 10 C-Atomen, eine verzweigte oder cyclische Alkyl- oder Alkoxygruppe mit 3 bis 10 C-Atomen, wobei die Alkyl- oder Alkoxygruppe jeweils mit einem oder mehreren Resten R² substituiert sein kann, wobei eine oder mehrere nicht benachbarte CH₂-Gruppen durch R²C=CR², C=C, Si(R²)₂, C=O, NR², O, S oder CONR² ersetzt sein können, oder ein aromatisches oder heteroaromatisches Ringsystem mit 5 bis 24 aromatischen Ringatomen, das jeweils durch einen oder mehrere Reste R² substituiert sein kann, oder eine Aryloxy- oder Heteroaryloxygruppe mit 5 bis 24 aromatischen Ringatomen, die durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

Wenn benachbarte Reste in den erfindungsgemäßen Strukturen ein aliphatisches Ringsystem bilden, dann ist es bevorzugt, wenn dieses keine aziden benzylischen Protonen aufweist. Unter benzylischen Protonen werden Protonen verstanden, die an ein Kohlenstoffatom binden, welches direkt an den Liganden gebunden sind. Dies kann dadurch erreicht werden, dass die Kohlenstoffatome des aliphatischen Ringsystems, die direkt an eine Aryl- oder Heteroarylgruppe binden, vollständig substituiert sind und keine Wasserstoffatome gebunden enthalten. So wird die Abwesenheit von aziden benzylischen Protonen in den Formeln (18) bis (24) dadurch erreicht, dass R³ ungleich Wasserstoff ist. Dies kann weiterhin auch dadurch erreicht werden, dass die Kohlenstoffatome des aliphatischen Ringsystems, die direkt an eine Aryl- oder Heteroarylgruppe binden, die Brückenköpfe einer bi- oder polycyclischen Struktur sind. Die an Brückenkopfkohlenstoffatome gebundenen Protonen sind aufgrund der räumlichen Struktur des Bi- oder Polycyclus wesentlich weniger azide als benzylische Protonen an Kohlenstoffatomen, die nicht in einer bi- oder polycyclischen Struktur gebunden sind, und werden im Sinne der vorliegenden Erfindung als nicht-azide Protonen angesehen. So wird die Abwesenheit von aziden benzylischen Protonen ist in Formeln (21) bis (24) dadurch erreicht, dass es sich dabei um eine bicyclische Struktur handelt, wodurch R¹, wenn es für H steht, deutlich weniger azide als benzylische Protonen, da das korrespondierende Anion der bicyclischen Struktur nicht mesomeriestabilisiert ist. Auch wenn R¹ in Formeln (21) bis (24) für H steht, handelt es sich dabei daher um ein nicht-azides Proton im Sinne der vorliegenden Anmeldung. In einer bevorzugten Ausführungsform der Erfindung ist R³ ungleich H.

Bevorzugte Ausführungsformen der Gruppen der Formeln (18) bis (24) können den Anmeldungen WO 2014/023377, WO 2015/104045 und WO 2015/117718 entnommen werden.

Wenn die erfindungsgemäßen Verbindungen Reste R aufweisen, die nicht den oben beschriebenen Resten R entsprechen, so sind diese Reste R bei jedem Auftreten gleich oder verschieden bevorzugt ausgewählt aus der Gruppe bestehend aus H, D, F, Br, I, N(R¹)₂, CN, Si(R¹)₃, B(OR¹)₂, C(=O)R', einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, wobei die Alkyl oder Alkenylgruppe jeweils mit einem oder mehreren Resten R¹ substituiert sein kann, oder einem aromatischen oder heteroaromatischen Ringsystem mit 5 bis 30 aromatischen Ringatomen, das jeweils durch einen oder mehrere Reste R¹ substituiert sein kann; dabei können zwei benachbarte Rest R oder R mit R¹ auch miteinander ein mono- oder polycyclisches, aliphatisches oder aromatisches Ringsystem bilden. Besonders bevorzugt sind diese Reste R bei jedem Auftreten gleich oder verschieden ausgewählt aus der Gruppe bestehend aus H, D, F, N(R¹)₂, einer geradkettigen Alkylgruppe mit 1 bis 6 C-Atomen oder einer verzweigten oder cyclischen Alkylgruppe mit 3 bis 10 C-Atomen, wobei ein oder mehrere H-Atome durch D oder F ersetzt sein können, oder einem aromatischen oder heteroaromatischen Ringsystem mit 5 bis 24 aromatischen Ringatomen, das jeweils durch einen oder mehrere Reste R¹ substituiert sein kann; dabei können zwei benachbarte Reste R oder R mit R¹ auch miteinander ein mono- oder polycyclisches, aliphatisches oder aromatisches Ringsystem bilden.

Bevorzugte Reste R¹, die an R gebunden sind, sind bei jedem Auftreten gleich oder verschieden H, D, F, N(R²)₂, CN, eine geradkettige Alkylgruppe mit 1 bis 10 C-Atomen oder eine Alkenylgruppe mit 2 bis 10 C-Atomen oder eine verzweigte oder cyclische Alkylgruppe mit 3 bis 10 C-Atomen, wobei die Alkylgruppe jeweils mit einem oder mehreren Resten R² substituiert sein kann, oder ein aromatisches oder heteroaromatisches Ringsystem mit 5 bis 24 aromatischen Ringatomen, das jeweils durch einen oder mehrere Reste R² substituiert sein kann; dabei können zwei oder mehrere benachbarte Reste R¹ miteinander ein mono- oder polycyclisches, aliphatisches Ringsystem bilden. Besonders bevorzugte Reste R¹, die an R gebunden sind, sind bei jedem Auftreten gleich oder verschieden H, F, CN, eine geradkettige Alkylgruppe mit 1 bis 5 C-Atomen oder eine verzweigte oder cyclische Alkylgruppe mit 3 bis 5 C-Atomen, die jeweils mit einem oder mehreren Resten R² substituiert sein kann, oder ein aromatisches oder heteroaromatisches Ringsystem mit 5 bis 13 aromatischen Ringatomen, das jeweils durch einen oder mehrere Reste R² substituiert sein kann; dabei können zwei oder mehrere benachbarte Reste R¹ miteinander ein mono- oder polycyclisches, aliphatisches Ringsystem bilden.

Bevorzugte Reste R² sind bei jedem Auftreten gleich oder verschieden **H,** F oder ein aliphatischer Kohlenwasserstoffrest mit 1 bis 5 C-Atomen oder ein aromatischer Kohlenwasserstoffrest mit 6 bis 12 C-Atomen; dabei können zwei oder mehrere Substituenten R² auch miteinander ein mono- oder polycyclisches, aliphatisches Ringsystem bilden.

Die oben genannten bevorzugten Ausführungsformen sind beliebig miteinander kombinierbar. **In** einer besonders bevorzugten Ausführungsform der Erfindung gelten die oben genannten bevorzugten Ausführungsformen gleichzeitig.

Beispiele für geeignete erfindungsgemäße Strukturen sind die nachfolgend abgebildeten Verbindungen.

| | |
|---|---|
| 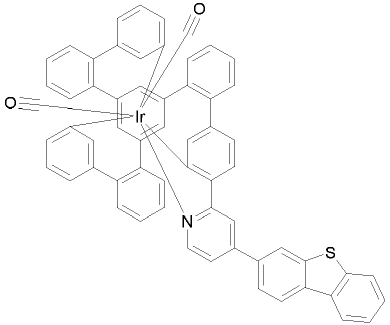 | 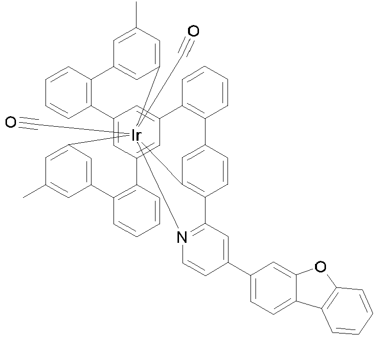 |
| 1 | 2 |
| 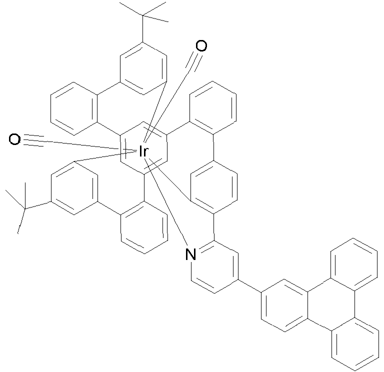 | 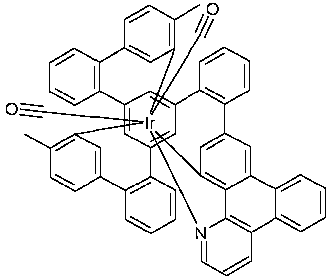 |
| 3 | 4 |
| 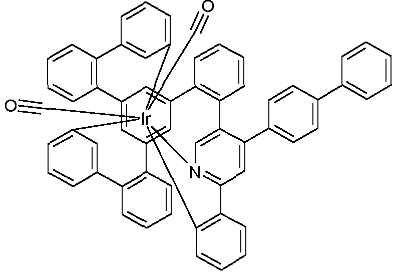 | 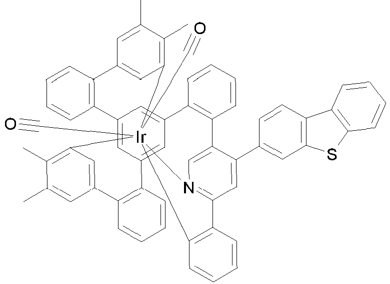 |
| 5 | 6 |
| 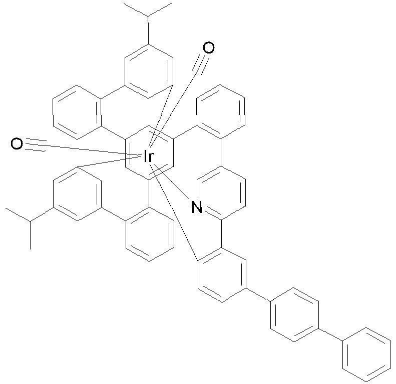 | 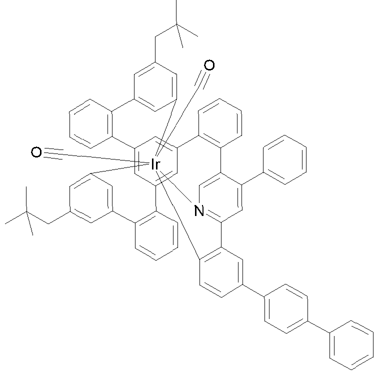 |
| 7 | 8 |
| 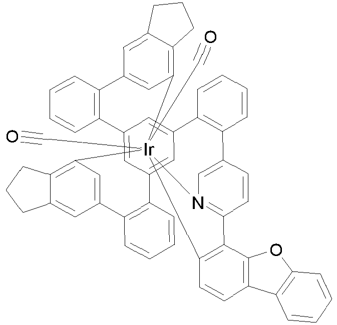 | 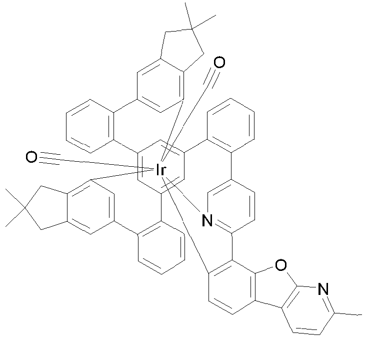 |
| 9 | 10 |
| 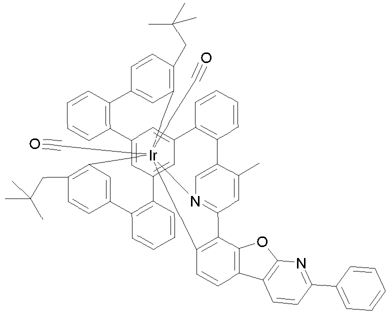 | 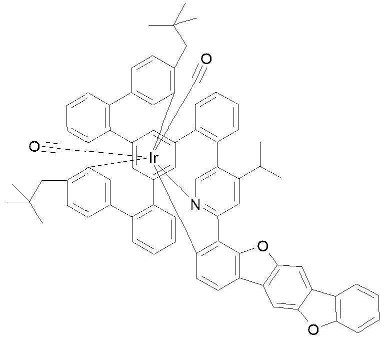 |
| 11 | 12 |
| 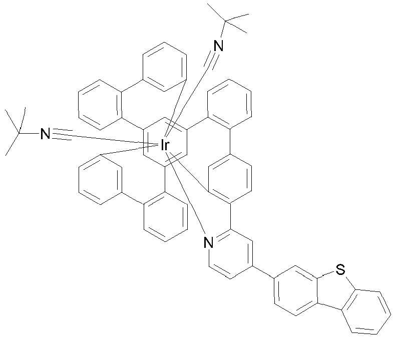 | 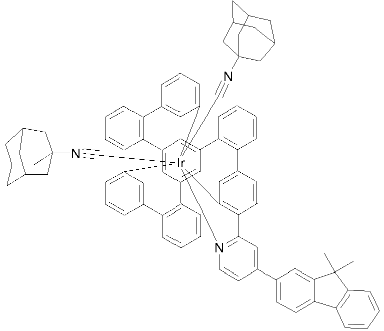 |
| 13 | 14 |
| 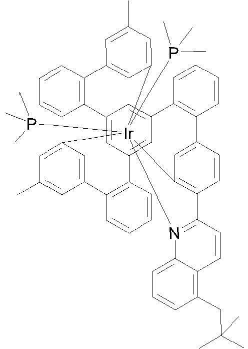 | 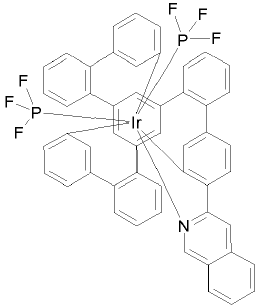 |
| 15 | 16 |
| 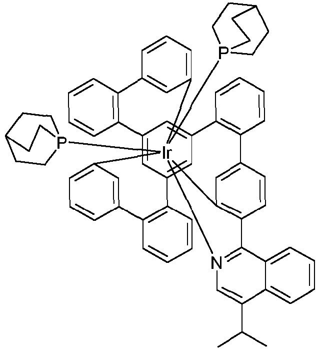 | 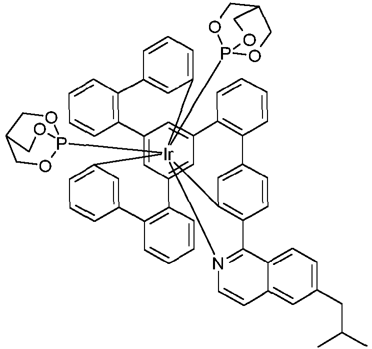 |
| 17 | 18 |
| 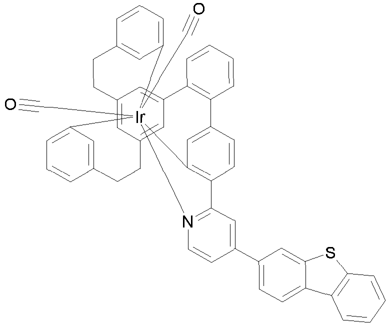 | 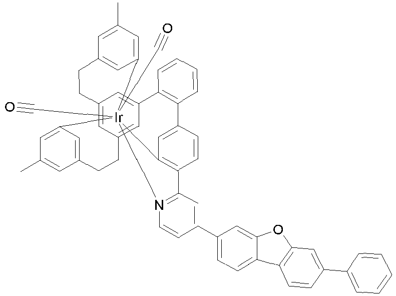 |
| 19 | 20 |
| 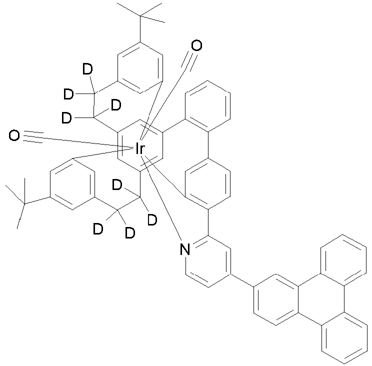 | 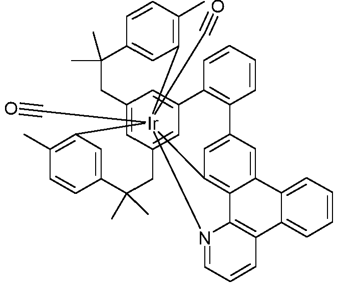 |
| 21 | 22 |
| 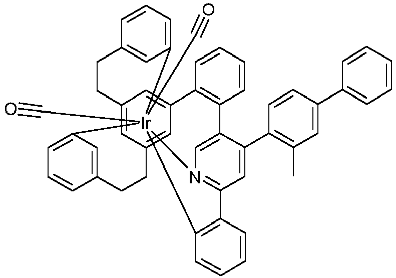 | 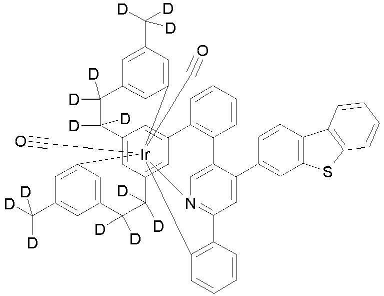 |
| 23 | 24 |
| 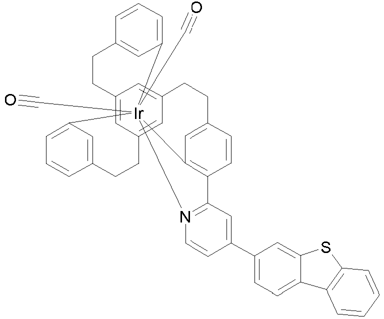 | 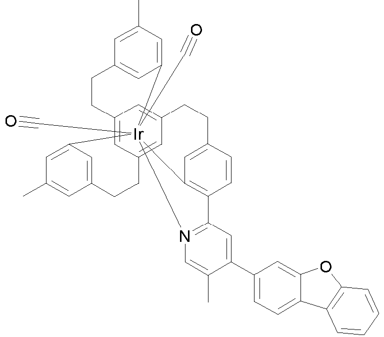 |
| 25 | 26 |
| 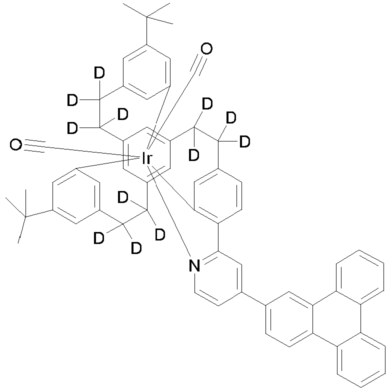 | 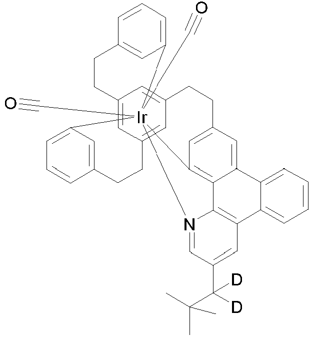 |
| 27 | 28 |
| 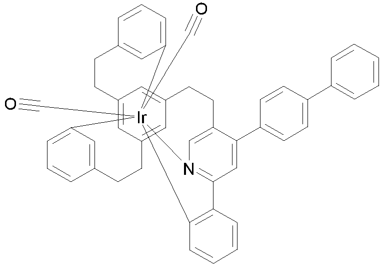 | 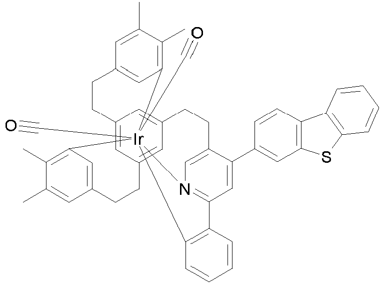 |
| 29 | 30 |
| 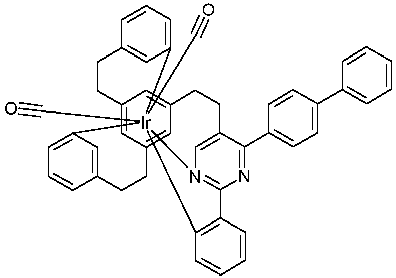 | 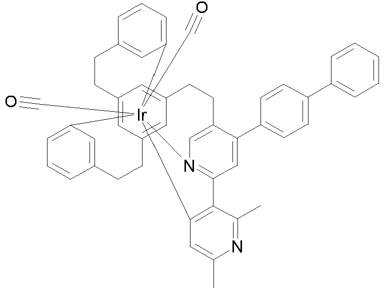 |
| 31 | 32 |
| 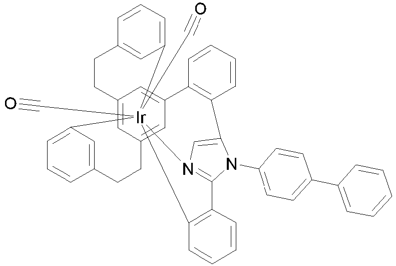 | 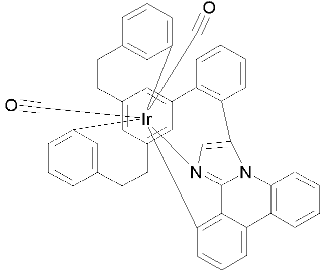 |
| 33 | 34 |
| 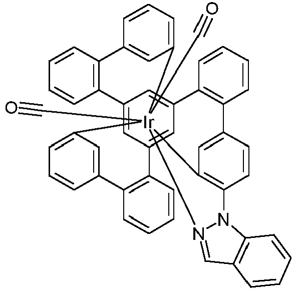 | 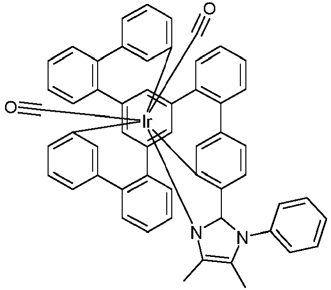 |
| 35 | 36 |
| 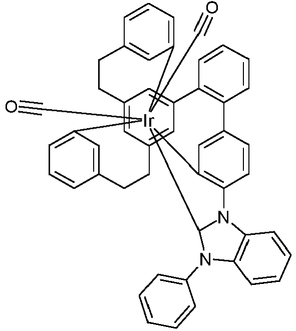 | 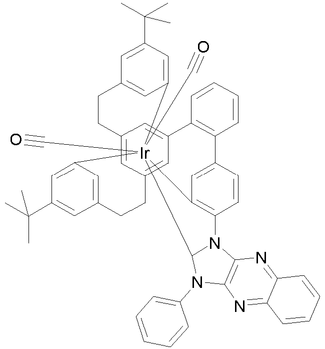 |
| 37 | 38 |
| 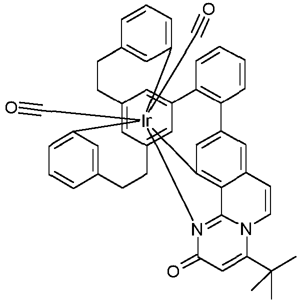 | 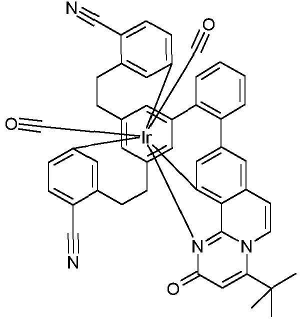 |
| 39 | 40 |
| 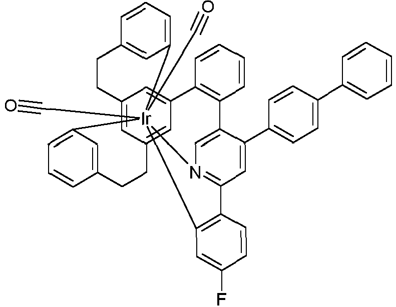 | 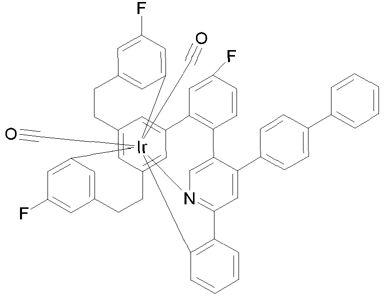 |
| 41 | 42 |
| 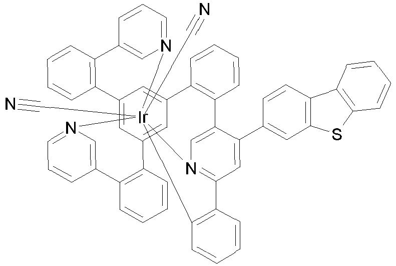 | 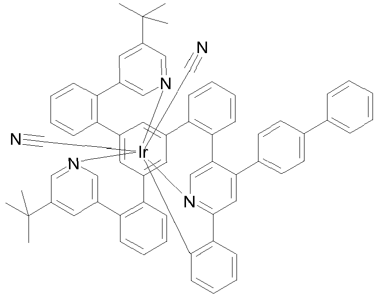 |
| 43 | 44 |
| 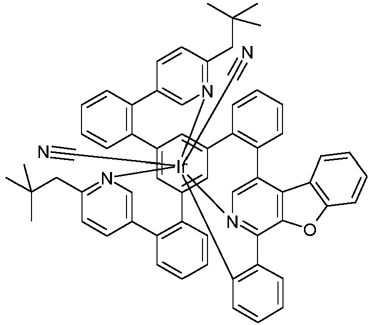 | 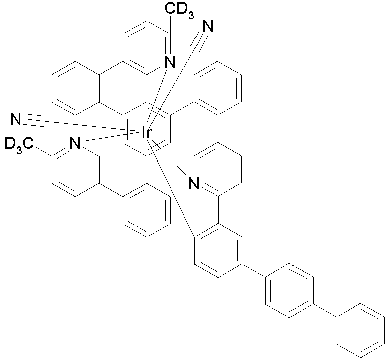 |
| 45 | 46 |
| 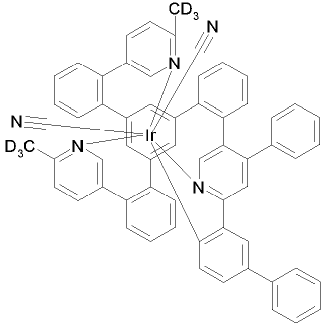 | 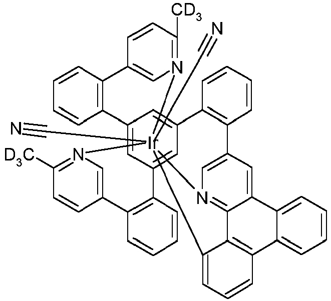 |
| 47 | 48 |
| 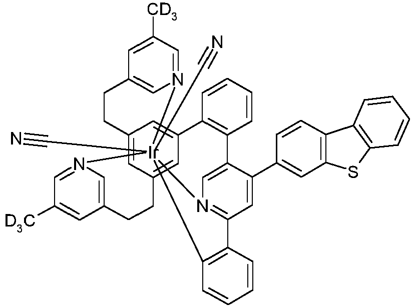 | 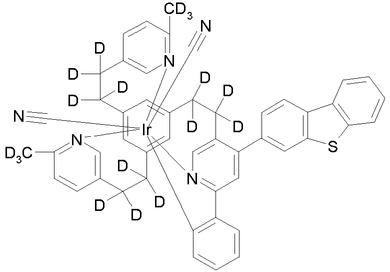 |
| 49 | 50 |
| 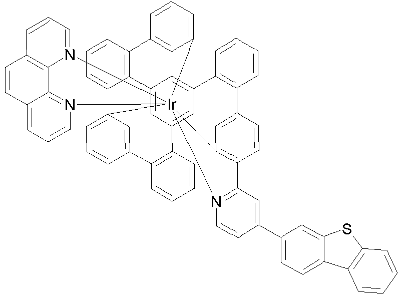 | 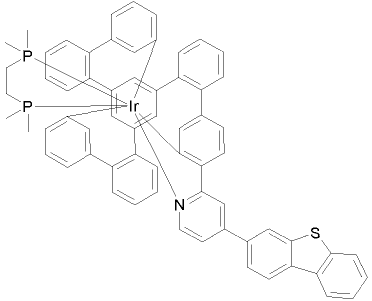 |
| 51 | 52 |
| 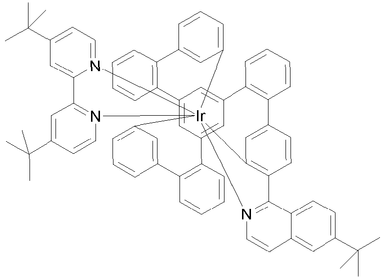 | 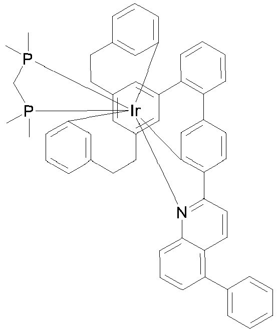 |
| 53 | 54 |
| 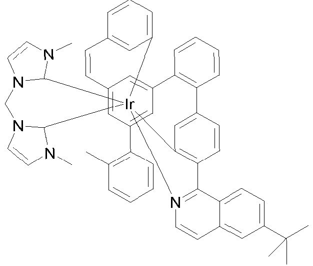 | 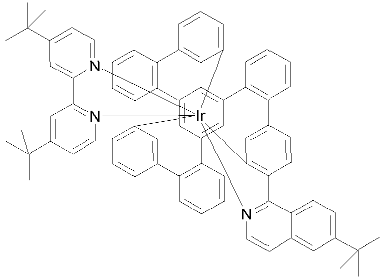 |
| 55 | 56 |
| 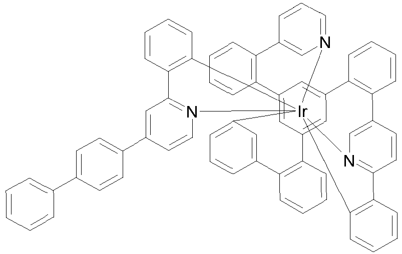 | 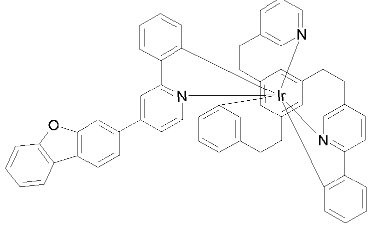 |
| 57 | 58 |
| 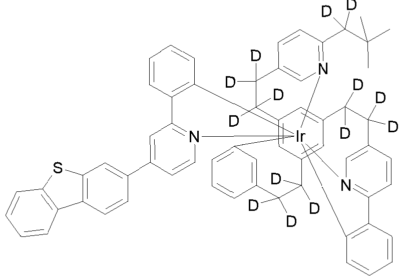 | 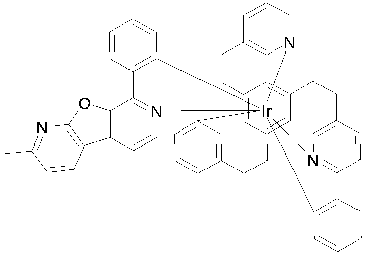 |
| 59 | 60 |
| 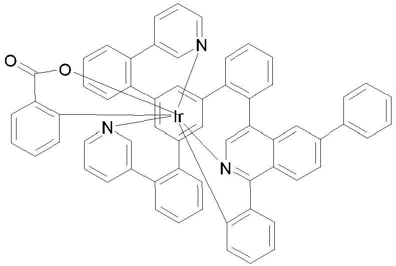 | 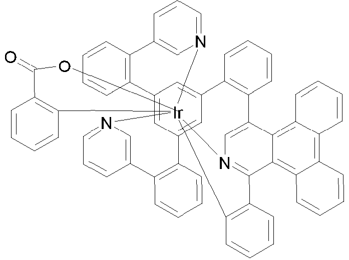 |
| 61 | 62 |
| 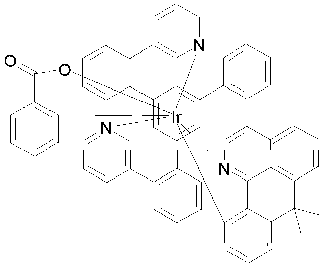 | 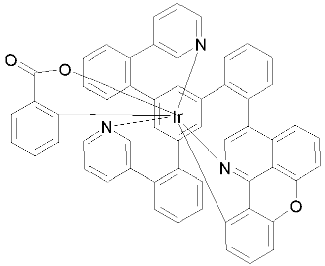 |
| 63 | 64 |
| 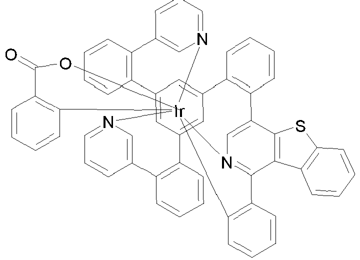 | 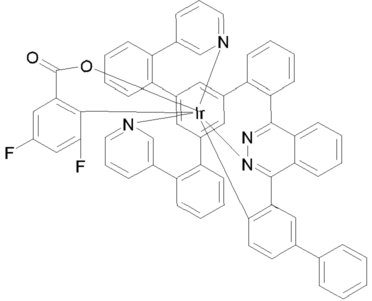 |
| 65 | 66 |
| 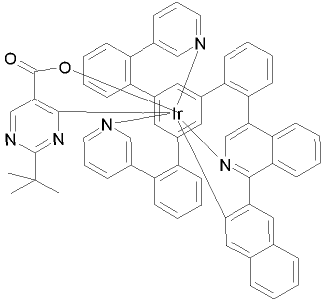 | 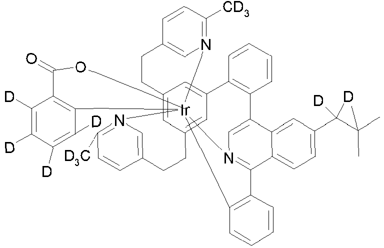 |
| 67 | 68 |
| 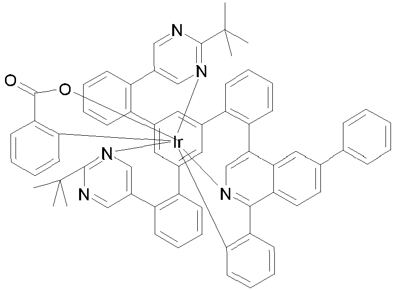 | 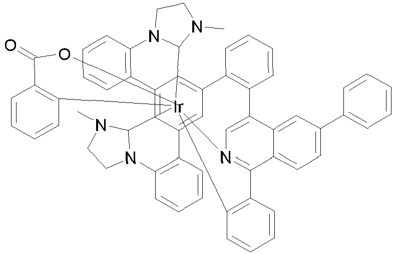 |
| 69 | 79 |
| 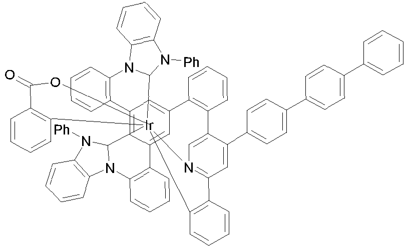 | 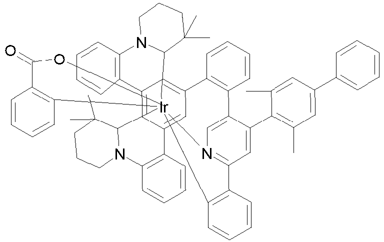 |
| 71 | 72 |
| 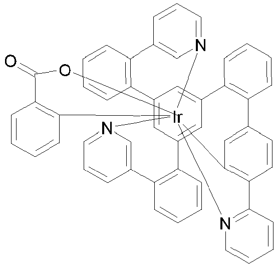 | 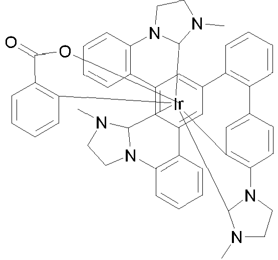 |
| 73 | 74 |
| 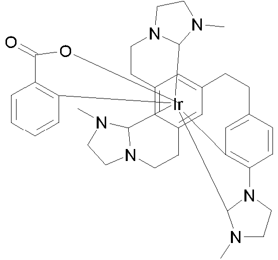 | 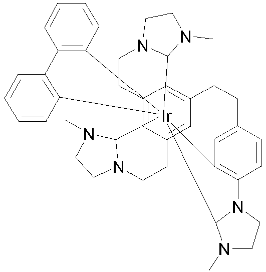 |
| 75 | 76 |
| 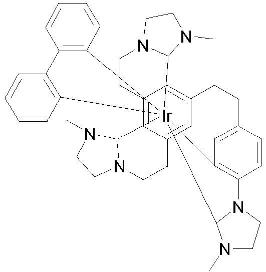 | 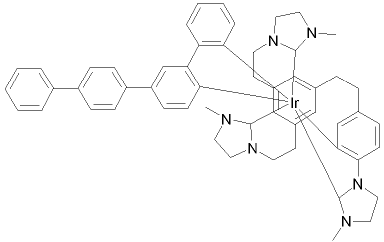 |
| 77 | 78 |
| 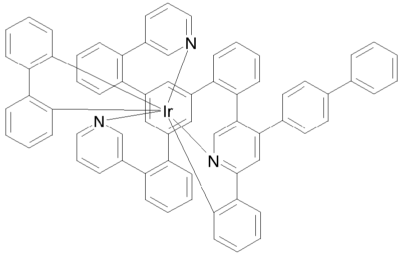 | 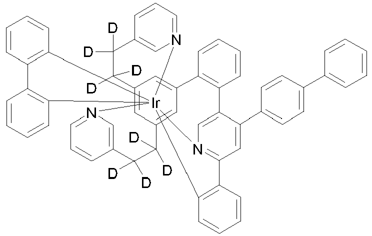 |
| 79 | 80 |
| 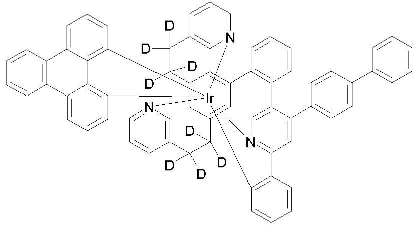 | 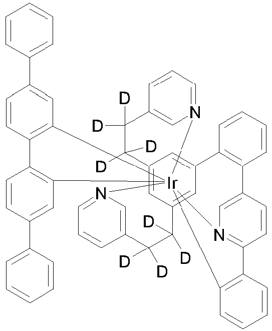 |
| 81 | 82 |

Die erfindungsgemäßen Verbindungen sind prinzipiell durch verschiedene Verfahren darstellbar. Generell wird hierzu eine Iridiumverbindung in einem ersten Schritt mit dem entsprechenden freien tetradentaten Liganden umgesetzt. Das so erhaltene Intermediat wir dann mit den einzähnigen bzw. dem zweizähigen Liganden zum Produkt umgesetzt. Dies ist nachfolgend am Beispiel eines einfachen tetradentaten Liganden mit einem monoanionischen Teilliganden L¹ und zwei neutralen Teilliganden L² und L³ in Kombination mit zwei monoanionischen Liganden L⁴ bzw. einem dianionischen Liganden L⁴ dargestellt.

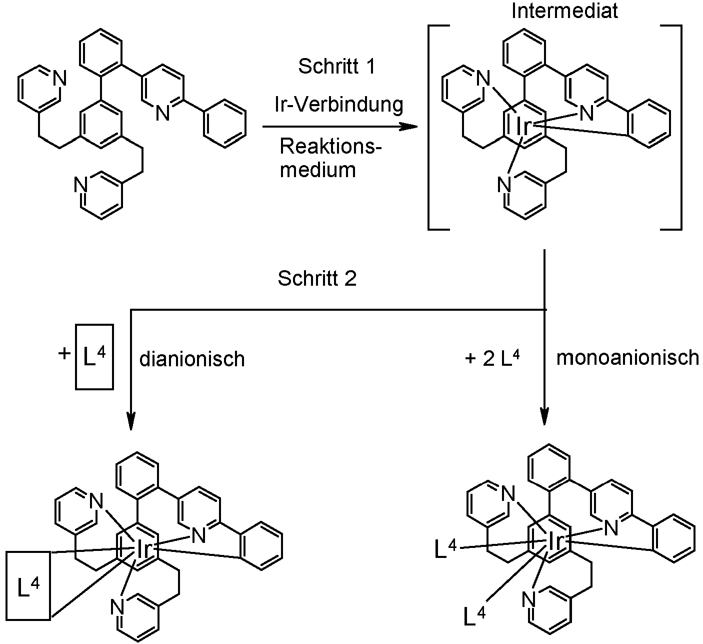

Daher ist ein weiterer Gegenstand der vorliegenden Erfindung ein Verfahren zur Herstellung der erfindungsgemäßen Verbindungen durch Umsetzung der entsprechenden freien tetradentaten Liganden mit Iridiumalkoholaten der Formel (25), mit Iridiumketoketonaten der Formel (26), mit Iridiumhalogeniden der Formel (27), mit Iridiumcarboxylaten der Formel (28), Iridium-Olefin-Cyclopentadienyl-Komplexen der Formel (29) oder mit Iridium-Olefin-Indenyl-Komplexen der Formel (30), 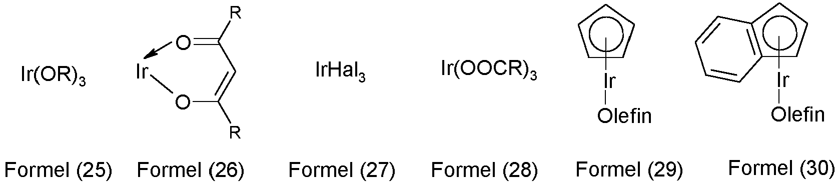 und anschließende Umsetzung des so erhaltenen Intermediats mit dem bzw. den Liganden L⁴. Dabei hat R die oben angegebenen Bedeutungen, Hal = F, Cl, Br oder I und die Iridiumedukte können auch als die entsprechenden Hydrate vorliegen. R steht bevorzugt für eine Alkylgruppe mit 1 bis 4 C-Atomen. Olefin in Formel (29) und (30) steht für ein Diolefin, typischerweise für 1,5-Cyclooctadien, aber auch andere Diolefine wie Cyclohexadien oder Norbornadien.

Es können ebenfalls Iridiumverbindungen, die sowohl Alkoholat- und/oder Halogenid- und/oder Hydroxy- wie auch Ketoketonatreste tragen, verwendet werden. Diese Verbindungen können auch geladen sein. Entsprechende Iridiumverbindungen, die als Edukte besonders geeignet sind, sind in WO 2004/085449 offenbart. Besonders geeignet sind [IrCl₂(acac)₂]⁻, beispielsweise Na[IrCl₂(acac)₂], Metallkomplexe mit Acetylacetonat-Derivaten als Ligand, beispielsweise Ir(acac)₃ oder Tris(2,2,6,6-Tetramethylheptan-3,5-dionato)iridium, und IrCl₃·xH₂O, wobei x üblicherweise für eine Zahl zwischen 2 und 4 steht.

Die Synthese der Komplexe wird bevorzugt durchgeführt wie in WO 2002/060910 und in WO 2004/085449 beschrieben. Dabei kann die Synthese beispielsweise auch thermisch, photochemisch und/oder durch Mikrowellenstrahlung aktiviert werden. Weiterhin kann die Synthese auch im Autoklaven bei erhöhtem Druck und/oder erhöhter Temperatur durchgeführt werden.

Die Reaktionen können ohne Zusatz von Lösemitteln oder Schmelzhilfen in einer Schmelze der entsprechenden zu ortho-metallierenden Liganden durchgeführt werden. Gegebenenfalls können auch Lösemittel oder Schmelzhilfen zugesetzt werden. Geeignete Lösemittel sind protische oder aprotische Lösemittel, wie aliphatische und/oder aromatische Alkohole (Methanol, Ethanol, iso-Propanol, t-Butanol, etc.), Oligo- und Polyalkohole (Ethylenglykol, 1,2-Propandiol, Glycerin, etc.), Alkoholether (Ethoxyethanol, Diethylenglykol, Triethylenglycol, Polyethylenglykol, etc.), Ether (Di- und Triethylenglykoldimethylether, Diphenylether, etc.), aromatische, heteroaromatische und oder aliphatische Kohlenwasserstoffe (Toluol, Xylol, Mesitylen, Chlorbenzol, Pyridin, Lutidin, Chinolin, Isochinolin, Tridecan, Hexadecan, etc.), Amide (DMF, DMAC, etc.), Lactame (NMP), Sulfoxide (DMSO) oder Sulfone (Dimethylsulfon, Sulfolan, etc.). Geeignete Schmelzhilfen sind Verbindungen, die bei Raumtemperatur fest vorliegen, jedoch beim Erwärmen der Reaktionsmischung schmelzen und die Reaktanden lösen, so dass eine homogene Schmelze entsteht. Besonders geeignet sind Biphenyl, m-Terphenyl, Triphenylen, R- oder S-Binaphthol oder auch das entsprechende Racemat, 1,2-, 1,3- oder 1,4-Bisphenoxybenzol, Triphenylphosphinoxid, 18-Krone-6, Phenol, 1-Naphthol, Hydrochinon, Brenzcatechin, Resorcin, etc.. Dabei ist die Verwendung von Hydrochinon besonders bevorzugt.

Weiterhin kann die Synthese bevorzugt in wasserfreiem Medium in Anwesenheit einer Carbonsäure durchgeführt werden, wie in der noch nicht offen gelegten Anmeldung EP19187468.4 beschrieben, wobei als Iridiumedukt bevorzugt ein Iridiumhalogenid, ein Iridiumcarboxylat, eine COD-Iridium(I)-Verbindung, ein Iridium-ketoketonat oder eine Verbindung gemäß einer der oben genannten Formeln (25) bis (30) verwendet wird. Besonders geeignete Carbonsäuren sind gewählt aus der Gruppe bestehend aus Essigsäure, Propionsäure, Pivalinsäure, Benzoesäure, Phenylessigsäure, Adipinsäure oder deren Gemischen. Bei Verwendung eines Hydrats als Iridiumedukt wird bevorzugt ein Wasserfänger zugesetzt, insbesondere ein Carbonsäureanhydrid, ein Carbonsäurehalogenid, ein Trialkyl-ortho-carboxylat, ein Carbodiimid, Phosphorpentoxid, Thionylchlorid oder Phosphorylchlorid. Bei Verwendung eines Halogenids als Iridiumedukt wird bevorzugt ein Halogenidfänger zugesetzt wird, insbesondere ein Alkali-, Erdalkali-, Ammonium- oder Zinksalz einer Carbonsäure.

Werden in der ortho-Metallierung Liganden mit zwei identischen Teilliganden L² und L³ eingesetzt, fällt üblicherweise ein racemisches Gemisch der C₁-symmetrischen Komplexe, also des Δ- und des A-Enantiomers, an. Diese können durch gängige Methoden (Chromatographie an chiralen Materialien / Säulen oder Racemattrennung durch Kristallisation) getrennt werden.

Werden in der Komplexierung Liganden mit unterschiedlichen Teilliganden L² und L³ eingesetzt, fällt üblicherweise ein Diastereomerengemisch der Komplexe an, das durch gängige Methoden (Chromatographie, Kristallisation, etc.) getrennt werden kann.

Durch diese Verfahren, gegebenenfalls gefolgt von Aufreinigung, wie z. B. Umkristallisation oder Sublimation, lassen sich die erfindungsgemäßen Verbindungen gemäß Formel (1) in hoher Reinheit, bevorzugt mehr als 99 % (bestimmt mittels ¹H-NMR und/oder HPLC) erhalten.

Die erfindungsgemäßen Verbindungen können auch durch geeignete Substitution, beispielsweise durch längere Alkylgruppen (ca. 4 bis 20 C-Atome), insbesondere verzweigte Alkylgruppen, oder gegebenenfalls substituierte Arylgruppen, beispielsweise Xylyl-, Mesityl- oder verzweigte Terphenyl- oder Quaterphenylgruppen, löslich gemacht werden. Insbesondere auch die Verwendung von ankondensierten aliphatischen Gruppen, wie sie beispielsweise durch die oben offenbarten Formeln (44) bis (50) dargestellt werden, führt zu einer deutlichen Verbesserung der Löslichkeit der Metallkomplexe. Solche Verbindungen sind dann in gängigen organischen Lösemitteln, wie beispielsweise Toluol oder Xylol bei Raumtemperatur in ausreichender Konzentration löslich, um die Komplexe aus Lösung verarbeiten zu können. Diese löslichen Verbindungen eignen sich besonders gut für die Verarbeitung aus Lösung, beispielsweise durch Druckverfahren.

Für die Verarbeitung der erfindungsgemäßen Iridiumkomplexe aus flüssiger Phase, beispielsweise durch Spin-Coating oder durch Druckverfahren, sind Formulierungen der erfindungsgemäßen Iridiumkomplexe erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden. Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropylenglycoldimethylether, Tetraethylenglycoldimethylether, 2-Isopropylnaphthalin, Pentylbenzol, Hexylbenzol, Heptylbenzol, Octylbenzol, 1,1-Bis(3,4-dimethylphenyl)ethan, Hexamethylindan, 2-Methylbiphenyl, 3-Methylbiphenyl, 1-Methylnaphthalin, 1-Ethylnaphthalin, Ethyloctanoat, Sebacinsäure-diethylester, Octyloctanoat, Heptylbenzol, Menthyl-isovalerat, Cyclohexylhexanoat oder Mischungen dieser Lösemittel.

Ein weiterer Gegenstand der vorliegenden Erfindung ist daher eine Formulierung, enthaltend mindestens eine erfindungsgemäßen Verbindung und mindestens eine weitere Verbindung. Die weitere Verbindung kann beispielsweise ein Lösemittel sein, insbesondere eines der oben genannten Lösemittel oder eine Mischung dieser Lösemittel. Die weitere Verbindung kann aber auch eine weitere organische oder anorganische Verbindung sein, die ebenfalls in der elektronischen Vorrichtung eingesetzt wird, beispielsweise ein Matrixmaterial. Diese weitere Verbindung kann auch polymer sein.

Die erfindungsgemäße Verbindung kann in der elektronischen Vorrichtung als aktive Komponente, bevorzugt als Emitter in der emissiven Schicht oder als Loch- oder Elektronentransportmaterial in einer loch- bzw. elektronentransportierenden Schicht, oder als Sauerstoff-Sensibilisatoren oder als Photoinitiator oder Photokatalysator verwendet werden. Ein weiterer Gegenstand der vorliegenden Erfindung ist somit die Verwendung einer erfindungsgemäßen Verbindung in einer elektronischen Vorrichtung oder als Sauerstoff-Sensibilisator oder als Photoinitiator oder Photokatalysator. Enantiomerenreine erfindungsgemäße Iridiumkomplexe eignen sich als Photokatalysatoren für chirale photoinduzierte Synthesen.

Nochmals ein weiterer Gegenstand der vorliegenden Erfindung ist eine elektronische Vorrichtung enthaltend mindestens eine erfindungsgemäße Verbindung.

Unter einer elektronischen Vorrichtung wird eine Vorrichtung verstanden, welche Anode, Kathode und mindestens eine Schicht enthält, wobei diese Schicht mindestens eine organische bzw. metallorganische Verbindung enthält. Die erfindungsgemäße elektronische Vorrichtung enthält also Anode, Kathode und mindestens eine Schicht, welche mindestens einen erfindungsgemäßen Iridiumkomplex enthält. Dabei sind bevorzugte elektronische Vorrichtungen ausgewählt aus der Gruppe bestehend aus organischen Elektrolumineszenzvorrichtungen (OLEDs, PLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), wobei hierunter sowohl rein organische Solarzellen wie auch farbstoffsensibilisierte Solarzellen verstanden werden, organischen optischen Detektoren, organischen Photorezeptoren, organischen Feld-Quench-Devices (O-FQDs), lichtemittierenden elektrochemischen Zellen (LECs), Sauerstoff-Sensoren oder organischen Laserdioden (O-Laser), enthaltend in mindestens einer Schicht mindestens eine erfindungsgemäße Verbindung. Verbindungen, die im Infraroten emittieren, eignen sich für den Einsatz in organischen Infrarot-Elektrolumineszenzvorrichtungen und Infrorot-Sensoren. Besonders bevorzugt sind organische Elektrolumineszenzvorrichtungen. Aktive Komponenten sind generell die organischen oder anorganischen Materialien, welche zwischen Anode und Kathode eingebracht sind, beispielsweise Ladungsinjektions-, Ladungstransport- oder Ladungsblockiermaterialien, insbesondere aber Emissionsmaterialien und Matrixmaterialien. Die erfindungsgemäßen Verbindungen zeigen besonders gute Eigenschaften als Emissionsmaterial in organischen Elektrolumineszenzvorrichtungen. Eine bevorzugte Ausführungsform der Erfindung sind daher organische Elektrolumineszenzvorrichtungen. Weiterhin können die erfindungsgemäßen Verbindungen zur Erzeugung von Singulett-Sauerstoff oder in der Photokatalyse eingesetzt werden.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten und/oder organische oder anorganische p/n-Übergänge. Dabei ist es möglich, dass eine oder mehrere Lochtransportschichten p-dotiert sind, beispielsweise mit Metalloxiden, wie MoO₃ oder WO₃, oder mit (per)fluorierten elektronenarmen Aromaten oder mit elektronenarmen Cyano-substituieren Heteroaromaten (z. B. gemäß JP 4747558, JP 2006-135145, US 2006/0289882, WO 2012/095143), oder mit chinoiden Systemen (z. B. gemäß EP1336208) oder mit LewisSäuren, oder mit Boranen (z. B. gemäß US 2003/0006411, WO 2002/051850, WO 2015/049030) oder mit Carboxylaten der Elemente der 3. , 4. oder 5. Hauptgruppe (WO 2015/018539) und/oder dass eine oder mehrere Elektronentransportschichten n-dotiert sind.

Ebenso können zwischen zwei emittierende Schichten Interlayers eingebracht sein, welche beispielsweise eine Exzitonen-blockierende Funktion aufweisen und/oder die Ladungsbalance in der Elektrolumineszenzvorrichtung steuern und/oder Ladungen erzeugen (Charge-Generation-Layer, z. B. in Schichtsystemen mit mehreren emittierenden Schichten, z. B. in weiß emittierenden OLED-Bauteilen) . Es sei aber darauf hingewiesen, dass nicht notwendigerweise jede dieser Schichten vorhanden sein muss.

Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen (für den prinzipiellen Aufbau siehe z. B. WO 2005/011013) bzw. Systeme, welche mehr als drei emittierende Schichten aufweisen. Es kann sich auch um ein Hybrid-System handeln, wobei eine oder mehrere Schichten fluoreszieren und eine oder mehrere andere Schichten phosphoreszieren. Eine bevorzugte Ausführungsform sind Tandem-OLEDs. Weiß emittierende organische Elektrolumineszenzvorrichtungen können für Beleuchtungsanwendungen oder mit Farbfilter auch für Vollfarb-Displays verwendet werden.

In einer bevorzugten Ausführungsform der Erfindung enthält die organische Elektrolumineszenzvorrichtung den erfindungsgemäßen Iridiumkomplex als emittierende Verbindung in einer oder mehreren emittierenden Schichten.

Wenn der erfindungsgemäße Iridiumkomplex als emittierende Verbindung in einer emittierenden Schicht eingesetzt wird, wird er bevorzugt in Kombination mit einem oder mehreren Matrixmaterialien eingesetzt. Die Mischung aus dem erfindungsgemäßen Iridiumkomplex und dem Matrixmaterial enthält zwischen 0.1 und 99 Vol.-%, vorzugsweise zwischen 1 und 90 Vol.-%, besonders bevorzugt zwischen 3 und 40 Vol.-%, insbesondere zwischen 5 und 15 Vol.-% des erfindungsgemäßen Iridiumkomplexes bezogen auf die Gesamtmischung aus Emitter und Matrixmaterial. Entsprechend enthält die Mischung zwischen 99.9 und 1 Vol.-%, vorzugsweise zwischen 99 und 10 Vol.-%, besonders bevorzugt zwischen 97 und 60 Vol.-%, insbesondere zwischen 95 und 85 Vol.-% des Matrixmaterials bezogen auf die Gesamtmischung aus Emitter und Matrixmaterial.

Geeignete Matrixmaterialien für die erfindungsgemäßen Verbindungen sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Biscarba-zolylbiphenyl), m-CBP oder die in WO 2005/039246, US 2005/0069729, JP 2004/288381, EP 1205527, WO 2008/086851 oder US 2009/0134784 offenbarten Carbazolderivate, verbrückte Carbazolderivate, z. B. gemäß US 2009/0136779, WO 2010/050778, WO 2011/042107 oder WO 2011/088877, Biscarbazolderivate, Indolocarbazolderivate, z. B. gemäß WO 2007/063754 oder WO 2008/056746, Indenocarbazolderivate, z. B. gemäß WO 2010/136109 oder WO 2011/000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Zinkkomplexe, z. B. gemäß EP 652273 oder WO 2009/062578, Dibenzofuranderivate, z. B. gemäß WO 2009/148015, Dibenzothiophenderivate oder Triphenylenderivate.

Es kann auch bevorzugt sein, mehrere verschiedene Matrixmaterialien als Mischung einzusetzen, insbesondere mindestens ein elektronenleitendes Matrixmaterial und mindestens ein lochleitendes Matrixmaterial. Eine bevorzugte Kombination ist beispielsweise die Verwendung eines aromatischen Ketons, eines Triazin-Derivats oder eines Phosphinoxid-Derivats mit einem Triarylamin-Derivat oder einem Carbazol-Derivat als gemischte Matrix für den erfindungsgemäßen Metallkomplex. Ebenso bevorzugt ist die Verwendung einer Mischung aus einem ladungstransportierenden Matrixmaterial und einem elektrisch inerten Matrixmaterial, welches nicht bzw. nicht in wesentlichem Maße am Ladungstransport beteiligt ist, wie z. B. in WO 2010/108579 beschrieben.

Bevorzugte Biscarbazole, die als Matrixmaterialien für die erfindungsgemäßen Verbindungen eingesetzt werden können, sind die Strukturen der folgenden Formeln (31) und (32), 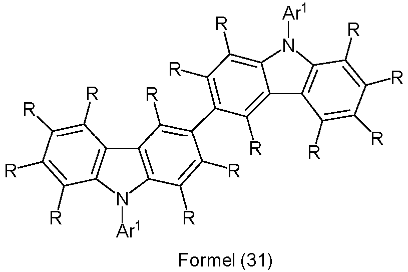 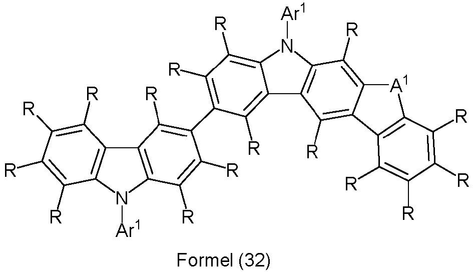 wobei Ar¹ gleich oder verschieden für ein aromatisches oder heteroaromatisches Ringsystem mit 5 bis 40 aromatischen Ringatomen, bevorzugt mit 6 bis 30 aromatischen Ringatomen steht, welches jeweils mit einem oder mehreren Resten R substituiert sein kann, A¹ für NR, CR₂, O oder S steht und R die oben genannten Bedeutungen aufweist. In einer bevorzugten Ausführungsform der Erfindung steht A¹ für CR₂.

Bevorzugte Ausführungsformen der Verbindungen der Formeln (31) bzw. (32) sind die Verbindungen der folgenden Formeln (31a) bzw. (32a), 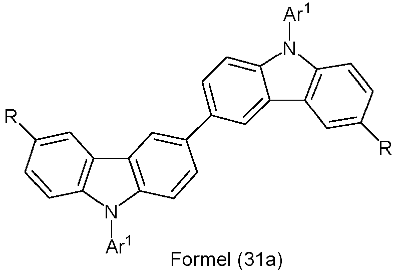 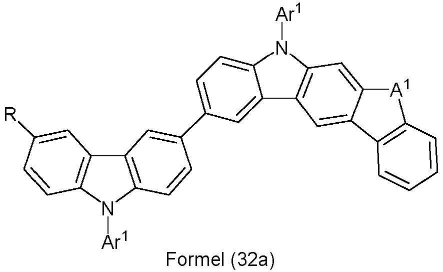 wobei die verwendeten Symbole die oben genannten Bedeutungen aufweisen.

Beispiele für geeignete Verbindungen gemäß Formel (31) oder (32) sind die nachfolgend abgebildeten Verbindungen.

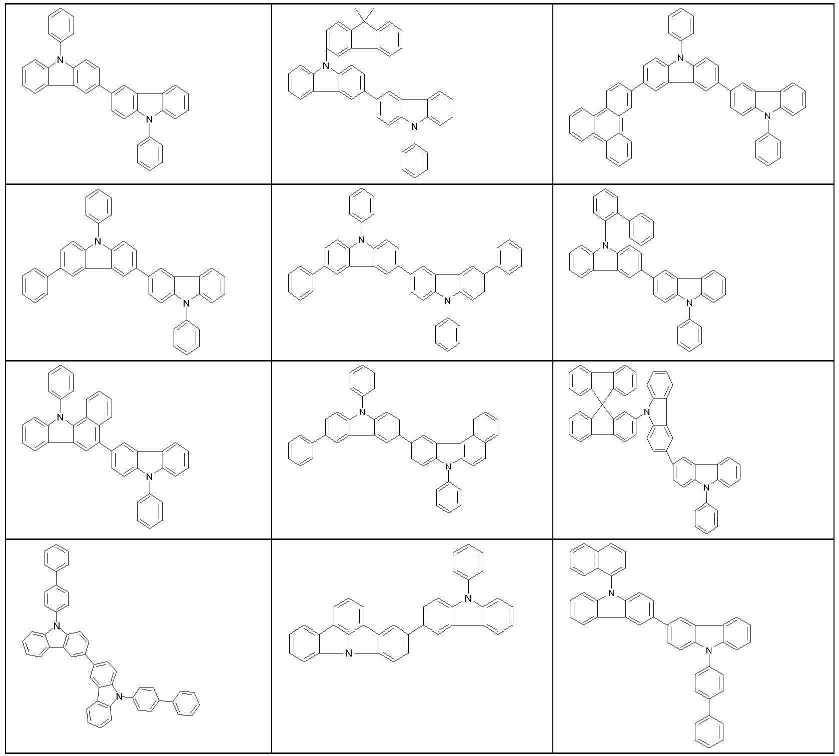

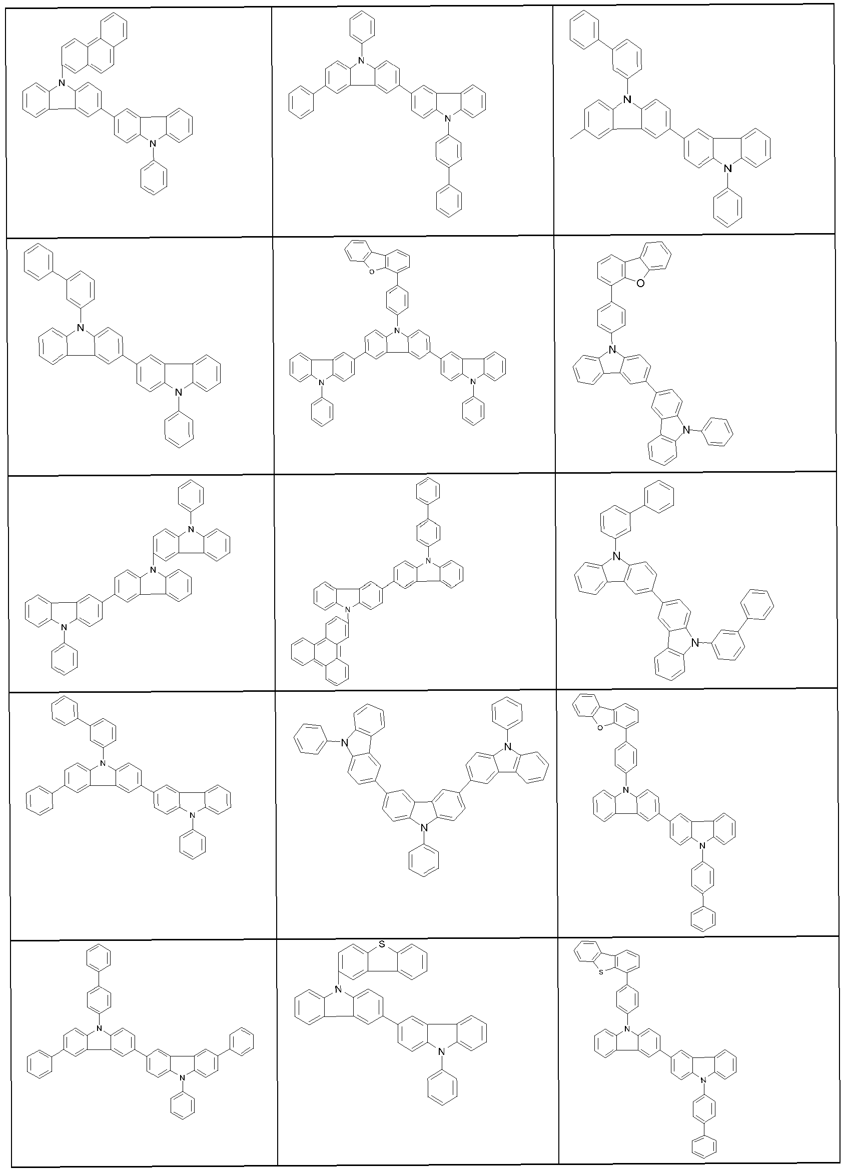

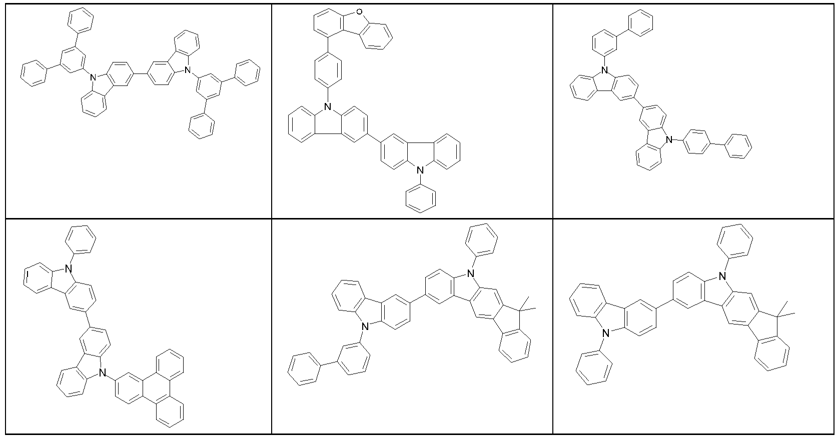

Bevorzugte Dibenzofuran-Derivate sind die Verbindungen der folgenden Formel (33), 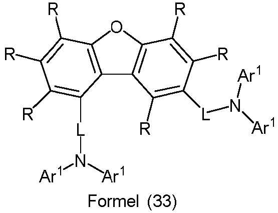 wobei der Sauerstoff auch durch Schwefel ersetzt sein kann, so dass ein Dibenzothiophen entsteht, L für eine Einfachbindung oder ein aromatisches oder heteroaromatisches Ringsystem mit 5 bis 30 aromatischen Ringatomen steht, welches auch durch eine oder mehrere Reste R substituiert sein kann, und R und Ar¹ die oben genannten Bedeutungen aufweisen. Dabei können die beiden Gruppen Ar¹, die an dasselbe Stickstoffatom binden, oder eine Gruppe Ar¹ und eine Gruppe L, die an dasselbe Stickstoffatom binden, auch miteinander verbunden sein, beispielsweise zu einem Carbazol.

Bevorzugte Carbazolamine sind die Strukturen der folgenden Formeln (34), (35) und (36), 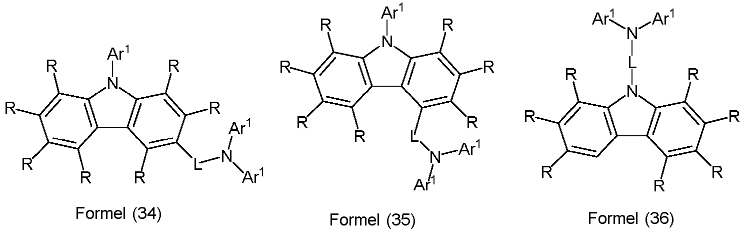 wobei L für ein aromatisches oder heteroaromatisches Ringsystem mit 5 bis 30 aromatischen Ringatomen steht, welches mit einem oder mehreren Resten R substituiert sein kann, und R und Ar¹ die oben genannten Bedeutungen aufweisen.

Bevorzugte Triazin-, Chinazolin- bzw. Pyrimidinderivate, welche als Mischung zusammen mit den erfindungsgemäßen Verbindungen eingesetzt werden können, sind die Verbindungen der folgenden Formeln (37), (38) und (39), 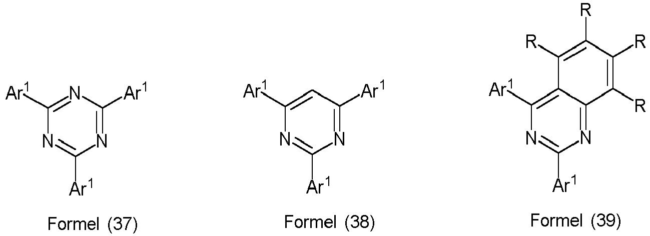 wobei Ar¹ und R die oben genannten Bedeutungen aufweist.

Besonders bevorzugt sind die Triazinderivate der Formel (37) und die Chinazolinderivate der Formel (39), insbesondere die Triazinderivate der Formel (37).

In einer bevorzugten Ausführungsform der Erfindung ist Ar¹ in den Formeln (37), (38) und (38) bei jedem Auftreten gleich oder verschieden ein aromatisches oder heteroaromatisches Ringsystem mit 6 bis 30 aromatischen Ringatomen, insbesondere mit 6 bis 24 aromatischen Ringatomen, das durch einen oder mehrere Reste R substituiert sein kann.

Dabei sind geeignete aromatische bzw. heteroaromatische Ringsysteme Ar¹ die gleichen, wie sie oben als Ausführungsformen für Ar¹, Ar² und Ar³ ausgeführt sind, insbesondere die Strukturen Ar-1 bis Ar-76.

Beispiele für geeignete Triazinverbindungen, welche als Matrixmaterialien zusammen mit den erfindungsgemäßen Verbindungen eingesetzt werden können, sind die in der folgenden Tabelle abgebildeten Verbindungen.

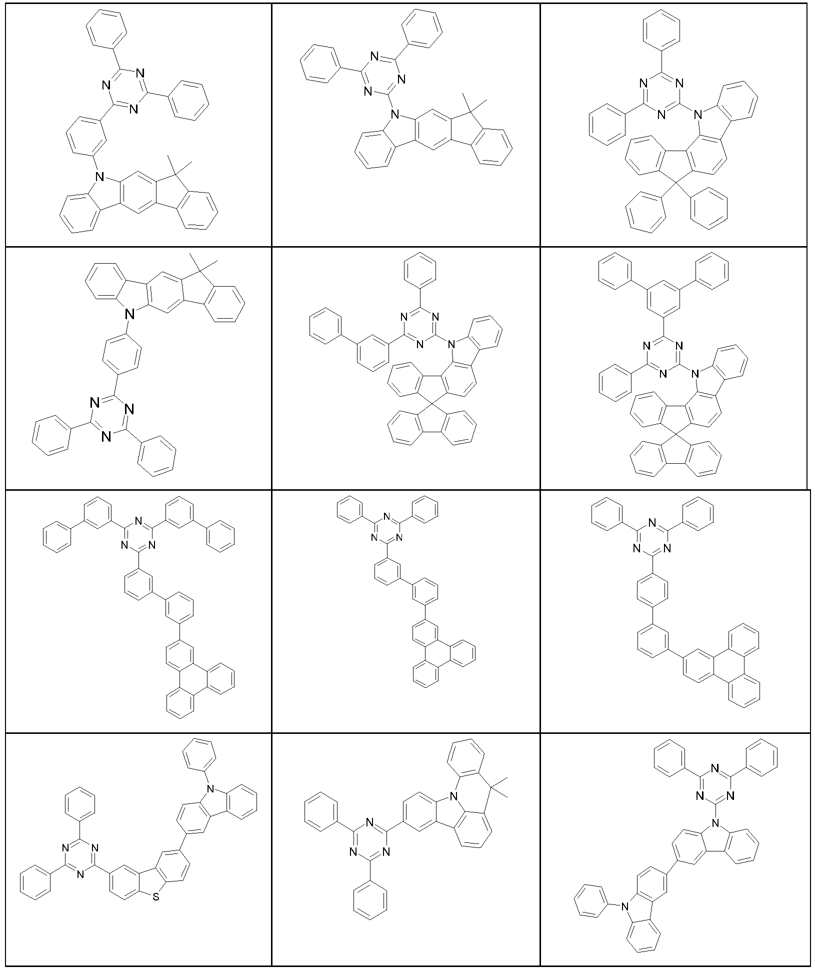

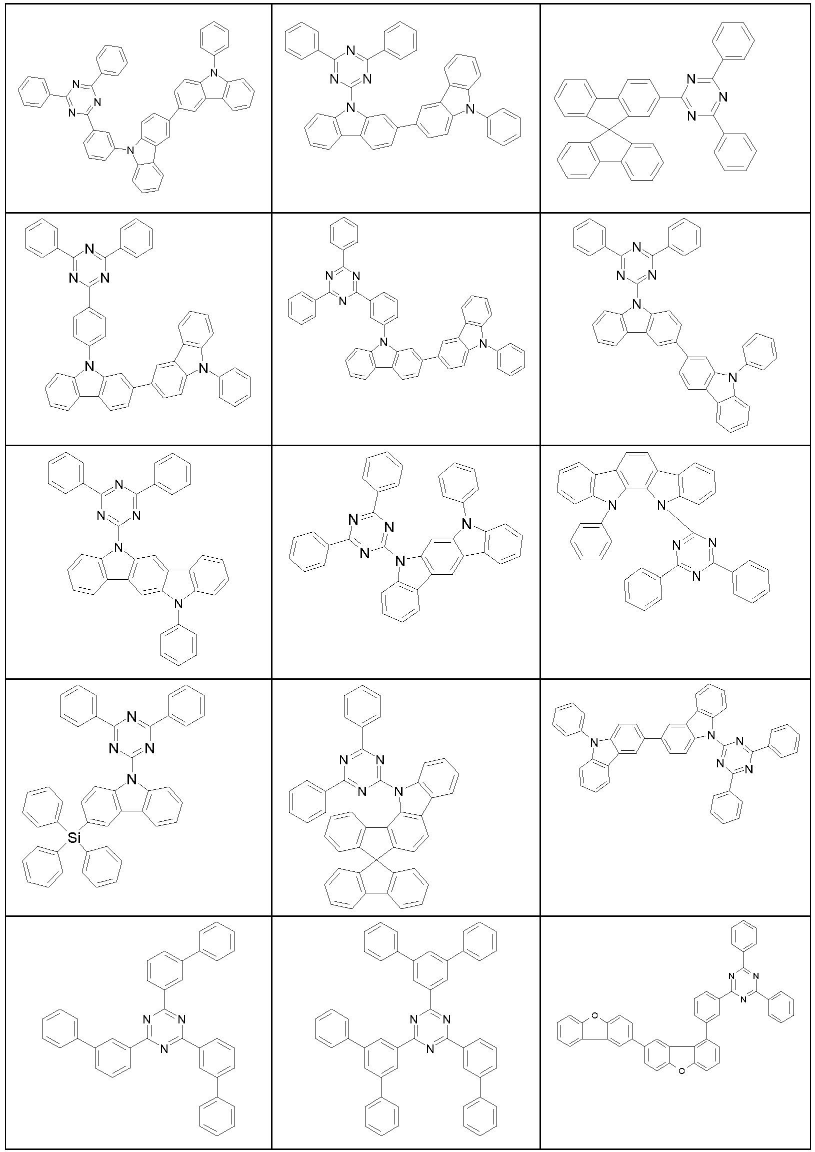

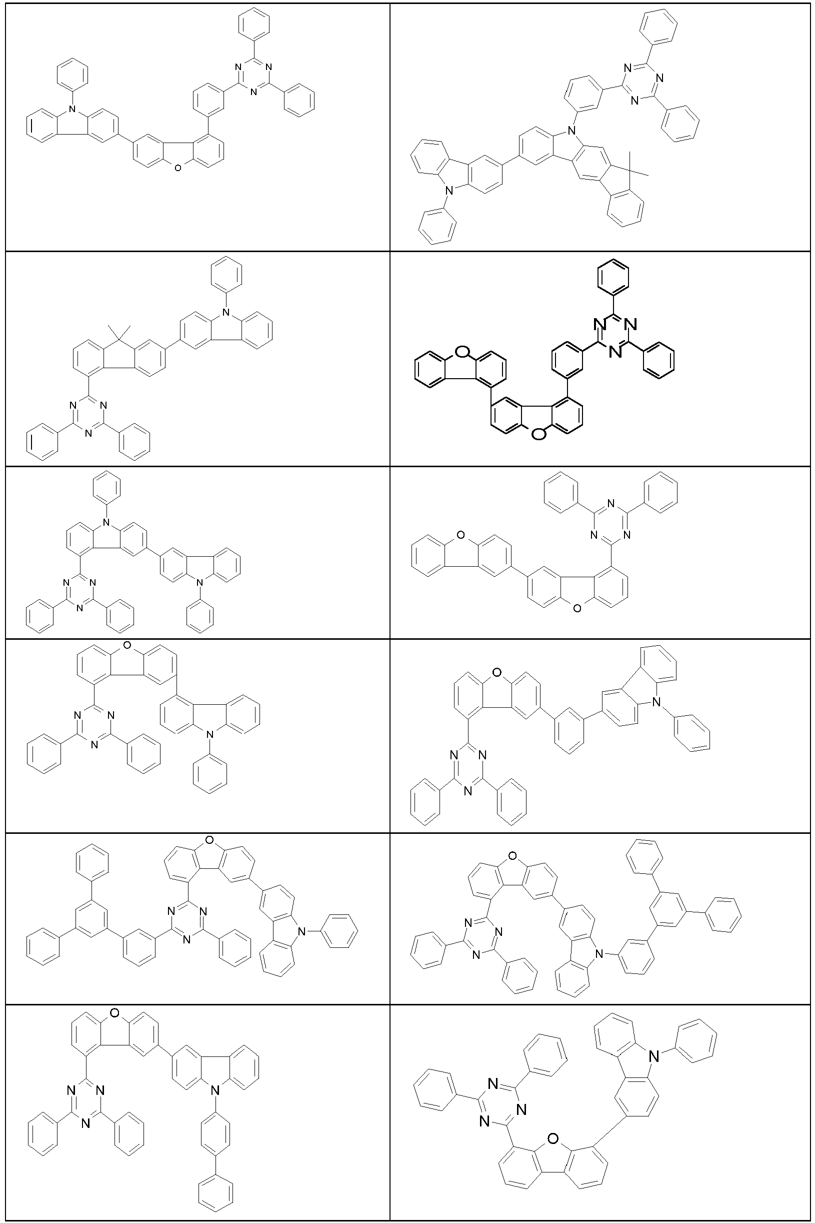

Weiterhin bevorzugt ist es, eine Mischung aus zwei oder mehr Triplett-Emittern, insbesondere zwei oder drei Triplettemittern, zusammen mit einem oder mehreren Matrixmaterialien einzusetzen. Dabei dient der Triplett-Emitter mit dem kürzerwelligen Emissionsspektrum als Co-Matrix für den Triplett-Emitter mit dem längerwelligen Emissionsspektrum. So können beispielsweise die erfindungsgemäßen Metallkomplexe mit einem kürzerwelligen, z.B. blau, grün oder gelb emittierenden, Metallkomplex als Co-Matrix kombiniert werden. Es können beispislweise auch erfindungsgemäße Metallkomplexe als Co-Matrix für längerwellig emittierende Triplettemitter, beispielsweise für rot emittierende Triplettemitter, eingesetzt werden. Dabei kann es auch bevorzugt sein, wenn sowohl der kürzerwellig wie auch der längerwellig emittierende Metallkomplex eine erfindungsgemäße Verbindung ist. Eine bevorzugte Ausführungsform bei Verwendung einer Mischung aus drei Triplett-Emittern ist, wenn zwei als Co-Host und einer als emittierendes Material eingesetzt werden. Dabei weisen diese Triplett-Emitter bevorzugt die Emissionsfarben Grün, Gelb und Rot oder Blau, Grün und Orange auf.

Eine bevorzugte Mischung in der emittierenden Schicht enthält ein elektronentransportierendes Hostmaterial, ein so genanntes "wide bandgap" Hostmaterial, das aufgrund seiner elektronischen Eigenschaften nicht oder nicht in wesentlichem Umfang am Ladungstransport in der Schicht beteiligt ist, einen Co-Dotanden, welcher ein Triplettemitter ist, welcher bei einer kürzeren Wellenlänge als die erfindungsgemäße Verbindung emittiert, sowie eine erfindungsgemäße Verbindung.

Eine weitere bevorzugte Mischung in der emittierenden Schicht enthält ein elektronentransportierendes Hostmaterial, ein so genanntes "wide band gap" Hostmaterial, das aufgrund seiner elektronischen Eigenschaften nicht oder nicht in wesentlichem Umfang am Ladungstransport in der Schicht beteiligt ist, ein lochtransportierendes Hostmaterial, einen Co-Dotanden, welcher ein Triplettemitter ist, welcher bei einer kürzeren Wellenlänge als die erfindungsgemäße Verbindung emittiert, sowie eine erfindungsgemäße Verbindung.

Die erfindungsgemäßen Verbindungen lassen sich auch in anderen Funktionen in der elektronischen Vorrichtung einsetzen, beispielsweise als Lochtransportmaterial in einer Lochinjektions- oder -transportschicht, als Ladungserzeugungsmaterial, als Elektronenblockiermaterial, als Lochblockiermaterial oder als Elektronentransportmaterial, beispielsweise in einer Elektronentransportschicht. Ebenso lassen sich die erfindungsgemäßen Verbindungen als Matrixmaterial für andere phosphoreszierende Metallkomplexe in einer emittierenden Schicht einsetzen.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Mg/Ag, Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, Li₂O, BaF₂, MgO, NaF, CsF, Cs₂CO₃, etc.). Ebenso kommen hierfür organische Alkalimetallkomplexe in Frage, z. B. Liq (Lithiumchinolinat). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/NiOₓ, Al/PtOₓ) bevorzugt sein. Für einige Anwendungen muss mindestens eine der Elektroden transparent oder teiltransparent sein, um entweder die Bestrahlung des organischen Materials (O-SC) oder die Auskopplung von Licht (OLED/PLED, O-LASER) zu ermöglichen. Bevorzugte Anodenmaterialien sind hier leitfähige gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere, z. B. PEDOT, PANI oder Derivate dieser Polymere. Bevorzugt ist weiterhin, wenn auf die Anode ein p-dotiertes Lochtransportmaterial als Lochinjektionsschicht aufgebracht wird, wobei sich als p-Dotanden Metalloxide, beispielsweise MoO₃ oder WO₃, oder (per)fluorierte elektronenarme Aromaten eignen. Weitere geeignete p-Dotanden sind HAT-CN (Hexacyano-hexaazatriphenylen) oder die Verbindung NPD9 von Novaled. Eine solche Schicht vereinfacht die Lochinjektion in Materialien mit einem tiefen HOMO, also einem betragsmäßig großen HOMO.

In den weiteren Schichten können generell alle Materialien verwendet werden, wie sie gemäß dem Stand der Technik für die Schichten verwendet werden, und der Fachmann kann ohne erfinderisches Zutun jedes dieser Materialien in einer elektronischen Vorrichtung mit den erfindungsgemäßen Materialien kombinieren.

Geeignete Ladungstransportmaterialien, wie sie in der Lochinjektions- bzw. Lochtransportschicht bzw. Elektronenblockierschicht oder in der Elektronentransportschicht der erfindungsgemäßen organischen Elektrolumineszenzvorrichtung verwendet werden können, sind beispielsweise die in Y. Shirota et al., Chem. Rev. 2007, 107(4), 953-1010 offenbarten Verbindungen oder andere Materialien, wie sie gemäß dem Stand der Technik in diesen Schichten eingesetzt werden. Bevorzugt sind als Lochtransportmaterialien, die in einer Lochtransport-, Lochinjektions- oder Elektronenblockierschicht in der erfindungsgemäßen Elektrolumineszenzvorrichtung verwendet werden können, Indenofluorenamin-Derivate (z. B. gemäß WO 06/122630 oder WO 06/100896), die in EP 1661888 offenbarten Aminderivate, Hexaazatriphenylenderivate (z. B. gemäß WO 01/049806), Aminderivate mit kondensierten Aromaten (z. B. gemäß US 5,061,569), die in WO 95/09147 offenbarten Aminderivate, Monobenzoindenofluorenamine (z. B. gemäß WO 08/006449), Dibenzoindenofluorenamine (z. B. gemäß WO 07/140847), Spirobifluoren-Amine (z. B. gemäß WO 2012/034627, WO2014/056565), Fluoren-Amine (z. B. gemäß EP 2875092, EP 2875699 und EP 2875004), Spiro-Dibenzopyran-Amine (z. B. EP 2780325) und Dihydroacridin-Derivate (z. B. gemäß WO 2012/150001).

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck von üblicherweise kleiner 10⁻⁵ mbar, bevorzugt kleiner 10⁻⁶ mbar aufgedampft. Es ist auch möglich, dass der Anfangsdruck noch geringer oder noch höher ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck oder Nozzle-Printing, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden.

Die organische Elektrolumineszenzvorrichtung kann auch als Hybridsystem hergestellt werden, indem eine oder mehrere Schichten aus Lösung aufgebracht werden und eine oder mehrere andere Schichten aufgedampft werden. So ist es beispielsweise möglich, eine emittierende Schicht enthaltend einen erfindungsgemäßen Metallkomplex und ein Matrixmaterial aus Lösung aufzubringen und darauf eine Lochblockierschicht und/oder eine Elektronentransportschicht im Vakuum aufzudampfen.

Diese Verfahren sind dem Fachmann generell bekannt und können von ihm ohne Probleme auf organische Elektrolumineszenzvorrichtungen enthaltend Verbindungen gemäß Formel (1) bzw. die oben aufgeführten bevorzugten Ausführungsformen angewandt werden.

Die erfindungsgemäßen elektronischen Vorrichtungen, insbesondere organische Elektrolumineszenzvorrichtungen, weisen eine hohe Effizienz, eine gute Lebensdauer und eine geringe Betriebsspannung auf. Weiterhin sind die erfindungsgemäßen Verbindungen thermisch sehr stabil und insbesondere die erfindungsgemäßen Verbindungen mit einem nicht zu hohen Molekulargewicht, insbesondere mit einem Molekulargewicht bis ca. 1200 g/mol, lassen sich gut und unzersetzt sublimieren.

Diese oben genannten Vorteile gehen nicht mit einer Verschlechterung der weiteren elektronischen Eigenschaften einher.

Die Erfindung wird durch die nachfolgenden Beispiele näher erläutert, ohne sie dadurch einschränken zu wollen. Der Fachmann kann aus den Schilderungen ohne erfinderisches Zutun weitere erfindungsgemäße elektronische Vorrichtungen herstellen und somit die Erfindung im gesamten beanspruchten Bereich ausführen.

### Beschreibung der Figuren

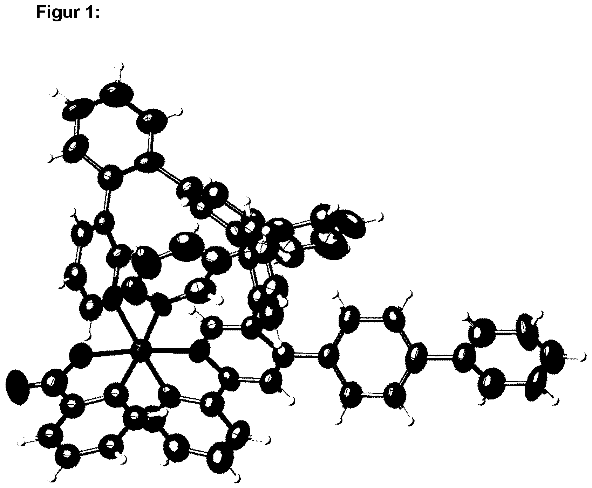

Figur 1 zeigt die Röntgenstruktur des erfindungsgemäßen Komplexes Ir617, dessen Synthese in den nachfolgenden Beispielen beschrieben wird.

### Beispiele:

Die nachfolgenden Synthesen werden, sofern nicht anders angegeben, unter einer Schutzgasatmosphäre in getrockneten Lösungsmitteln durchgeführt. Die Metallkomplexe werden zusätzlich unter Ausschluss von Licht bzw. unter Gelblicht gehandhabt. Die Lösungsmittel und Reagenzien können z. B. von Sigma-ALDRICH bzw. ABCR bezogen werden. Die jeweiligen Angaben in eckigen Klammern bzw. die zu einzelnen Verbindungen angegebenen Nummern beziehen sich auf die CAS-Nummern der literaturbekannten Verbindungen. Bei Verbinden, die mehrere tautomere, isomere, enantiomere oder diastereomere Formen ausweisen können, wird eine Form stellvertretend gezeigt.

### A: Synthese der Synthone S:

### Beispiel S1:

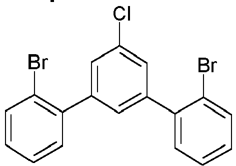

Ein Gemisch aus 18.2 g (50 mmol) 2,2'-(5-Chlor-1,3-phenylen)-bis[4,4,5,5-tetramethyl-1,3,2-dioxaborolan [1417036-49-7], 28.3 g (100 mol) 1-Brom-2-iodbenzol, 31.8 g (300 mmol) Natriumcarbonat, 200 ml Toluol, 100 ml Ethanol und 200 ml Wasser wird unter sehr gutem Rühren mit 788 mg (3 mmol) Triphenylphosphin und dann mit 225 mg (1 mmol) Palladium(II)-acetat versetzt und 48 h unter Rückfluss erhitzt. Nach Erkalten trennt man die organische Phase ab, wäscht diese einmal mit 300 ml Wasser und einmal mit 300 ml gesättigter Kochsalzlösung und trocknet über Magnesiumsulfat. Man filtriert vom Trockenmittel ab und engt das Filtrat im Vakuum vollständig ein. Der Rückstand wird Flash-chromatographiert (Säulenautomat Torrent der Fa. A. Semrau). Ausbeute: 16.5 g (39 mmol), 78 %; Reinheit: ca. 97 %ig n. ¹H-NMR.

### Beispiel S2:

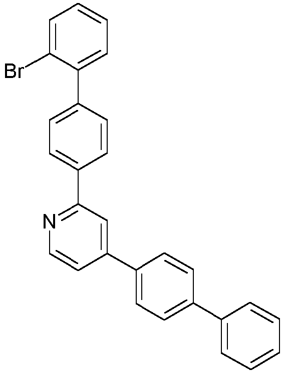

### StufeS2a:

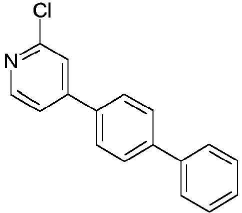

Ein gut gerührtes Gemisch aus 23.9 g (100 mmol) 2-Chlor-4-iodpyridin [153034-86-7], 19.8 g (100 mmol) Biphenylboronsäure [5122-94-1], 21.2 g (200 mmol) Natriumcarbonat, 1.16 g (1 mmol) Tetrakis-triphenylphosphino-palladium(0), 150 ml Toluol, 50 ml Dioxan und 100 ml Wasser wird 16 unter Rückfluss erhitzt. Nach Erkalten saugt man vom ausgefallenen Feststoff ab, wäscht diesen dreimal mit je 100 ml Wasser und zweimal mit je 50 ml Methanol und trocknet im Vakuum. Der Feststoff wird in 150 ml Acetonitril heiß ausgerührt, abgesaugt und im Vakuum getrocknet. Ausbeute: 24.2 g (91 mmol), 91 %; Reinheit: ca. 97 %ig n. ¹H-NMR.

### Stufe S2b:

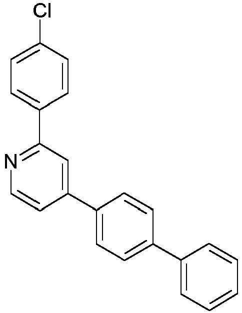

Ein gut gerührtes Gemisch aus 26.6 g (100 mmol) S2a, 15.6 g (100 mmol) 4-Chlorphenylboronsäure [1679-18-1], 27.6 g (200 mmol) Kaliumcarbonat, 702 mg (1 mmol) Bis-triphenylphosphin-palladium(II)chlorid, 50 g Glaskugeln (3 mmol Durchmesser), 200 ml Acetonitril und 100 ml Methanol wird 16 h unter Rückfluss erhitzt. Nach Erkalten saugt man vom ausgefallenen Feststoff ab, wäscht diesen dreimal mit je 100 ml Wasser und zweimal mit je 50 ml Methanol und trocknet im Vakuum. Der Feststoff wird in 500 ml Dichlormethan (DCM) und 100 ml Ethylacetat (EE) gelöst und über ein mit DCM vorgeschlämmtes Kieselgel-Bett filtriert. Das Filtrat wird im Vakuum eingeengt. Der verbleibende Feststoff wird mit 150 ml Ethanol heiß ausgerührt, abgesaugt und im Vakuum getrocknet. Ausbeute: 27.3 g (80 mmol), 80 %; Reinheit: ca. 97 %ig n. ¹H-NMR.

### Stufe S2c:

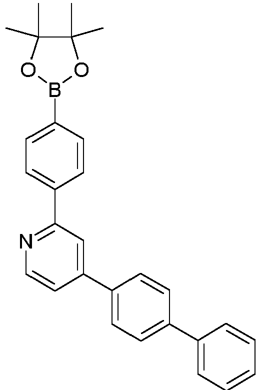

Ein Gemisch aus 34.2 g (100 mmol) S2b, 26.7 g (105 mmol) Bis(pinaco-lato)diboran, 29.4 g (300 mmol) Kaliumacetat (wasserfrei), 50 g Glaskugeln (3 mm Durchmesser) und 500 ml THF wird unter gutem Rühren mit 821 mg (2 mmol) S-Phos und dann mit 225 mg (1 mmol) Palladium(II)-acetat versetzt und 16 h unter Rückfluss erhitzt. Man saugt noch heiß von den Salzen und Glaskugeln über ein mit THF vorgeschlämmtes Celite-Bett ab, wäscht dieses mit etwas THF nach und engt das Filtrat zur Trockene ein. Man nimmt den Rückstand in 100 ml MeOH auf, rührt warm aus, saugt vom auskristallisieren Produkt ab, wäscht zweimal mit je 30 ml Methanol nach und trocknet im Vakuum. Ausbeute: 36.4 g (84 mmol), 84 %; Reinheit: ca. 95 %ig n. ¹H-NMR.

### Stufe S2:

Ein gut gerührtes Gemisch aus 21.3 g (100 mmol) S2c, 13.6 g (100 mmol) 1-Brom-2-iodbenzol [583-55-1], 53.0 g (500 mmol) Natriumcarbonat, 400 ml Toluol, 200 ml Ethanol und 400 ml Wasser wird mit 1.57 g (6 mmol) Triphenylphosphin und dann mit 449 mg (2 mmol) Palladium(II)-acetat versetzt und 16 h unter Rückfluss erhitzt. Nach Erkalten trennt man die organische Phase ab, wäscht diese zweimal mit je 200 ml Wasser, einmal mit 200 ml gesättigter Kochsalzlösung und trocknet über Magnesiumsulfat. Man filtriert über ein mit Toluol vorgeschlämmtes Celite-Bett ab, engt das Filtrat zur Trockene ein und kristallisiert den Rückstand aus ca. 50 ml Methanol unter Zusatz von etwas Ethylacetat um. Ausbeute: 37.4 g (83 mmol), 83 %; Reinheit: ca. 95 %ig n. ¹H-NMR.

Analog können folgende Verbindungen dargestellt werden:

| Bsp. | Edukte | Produkt | Ausbeute* |
|---|---|---|---|
| S3 | 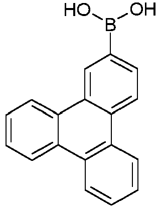 | 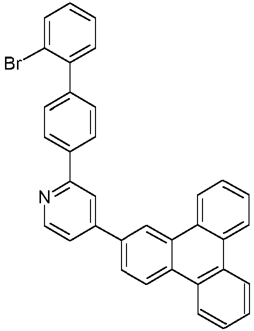 | 54 % |
| | Stufe a | | |
| | 654664-63-8 | | |
| S4 | 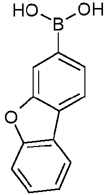 | 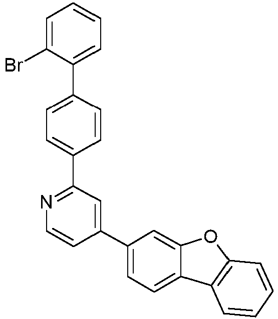 | 47 % |
| | Stufe a | | |
| | 395087-89-5 | | |

| | | | |
|---|---|---|---|
| * über drei Stufen | | | |

### Beispiel S20:

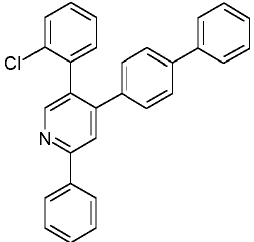

### Stufe S20b:

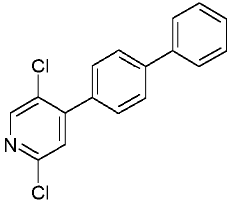

Ein gut gerührtes Gemisch aus 27.4 g (100 mmol) 2,5-Dichlor-4-iodpyridin [796851-03-1], 19.8 g (100 mmol) Biphenylboronsäure [5122-94-1], 27.6 g (200 mmol) Kaliumcarbonat, 702 mg (1 mmol) Bis-triphenylphosphin-palladium(II)chlorid, 50 g Glaskugeln (3 mmol Durchmesser), 150 mmol Acetonitril und 150 ml Methanol wird 16 h unter Rückfluss erhitzt. Nach Erkalten wird die Reaktionsmischung in 1000 ml Wasser eingerührt. Der ausgefallene Feststoff wird abgesaugt, dreimal mit je 100 ml Wasser und einmal mit 50 ml Methanol gewaschen und im Vakuum getrocknet. Ausbeute: 29.4 g (98 mmol), 98 %; Reinheit: ca. 97 %ig n. ¹H-NMR.

### StufeS20a:

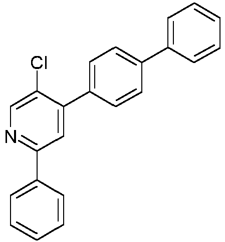

Durchführung analog 20a, wobei anstelle von Biphenylboronsäure [5122-94-1] 12.2 g (100 mmol) Phenylboronsäure [98-80-6] eingesetzt wird. Das Rohprodukt wird in 300 ml DCM und 100 ml EE gelöst und über ein Kieselgel-Bett filtriert. Nach Einengen des Filtrats wird der Feststoff aus 70 ml Acetonitril heiß ausgerührt. Ausbeute: 27.3 g (80 mmol), 80 %; Reinheit: ca. 97 %ig n. ¹H-NMR.

### Stufe S20:

Ein gut gerührtes Gemisch aus 34.2 g (100 mmol) S20b, 17.2 g (110 mmol) 2-Chlor-phenylboronsäure [3900-89-8], 41.5 g (300 mmol) Kaliumcarbonat, 600 ml THF und 200 ml Wasser wird mit 1.64 g (4 mmol) S-Phos und 499 mg (2 mmol) Palladium(II)acetat versetzt und 16 h unter schwachem Rückfluss gerührt. Nach Erkalten trennt man die organische Phase ab, wäscht diese zweimal mit je 200 ml gesättigter Kochsalzlösung und engt zur Trockene ein. Der Rückstand wird in 100 ml Ethanol 4 h ausgekocht. Der Feststoff wird nach Erkalten abgesaugt, mit 50 ml Ethanol gewaschen und getrocknet. Die weitere Reinigung erfolgt durch Umkristallisation aus ca. 200 ml Ethylacetat. Ausbeute: 25.9 g (62 mmol), 62 %; Reinheit: ca. 95 %ig n. ¹H-NMR.

Analog können folgende Verbindungen dargestellt werden:

| Bsp. | Edukte | Produkt | Ausbeute* |
|---|---|---|---|
| S21 | 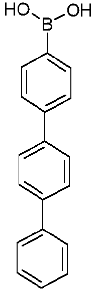 | 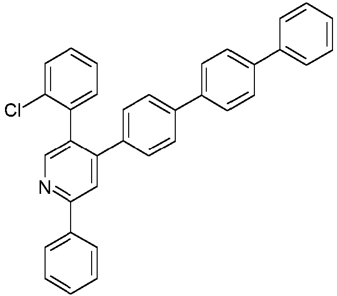 | 50 % |
| | 877993-09-4 | | |
| | Stufe 20a | | |
| S22 | 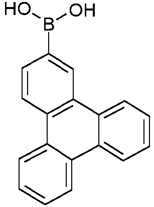 | 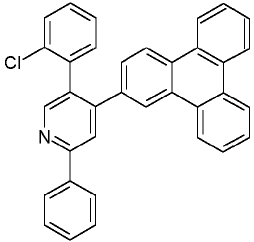 | 54 % |
| | 654664-63-8 | | |
| | Stufe 20a | | |
| S23 | 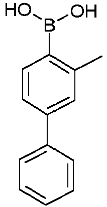 | 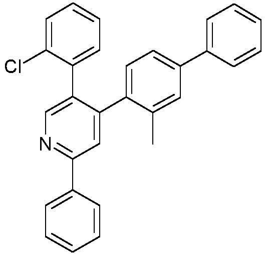 | 46 % |
| | 1383628-42-9 | | |
| | Stufe 20a | | |
| S24 | 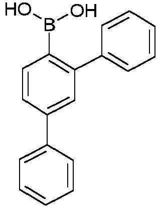 | 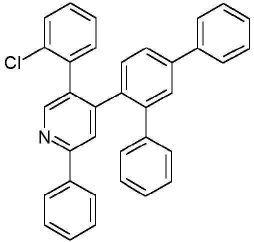 | 48 % |
| | 364050-45-3 | | |
| | Stufe 20a | | |
| S25 | 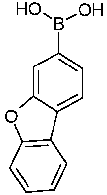 | 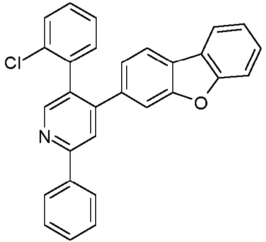 | 50 % |
| | 395087-89-5 | | |
| | Stufe 20a | | |
| S26 | 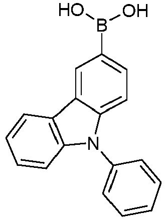 | 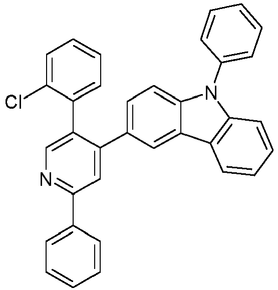 | 52 % |
| | 845952-58-2 | | |
| | Stufe 20a | | |
| S27 | 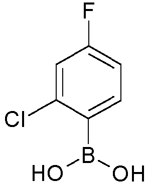 | 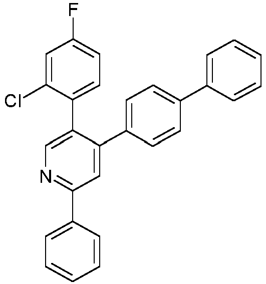 | 44 % |
| | 313454-72-1 | | |
| | Stufe 20 | | |
| S28 | 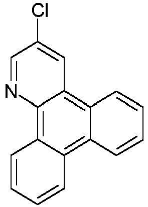 | 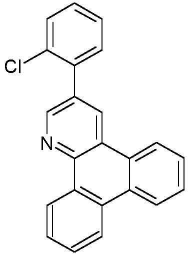 | 81 % |
| | Nur Stufe S20 Darstellung siehe | | |
| | KR 2018045695 | | |
| S29 | 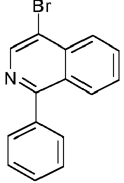 | 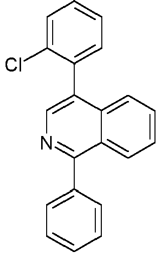 | 87 % |
| | 22960-25-4 | | |
| | Nur Stufe 20 | | |
| S30 | 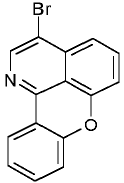 | 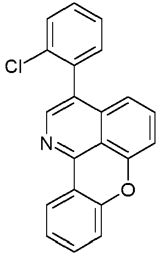 | 85 % |
| | 2222066-63-7 | | |
| | Nur Stufe 20 | | |

| | | | |
|---|---|---|---|
| * über drei Stufen | | | |

### Beispiel S50:

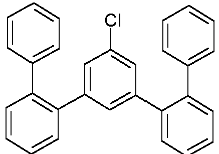

Ein Gemisch aus 21.1 g (50 mmol) S1, 20.4 g (100mol) 4,4,5,5-Tetramethyl-2-phenyl-1,3,2-dioxaborolan [24388-23-6], 63.4 g (600 mmol) Natriumcarbonat, 400 ml Toluol, 200 ml Ethanol und 400 ml Wasser wird unter sehr gutem Rühren mit 1.58 g (6 mmol) Triphenylphosphin und dann mit 449 mg (2 mmol) Palladium(II)acetat versetzt und 48 h unter Rückfluss erhitzt. Nach Erkalten trennt man die organische Phase ab, wäscht diese einmal mit 300 ml Wasser und einmal mit 300 ml gesättigter Kochsalzlösung und trocknet über Magnesiumsulfat. Man filtriert vom Trockenmittel ab und engt das Filtrat um Vakuum vollständig ein. Der Rückstand wird Flash-chromatographiert (Säulenautomat Torrent der Fa. A. Semrau). Ausbeute: 17.1 g (41 mmol), 82 %; Reinheit: ca. 97 %ig n. ¹H-NMR.

Analog können folgende Verbindungen dargestellt werden:

| Bsp. | Edukte | Produkt | Aus- |
|---|---|---|---|
| | | | beute |
| S51 | 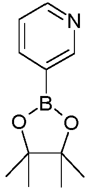 329214-79-1 | 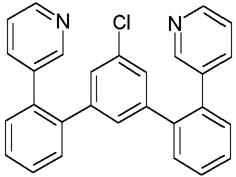 | 73 % |
| S52 | 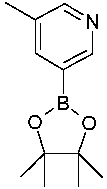 1171891-42-1 | 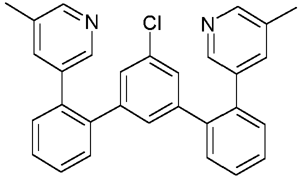 | 70 % |
| S53 | 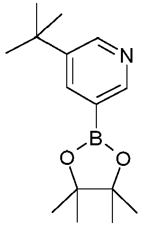 2225172-53-0 | 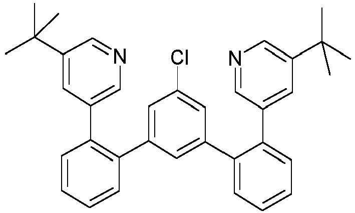 | 75 % |
| S54 | 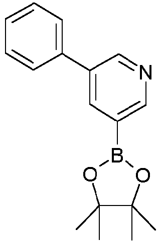 1171891-07-8 | 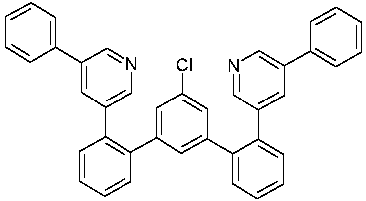 | 77 % |
| S55 | 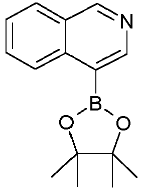 685103-98-4 | 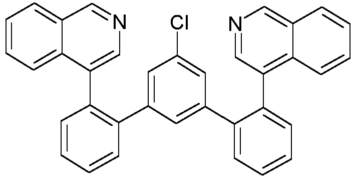 | 70 % |
| S56 | 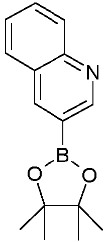 171364-85-5 | 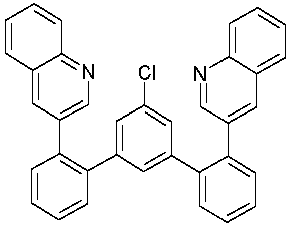 | 67 % |
| S57 | 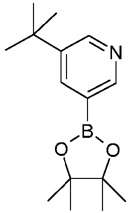 | 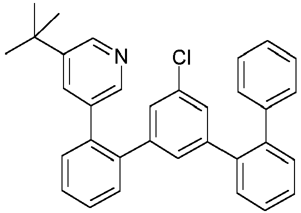 | 20 % |
| | 2225172-53-0, 50 mmol | | |
| | 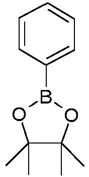 | | |
| | 24388-23-6, 50 mmol | | |

### Beispiel S100:

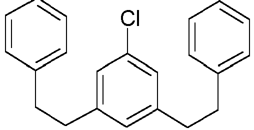

Ein gut gerührtes Gemisch aus 31.4 g (200 mmol) Brombenzol [108-86-1], 16.1 g (100 mmol) 1-Chlor-3,5-ethinyl-benzol [1378482-52-0], 194.5 ml (1.5 mol) Triethylamin, 700 ml DMF und 2.31 g (2 mmol) Tetrakistriphenylphosphino-palladium(0) wird 16 h bei 70 °C gerührt. Man saugt noch warm vom gebildeten Triethylammoniumhydrobromid ab und wäscht dieses einmal mit 50 ml DMF. Das Filtrat wird zur Trockene eingeengt und der Rückstand wird in 1000 ml Dichlormethan aufgenommen. Die organische Phase wird dreimal mit je 300 ml Wasser und einmal mit 300 ml gesättigter Kochsalzlösung gewaschen und über Magnesiumsulfat getrocknet. Man engt die organische Phase auf ca. 300 ml ein, versetzt mit 100 ml Ethylacetat, filtriert über ein Kieselgelbett-Bett ab und entfernt das Lösungsmittel im Vakuum. Der so erhaltene Feststoff wird einmal mit 150 ml Methanol ausgerührt und dann im Vakuum getrocknet. Der Feststoff wird in einem Gemisch aus 500 ml THF und 100 ml MeOH unter Zugabe von 10.7 g (200 mmol) Ammoniumchlorid, 5 g Palladium (5%) auf Kohle bei 40 °C unter 2 bar Wasserstoff-Atmosphäre bis zur beendeten Wasserstoffaufnahme (ca. 12 h) hydriert. Man filtriert vom Katalysator über ein mit THF vorgeschlämmtes Celite-Bett ab, entfernt das Lösungsmittel im Vakuum und flash-chromatographiert den Rückstand an einem Säulenautomaten (CombiFlashTorrent der Fa. A Semrau).

Ausbeute: 26.3 g (82 mmol), 82 %; Reinheit: ca. 97 %ig n. ¹H-NMR.

Analog können folgende Verbindungen dargestellt werden:

| Bsp. | Edukte Variante | Produkt | Ausbeute |
|---|---|---|---|
| S101 | 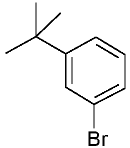 3972-64-3 | 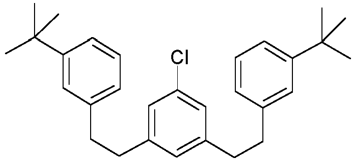 | 78 % |
| S102 | 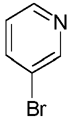 626-55-1 | 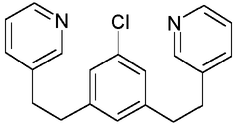 | 80 % |
| S103 | 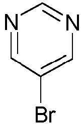 4595-59-9 | 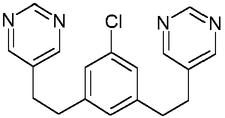 | 75 % |
| S104 | 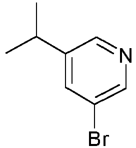 1209459-74-4 | 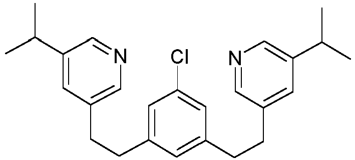 | 85 % |
| S105 | 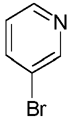 626-55-1 | 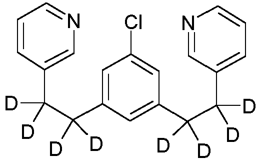 | 70 % |
| | Verwendung von: MeOD / ND₄Cl / D₂ | | |

### Beispiel S200:

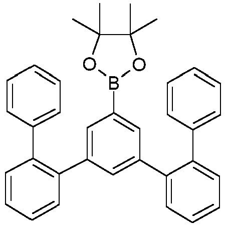

Ein Gemisch aus 41.7 g (100 mmol) S50, 26.7 g (105 mmol) Bis(pinaco-lato)diboran [73183-34-3], 29.4 g (300 mmol) Kaliumacetat (wasserfrei), 50 g Glaskugeln (3 mm Durchmesser) und 300 ml THF wird unter gutem Rühren mit 821 mg (2 mmol) S-Phos und dann mit 225 mg (1 mmol) Palladium(II)acetat versetzt und 16 h unter Rückfluss erhitzt. Nach Erkalten saugt man von den Salzen und Glaskugeln über ein mit THF vorgeschlämmtes Celite-Bett ab, wäscht dieses mit etwas THF nach und engt das Filtrat zur Trockene ein. Man nimmt den Rückstand in 100 ml MeOH auf, rührt warm aus, saugt vom auskristallisieren Produkt ab, wäscht zweimal mit je 30 ml Methanol nach und trocknet im Vakuum. Ausbeute: 45.8 g (90 mmol), 90 %; Reinheit: ca. 95 %ig n. ¹H-NMR.

Analog können folgende Verbindungen dargestellt werden:

| Bsp. | Edukte | Produkt | Ausbeute |
|---|---|---|---|
| S201 | S51 | 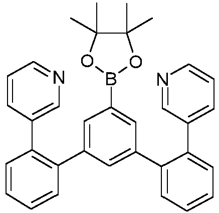 | 88 % |
| S202 | S52 | 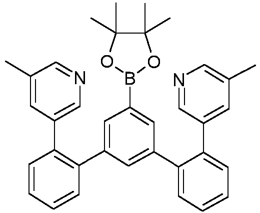 | 85 % |
| S203 | S53 | 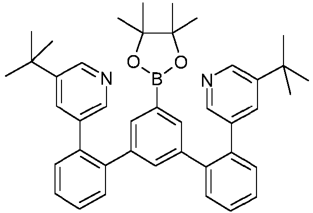 | 87 % |
| S204 | S54 | 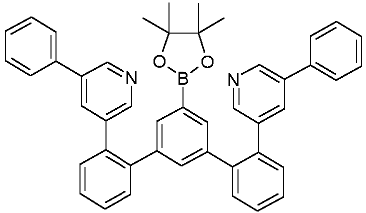 | 91 % |
| S205 | S55 | 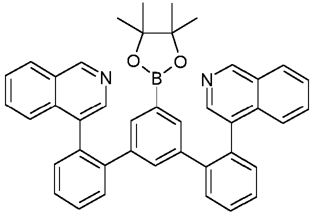 | 90 % |
| S206 | S56 | 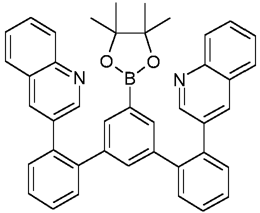 | 93 % |
| S207 | S57 | 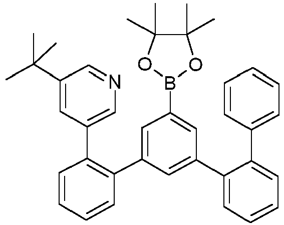 | 90 % |
| S300 | S100 | 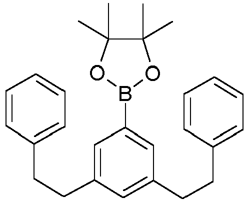 | 84 % |
| S301 | S101 | 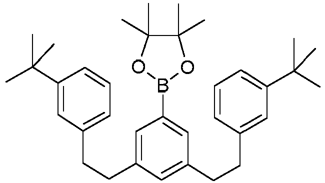 | 81 % |
| S302 | S102 | 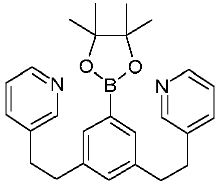 | 86 % |
| S303 | S103 | 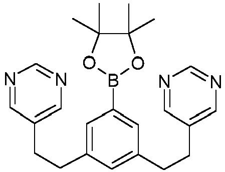 | 77 % |
| S304 | S104 | 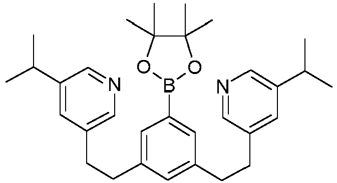 | 88 % |
| S305 | S105 | 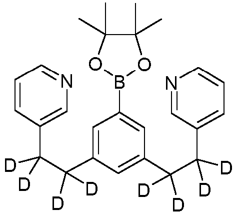 | 80 % |

### Beispiel S400:

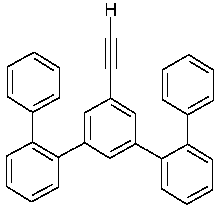

Ein gut gerührtes Gemisch von 50.8 g (100 mmol) S200, 31.4 g (120 mmol) Tri-iso-propylsilyl-ethinylbromid [111409-79-1], 26.5 g (250 mmol) Natriumcarbonat, 2.31 g (2 mmol) Tetrakis-triphenylphosphino-palladium(0), 600 ml Toluol, 300 ml Ethanol und 100 ml Wasser wird 24 h bei 80 °C gerührt. Nach Erkalten trennt man die organische Phase ab, wäscht diese zweimal mit je 200 ml gesättigter Kochsalzlösung und trocknet über Magnesiumsulfat. Man filtriert vom Trockenmittel ab, engt das Filtrat bei 30 °C im Vakuum ein, nimmt den Rückstand in 500 ml Dichlormethan auf, gibt 110 ml TBAF (1M in THF) [10549-76-5] zu, rührt 1 h bei RT nach, wäscht dann zweimal mit je 300 ml Wasser und zweimal mit je 200 ml gesättigter Kochsalzlösung, engt bei 30 °C ein und chromatographiert den Rückstand an einem Säulenautomaten (CombiFlashTorrent der Fa. A Semrau). Lagerung des Produkts im Tiefkühlschrank. Ausbeute: 29.4 g (72 mmol), 72 %; Reinheit: ca. 97 %ig n. ¹H-NMR.

Analog können folgende Verbindungen dargestellt werden:

| Bsp. | Edukte | Produkt | Ausbeute |
|---|---|---|---|
| S401 | S201 | 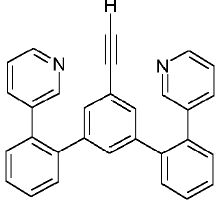 | 68 % |
| S402 | S202 | 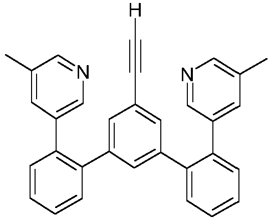 | 65 % |
| S403 | S203 | 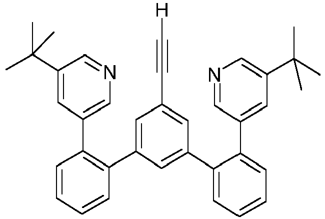 | 71 % |
| S500 | S301 | 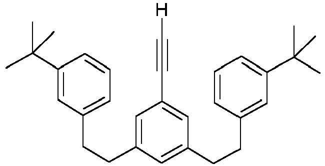 | 70 % |
| S501 | S302 | 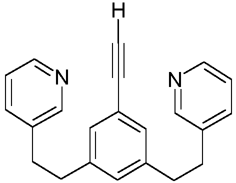 | 67 % |

### B: Synthese der Liganden L:

### Beispiel L1:

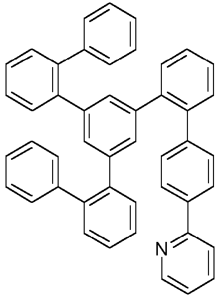

Ein Gemisch aus 50.9 g (100 mmol) S200, 31.0 g (100 mmol) 2-(2'-Brom-[1,1'-biphenyl]-4-yl)-pyridin [1374202-35-3], 63.7 g (300 mmol) Trikaliumphosphat, 400 ml Toluol, 200 ml Dioxan und 400 ml Wasser wird unter gutem Rühren mit 1.64 g (4 mmol) S-Phos und dann mit 449 mg (2 mmol) Palladium(II)acetat versetzt und anschließend 24 h unter Rückfluss erhitzt. Nach Erkalten trennt man die organische Phase ab, wäscht diese zweimal mit je 300 ml Wasser und einmal mit 300 ml gesättigter Kochsalzlösung und trocknet über Magnesiumsulfat. Man filtriert vom Trockenmittel ab, engt das Filtrat im Vakuum zur Trockene ein und kristallisiert das glasartige Rohprodukt in der Siedehitze aus Acetonitril (-150 ml) und dann ein zweites Mal aus Acetonitril/Ethylacetat um. Ausbeute: 43.3 g (71 mmol), 71 %; Reinheit: ca. 95 %ig n. ¹H-NMR.

Analog können folgende Verbindungen dargestellt werden:

| Bsp. | Edukte Variante | Produkt | Ausbeut e |
|---|---|---|---|
| L2 | S2 | 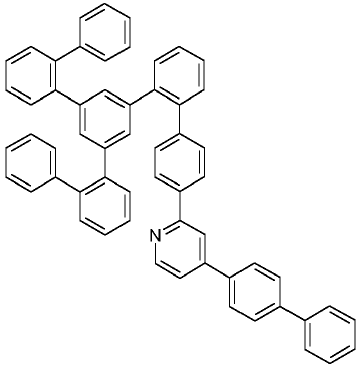 | 75 % |
| | S200 | | |
| L3 | S3 | 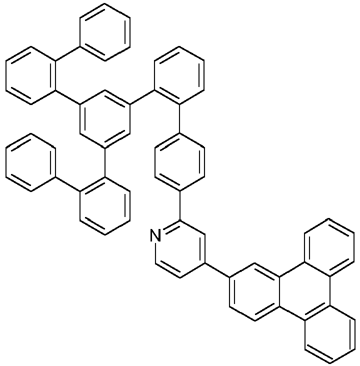 | 79 % |
| | S200 | | |
| L4 | S4 | 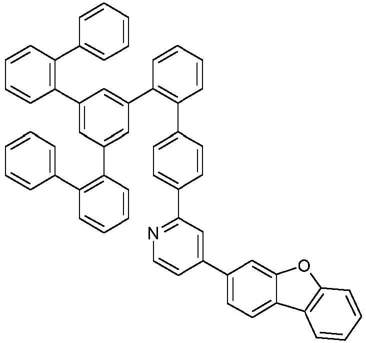 | 70 % |
| | S200 | | |
| L5 | 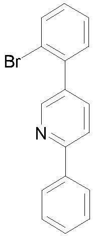 | 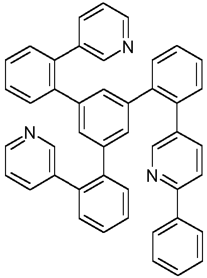 | 73 % |
| | 1989597-29-6 | | |
| | S201 | | |
| L6 | 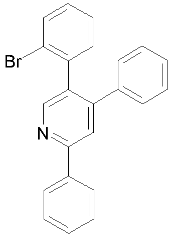 1989597-32-1 | 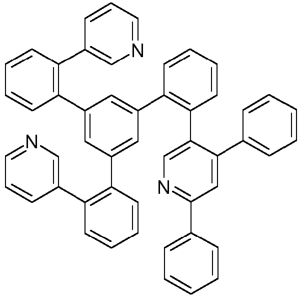 | 70 % |
| | S201 | | |
| L7 | S20 | 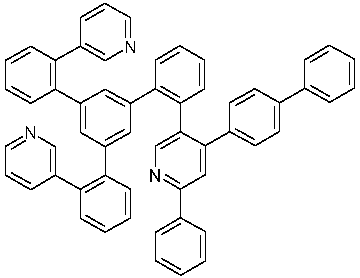 | 77 % |
| | S201 | | |
| L8 | S21 | 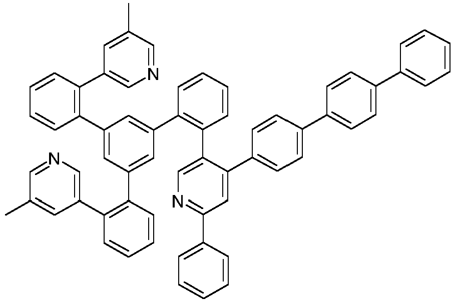 | 72 % |
| | S202 | | |
| L9 | S22 | 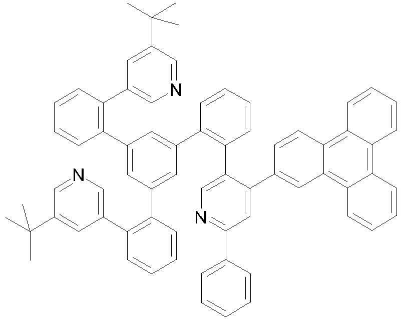 | 67 % |
| | S203 | | |
| L10 | S26 | 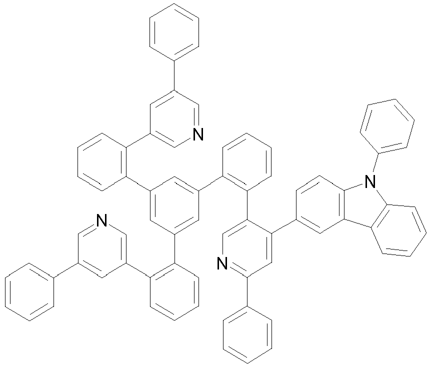 | 69 % |
| | S204 | | |
| L11 | S29 | 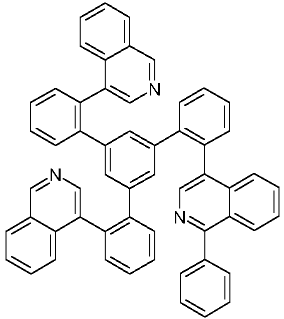 | 76 % |
| | S205 | | |
| L12 | S30 | 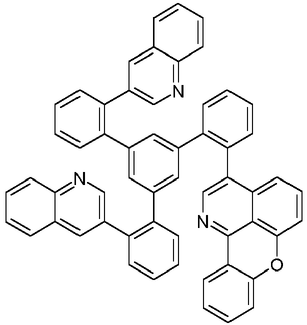 | 75 % |
| | S206 | | |
| L13 | S20 | 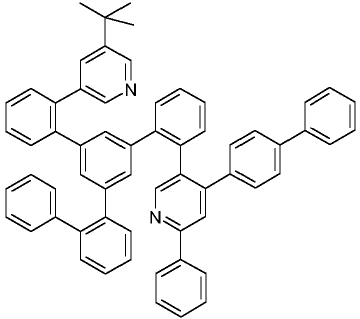 | 65 % |
| | S207 | | |
| L10 0 | S24 | 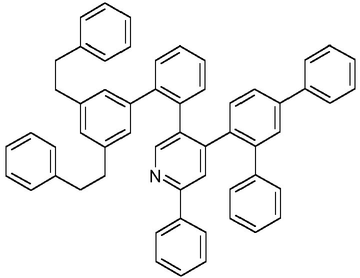 | 67 % |
| | S300 | | |
| L10 1 | S3 | 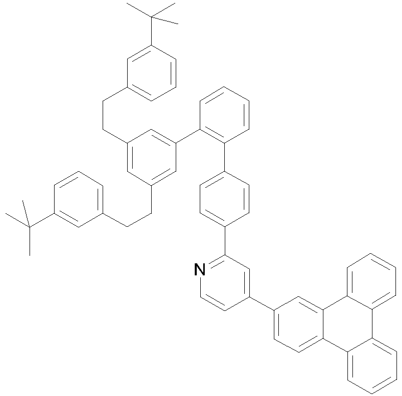 | 78 & |
| | S301 | | |
| L10 2 | S21 | 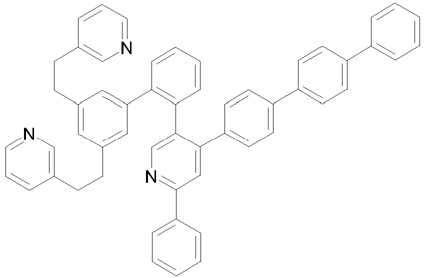 | 74 % |
| | S302 | | |
| L10 3 | S25 | 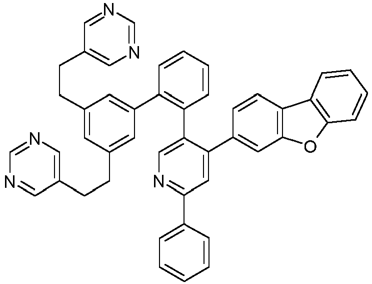 | 70 % |
| | S303 | | |
| L10 4 | S23 | 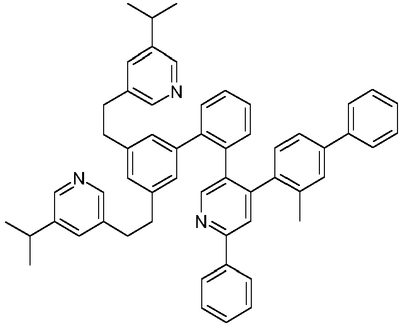 | 69 % |
| | S304 | | |
| L10 5 | S27 | 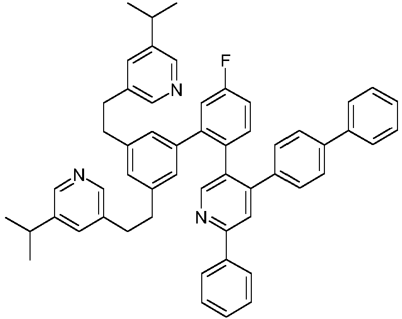 | 72 % |
| | S304 | | |
| L10 6 | S28 | 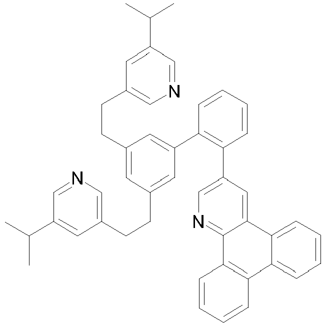 | 75 % |
| | S304 | | |
| L10 7 | S21 | 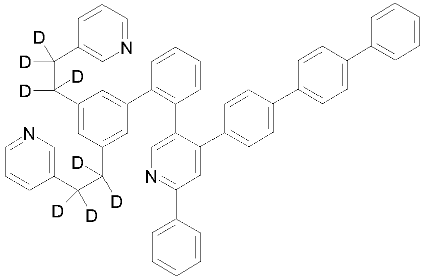 | 72 % |
| | S305 | | |

### Beispiel L200:

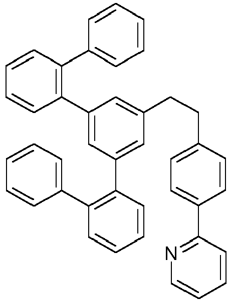

Ein gut gerührtes Gemisch aus 23.4 g (100 mmol) 2-(4-Bromphenyl)-pyridin [63993-36-1], 40.7 g (100 mmol) S400, 81.5 g (250 mmol) Caesiumcarbonat, 50 g Glaskugeln (3 mm Durchmesser), 787 mg (1 mmol) XPhos-Pd-G2 [1310584-14-5], 477 mg (1 mmol) XPhos [564483-18-7] und 500 ml Acetonitril wird 16 h bei 90 °C gerührt. Man saugt noch warm von den Salzen ab und wäscht diese zweimal mit je 200 ml DCM nach. Das Filtrat wird zur Trockene eingeengt. Der Rückstand wird in 1000 ml Dichlormethan aufgenommen. Die organische Phase wird dreimal mit je 300 ml Wasser und einmal mit 300 ml gesättigter Kochsalzlösung gewaschen und über Magnesiumsulfat getrocknet. Man engt die organische Phase auf ca. 500 ml ein, versetzt mit 200 ml Ethylacetat, filtriert über ein Kieselgelbett-Bett ab und entfernt das Lösungsmittel im Vakuum. Der so erhaltene Feststoff wird einmal mit 150 ml Methanol ausgerührt und dann im Vakuum getrocknet. Der Feststoff wird in einem Gemisch aus 500 ml THF und 100 ml MeOH untere Zugabe von 10.7 g (200 mmol) Ammoniumchlorid, 5 g Palladium (5%) auf Kohle bei 40 °C unter 2 bar Wasserstoff-Atmosphäre bis zur beendeten Wasserstoffaufnahme (ca. 12 h) hydriert. Man filtriert vom Katalysator über ein mit THF vorgeschlämmtes Celite-Bett ab, entfernt das Lösungsmittel im Vakuum und flash-chromatographiert den Rückstand an einem Säulenautomaten (CombiFlashTorrent der Fa. A Semrau). Ausbeute: 35.6 g (63 mmol), 63 %; Reinheit: ca. 97 %ig n. ¹H-NMR.

Analog können folgende Verbindungen dargestellt werden:

| Bsp. | Edukte | Produkt | Ausbeute |
|---|---|---|---|
| L201 | S20b | 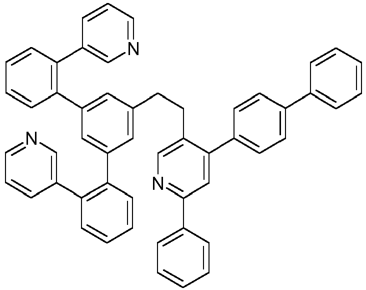 | 55 % |
| | S201 | | |
| L202 | S22b | 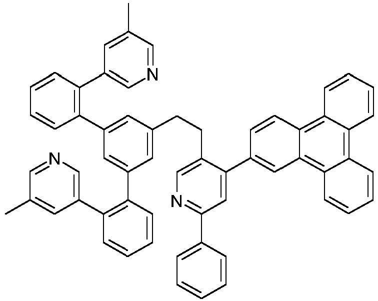 | 58 % |
| | S202 | | |
| L203 | S28 Edukt | 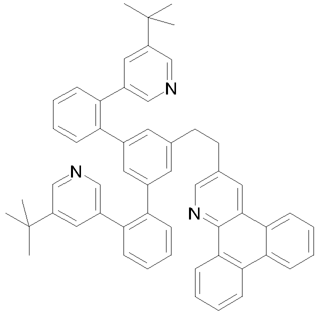 | 61 % |
| | S203 | | |
| L300 | S2b | 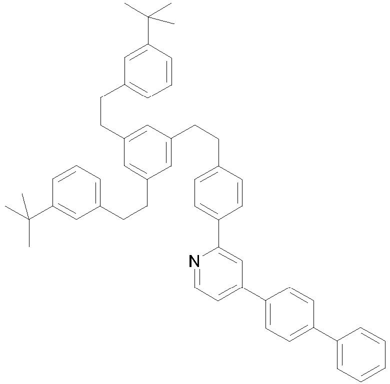 | 57 % |
| | S501 | | |
| L301 | S21b | 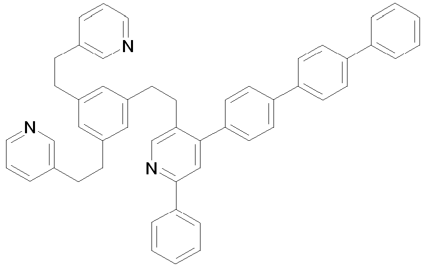 | 60 % |
| | S502 | | |

### C: Synthese der Komplexe:

### C1: Neutrale, einzähnige Co-Liganden

### Beispiel Ir100:

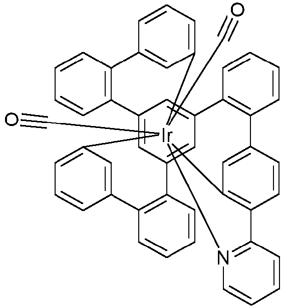

Ein Gemisch aus 6.12 g (10 mmol) L1, 4.15 g (10 mmol) [(1,2,5,6-η)-1,5-Cyclooctadien][(1,2,3,3a,7a-η)-1*H*-inden-1-yl]-iridium (= (Ind)Ir(COD)) [102525-11-1], 100 ml Eisessig und 100 ml Dioxan wird 24 h bei 100 °C gerührt. Man engt die rote Lösung zur Trockene ein, nimmt den Rückstand in 100 ml DCM auf, gibt 5 ml Triethylamin zu und leitet bei 25 °C unter gutem Rühren für 3 h einen Kohlenmonoxid-Strom durch die Lösung. Dann destilliert man das DCM ab und ersetzt das abdestillierte DCM kontinuierlich durch Methanol. Abschließend engt man im Vakuum auf ein Volumen von ca. 50 ml ein, saugt das Produkt ab, wäscht dieses dreimal mit je 30 ml Methanol und trocknet im Vakuum. Die Reinigung erfolgt durch zweimalige Chromatographie an Kieselgel mit DCM/n-Heptan (2:1, vv). Das so erhaltene Produkt kann, wie in WO 2016/124304 beschrieben, mittels Heißextraktion und Tempern bzw. fraktionierter Sublimation weiter gereinigt werden. Ausbeute: 4.42 g (6.3 mmol); 63 % d. Th.; Reinheit: > 99.5 % n. ¹H-NMR.

Analog können folgende Verbindungen dargestellt werden:

| Bsp. | Ligand | Produkt | Ausbeute |
|---|---|---|---|
| Ir101 | L2 | 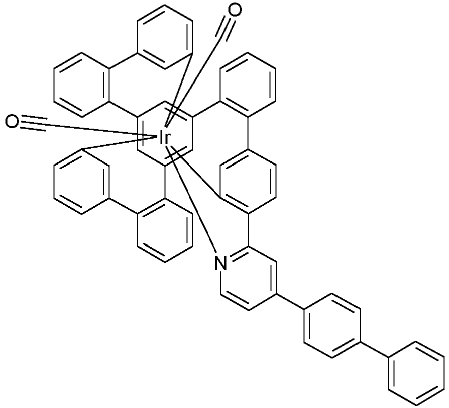 | 48 % |
| Ir102 | L3 | 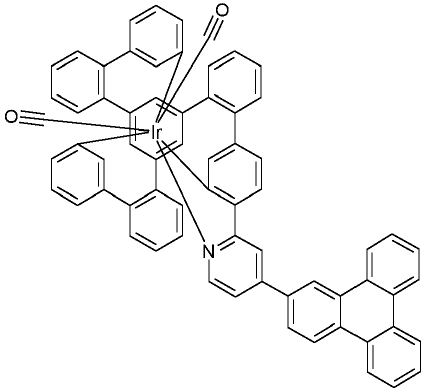 | 45 % |
| Ir103 | L4 | 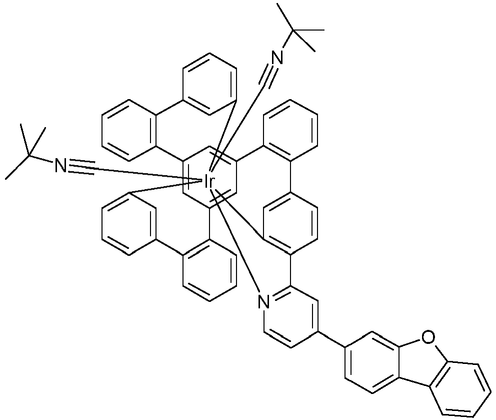 | 49 % |
| | 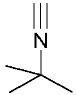 | | |
| | 7188-38-7 | | |
| | 25 mmol Anstelle von CO | | |
| Ir104 | L100 | 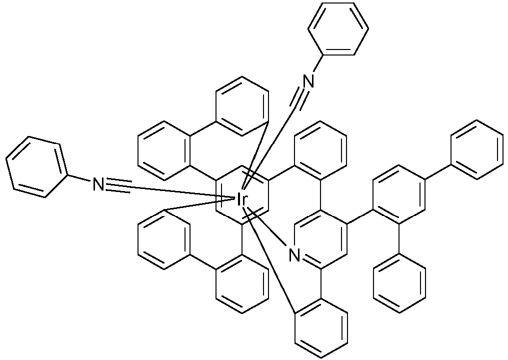 | 37 % |
| | 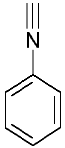 | | |
| | 931-54-4 | | |
| | 25 mmol Anstelle von CO | | |
| Ir105 | L101 | 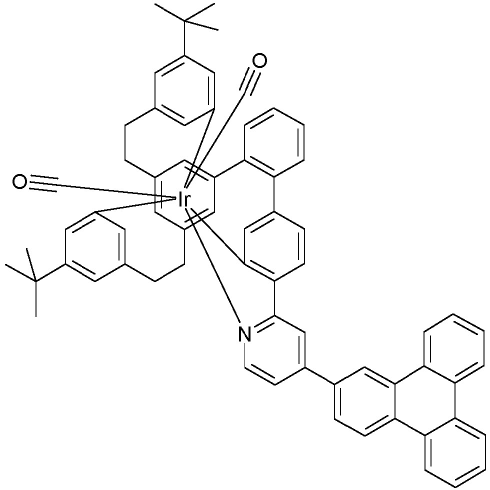 | 55 % |
| Ir106 | L200 | 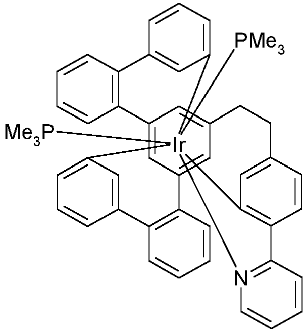 | 51 % |
| | PMe₃ 504-09-2 | | |
| | 25 mmol Anstelle von CO | | |
| Ir107 | L300 | 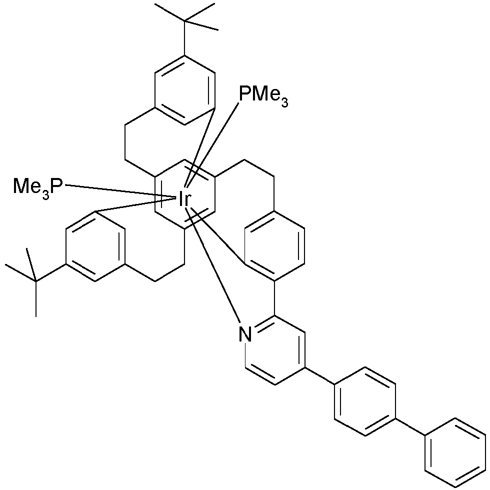 | 37 % |
| | PF₃ 7783-55-3 | | |
| | 25 mmol Anstelle von CO | | |

### C2: Monoanionische, einzähnige Co-Liganden

### Beispiel Ir200:

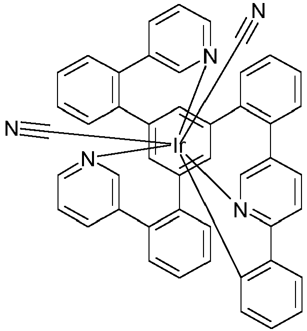

Ein Gemisch aus 6.14 g (10 mmol) L5 und 3.53 g (10 mmol) IrCl₃ x 3 H₂O [13569-57-8], 150 ml Ethoxyethanol und 50 ml Wasser wird 24 h unter Rückfluss erhitzt. Man engt die braune Suspension zur Trockene ein, nimmt den Rückstand in 50 ml DMSO auf, fügt 1.08 g (22 mmol) Natriumcyanid [143-33-9] zu und rührt 8 h bei 50 °C nach. Nach Entfernen des Lösungsmittels im Vakuum nimmt man den Rückstand in 200 ml DCM auf und chromatographiert an Kieselgel. Man schneidet die gelbe Kernfraktion (Rf ~ 0.8) heraus und destilliert das DCM am Rotationsverdampfer bei 50 °C Wasserbadtemperatur bei Normaldruck ab, wobei das abdestillierte Volumen an DCM kontinuierlich durch Zugabe von EtOH ersetzt wird.

Nach beendeter DCM-Destillation engt man im Vakuum auf ca. 100 ml Volumen ein, saugt vom gelben Feststoff über eine Umkehrfritte ab, wäscht den Feststoff zweimal mit je 50 ml Ethanol und trocknet diesen zunächst im Argonstrom und dann im Vakuum (p ~ 10⁻³ mbar, T ~ 100 °C). Das so erhaltene Produkt kann, wie in WO 2016/124304 beschrieben, mittels Heißextraktion und fraktionierter Sublimation weiter gereinigt werden. Ausbeute: 4.06 g (4.7 mmol); 4.7 % d. Th.; Reinheit: > 99.5 % n. ¹H-NMR und HPLC.

Analog kann die folgende Verbindung dargestellt werden:

| Bsp. | Ligand | Produkt | Ausbeute |
|---|---|---|---|
| Ir201 | L7 | 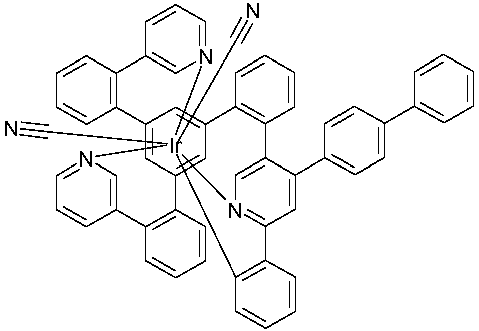 | 43 % |

### C3: Monoanionische und neutrale, einzähnige Co-Liganden

### Beispiel Ir300:

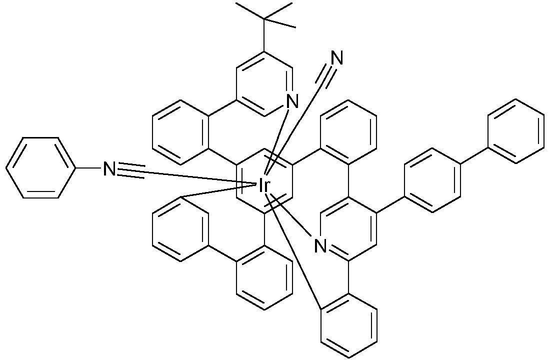

Darstellung analog C2. Einsatz von 8.21 g (10 mmol) L13, 490 mg (10 mmol) NaCN und 1.03 g (10 mmol) Phenyl-isonitril [931-54-4].

Ausbeute: 2.65 g (2.3 mmol); 23 % d. Th., Diastereomerengemisch; Reinheit: > 99.0 % n. ¹H-NMR.

### C4: Neutrale, zweizähnige Co-Liganden

### Beispiel Ir400:

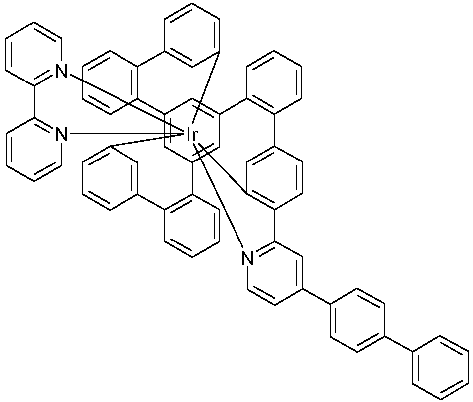

Ein Gemisch aus 7.64 g (10 mmol) L2, 4.15 g (10 mmol) [(1,2,5,6-η)-1,5-Cyclooctadien][(1,2,3,3a,7a-η)-1*H*-inden-1-yl]-iridium (= (Ind)Ir(COD)) [102525-11-1], 100 ml Eisessig und 100 ml Dioxan wird 24 h bei 100 °C gerührt. Man engt die rote Lösung zur Trockene ein, nimmt den Rückstand in 100 ml DCM auf, gibt 5 ml Triethylamin und dann 1.87 g (12 mmol) 2,2'-Bipyridin [366-18-7] zu und rührt 12 h nach. Dann destilliert man das DCM ab und ersetzt das abdestillierte DCM kontinuierlich durch Methanol. Abschließend engt man in Vakuum auf ein Volumen von ca. 50 ml ein, saugt das Produkt ab, wäscht dieses dreimal mit je 30 ml Methanol und trocknet im Vakuum. Die Reinigung erfolgt durch zweimalige Chromatographie an Kieselgel mit DCM/EE (2:1, vv). Das so erhaltene Produkt kann, wie in WO 2016/124304 beschrieben, mittels Heißextraktion und Tempern bzw. fraktionierter Sublimation weiter gereinigt werden. Ausbeute: 3.67 g (3.3 mmol); 33 % d. Th.; Reinheit: > 99.5 % n. ¹H-NMR.

### C5: Monoanionische, zweizähnige Co-Liganden

### Beispiel Ir500:

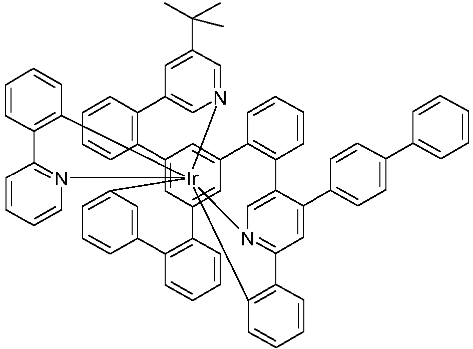

Ein Gemisch aus 8.21 g (10 mmol) L13 und 3.53 g (10 mmol) IrCl₃ x 3 H₂O [13569-57-8], 150 ml Ethoxyethanol und 50 ml Wasser wird 24 h unter Rückfluss erhitzt. Man engt die braune Suspension zur Trockene ein, nimmt den Rückstand in 100 ml 2-Ethoxyethanol auf, gibt 7.76 g (50 mmol) 2-Phenylpyridin [1008-89-5] und dann 7.71 g (30 mmol) Silber-trifluormethansulfonat [2923-28-6] zu und rührt 16 h bei 130 °C nach. Man entfernt das Lösungsmittel im Vakuum, nimmt den Rückstand in 300 ml DCM auf, filtriert über ein mit DCM vorgeschlämmtes Celite-Bett ab, destilliert das DCM ab und ersetzt es kontinuierlich mit Methanol. Abschließend engt man auf ca. 100 ml ein, saugt vom ausgefallenen Produkt ab, wäscht dieses dreimal mit je 30 ml Methanol und trocknet im Vakuum. Die Reinigung erfolgt durch zweimalige Chromatographie an Kieselgel mit Toluol/DCM (9:1, vv). Das so erhaltene Produkt kann, wie in WO 2016/124304 beschrieben, mittels Heißextraktion und Tempern bzw. fraktionierter Sublimation weiter gereinigt werden. Ausbeute: Ir500a, Diastereomer1: 2.50 g (2.1 mmol); Ir500b, Diastereomer2: 2.24 g (1.9 mmol); Reinheit: > 99.5 % n. ¹H-NMR.

### C6: Dianionische, zweizähnige Co-Liganden

### Beispiel Ir600:

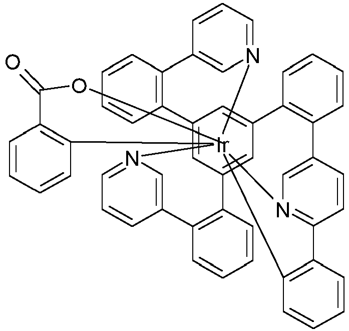

Ein 1000 ml Dreihalskolben mit Magnetrührkern, Wasserabscheider mit Rückflusskühler und Argonüberlagerung, Innenthermometer (Pt-100 Thermoelement) und Tropftrichter wird unter Argonatmosphäre mit 6.14 g (10 mmol) Ligand L5, 3.53 g (10 mmol) IrCl₃ x 3 H₂O [13569-57-8], 29.45 g (300 mmol) Kaliumacetat (wasserfrei) [127-08-2], 244 g (2 mol) Benzoesäure [65-85-0] und 9.47 ml (100 mmol) Acetanhydrid [108-24-7] beschickt. Man heizt die Reaktionsmischung zügig auf 250 °C auf und rührt dann 3 h bei dieser Temperatur nach. Die abdestillierte Essigsäure wird über den Wasserabscheider ausgeschleust. Nach 3 h lässt man die Reaktionsmischung auf 130 °C erkalten und gibt dann langsam (Vorsicht Siedeverzüge möglich!) tropfenweise 500 ml Methanol zu. Man lässt das ausgefallene Produkt sedimentieren, dekantiert vom Überstand ab, überführt mit Methanol auf eine Umkehrfritte, saugt das Produkt ab, wäscht dreimal mit 50 ml heißem Methanol nach und trocknet im Vakuum. Man suspendiert den Feststoff für 1 h in 300 ml warmen DCM und chromatographiert dann mit DCM an 300 g Kieselgel 60 (Merck). Man schneidet die gelbe-orange Kernfraktion (Rf ~ 0.9) heraus und destilliert das DCM am Rotationsverdampfer bei 50 °C Wasserbadtemperatur bei Normaldruck ab, wobei das abdestillierte Volumen an DCM kontinuierlich durch Zugabe von EtOH ersetzt wird. Nach beendeter DCM-Destillation engt man im Vakuum auf ca. 100 ml Volumen ein, saugt vom gelben Feststoff über eine Umkehrfritte ab, wäscht den Feststoff zweimal mit je 50 ml Ethanol und trocknet diesen zunächst im Argonstrom und dann im Vakuum (p ~ 10⁻³ mbar, T ~ 100 °C). Das so erhaltene Produkt kann, wie in WO 2016/124304 beschrieben, mittels Heißextraktion und fraktionierter Sublimation weiter gereinigt werden. Ausbeute: 8.5 g (9.00 mmol); 90 % d. Th.; Reinheit: > 99.5 % n. ¹H-NMR und HPLC.

Analog können folgende Verbindungen dargestellt werden:

| Bsp. | Ligand | Produkt | Ausbeute |
|---|---|---|---|
| Ir601 | L6 | 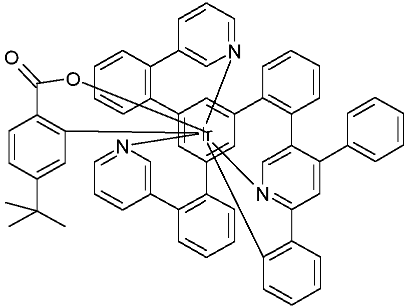 | 67 % |
| | 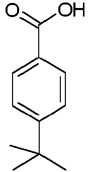 | | |
| | 98-73-3 | | |
| Ir602 | L7 | 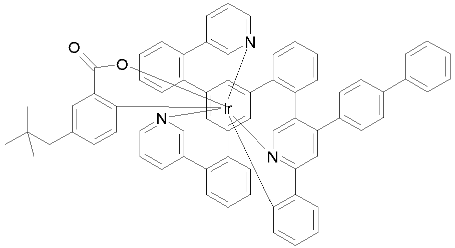 | 70 % |
| | 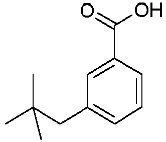 | | |
| | 67688-80-6 | | |
| Ir603 | L8 | 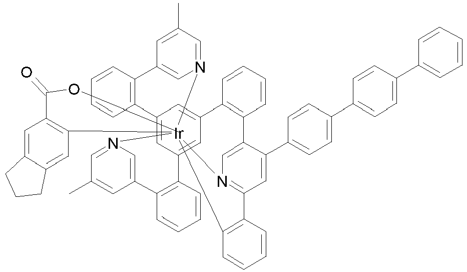 | 64 % |
| | 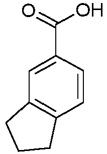 | | |
| | 65898-38-6 | | |
| Ir604 | L9 | 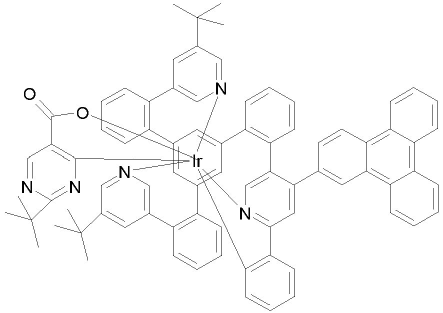 | 34 % |
| | 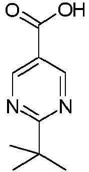 | | |
| | 126230-73-7 | | |
| Ir605 | L10 | 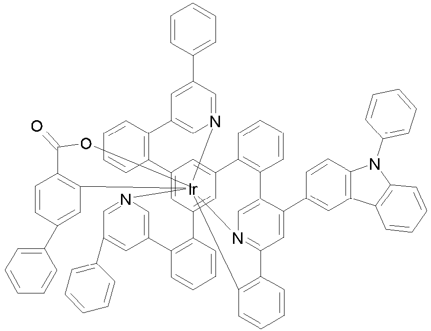 | 67 % |
| | 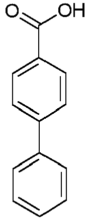 | | |
| | 92-92-2 | | |
| Ir606 | L11 | 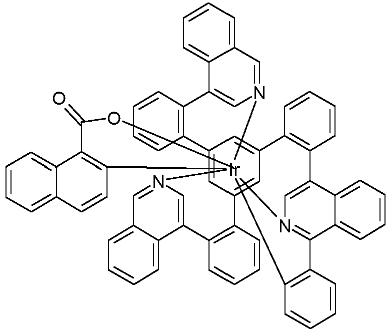 | 63 % |
| | 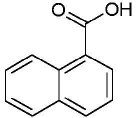 | | |
| | 86-55-5 | | |
| Ir607 | L12 | 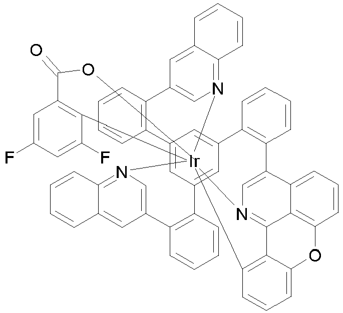 | 48 % |
| | 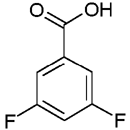 | | |
| | 455-40-3 | | |
| Ir608 | L102 | 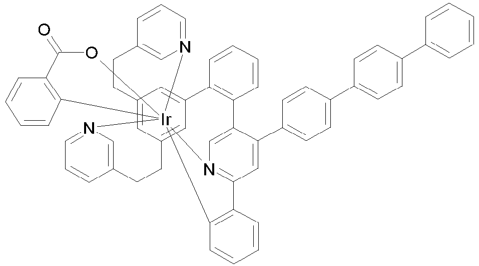 | 77 % |
| | 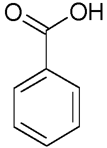 | | |
| | 65-85-0 | | |
| Ir609 | L103 | 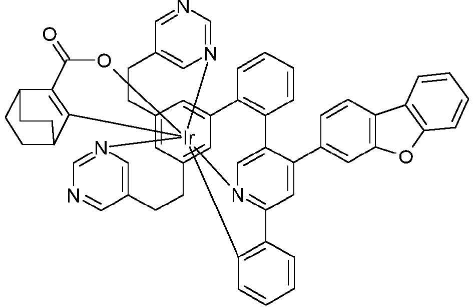 | 60 % |
| | 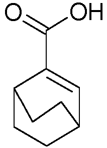 | | |
| | 16317-22-9 | | |
| Ir610 | L104 | 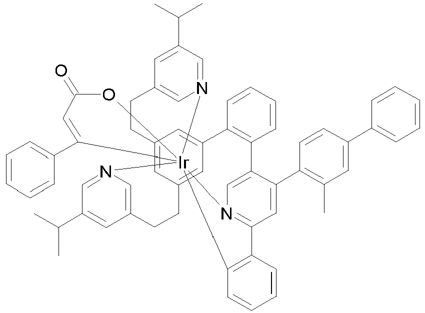 | 38 % |
| | 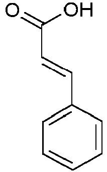 | | |
| | 140-10-3 | | |
| Ir611 | L105 | 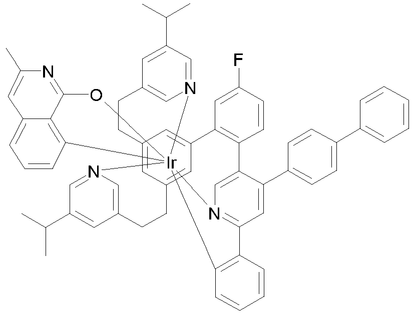 | 55 % |
| | 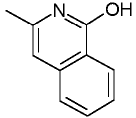 | | |
| | 7114-80-9 | | |
| Ir612 | L106 | 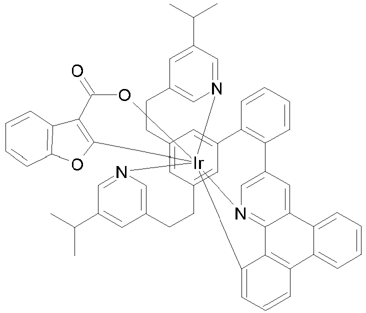 | 22 % |
| | 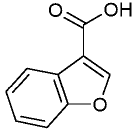 | | |
| | 26537-68-8 | | |
| Ir613 | L201 | 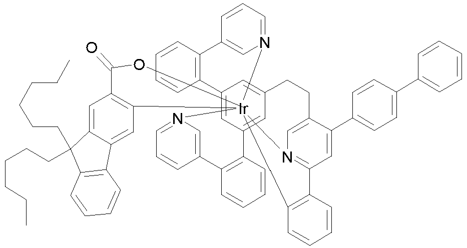 | 69 % |
| | 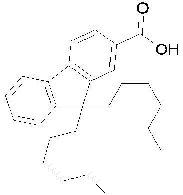 | | |
| | 1877288-45-3 | | |
| Ir614 | L202 | 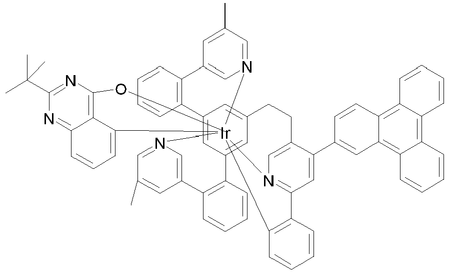 | 55 % |
| | 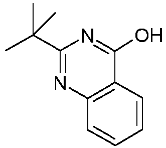 | | |
| | 13182-65-5 | | |
| Ir615 | L203 | 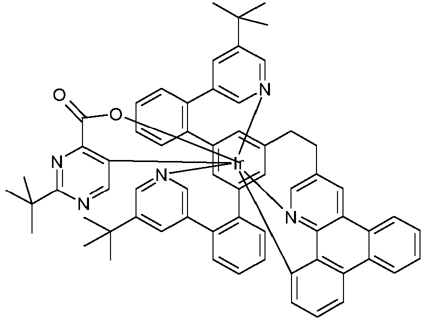 | 61 % |
| | 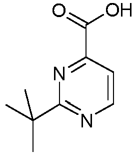 | | |
| | 847955-90-2 | | |
| Ir616 | L301 | 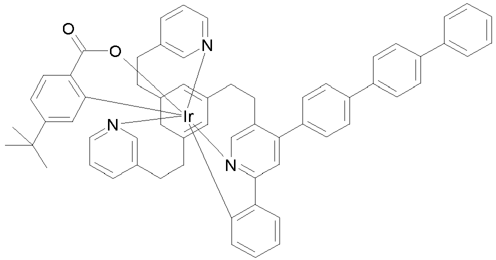 | 67 % |
| | 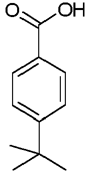 | | |
| | 98-73-3 | | |
| Ir617 | L7 | 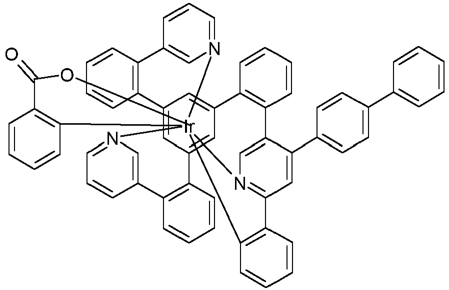 | 70 % |
| | 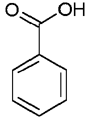 | | |
| | 65-85-0 | | |
| Ir618 | L107 | 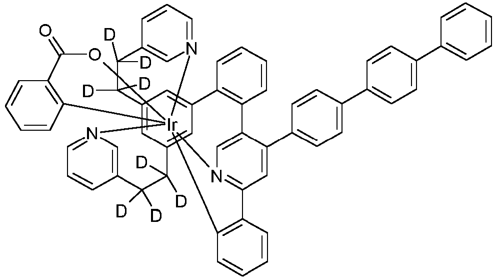 | 77 % |
| | 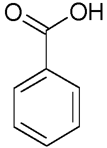 | | |
| | 65-85-0 | | |

### Beispiel: Herstellung der OLEDs

### 1) Vakuum-prozessierte Devices:

Die Herstellung von erfindungsgemäßen OLEDs sowie OLEDs nach dem Stand der Technik erfolgt nach einem allgemeinen Verfahren gemäß WO 2004/058911, das auf die hier beschriebenen Gegebenheiten (Schichtdickenvariation, verwendete Materialien) angepasst wird.

In den folgenden Beispielen werden die Ergebnisse verschiedener OLEDs vorgestellt. Gereinigte Glasplättchen (Reinigung in Miele Laborspülmaschine, Reiniger Merck Extran), die mit strukturiertem ITO (Indium Zinn Oxid) der Dicke 50 nm beschichtet sind, werden 25 Minuten mit UV-Ozon vorbehandelt (UV-Ozon Generator PR-100, Firma UVP) und innerhalb 30 min. zur verbesserten Prozessierung mit 20 nm PEDOT:PSS beschichtet (Poly(3,4-ethylendioxy-thiophen)poly(styrolsulfonat), bezogen als CLEVIOS^{™} P VP Al 4083 von Heraeus Precious Metals GmbH Deutschland, aus wässriger Lösung aufgeschleudert) und anschließend bei 180 °C 10 min. lang ausgeheizt. Diese beschichteten Glasplättchen bilden die Substrate, auf welche die OLEDs aufgebracht werden.

Die OLEDs haben prinzipiell folgenden Schichtaufbau: Substrat / Lochinjektionsschicht 1 (HIL1) bestehend aus HTM1 dotiert mit 5 % NDP-9 (kommerziell erhältlich von der Fa. Novaled), 20 nm / Lochtransportschicht 1 (HTL1) bestehend aus HTM1, 150 nm für blaue Devices, 215 nm für grüne/gelbe Devices, 110 nm für rote Devices / Lochtransportschicht 2 (HTL2) / Emissionsschicht (EML) / Lochblockierschicht (HBL) / Elektronentransportschicht (ETL) und abschließend eine Kathode. Die Kathode wird durch eine 100 nm dicke Aluminiumschicht gebildet.

Zunächst werden vakuum-prozessierte OLEDs beschrieben. Hierfür werden alle Materialien in einer Vakuumkammer thermisch aufgedampft. Dabei besteht die Emissionsschicht immer aus mindestens einem Matrixmaterial (Hostmaterial, Wirtsmaterial) und einem emittierenden Dotierstoff (Dotand, Emitter), der dem Matrixmaterial bzw. den Matrixmaterialien durch Co₋Verdampfung in einem bestimmten Volumenanteil beigemischt wird. Eine Angabe wie M1:M2:Ir(L1) (55%:35%:10%) bedeutet hierbei, dass das Material M1 in einem Volumenanteil von 55%, M2 in einem Volumenanteil von 35% und Ir(L1) in einem Volumenanteil von 10% in der Schicht vorliegt. Analog kann auch die Elektronentransportschicht aus einer Mischung zweier Materialien bestehen. Der genaue Aufbau der OLEDs ist Tabelle 1 zu entnehmen. Die zur Herstellung der OLEDs verwendeten Materialien sind in Tabelle 4 gezeigt.

Die OLEDs werden standardmäßig charakterisiert. Hierfür werden die Elektrolumineszenzspektren, die Stromeffizienz (gemessen in cd/A), die Leistungseffizienz (gemessen in Im/W) und die externe Quanteneffizienz (EQE, gemessen in Prozent) in Abhängigkeit der Leuchtdichte, berechnet aus Strom-Spannungs-Leuchtdichte-Kennlinien (IUL-Kennlinien) unter Annahme einer lambertschen Abstrahlcharakteristik sowie die Lebensdauer bestimmt. Die Elektrolumineszenzspektren werden bei einer Leuchtdichte von 1000 cd/m² bestimmt und daraus die CIE 1931 x und y Farbkoordinaten berechnet. Die OLEDs können initital auch bei anderen Startleuchtdichten betrieben werden. Die Werte für die Lebensdauer können dann mit Hilfe dem Fachmann bekannten Umrechnungsformeln auf eine Angabe für andere Startleuchtdichten umgerechnet werden.

### Verwendung von erfindungsgemäßen Verbindungen als Emittermaterialien in phosphoreszierenden OLEDs

Die erfindungsgemäßen Verbindungen lassen sich unter anderem als phosphoreszierende Emittermaterialien in der Emissionsschicht in OLEDs einsetzen. Die Ergebnisse der OLEDs sind in Tabelle 2 zusammengefasst.

**Tabelle 1: Aufbau der OLEDs**

| **Bsp.** | **HTL2 Dicke** | **EML Dicke** | **HBL Dicke** | **ETL Dicke** |
|---|---|---|---|---|
| D1 | HTM3 | M3:M4:lr101 (30%:60%:10%) | ETM1 | ETM1:ETM2 (50%:50%) |
| | 20 nm | 30 nm | 10nm | 30 nm |
| D2 | HTM2 | M1:M2:lr201 (30%:60%:10%) | ETM1 | ETM1:ETM2 (50%:50%) |
| | 10 nm | 30 nm | 10nm | 30 nm |
| D3 | HTM2 | M1:M2:Ir500a (60%:30%:10%) | ETM1 | ETM1:ETM2 (50%:50%) |
| | 10 nm | 30 nm | 10nm | 30 nm |
| D4 | HTM2 | M1:M2:Ir608 (45%:45%:10%) | ETM1 | ETM1:ETM2 (50%:50%) |
| | 10 nm | 30 nm | 10nm | 30 nm |
| D5 | HTM2 | M1:M2:Ir617 (45%:45%:10%) | ETM1 | ETM1:ETM2 (50%:50%) |
| | 10 nm | 30 nm | 10nm | 30 nm |

**Tabelle 2: Ergebnisse der Vakuum-prozessierten OLEDs**

| **Bsp.** | **EQE (%) 1000 cd/m²** | **Spannung (V) 1000 cd/m²** | **CIE x/y 1000 cd/m²** |
|---|---|---|---|
| D1 | 23.2 | 3.6 | 0.16/0.35 |
| D2 | 25.7 | 3.1 | 0.32/0.63 |
| D3 | 23.8 | 3.0 | 0.51/0.48 |
| D4 | 27.3 | 3.1 | 0.52/0.48 |
| D5 | 27.9 | 3.0 | 0.56/0.43 |

### Lösungs-prozessierte Devices:

### A: Aus niedermolekularen löslichen Funktionsmaterialien

Die erfindungsgemäßen Iridium-Komplexe können auch aus Lösung verarbeitet werden und führen dort zu prozesstechnisch wesentlich einfacheren OLEDs, im Vergleich zu den vakuumprozessierten OLEDs, mit dennoch guten Eigenschaften. Die Herstellung solcher Bauteile lehnt sich an die Herstellung polymerer Leuchtdioden (PLEDs) an, die in der Literatur bereits vielfach beschrieben ist (z. B. in der WO 2004/037887). Der Aufbau setzt sich aus Substrat / ITO / Lochinjektionsschicht (60 nm) / Interlayer (20 nm) / Emissionsschicht (60 nm) / Lochblockierschicht (10 nm) / Elektronentransportschicht (40 nm) / Kathode zusammen. Dazu werden Substrate der Firma Technoprint (Sodalimeglas) verwendet, auf welche die ITO-Struktur (Indium-Zinn-Oxid, eine transparente, leitfähige Anode) aufgebracht wird. Die Substrate werden im Reinraum mit DI Wasser und einem Detergens (Deconex 15 PF) gereinigt und dann durch eine UV/Ozon-Plasmabehandlung aktiviert. Danach wird ebenfalls im Reinraum eine 20 nm Lochinjektionsschicht (PEDOT:PSS von Clevios^{™}) durch Spin-Coating aufgebracht. Die benötigte Spinrate hängt vom Verdünnungsgrad und der spezifischen Spin-Coater-Geometrie ab. Um Restwasser aus der Schicht zu entfernen, werden die Substrate für 30 Minuten bei 200 °C auf einer Heizplatte ausgeheizt. Die verwendete Interlayer dient dem Lochtransport, wobei in diesem Fall wird HL-X von Merck verwendet wird. Die Interlayer kann alternativ auch durch eine oder mehrere Schichten ersetzt werden, die lediglich die Bedingung erfüllen müssen, durch den nachgelagerten Prozessierungsschritt der EML-Abscheidung aus Lösung nicht wieder abgelöst zu werden. Zur Herstellung der Emissionsschicht werden die erfindungsgemäßen Triplettemitter zusammen mit den Matrixmaterialien in Toluol oder Chlorbenzol gelöst. Der typische Feststoffgehalt solcher Lösungen liegt zwischen 16 und 25 g/L, wenn, wie hier, die für eine Device typische Schichtdicke von 60 nm mittels Spincoating erzielt werden soll. Die lösungsprozessierten Devices enthalten eine Emissionsschicht aus M5:M6:IrL (20%:55%:25%). Die Emissionsschicht wird in einer Inertgasatmosphäre, im vorliegenden Fall Argon, aufgeschleudert und 10 min bei 160 °C ausgeheizt. Darüber wird die Lochblockierschicht (10 nm ETM1) und die Elektronentransportschicht (40 nm ETM1 (50%) / ETM2 (50%)) aufgedampft (Aufdampfanlagen von Lesker o.a., typischer Aufdampfdruck 5 x 10⁻⁶ mbar). Zuletzt wird eine Kathode aus Aluminium (100 nm) (hochreines Metall von Aldrich) aufgedampft. Um das Device vor Luft und Luftfeuchtigkeit zu schützen, wird die Vorrichtung abschließend verkapselt und dann charakterisiert. Die genannten OLED-Beispiele sind noch nicht optimiert. Tabelle 3 fasst die erhaltenen Daten zusammen.

**Tabelle 3: Ergebnisse mit aus Lösung prozessierten Materialien**

| **Bsp.** | **Emitter Device** | **EQE (%)** | **Spannung (V)** | **CIE x/y** |
|---|---|---|---|---|
| | | **1000 cd/m²** | **1000 cd/m²** | **1000 cd/m²** |
| Sol-D1 | Ir107 | 20.0 | 4.6 | 0.28/0.60 |
| Sol-D2 | Ir300 | 19.3 | 4.5 | 0.48/0.51 |
| Sol-D3 | Ir400 | 16.2 | 4.7 | 0.56/0.41 |
| Sol-D4 | Ir602 | 21.8 | 4.5 | 0.56/0.43 |
| Sol-D5 | Ir606 | 20.7 | 4.4 | 0.66/0.34 |
| Sol-D6 | Ir613 | 19.8 | 4.6 | 0.47/0.49 |
| Sol-D7 | Ir616 | 21.5 | 4.4 | 0.49/0.50 |

**Tabelle 4: Strukturformeln der verwendeten Materialien**

| | |
|---|---|
| 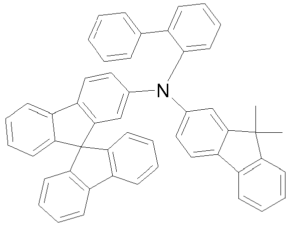 HTM1 [136463-07-5] | 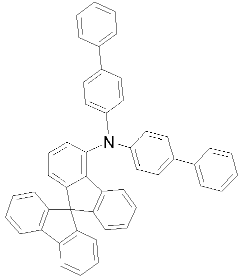 HTM2 [1450933-43-3] |
| 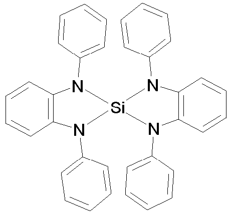 HTM3 [1206465-62-4] | 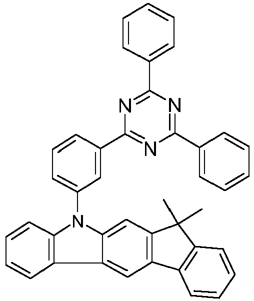 M1 [1257248-13-7] |
| 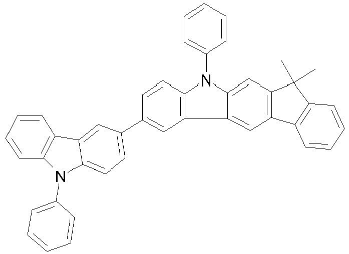 M2 [1357150-54-9] | 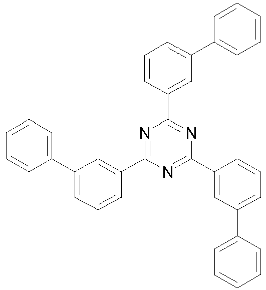 M3 [1201800-83-0] |
| 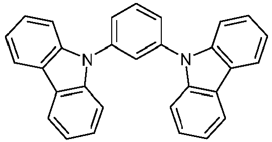 M4 [550378-78-4] | 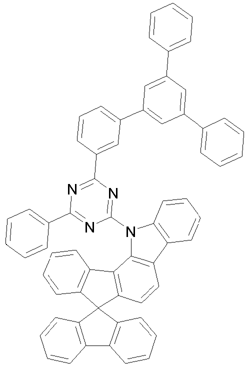 M5 [1616231-60-7] |
| 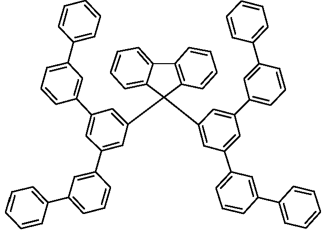 M6 [1246496-85-4] | 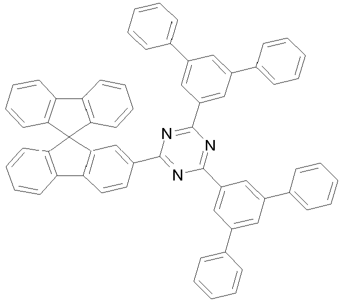 ETM1 = M10 [1233200-52-6] |
| 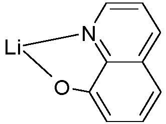 ETM2 [25387-93-3] | |

## Patentansprüche

1. Verbindung der Formel (1), 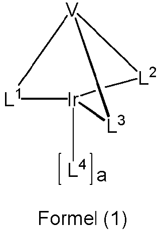 wobei für die verwendeten Symbole und Indizes gilt:
L¹ ist ein bidentater Teilligand, der über ein Kohlenstoffatom und ein Stickstoffatom oder über zwei Kohlenstoffatome an das Iridium koordiniert;
L², L³ sind gleich oder verschieden bei jedem Auftreten gewählt aus einer Aryl- oder Heteroarylgruppe mit 5 bis 14 aromatischen Ringatomen oder einer heteroalicyclischen Gruppe mit 5 bis 7 Ringatomen, die jeweils über ein Kohlenstoffatom oder ein Stickstoffatom, das jeweils Teil der Aryl- bzw. Heteroarylgruppe bzw. der heteroalicyclischen Gruppe ist, an das Iridium koordiniert und die durch einen oder mehrere Reste R substituiert sein kann;
L⁴ ist ein bidentater Ligand oder ist bei jedem Auftreten gleich oder verschieden ein monodentater Ligand;
a ist 1, wenn L⁴ ein bidentater Ligand ist, und ist 2, wenn L⁴ ein monodentater Ligand ist;
V ist eine Gruppe der Formel (2) oder (3), 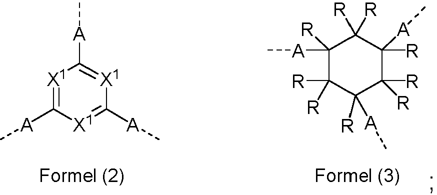 wobei die gestrichelten Bindungen jeweils die Position der Verknüpfung zu den Teilliganden L¹, L² und L³ darstellen und weiterhin gilt:
A ist bei jedem Auftreten gleich oder verschieden CR₂-CR₂ oder eine Gruppe der folgenden Formel (4): 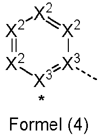 wobei die gestrichelte Bindung jeweils die Position der Bindung der Teilliganden L¹, L² bzw. L³ darstellt und * die Position der Verknüpfung der Einheit der Formel (4) mit der zentralen trivalenten Aryl- bzw. Heteroarylgruppe in Formel (2) bzw. mit der zentralen Cyclohexangruppe in Formel (3) darstellt;
X¹ ist bei jedem Auftreten gleich oder verschieden CR oder N;
X² ist bei jedem Auftreten gleich oder verschieden CR oder N; oder zwei benachbarte Gruppen X² stehen zusammen für NR, O oder S, so dass ein Fünfring entsteht, und die verbleibenden Gruppen X² stehen gleich oder verschieden bei jedem Auftreten für CR oder N; oder zwei benachbarte Gruppen X² stehen zusammen für CR oder N, wenn in dem Cyclus eine der Gruppen X³ für N steht, so dass ein Fünfring entsteht, und die verbleibenden Gruppen X² stehen gleich oder verschieden bei jedem Auftreten für CR oder N; mit der Maßgabe, dass maximal zwei benachbarte Gruppen X² in jedem Ring für N stehen;
X³ ist bei jedem Auftreten in demselben Cyclus C, oder eine Gruppe X³ steht für N und die andere Gruppe X³ in demselben Cyclus steht für C; mit der Maßgabe, dass zwei benachbarte Gruppen X² zusammen für CR oder N stehen, wenn in dem Cyclus eine der Gruppen X³ für N steht;
R ist bei jedem Auftreten gleich oder verschieden H, D, F, Cl, Br, I, N(R¹)₂, OR¹, SR¹, CN, NO₂, COOH, C(=O)N(R¹)₂, Si(R¹)₃, Ge(R¹)₃, B(OR¹)₂, C(=O)R¹, P(=O)(R¹)₂, S(=O)R¹, S(=O)₂R¹, OSO₂R¹, eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R¹ substituiert sein kann und wobei eine oder mehrere nicht benachbarte CH₂-Gruppen durch Si(R¹)₂, C=O, NR¹, O, S oder CONR¹ ersetzt sein können, oder ein aromatisches oder heteroaromatisches Ringsystem mit 5 bis 40 aromatischen Ringatomen, das jeweils durch einen oder mehrere Reste R¹ substituiert sein kann; dabei können zwei Reste R auch miteinander ein Ringsystem bilden;
R¹ ist bei jedem Auftreten gleich oder verschieden H, D, F, Cl, Br, I, N(R²)₂, OR², SR², CN, NO₂, Si(R²)₃, Ge(R²)₃, B(OR²)₂, C(=O)R², P(=O)(R²)₂, S(=O)R², S(=O)₂R², OSO₂R², eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R² substituiert sein kann und wobei eine oder mehrere nicht benachbarte CH₂-Gruppen durch Si(R²)₂, C=O, NR², O, S oder CONR² ersetzt sein können, oder ein aromatisches oder heteroaromatisches Ringsystem mit 5 bis 40 aromatischen Ringatomen, das jeweils durch einen oder mehrere Reste R² substituiert sein kann; dabei können zwei oder mehrere Reste R¹ miteinander ein Ringsystem bilden;
R² ist bei jedem Auftreten gleich oder verschieden H, D, F oder ein aliphatischer, aromatischer und/oder heteroaromatischer organischer Rest, insbesondere ein Kohlenwasserstoffrest, mit 1 bis 20 C-Atomen, in dem auch ein oder mehrere H-Atome durch F ersetzt sein können.

2. Verbindung nach Anspruch 1, **dadurch gekennzeichnet, dass** die Gruppe der Formel (2) durch Formel (2a) dargestellt wird und dass die Gruppe der Formel (3) durch Formel (3a) dargestellt wird, 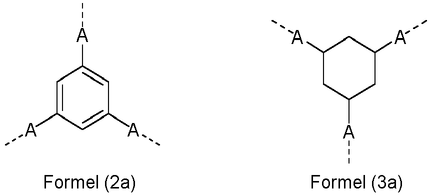 wobei die Symbole die in Anspruch 1 genannten Bedeutungen aufweisen.

3. Verbindung nach Anspruch 1 oder 2, **dadurch gekennzeichnet, dass** die Gruppe der Formel (4) durch Formel (4') dargestellt wird, 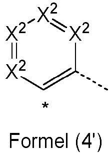 wobei die Symbole die in Anspruch 1 aufgeführten Bedeutungen aufweisen und X² bevorzugt gleich oder verschieden bei jedem Auftreten für CR steht.

4. Verbindung nach einem oder mehreren der Ansprüche 1 bis 3,
**dadurch gekennzeichnet, dass** alle drei Gruppen A für die gleiche Gruppe der Formel (4') mit X² = CR stehen oder dass zwei Gruppen A für die gleiche Gruppe der Formel (4') mit X² = CR stehen und und die dritte Gruppe A für CR₂-CR₂ steht oder dass eine Gruppe A für eine Gruppe der Formel (4') mit X² = CR steht und die beiden anderen Gruppen A für die gleiche Gruppe CR₂-CR₂ stehen oder dass alle drei Gruppen A für die gleiche Gruppe CR₂-CR₂ stehen.

5. Verbindung nach einem oder mehreren der Ansprüche 1 bis 4,
**dadurch gekennzeichnet, dass** die Gruppe der Formel (2) ausgewählt ist aus den Gruppen der Formeln (2a-1) bis (2d-1) und dass die Gruppe der Formel (3) ausgewählt ist aus den Gruppen der Formeln (3a-1) bis (3d-1), 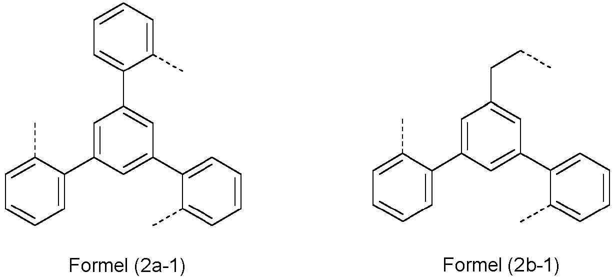 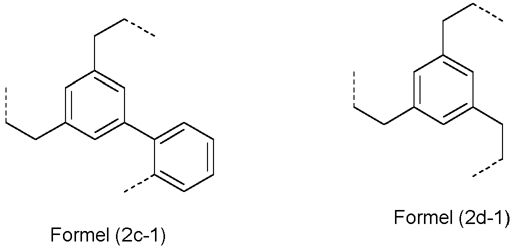 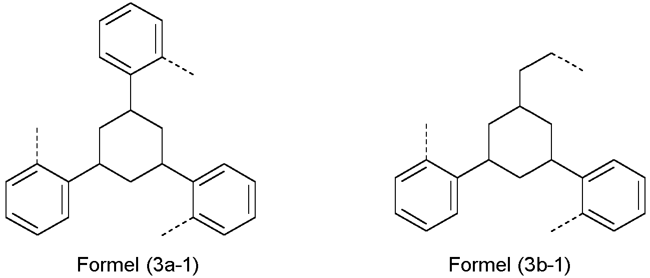 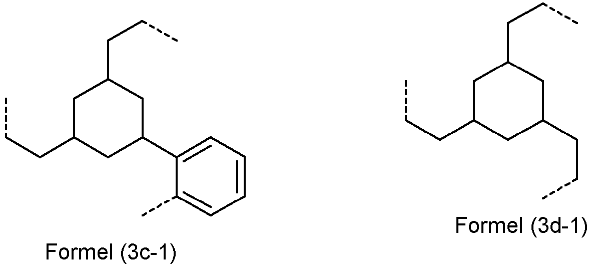 wobei die Symbole die in Anspruch 1 genannten Bedeutungen aufweisen.

6. Verbindung nach einem oder mehreren der Ansprüche 1 bis 5,
**dadurch gekennzeichnet, dass** der Teilligand L¹ eine Struktur gemäß einer der folgenden Formeln (L¹-1) oder (L¹-2) aufweist, 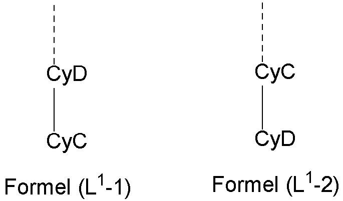 wobei die gestrichelte Bindung die Bindung des Teilliganden L¹ an V darstellt und für die weiteren Symbole gilt:
CyC ist gleich oder verschieden bei jedem Auftreten eine substituierte oder unsubstituierte Aryl- oder Heteroarylgruppe mit 5 bis 14 aromatischen Ringatomen, welche jeweils über ein Kohlenstoffatom an das Iridium koordiniert und welche über eine kovalente Bindung mit CyD verbunden ist;
CyD ist gleich oder verschieden bei jedem Auftreten eine substituierte oder unsubstituierte Heteroarylgruppe mit 5 bis 14 aromatischen Ringatomen oder eine substituierte oder unsubstituierte heteroalicyclische Gruppe mit 5 bis 7 Ringatomen, welche jeweils über ein Stickstoffatom oder über ein Carben-Kohlenstoffatom an das Iridium koordiniert und welche über eine kovalente Bindung mit CyC verbunden ist;
dabei können mehrere der optionalen Substituenten miteinander ein Ringsystem bilden.

7. Verbindung nach Anspruch 6, **dadurch gekennzeichnet, dass** CyC ausgewählt ist aus den Strukturen der Formeln (CyC-1) bis (CyC-20), wobei die Gruppe CyC jeweils an der durch # gekennzeichneten Position an CyD bindet und an der durch * gekennzeichneten Position an das Iridium koordiniert, 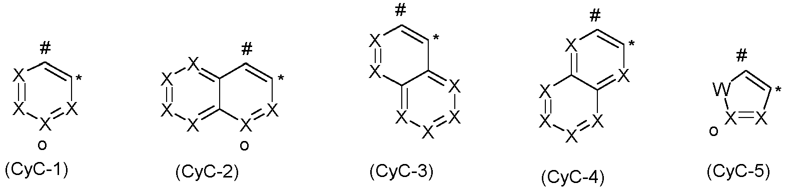 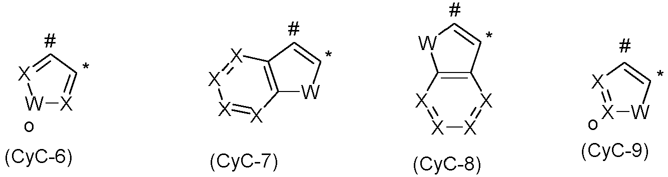 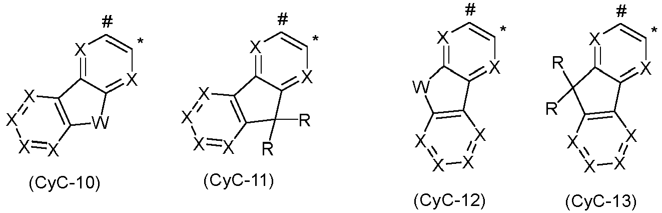 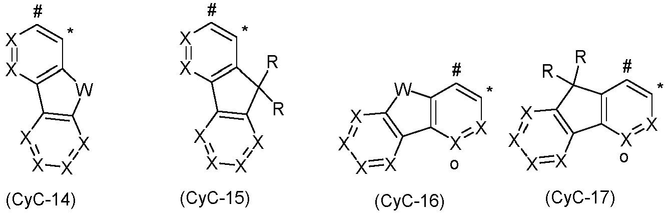 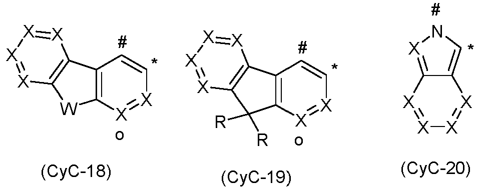 und dass CyD ausgewählt ist aus den Strukturen der Formeln (CyD-1) bis (CyD-23), wobei die Gruppe CyD jeweils an der durch # gekennzeichneten Position an CyC bindet und an der durch * gekennzeichneten Position an das Iridium koordiniert, 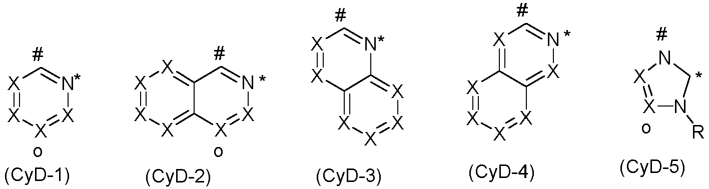 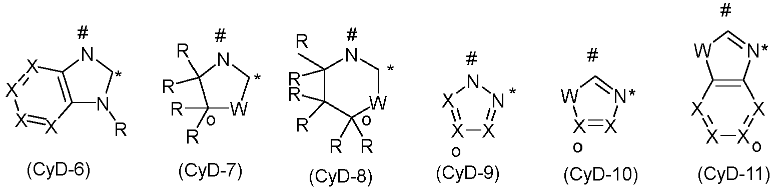 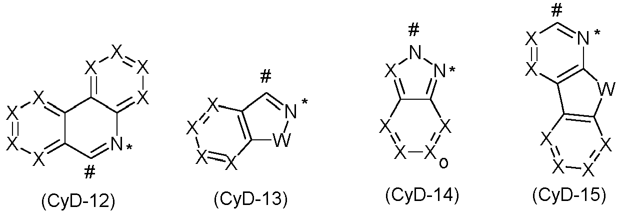 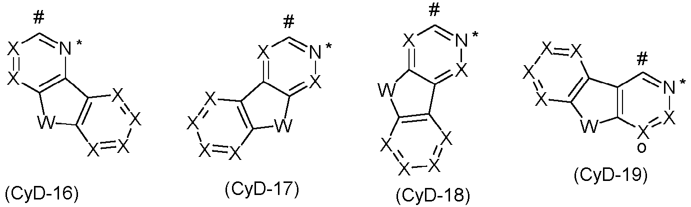 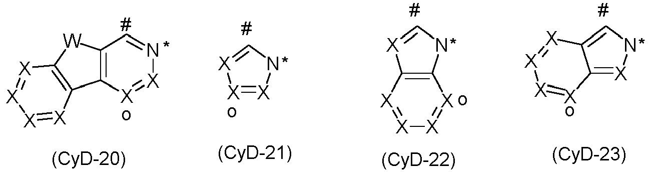 wobei R die in Anspruch 1 genannten Bedeutungen aufweist und für die weiteren verwendeten Symbole gilt:
X ist bei jedem Auftreten gleich oder verschieden CR oder N mit der Maßgabe, dass maximal zwei Symbole X pro Cyclus für N stehen;
W ist bei jedem Auftreten gleich oder verschieden NR, O oder S und kann in CyD weiterhin auch CR₂ sein;
mit der Maßgabe, dass das Symbol X, das an die Brücke V gebunden ist, für C steht, wobei die Bindung an die Brücke V bevorzugt über die mit "o" markierte Position erfolgt

8. Verbindung nach einem oder mehreren der Ansprüche 1 bis 7,
dadurch gekennzeichent, dass L¹ ausgewählt ist aus den Strukturen der Formeln (L¹-1-1) bis (L¹-1-3) und (L¹-2-1) bis (L¹-2-5), die über die beiden mit * gekennzeichneten Positionen an das Iridium koordinieren, 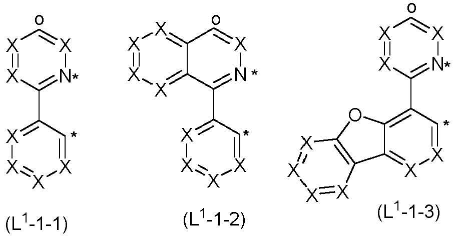 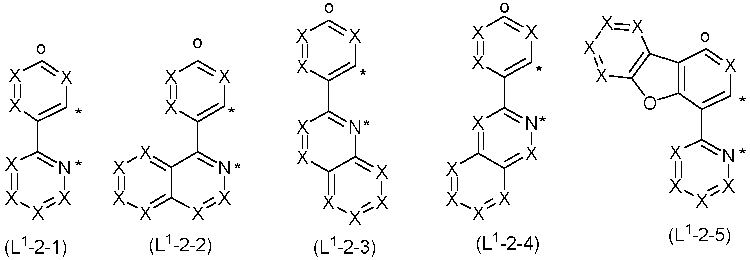
wobei die Symbole die in Anspruch 1 und 7 genannten Bedeutungen aufweisen und "o" die Position der Bindung an die Brücke V darstellt,
oder dass L¹ ausgewählt ist aus den Strukturen der Formeln (L¹-39) oder (L¹-40), die über die beiden mit * gekennzeichneten Positionen an das Iridium koordinieren, 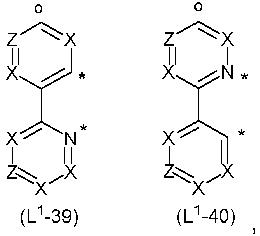
wobei "o" die Position der Verknüpfung mit der Brücke V bezeichnet und weiterhin gilt:
X ist bei jedem Auftreten gleich oder verschieden CR oder N;
Z ist CR', CR oder N, mit der Maßgabe, dass genau ein Z für CR' steht und das andere Z für CR oder N steht;
dabei steht insgesamt maximal ein Symbol X oder Z pro Cyclus für N;
R' ist eine Gruppe der folgenden Formel (16) oder (17), 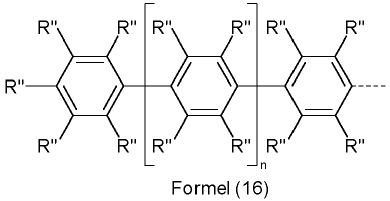 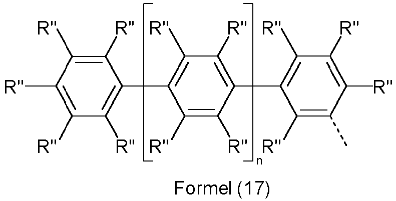 wobei die gestrichelte Bindung die Verknüpfung der Gruppe an den Teilliganden der Formel (L¹-39) bzw. (L¹-40) andeutet;
R" ist gleich oder verschieden bei jedem Auftreten H, D, F, CN, eine geradkettige Alkylgruppe mit 1 bis 10 C-Atomen, in der auch ein oder mehrere H-Atome durch D oder F ersetzt sein können, oder eine verzweigte oder cyclische Alkylgruppe mit 3 bis 10 C-Atomen, in der auch ein oder mehrere H-Atome durch D oder F ersetzt sein können, oder eine Alkenylgruppe mit 2 bis 10 C-Atomen, in der auch ein oder mehrere H-Atome durch D oder F ersetzt sein können; dabei können auch zwei benachbarte Reste R" bzw. zwei Reste R" an benachbarten Phenylgruppen miteinander ein Ringsystem bilden; oder zwei R" an benachbarten Phenylgruppen stehen zusammen für eine Gruppe ausgewählt aus C(R¹)₂, NR¹, O oder S, so dass die beiden Phenylringe zusammen mit der verbrückenden Gruppe für ein Carbazol, Fluoren, Dibenzofuran oder Dibenzothiophen stehen, und die weiteren R" sind wie vorstehend definiert;
n ist 0, 1, 2, 3, 4 oder 5.

9. Verbindung nach einem oder mehreren der Ansprüche 1 bis 8,
**dadurch gekennzeichnet, dass** L² und L³ gleich oder verschieden bei jedem Auftreten ausgewählt sind aus den Strukturen der Formeln (L²-1) bzw. (L³-1) bis (L²-55) bzw. (L³-55), wobei die Gruppen jeweils an der durch * gekennzeichneten Position an das Iridium koordinieren und an der durch "o" gekennzeichneten Position an den Brückenkopf V gebunden sind, 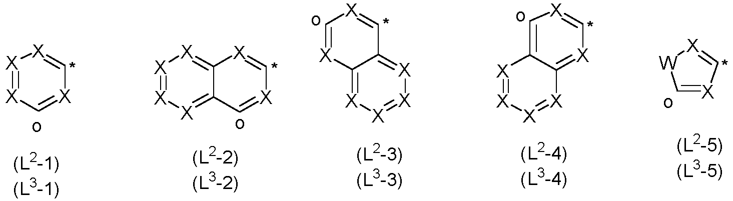 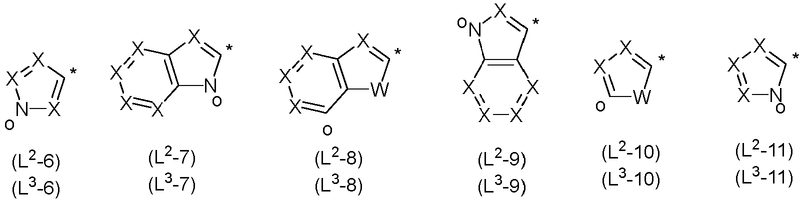 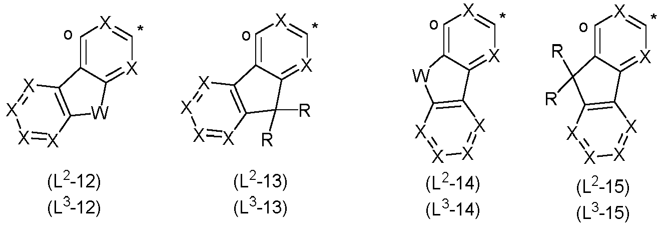 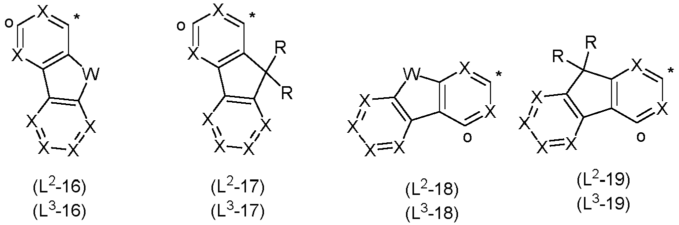 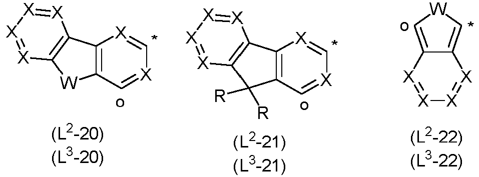 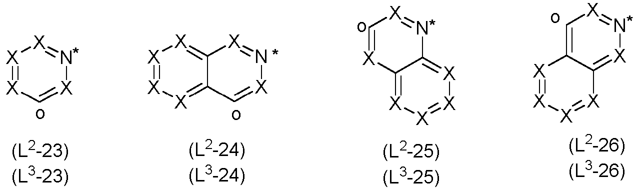 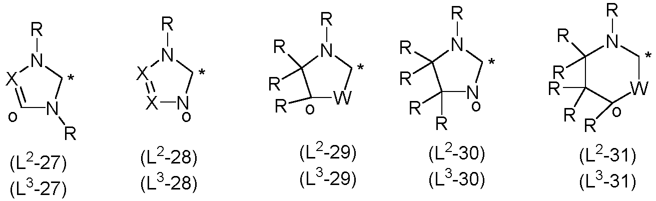 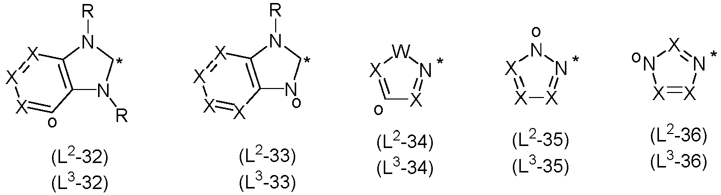 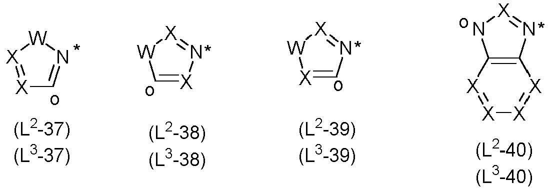 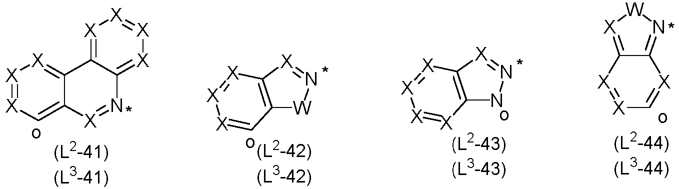 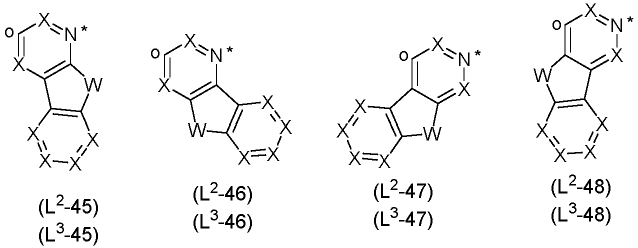 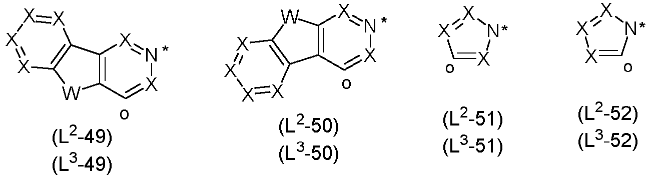 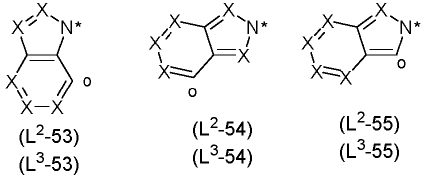 wobei R die in Anspruch 1 genannten Bedeutungen aufweist und für die weiteren Symbole gilt:
X ist bei jedem Auftreten gleich oder verschieden CR oder N mit der Maßgabe, dass maximal zwei Symbole X pro Cyclus für N stehen;
W ist bei jedem Auftreten gleich oder verschieden NR, O oder S.

10. Verbindung nach einem oder mehreren der Ansprüche 1 bis 9,
**dadurch gekennzeichnet, dass** die monodentaten Liganden L⁴ gleich oder verschieden bei jedem Auftreten ausgewählt sind aus der Gruppe bestehend aus Kohlenmonoxid, Stickstoffmonoxid, Alkylcyaniden, Arylcyaniden, Alkylisocyaniden, Arylisocyaniden, Aminen, Phosphinen, Phosphiten, Arsinen, Stibinen, stickstoffhaltigen Heterocyclen, Carbenen, Hydrid, Deuterid, Fluorid, Chlorid, Bromid, Iodid, Alkylacetyliden, Arylacetyliden, Cyanid, Cyanat, Isocyanat, Thiocyanat, Isothiocyanat, aliphatischen oder aromatischen Alkoholaten, aliphatischen oder aromatischen Thioalkoholaten, Amiden, Carboxylaten oder Arylgruppen, und dass die bidentaten Liganden L⁴ ausgewählt sind aus der Gruppe bestehend aus Diaminen, Iminen, Diiminen, Heterocyclen enthaltend zwei Stickstoffatome, Diphosphinen, 1,3-Diketonaten abgeleitet von 1,3-Diketonen, 3-Ketonaten abgeleitet von 3-Ketoestern, Carboxylaten abgeleitet von Aminocarbonsäuren, Salicyliminaten abgeleitet von Salicyliminen, Dialkoholaten abgeleitet von Dialkoholen, Dithiolaten abgeleitet von Dithiolen, Bis(pyrazolyl-boraten), Bis(imidazolyl)boraten, 3-(2-Pyridyl)-diazolen, oder 3-(2-Pyridyl)-triazolen;
oder L⁴ ist ein Ligand gemäß einer der Formeln (L⁴-1), (L⁴-2) und (L⁴-3), 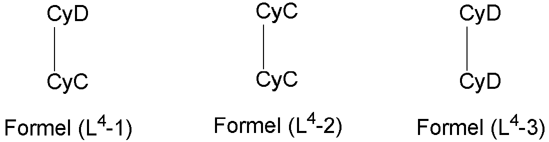
wobei für die verwendeten Symbole gilt:
CyC ist gleich oder verschieden bei jedem Auftreten eine substituierte oder unsubstituierte Aryl- oder Heteroarylgruppe mit 5 bis 14 aromatischen Ringatomen, welche jeweils über ein Kohlenstoffatom an das Metall koordiniert und welche über eine kovalente Bindung mit CyD verbunden ist;
CyD ist gleich oder verschieden bei jedem Auftreten eine substituierte oder unsubstituierte Heteroarylgruppe mit 5 bis 14 aromatischen Ringatomen, welche über ein Stickstoffatom oder über ein Carben-Kohlenstoffatom an das Metall koordiniert und welche über eine kovalente Bindung mit CyC verbunden ist;
dabei können mehrere der optionalen Substituenten miteinander ein Ringsystem bilden;
oder L⁴ ist ein Ligand gemäß einer der Formeln (L⁴-19) bis (L⁴-24), wobei diese Liganden jeweils über die beiden mit * gekennzeichneten Atome an das Iridium koordinieren, 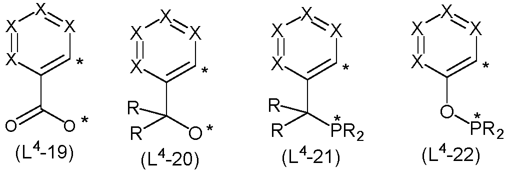 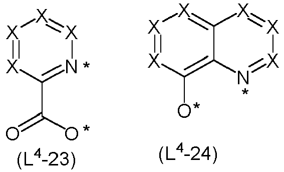
wobei R die in Anspruch 1 genannten Bedeutungen aufweist und X gleich oder verschieden bei jedem Auftreten für CR oder N steht mit der Maßgabe, dass nicht mehr als zwei X für N stehen.

11. Formulierung, enthaltend mindestens eine Verbindung nach einem oder mehreren der Ansprüche 1 bis 10 und mindestens eine weitere Verbindung und/oder ein Lösemittel.

12. Verwendung einer Verbindung nach einem oder mehreren der Ansprüche 1 bis 10 in einer elektronischen Vorrichtung oder als Sauerstoff-Sensibilisator oder als Photoinitiator oder als Photokatalysator.

13. Elektronische Vorrichtung enthaltend mindestens eine Verbindung nach einem oder mehreren der Ansprüche 1 bis 10.

14. Elektronische Vorrichtung nach Anspruch 13, wobei es sich um eine organische Elektrolumineszenzvorrichtung handelt, **dadurch gekennzeichnet, dass** die Verbindung nach einem oder mehreren der Ansprüche 1 bis 15 als Emitter in einer emittierenden Schicht in Kombination mit einem oder mehreren Matrixmaterialien ausgewählt aus der Gruppe bestehend aus Ketonen, Phosphinoxiden, Sulfoxiden, Sulfonen, Triarylaminen, Carbazolderivaten, Biscarbazolen, verbrückten Carbazolderivaten, Indolocarbazolderivaten, Indenocarbazolderivaten, Azacarbazolen, bipolaren Matrixmaterialien, Azaborolen, Boronestern, Diazasilolderivaten, Diazaphospholderivaten, Triazinderivaten, Zinkkomplexen, Dibenzofuranderivaten, Dibenzothiophenderivaten oder Triphenylenderivaten eingesetzt wird.

## Claims

1. A compound of the formula (1) 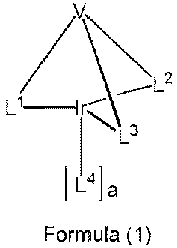 wherein the symbols and indices used are as follows:
L¹ is a bidentate partial ligand which coordinates to the iridium via one carbon atom and one nitrogen atom or via two carbon atoms;
L², L³ are the same or different at each occurrence and are selected from an aryl or heteroaryl group having 5 to 14 aromatic ring atoms or a heteroalicyclic group having 5 to 7 ring atoms, each of which coordinates to the iridium via a carbon atom or a nitrogen atom each of which is part of the aryl or heteroaryl group or the heteroalicyclic group, and which may be substituted by one or more R radicals;
L⁴ is a bidentate ligand or is the same or different at each occurrence and is a monodentate ligand;
a is 1 when L⁴ is a bidentate ligand, and is 2 when L⁴ is a monodentate ligand;
V is a group of the formula (2) or (3) 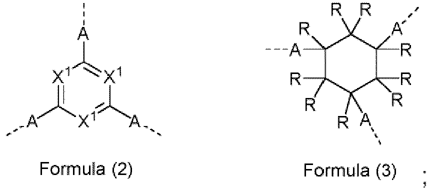 wherein the dotted bonds each represent the position of linkage to the partial ligands L¹, L² and L³, and furthermore:
A is the same or different at each occurrence and is CR₂-CR₂ or a group of the following formula (4): 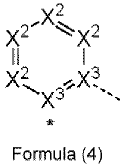 wherein the dotted bond in each case represents the position of the bond of the partial ligands L¹, L² or L³ and * represents the position of the linkage of the unit of the formula (4) to the central trivalent aryl or heteroaryl group in formula (2) or to the central cyclohexane group in formula (3);
X¹ is the same or different at each occurrence and is CR or N;
X² is the same or different at each occurrence and is CR or N; or two adjacent X² groups together are NR, O or S, thus forming a five-membered ring, and the remaining X² groups are the same or different at each occurrence and are CR or N; or two adjacent X² groups together are CR or N when one of the X³ groups in the cycle is N, thus forming a five-membered ring, and the remaining X² groups are the same or different at each occurrence and are CR or N; with the proviso that not more than two adjacent X² groups in each ring are N;
X³ is C at each occurrence in the same cycle or one X³ group is N and the other X³ group in the same cycle is C; with the proviso that two adjacent X² groups together are CR or N when one of the X³ groups in the cycle is N;
R is the same or different at each occurrence and is H, D, F, Cl, Br, I, N(R¹)₂, OR¹, SR¹, CN, NO₂, COOH, C(=O)N(R¹)₂, Si(R¹)₃, Ge(R¹)₃, B(OR¹)₂, C(=O)R¹, P(=O)(R¹)₂, S(=O)R¹, S(=O)₂R¹, OSO₂R¹, a straight-chain alkyl group having 1 to 20 carbon atoms, or an alkenyl or alkynyl group having 2 to 20 carbon atoms, or a branched or cyclic alkyl group having 3 to 20 carbon atoms, wherein the alkyl, alkenyl or alkynyl group may in each case be substituted by one or more R¹ radicals, and wherein one or more nonadjacent CH₂ groups may be replaced by Si(R¹)₂, C=O, NR¹, O, S or CONR¹, or an aromatic or heteroaromatic ring system which has 5 to 40 aromatic ring atoms and which may each be substituted by one or more R¹ radicals; optionally, two R radicals together may also form a ring system;
R¹ is the same or different at each occurrence and is H, D, F, Cl, Br, I, N(R²)₂, OR², SR², CN, NO₂, Si(R²)₃, Ge(R²)₃, B(OR²)₂, C(=O)R², P(=O)(R²)₂, S(=O)R², S(=O)₂R², OSO₂R², a straight-chain alkyl group having 1 to 20 carbon atoms, or an alkenyl or alkynyl group having 2 to 20 carbon atoms, or a branched or cyclic alkyl group having 3 to 20 carbon atoms, wherein the alkyl, alkenyl or alkynyl group may in each case be substituted by one or more R² radicals, and wherein one or more nonadjacent CH₂ groups may be replaced by Si(R²)₂, C=O, NR², O, S or CONR², or an aromatic or heteroaromatic ring system which has 5 to 40 aromatic ring atoms and which may each be substituted by one or more R² radicals; optionally, two or more R¹ radicals together may also form a ring system;
R² is the same or different at each occurrence and is H, D, F, or an aliphatic, aromatic and/or heteroaromatic organic radical, in particular a hydrocarbyl radical, having 1 to 20 carbon atoms, in which one or more hydrogen atoms may also be replaced by F.

2. A compound as claimed in claim 1, **characterized in that** the group of the formula (2) is represented by formula (2a), and **in that** the group of the formula (3) is represented by formula (3a): 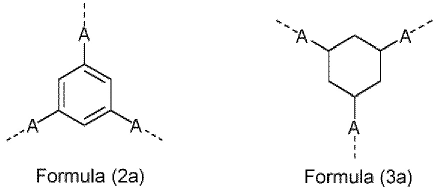 wherein the symbols have the definitions given in claim 1.

3. A compound as claimed in claim 1 or 2, **characterized in that** the group of the formula (4) is represented by formula (4'): 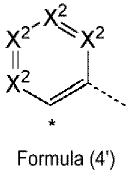 wherein the symbols have the definitions detailed in claim 1, and X² is preferably the same or different at each occurrence and is CR.

4. A compound as claimed in one or more of claims 1 to 3, **characterized in that** all three A groups are the same group of the formula (4') with X² = CR, or two A groups are the same group of the formula (4') with X² = CR and the third A group is CR₂-CR₂, or one A group is a group of the formula (4') with X² = CR and the two other A groups are the same CR₂-CR₂ group, or all three A groups are the same CR₂-CR₂ group.

5. A compound as claimed in one or more of claims 1 to 4, **characterized in that** the group of the formula (2) is selected from the groups of the formulae (2a-1) to (2d-1), and the group of the formula (3) is selected from the groups of the formulae (3a-1) to (3d-1): 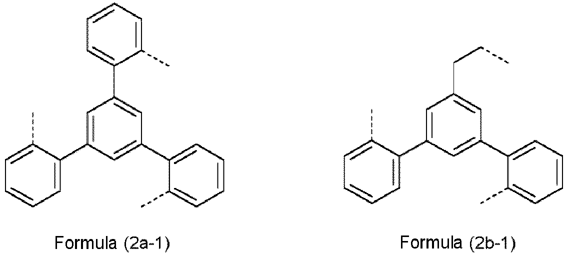 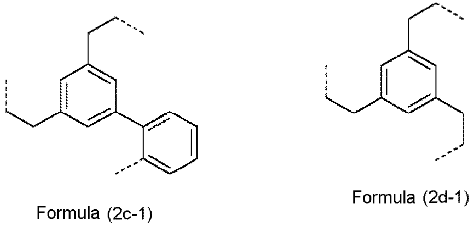 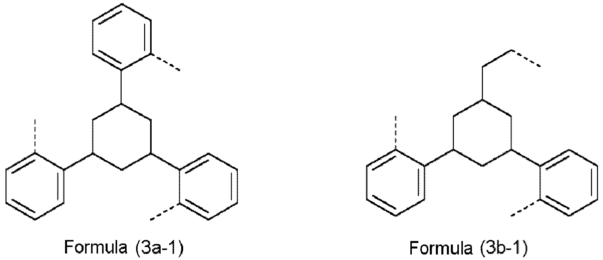 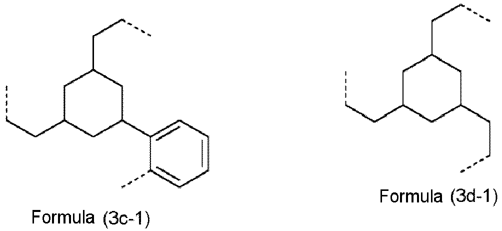 wherein the symbols have the definitions given in claim 1.

6. A compound as claimed in one or more of claims 1 to 5, **characterized in that** the partial ligand L¹ has a structure of one of the following formulae (L¹-1) and (L¹-2): 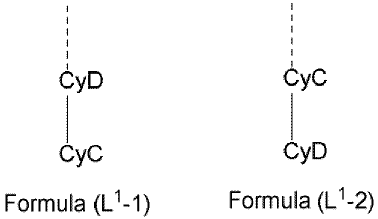
wherein the dotted bond represents the bond of the partial ligand L¹ to V and the other symbols are as follows:
CyC is the same or different at each occurrence and is a substituted or unsubstituted aryl or heteroaryl group which has 5 to 14 aromatic ring atoms and coordinates in each case to the iridium via a carbon atom ,and which is bonded to CyD via a covalent bond;
CyD is the same or different at each occurrence and is a substituted or unsubstituted heteroaryl group which has 5 to 14 aromatic ring atoms or a substituted or unsubstituted heteroalicyclic group having 5 to 7 ring atoms, each of which coordinates to the iridium via a nitrogen atom or via a carbene carbon atom, and which is bonded to CyC via a covalent bond;
wherein, optionally, two or more of the optional substituents together may form a ring system.

7. A compound as claimed in claim 6, **characterized in that** CyC is selected from the structures of the formulae (CyC-1) to (CyC-20), wherein the CyC group binds in each case at the position identified by # to CyD, and at the position identified by * to the iridium: 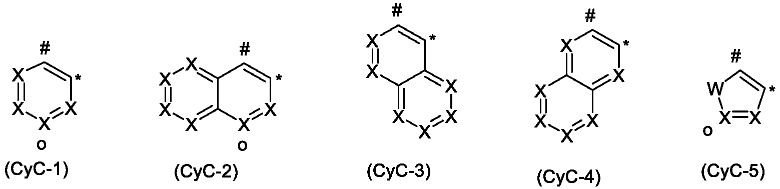 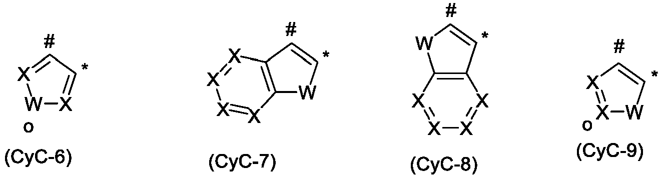 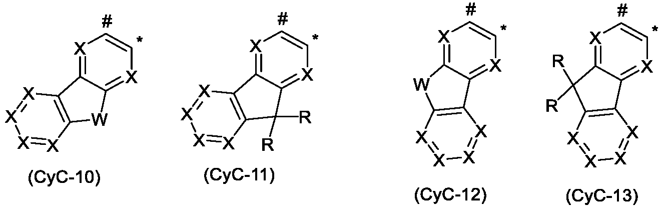 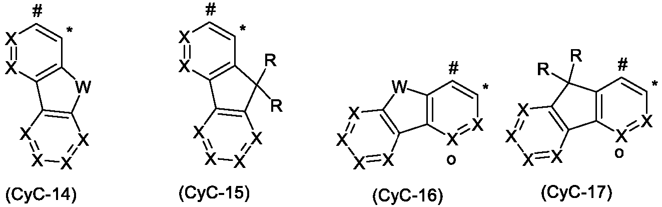 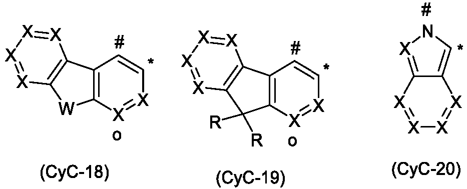 and wherein CyD is selected from the structures of the formulae (CyD-1) to (CyD-23), wherein the CyD group binds in each case at the position identified by # to CyC and coordinates at the position identified by * to the iridium, 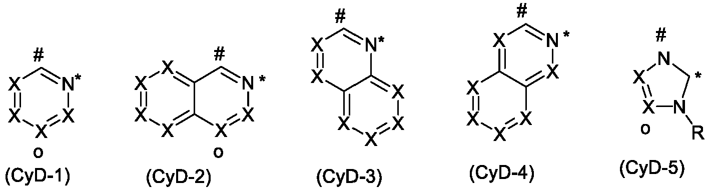 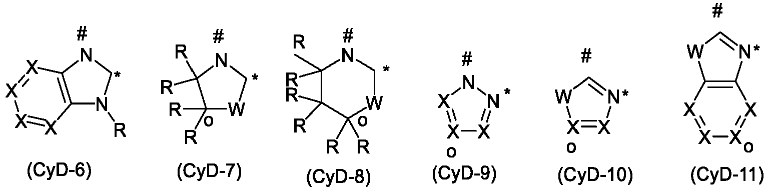 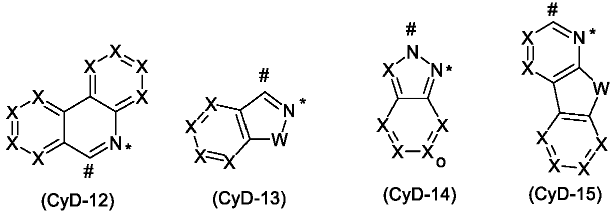 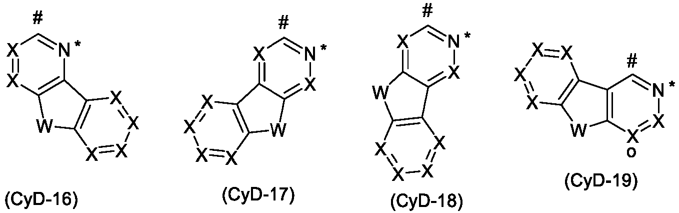 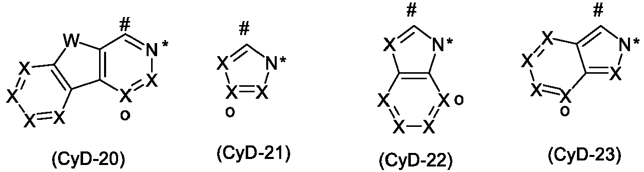 wherein R has the definitions given in claim 1 and the other symbols used are as follows:
X is the same or different at each occurrence and is CR or N, with the proviso that a maximum of two symbols X per ring are N;
W is the same or different at each occurrence and is NR, O or S, and in CyD may additionally also be CR₂;
with the proviso that the symbol X bonded to the bridge V is C, where the bond to the bridge V is preferably via the position marked "o".

8. A compound as claimed in one or more of claims 1 to 7, **characterized in that** L¹ is selected from the structures of the formulae (L¹-1-1) to (L¹-1-3) and (L¹-2-1) to (L¹-2-5) that coordinate to the iridium via the two positions identified by *: 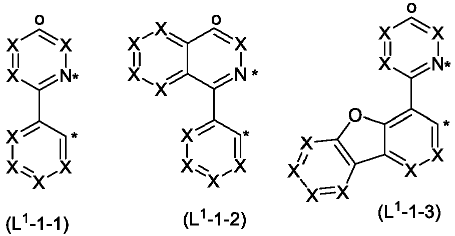 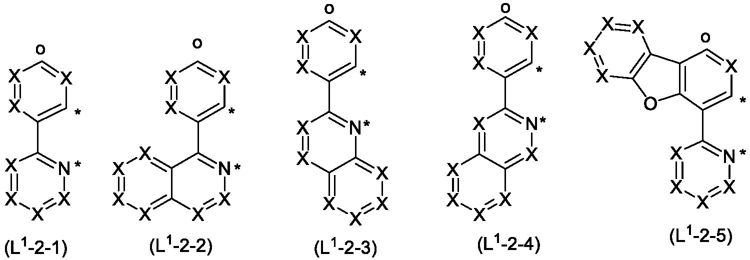
wherein the symbols have the definitions given in claims 1 and 7 and "o" represents the position of the bond to the bridge V,
or L¹ is selected from the structures of the formula (L¹-39) or (L¹-40) that coordinate to the iridium by the two positions identified by *: 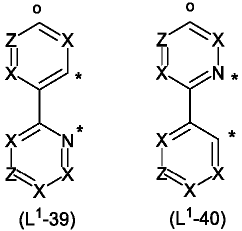
wherein "o" denotes the position of linkage to the bridge V, and in addition:
X is the same or different at each occurrence and is CR or N;
Z is CR', CR or N, with the proviso that exactly one Z is CR' and the other Z is CR or N;
wherein a maximum of one symbol X or Z per cycle is N;
R' is a group of the following formula (16) or (17): 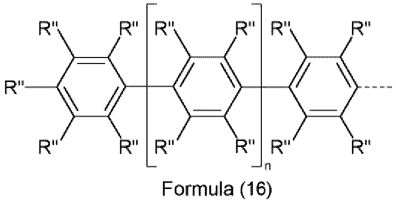 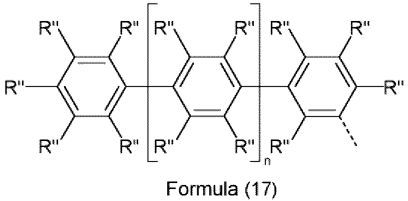 wherein the dotted bond indicates the linkage of the group to the partial ligands of the formula (L¹-39) or (L¹-40);
R" is the same or different at each occurrence and is H, D, F, CN, a straight-chain alkyl group having 1 to 10 carbon atoms in which one or more hydrogen atoms may also be replaced by D or F, or a branched or cyclic alkyl group having 3 to 10 carbon atoms in which one or more hydrogen atoms may also be replaced by D or F, or an alkenyl group having 2 to 10 carbon atoms in which one or more hydrogen atoms may also be replaced by D or F; wherein, optionally, two adjacent R" radicals or two R" radicals on adjacent phenyl groups together may also form a ring system; or two R" on adjacent phenyl groups together are a group selected from C(R¹)₂, NR¹, O or S, such that the two phenyl rings together with the bridging group are a carbazole, fluorene, dibenzofuran or dibenzothiophene, and the further R" are as defined above;
n is 0, 1, 2, 3, 4 or 5.

9. A compound as claimed in one or more of claims 1 to 8, **characterized in that** L² and L³ are the same or different at each occurrence and are selected from the structures of the formulae (L²-1)/(L³-1) to (L²-55)/(L³-55), wherein the groups each coordinate to the iridium at the position identified by * and to the bridgehead V at the position identified by "o": 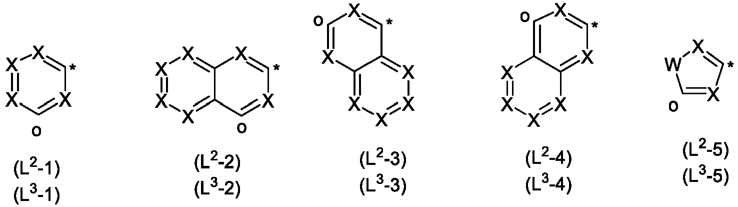 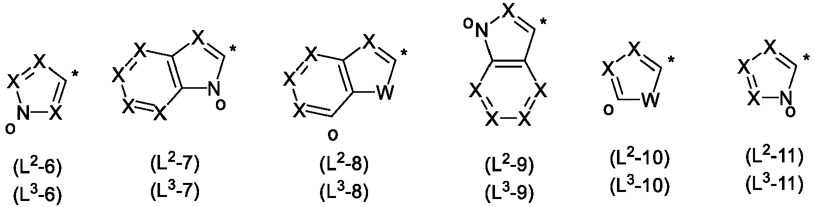 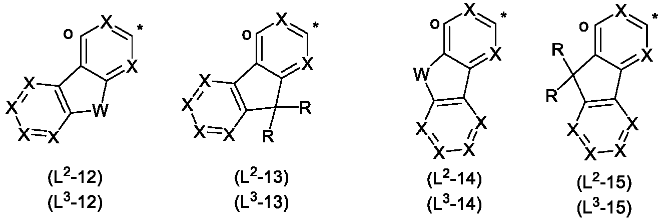 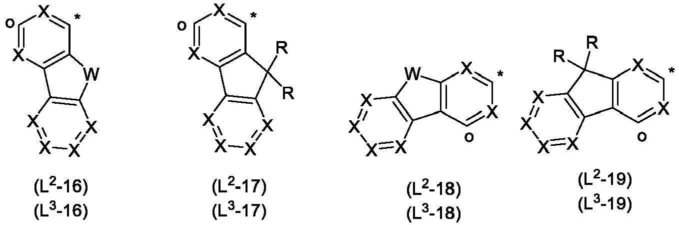 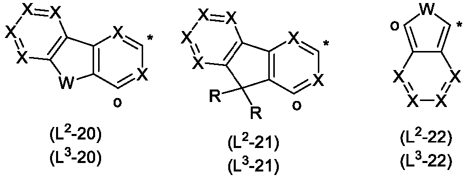 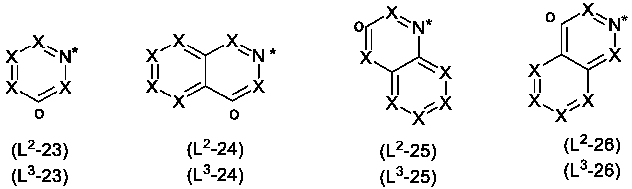 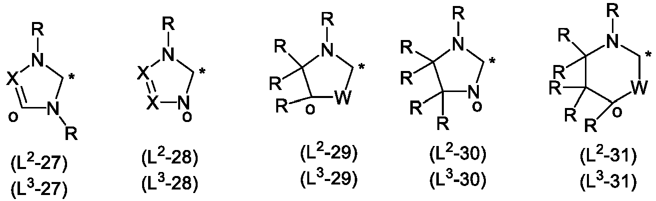 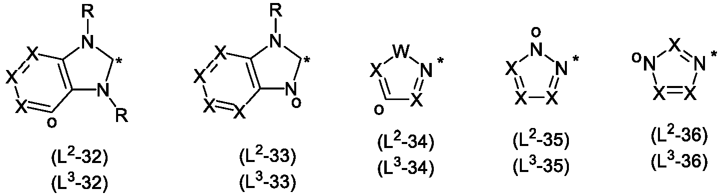 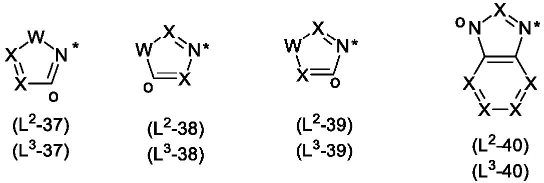 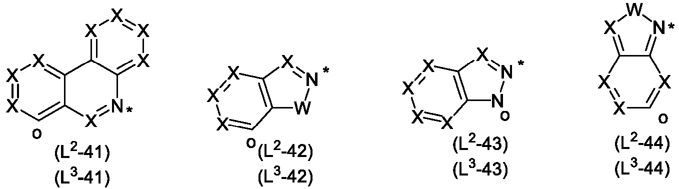 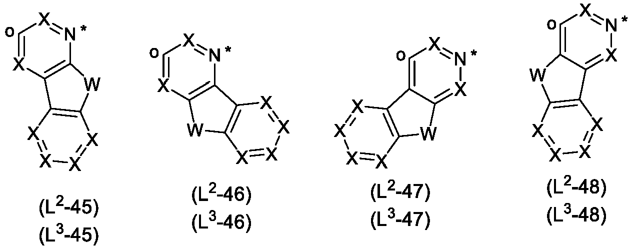 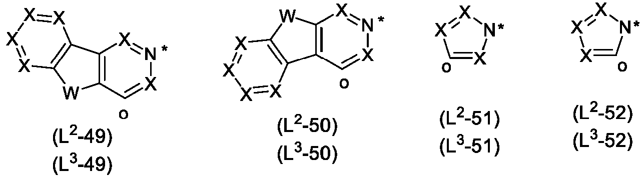 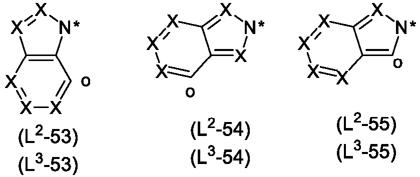 wherein R has the definitions given in claim 1 and the other symbols are as follows:
X is the same or different at each occurrence and is CR or N, with the proviso that a maximum of two symbols X per ring are N;
W is the same or different at each occurrence and is NR, O or S.

10. A compound as claimed in one or more of claims 1 to 9, **characterized in that** the monodentate ligands L⁴ are the same or different at each occurrence and are selected from the group consisting of carbon monoxide, nitrogen monoxide, alkyl cyanides, aryl cyanides, alkyl isocyanides, aryl isocyanides, amines, phosphines, phosphites, arsines, stibines, nitrogen heterocycles, carbenes, hydride, deuteride, fluoride, chloride, bromide, iodide, alkylacetylidene, arylacetylidene, cyanide, cyanate, isocyanate, thiocyanate, isothiocyanate, aliphatic or aromatic alkoxides, aliphatic or aromatic thioalkoxides, amides, carboxylates or aryl groups, and wherein the bidentate ligands L⁴ are selected from the group consisting of diamines, imines, diimines, heterocycles containing two nitrogen atoms, diphosphines, 1,3-diketonates derived from 1,3-diketones, 3-ketonates derived from 3-keto esters, carboxylates derived from aminocarboxylic acids, salicyliminates derived from salicylimines, dialkoxides derived from dialcohols, dithiolates derived from dithiols, bis(pyrazolylborates), bis(imidazolyl)borates, 3-(2-pyridyl)diazoles, or 3-(2-pyridyl)triazoles;
or L⁴ is a ligand of one of the formulae (L⁴-1), (L⁴-2) and (L⁴-3): 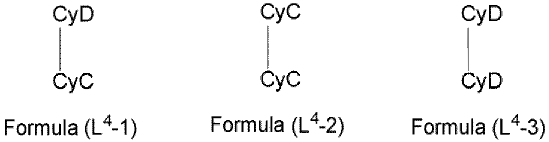
wherein the symbols used are as follows:
CyC is the same or different at each occurrence and is a substituted or unsubstituted aryl or heteroaryl group which has 5 to 14 aromatic ring atoms and coordinates in each case to the metal via a carbon atom, and which is bonded to CyD via a covalent bond;
CyD is the same or different at each occurrence and is a substituted or unsubstituted heteroaryl group which has 5 to 14 aromatic ring atoms and coordinates to the metal via a nitrogen atom or via a carbene carbon atom, and which is bonded to CyC via a covalent bond;
wherein, optionally, two or more of the optional substituents together may form a ring system;
or L⁴ is a ligand of one of the formulae (L⁴-19) to (L⁴-24), wherein these ligands each coordinate to the iridium via the two atoms identified by *: 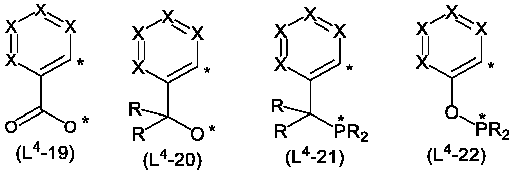 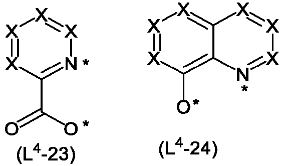
wherein R has the definitions given in claim 1 and X is the same or different at each occurrence and is CR or N, with the proviso that not more than two X are N.

11. A formulation comprising at least one compound as claimed in one or more of claims 1 to 10 and at least one further compound and/or a solvent.

12. The use of a compound as claimed in one or more of claims 1 to 10 in an electronic device, or as oxygen sensitizer, or as a photoinitiator, or as photocatalyst.

13. An electronic device comprising at least one compound as claimed in one or more of claims 1 to 10.

14. The electronic device as claimed in claim 13, which is an organic electroluminescent device, **characterized in that** the compound as claimed in one or more of claims 1 to 15 is used as emitter in an emitting layer in combination with one or more matrix materials selected from the group consisting of ketones, phosphine oxides, sulfur oxides, sulfones, triarylamines, carbazole derivatives, biscarbazoles, bridged carbazole derivatives, indolocarbazole derivatives, indenocarbazole derivatives, azacarbazoles, bipolar matrix materials, azaboroles, boronic esters, diazasilole derivatives, diazaphosphole derivatives, triazine derivatives, zinc complexes, dibenzofuran derivatives, dibenzothiophene derivatives or triphenylene derivatives.

## Revendications

1. Composé de formule (1), 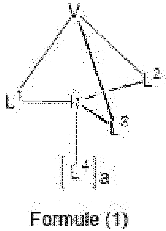 dans laquelle les symboles et les indices utilisés sont comme suit :
L¹ est un ligand partiel bidenté qui se coordonne à l'iridium via un atome de carbone et un atome d'azote ou via deux atomes de carbone,
L², L³ sont identiques ou différents à chaque occurrence et sont choisis parmi un groupe aryle ou hétéroaryle possédant 5 à 14 atomes de cycle aromatique ou un groupe hétéroalicyclique possédant 5 à 7 atomes de cycle, qui est respectivement coordonné à l'iridium via un atome de carbone ou un atome d'azote faisant respectivement partie du groupe aryle ou hétéroaryle ou du groupe hétéroalicyclique, et qui peut être substitué par un ou plusieurs radicaux R,
L⁴ est un ligand bidenté ou est identique ou différent à chaque occurrence et est un ligand monodenté,
a vaut 1 lorsque L⁴ est un ligand bidenté et vaut 2 lorsque L⁴ est un ligand monodenté,
V est un groupe de formule (2) ou (3), 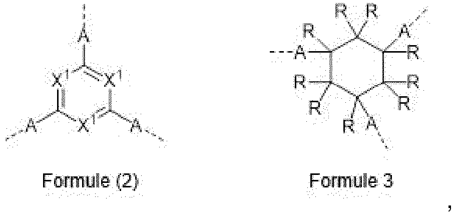
dans lesquelles les liaisons en pointillés représentent la position de la liaison aux ligands partiels L¹, L² et L³ et de plus :
A est identique ou différent à chaque occurrence et est CR₂-CR ₂ ou un groupe ayant la formule (4) suivante : 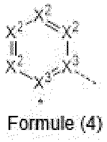
dans laquelle la liaison en pointillés représente respectivement la position de la liaison des ligands partiels L¹, L² ou L³ et * représente la position de la liaison entre l'unité de la formule (4) et le groupe aryle ou hétéroaryle trivalent central dans la formule (2) ou le groupe cyclohexane central dans la formule (3),
X¹ est identique ou différent à chaque occurrence et est CR ou N,
X² est identique ou différent à chaque occurrence et est CR ou N, ou deux groupes X² adjacents représentent ensemble NR, O ou S, de sorte qu'un cycle à cinq chaînons est formé, et les groupes X ² restants sont identiques ou différents à chaque occurrence et sont CR ou N, ou deux groupes X ² adjacents représentent ensemble CR ou N, lorsque l'un des groupes X ³ dans le cycle représente N, de sorte qu'un cycle à cinq chaînons est formé, et les groupes X² restants sont identiques ou différents à chaque occurrence et sont CR ou N, à condition qu'au maximum deux groupes X ² adjacents dans chaque cycle représentent N,
X³ est C à chaque occurrence dans le même cycle, ou un groupe X³ représente N et l'autre groupe X³ dans le même cycle représente C, à condition que deux groupes X² adjacents représentent ensemble CR ou N lorsque l'un des groupes X³ dans le cycle représente N,
R est identique ou différent à chaque occurrence et est H, D, F, CI, Br, I, N(R¹)₂, OR¹, SR¹, CN, NO₂, COOH, C(=O)N(R¹)₂, Si(R¹)₃, Ge(R¹)₃, B(OR¹)₂, C(=O)R¹, P(=O)(R¹)₂, S(=O)R¹, S(=O)₂R¹, OSO₂R¹, un groupe alkyle à chaîne droite possédant 1 à 20 atomes de C ou un groupe alcényle ou alcynyle possédant 2 à 20 atomes de C ou un groupe alkyle ramifié ou cyclique possédant 3 à 20 atomes de C, dans lequel le groupe alkyle, alcényle ou alcynyle peut respectivement être substitué par un ou plusieurs radicaux R¹ et dans lequel un ou plusieurs groupes CH₂ non adjacents peuvent être remplacés par Si(R¹)₂, C=O, NR¹, O, S ou CONR¹, ou un système de cycle aromatique ou hétéroaromatique possédant 5 à 40 atomes de cycle aromatique, qui peut respectivement être substitué par un ou plusieurs radicaux R¹, deux radicaux R pouvant ainsi également former un système cyclique l'un avec l'autre,
R¹ est identique ou différent à chaque occurrence et est H, D, F, CI, Br, I, N(R²)₂, OR², SR², CN, NO₂, Si(R²)₃, Ge(R²)₃, B(OR²)₂, C(=O)R², P(=O)(R²)₂, S(=O)R², S(=O)₂R², OSO₂R², un groupe alkyle à chaîne droite possédant 1 à 20 atomes de C ou un groupe alcényle ou alcynyle possédant 2 à 20 atomes de C ou un groupe alkyle ramifié ou cyclique possédant 3 à 20 atomes de C, dans lequel le groupe alkyle, alcényle ou alcynyle peut respectivement être substitué par un ou plusieurs radicaux R² et dans lequel un ou plusieurs groupes CH₂ non adjacents peuvent être remplacés par Si(R²)₂, C=O, NR², O, S ou CONR², ou un système de cycle aromatique ou hétéroaromatique possédant 5 à 40 atomes de cycle aromatique, qui peut respectivement être substitué par un ou plusieurs radicaux R², deux ou plusieurs radicaux R¹ pouvant ainsi également former un système cyclique les uns avec les autres,
R² est identique ou différent à chaque occurrence et est H, D, F ou un radical organique aliphatique, aromatique et/ou hétéroaromatique, en particulier un radical hydrocarbure possédant 1 à 20 atomes de C, dans lequel un ou plusieurs atomes de H peuvent également être remplacés par F.

2. Composé selon la revendication 1, **caractérisé en ce que** le groupe de formule (2) est représenté par la formule (2a) et **en ce que** le groupe de formule (3) est représenté par la formule (3a), 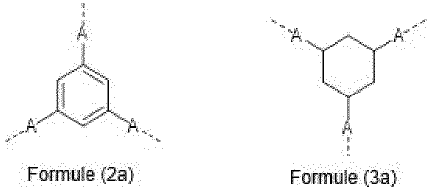 dans lesquelles les symboles ont les significations indiquées dans la revendication 1.

3. Composé selon la revendication 1 ou 2, **caractérisé en ce que** le groupe de formule (4) est représenté par la formule (4'), 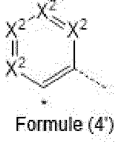 dans laquelle les symboles ont les significations indiquées dans la revendication 1 et X² est de préférence identique ou différent à chaque occurrence et est CR.

4. Composé selon une ou plusieurs des revendications 1 à 3, **caractérisé en ce que** les trois groupes A représentent tous le même groupe de formule (4') avec X ² = CR ou **en ce que** deux groupes A représentent le même groupe de formule (4') avec X ² = CR et le troisième groupe A représente CR ₂-CR ₂ ou **en ce qu'**un groupe A représente un groupe de formule (4') avec X² = CR ₂ et les deux autres groupes A représentent le même groupe CR₂-CR₂ ou **en ce que** les trois groupes A représentent tous le même groupe CR₂-CR₂.

5. Composé selon une ou plusieurs des revendications 1 à 4, **caractérisé en ce que** le groupe de formule (2) est choisi parmi les groupes de formules (2a-1) à (2d-1) et **en ce que** le groupe de formule (3) est choisi parmi les groupes de formules (3a-1) à (3d-1), 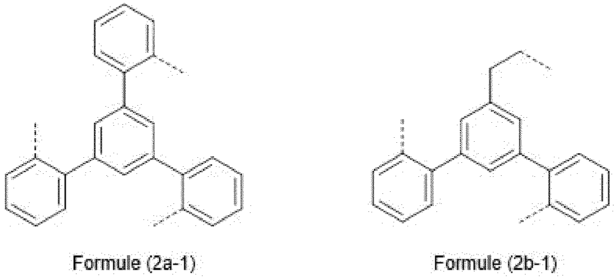 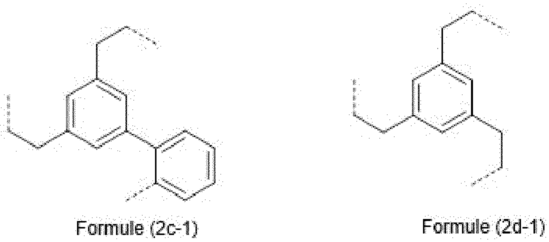 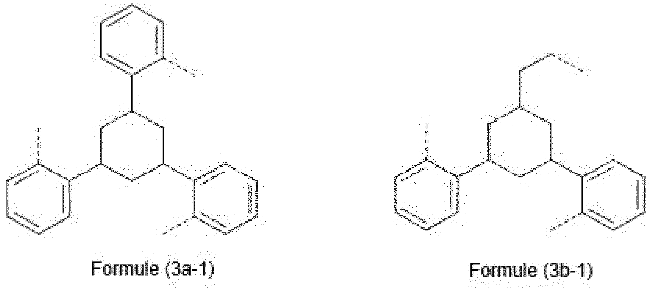 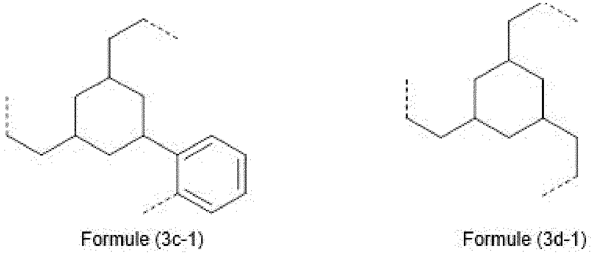 dans lesquelles les symboles ont les significations indiquées dans la revendication 1.

6. Composé selon une ou plusieurs des revendications 1 à 5, **caractérisé en ce que** le ligand partiel L¹ présente une structure selon l'une des formules (L'-1) ou (L¹-2) suivantes : 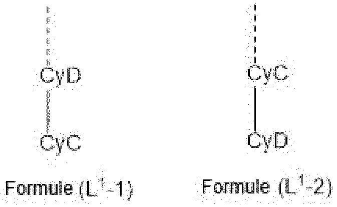 dans lesquelles la liaison en pointillés représente la liaison du ligand partiel L¹ à V et pour les autres symboles :
CyC est identique ou différent à chaque occurrence et est un groupe aryle ou hétéroaryle substitué ou non substitué possédant 5 à 14 atomes de cycle aromatique, qui se coordonne respectivement à l'iridium via un atome de carbone et est lié à CyD par une liaison covalente,
CyD est identique ou différent à chaque occurrence et est un groupe hétéroaryle substitué ou non substitué possédant 5 à 14 atomes de cycle aromatique ou un groupe hétéroalicyclique substitué ou non substitué possédant 5 à 7 atomes de cycle, qui se coordonne respectivement à l'iridium via un atome d'azote ou via un atome de carbène-carbone et qui est lié à CyC par une liaison covalente,
plusieurs des substituants facultatifs pouvant ainsi former un système cyclique les uns avec les autres.

7. Composé selon la revendication 6, **caractérisé en ce que** CyC est choisi parmi les structures de formules (CyC-1) à (CyC-20), dans lesquelles le groupe CyC est respectivement lié à CyD à la position identifiée par # et se coordonne à l'iridium à la position identifiée par *, 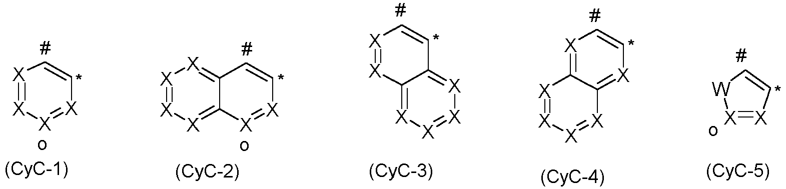 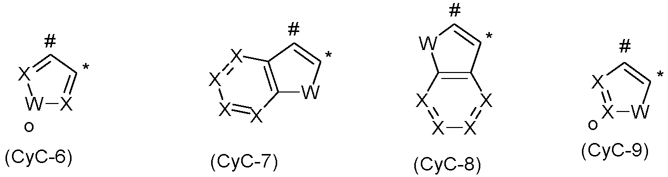 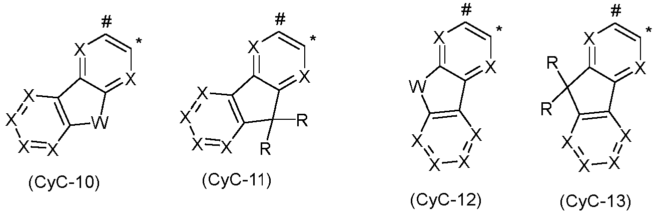 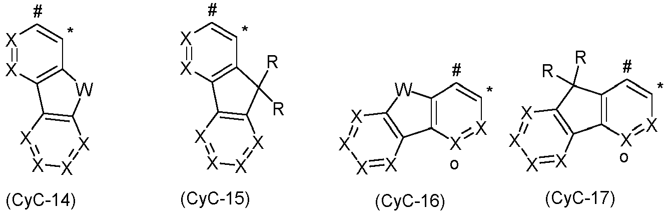 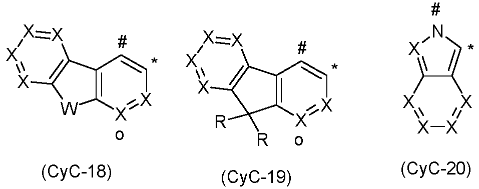 et **en ce que** CyD est choisi parmi les structures des formules (CyD-1) à (CyD-23), dans lesquelles le groupe CyD est respectivement lié à CyC à la position identifiée par # et se coordonne à l'iridium à la position identifiée par *, 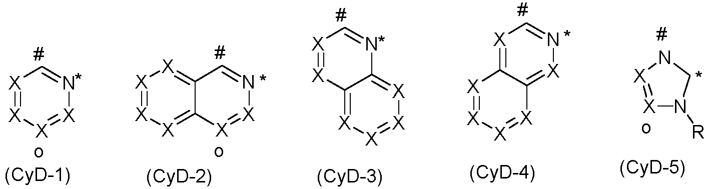 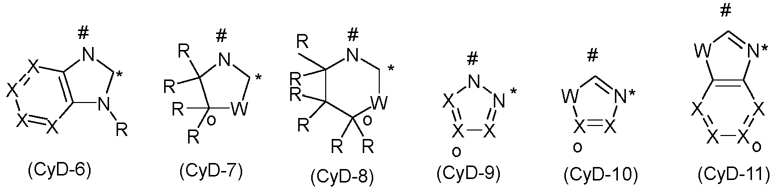 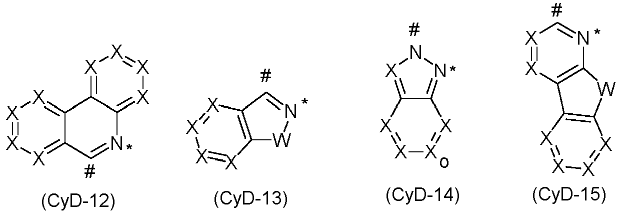 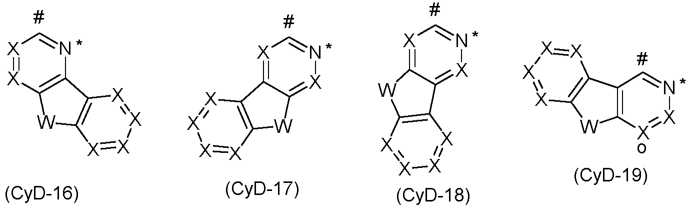 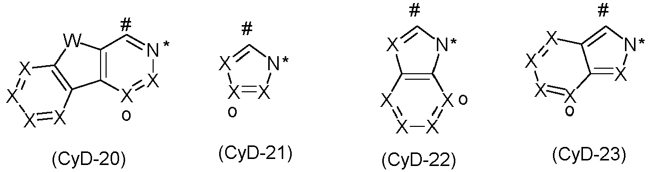 dans lesquelles R a les significations indiquées dans la revendication 1 et pour les autres symboles utilisés :
X est identique ou différent à chaque occurrence et est Cr ou N, à condition qu'au maximum deux symboles X par cycle représentent N,
W est identique ou différent à chaque occurrence et est NR, O ou S, et de plus, en CyD, peut également être CR₂,
à condition que le symbole X, qui est lié au pont V, représente C, la liaison au pont V s'effectuant de préférence via la position marquée "o".

8. Composé selon une ou plusieurs des revendications 1 à 7, **caractérisé en ce que** L¹ est choisi parmi les structures de formules (L'-1-1) à (L'-1-3) et (L'-2-1) à (L'-2-5) qui se coordonnent à l'iridium via les deux positions identifiées par *, 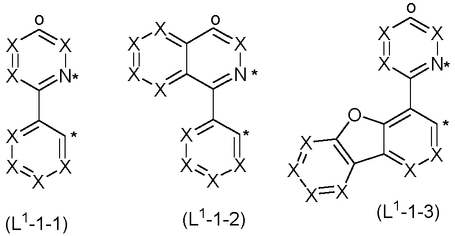 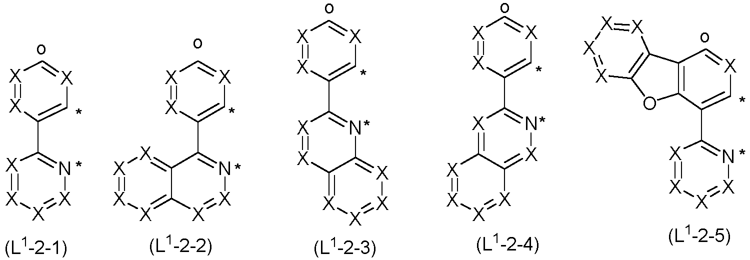
dans lesquelles les symboles ont les significations indiquées dans les revendications 1 et 7 et "o" représente la position de la liaison au pont V,
ou **en ce que** L¹ est choisi parmi les structures des formules (L'-39) ou (L¹-40) qui se coordonnent à l'iridium via les deux positions identifiées par *, 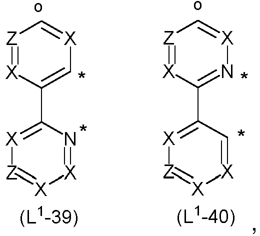
dans lesquelles "o" représente la position de la liaison au pont V et de plus :
X est identique ou différent à chaque occurrence et est CR ou N,
Z est CR', CR ou N, à condition qu'exactement un Z représente CR' et que l'autre Z représente CR ou N,
au maximum un symbole X ou Z au total par cycle représentant N,
R' est un groupe ayant les formules (16) ou (17) suivantes, 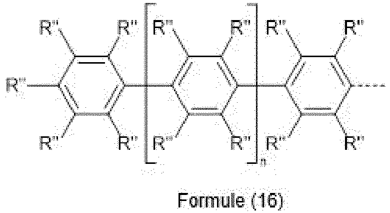 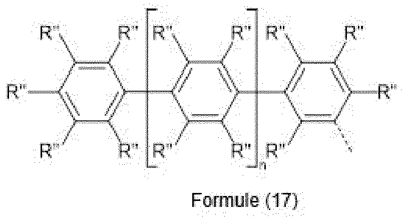
dans lesquelles la liaison en pointillés indique l'association du groupe aux ligands partiels de formule (L'-39) ou (L¹-40)
R" est identique ou différent à chaque occurrence et est H, D, F, CN, un groupe alkyle à chaîne droite possédant 1 à 10 atomes de C, dans lequel un ou plusieurs atomes de H peuvent également être remplacés par D ou F, ou un groupe alkyle ramifié ou cyclique possédant 3 à 10 atomes de C, dans lequel un ou plusieurs atomes de H peuvent également être remplacés par D ou F, ou un groupe alcényle possédant 2 à 10 atomes de C, dans lequel un ou plusieurs atomes de H peuvent également être remplacés par D ou F, deux radicaux R" adjacents ou deux radicaux R" sur des groupes phényliques adjacents pouvant également former un système cyclique l'un avec l'autre, ou deux R" sur des groupes phényle adjacents représentent ensemble un groupe choisi parmi C(R¹)₂, NR¹, O ou S, de sorte que les deux cycles phényliques associés au groupe de pontage représentent un carbazole, un fluorène, un dibenzofurane ou un dibenzothiophène, et les autres R" sont tel que défini ci-dessus,
n vaut 0, 1, 2, 3, 4 ou 5.

9. Composé selon une ou plusieurs des revendications 1 à 8, **caractérisé en ce que** L² et L³ sont identiques ou différents à chaque occurrence et sont choisis parmi les structures de formules (L²-1) ou (L³-1) à (L²-55) ou (L³-55), dans lesquelles les groupes se coordonnent respectivement à l'iridium à la position identifiée par * et sont liés à la tête de pont V à la position identifiée par "o", 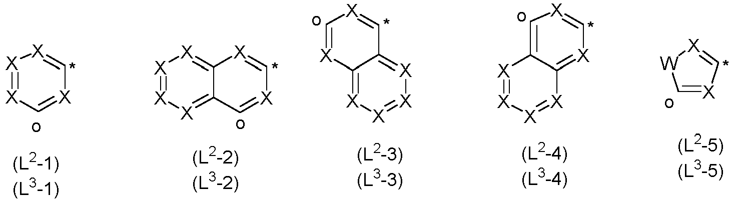 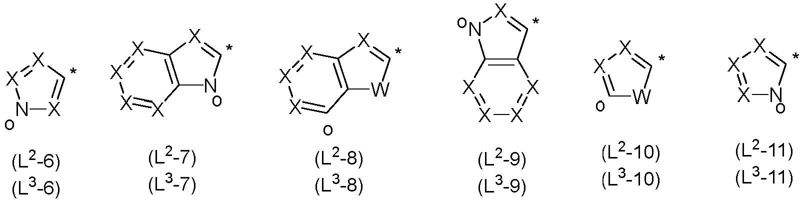 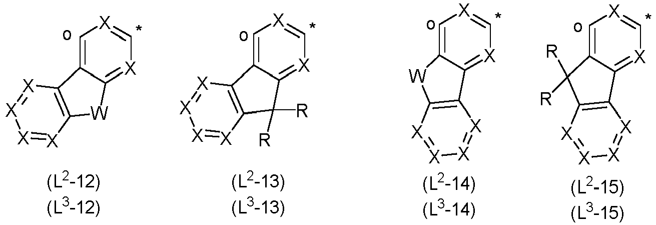 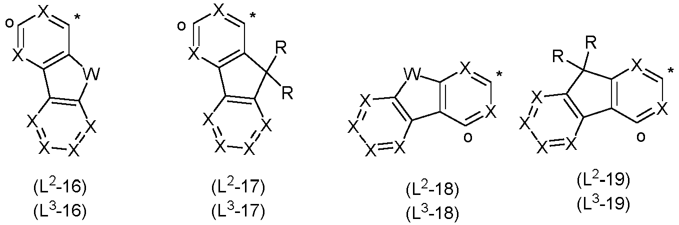 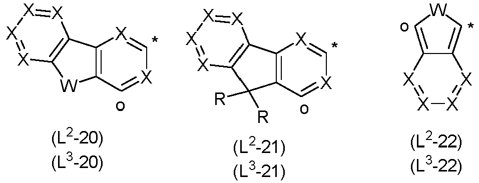 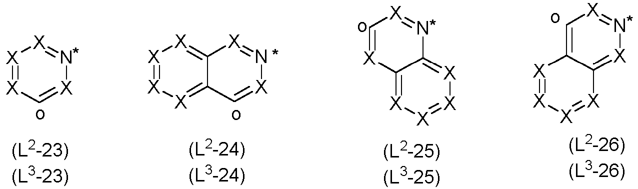 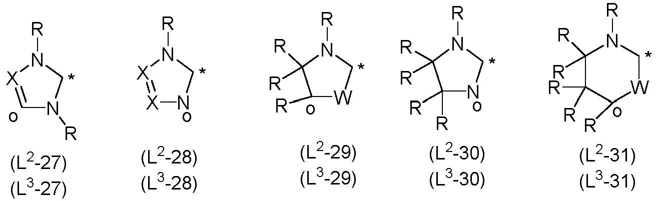 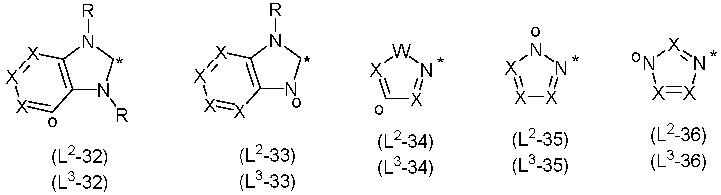 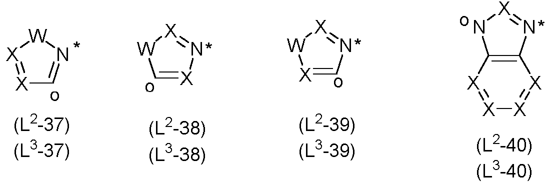 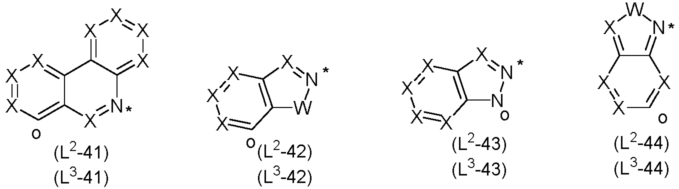 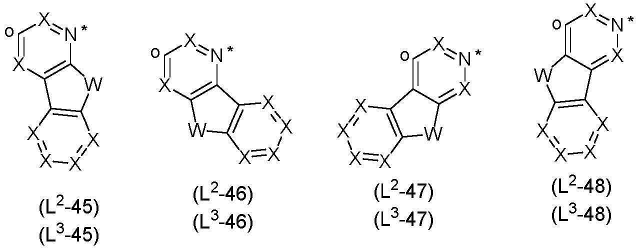 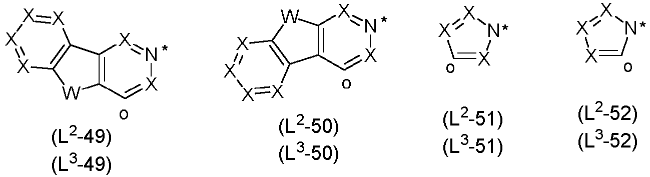 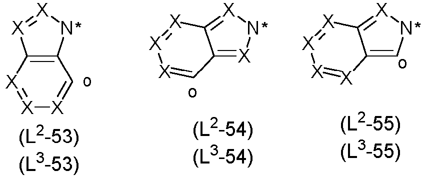 dans lesquelles R a les significations indiquées dans la revendication 1 et pour les autres symboles :
X est identique ou différent à chaque occurrence et est Cr ou N, à condition qu'au maximum deux symboles X par cycle représentent N,
W est identique ou différent à chaque occurrence et est NR, O ou S.

10. Composé selon une ou plusieurs des revendications 1 à 9, **caractérisé en ce que** les ligands monodentés L⁴ sont identiques ou différents à chaque occurrence et sont choisis parmi le groupe constitué de monoxyde de carbone, monoxyde d'azote, cyanures d'alkyle, cyanures d'aryle, isocyanures d'alkyle, isocyanures d'aryle, d'amines, phosphines, phosphites, arsines, stibines, hétérocycles comprenant de l'azote, carbènes, hydrure, deutérure, fluorure, chlorure, bromure, iodure, acétylidène d'alkyle, acétylidène d'aryle, cyanure, cyanate, isocyanate, thiocyanate, isothiocyanate, alcoolates aliphatiques ou aromatiques, thioalcoolates aliphatiques ou aromatiques, amides, carboxylates ou groupes aryle, et **en ce que** les ligands bidentés L⁴ sont choisis parmi le groupe constitué de diamines, imines, diimines, hétérocycles contenant deux atomes d'azote, diphosphine, 1,3-dikétonates dérivés de 1,3-dicétone, 3-kétonates dérivés de 3-céto esters, carboxylates dérivés d'acides aminocarboxyliques, salicyliminates dérivés de salicylimines, dialcoolates dérivés de dialcools, dithiolates dérivés de dithiols, bis(pyrazolylborates), bis(imidazolyl)borates, 3-(2-pyridyl)-diazoles ou 3-(2-pyridyl)-triazoles,
ou L⁴ est un ligand selon l'une des formules (L⁴-1), (L⁴-2) et (L⁴-3), 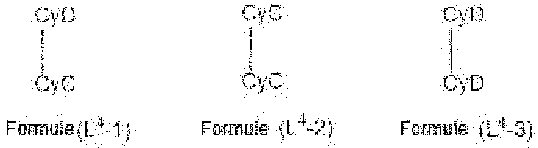 dans lesquelles les symboles utilisés sont comme suit :
CyC est identique ou différent à chaque occurrence et est un groupe aryle ou hétéroaryle substitué ou non substitué possédant 5 à 14 atomes de cycle aromatique, qui se coordonne respectivement au métal via un atome de carbone et qui est lié à CyD par une liaison covalente,
CyD est identique ou différent à chaque occurrence et est un groupe hétéroaryle substitué ou non substitué possédant 5 à 14 atomes de cycle aromatique, qui se coordonne respectivement au métal via un atome d'azote ou via un atome de carbène-carbone et qui est lié à CyC par une liaison covalente,
plusieurs des substituants facultatifs pouvant ainsi former un système cyclique les uns avec les autres,
ou L⁴ est un ligand selon l'une des formules (L⁴-19) à (L⁴-24), dans lesquelles ces ligands se coordonnent respectivement à l'iridium via les deux atomes identifiés par *, 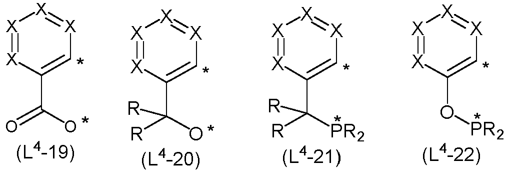 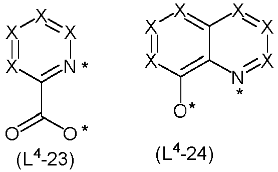
dans lesquelles R a les significations indiquées dans la revendication 1 et X est identique ou différent à chaque occurrence et est CR ou N, à condition que pas plus de deux X représentent N.

11. Formulation contenant au moins un composé selon une ou plusieurs des revendications 1 à 10 et au moins un composé supplémentaire et/ou un solvant.

12. Utilisation d'un composé selon une ou plusieurs des revendications 1 à 10 dans un dispositif électronique ou comme sensibilisateur d'oxygène ou comme photoinitiateur ou comme photocatalyseur.

13. Dispositif électronique contenant au moins un composé selon une ou plusieurs des revendications 1 à 10.

14. Dispositif électronique selon la revendication 13, lequel dispositif étant un dispositif électroluminescent organique, **caractérisé en ce que** le composé selon une ou plusieurs des revendications 1 à 15 est utilisé comme émetteur dans une couche émettrice en combinaison avec un ou plusieurs matériaux de matrice choisis parmi le groupe constitué de cétones, d'oxydes de phosphine, d'oxydes de soufre, de sulfones, de triarylamines, de dérivés de carbazole, de biscarbozoles, de dérivés de carbazole pontés, de dérivés d'indolocarbazole, de dérivés d'indénocarbazole, d'azacarbazoles, de matériaux de matrice bipolaires, d'azaboroles, d'esters de bore, de dérivés de diazasilol, de dérivés de diazaphosphole, de dérivés de triazine, de complexes de zinc, de dérivés de dibenzofurane, de dérivés de dibenzothiophène ou de dérivés de triphénylène.
